# EUROPEAN PATENT SPECIFICATION

(11) **EP 3 193 384 B1**
(45) Date of publication and mention of the grant of the patent: **28.04.2021**
(21) Application number: 17151515.8
(22) Date of filing: 13.01.2017
(51) Int. Cl.: H01L 51/54

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 13.01.2016 KR 20160004417
(43) Date of publication of application: 19.07.2017
(73) Proprietor: Samsung Display Co., Ltd., Yongin-si, Gyeonggi-Do 17113 (KR)
(72) Inventor: KIM, Seulong, Gyeonggi-do (KR); ITO, Naoyuki, Gyeonggi-do (KR); KIM, Younsun, Gyeonggi-do (KR); SHIN, Dongwoo, Gyeonggi-do (KR); LEE, Jungsub, Gyeonggi-do (KR); LIM, Jino, Gyeonggi-do (KR); JEONG, Hyein, Gyeonggi-do (KR)
(74) Representative: Mounteney, Simon James

(56) References cited:
- EP-A1- 2 891 648
- WO-A1-2015/129896
- WO-A1-2015/162912
- KR-A- 20150 064 796

## Description

### BACKGROUND

### 1. Field

One or more embodiments relate to an organic light-emitting device.

### 2. Description of the Related Art

Organic light-emitting devices are self-emission devices that have wide viewing angles, high contrast ratios, short response times, and/or excellent brightness, driving voltage, and/or response speed characteristics, and may produce full-color images.

The organic light-emitting device may include a first electrode disposed on a substrate, and a hole transport region, an emission layer, an electron transport region, and a second electrode, which are sequentially disposed on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. Then, the excitons are transitioned from an excited state to a ground state, thereby generating light.
WO 2015/162912 A1 relates to an organic electroluminescent element.
WO 2015/129896 A1 relates to compounds for an organic electroluminescent element.
EP 2 891 648 A1 relates to aromatic amine derivatives and organic electroluminescence devices using the aromatic amine derivatives.
KR 2015 0064796 A relates to an organic compound and organic electroluminescence devices using the organic compound.

### SUMMARY

An aspect according to one or more embodiments of the present disclosure is directed toward an organic light-emitting device.

Additional aspects will be set forth in part in the description which follows and, in part, will be apparent from the description, or may be learned by practice of the presented embodiments.

According to one or more embodiments, an organic light-emitting device includes a first electrode; a second electrode facing the first electrode; and an organic layer between the first electrode and the second electrode.

The organic layer comprises: an emission layer; and a hole transport region between the emission layer and the first electrode, wherein the emission layer comprises the first compound represented by Formula 1. The hole transport region comprises the second compound represented by Formula 2 and the third compound represented by one selected from Formulae 3-1 to 3-3.

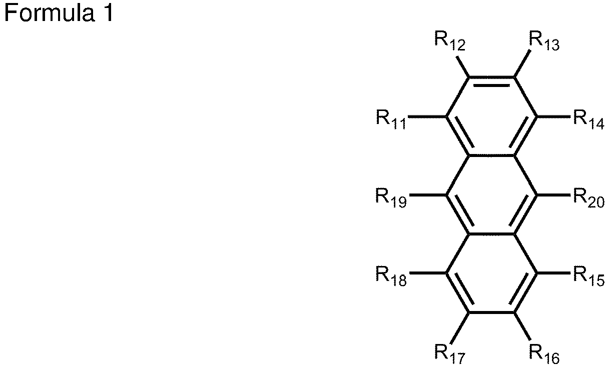

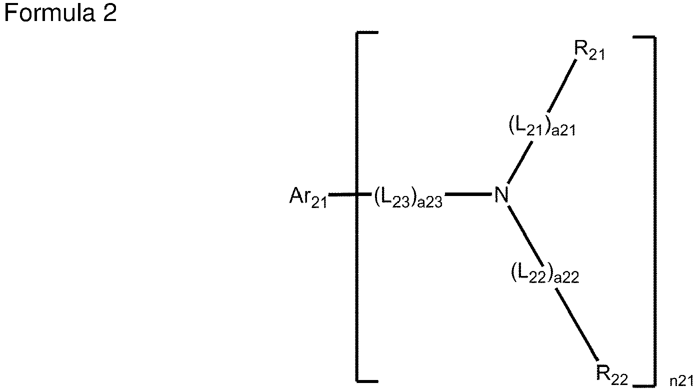

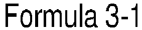

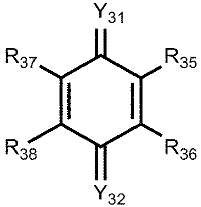

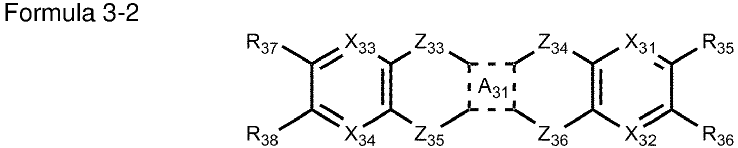

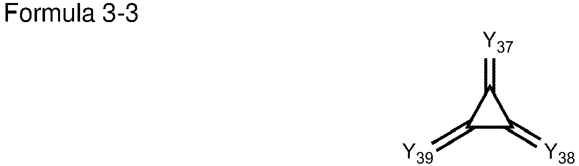

Formula 7 *-(L₇₁)ₐ₇₁-R₇₁

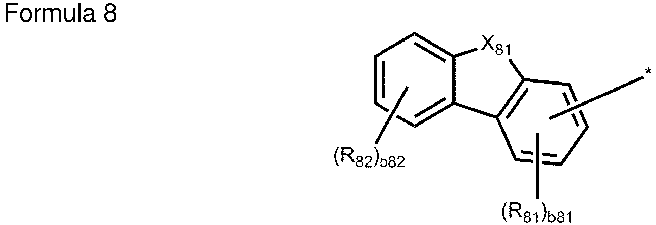

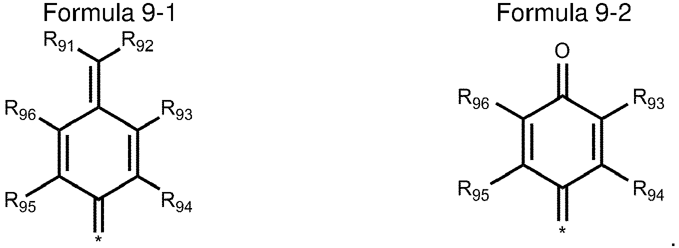

In Formulae 1, 2, 3-1 to 3-3, 7, 8, 9-1, and 9-2,
R₁₁ to R₂₀ are each independently selected from a group represented by Formula 7, hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), - C(=O)(Q₁), -S(=O)₂(Q₁) and -P(=O)(Q₁)(Q₂), provided that at least one selected from R11 to R₂₀ is the group represented by Formula 7;
i) two neighboring groups selected from R₁₁ to R₂₀ are linked to form a ring, and R₇₁ is selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group; or
ii) R₇₁ is selected from a phenanthrenyl group, an anthracenyl group, a tetraphenyl group, a carbazolyl group and a group represented by one selected from Formulae 7A-1 to 7A-31, 7B-1 to 7B-3, 7C-1 to 7C-3, 7D-1 to 7D-3, 7E-1, and 7E-2;
a phenanthrenyl group, an anthracenyl group, a tetraphenyl group, a carbazolyl group, each substituted with at least one selected from deuterium, a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group; and
a phenanthrenyl group, an anthracenyl group, a tetraphenyl group, a carbazolyl group, each substituted with at least one substituent selected from a phenyl group and a naphthyl group, each of the at least one subsitutent is substituted with at least one selected from deuterium, a methyl group, an ethyl group, an n-propyl group, an iso-propyl group, an n-butyl group, a sec-butyl group, an iso-butyl group, a tert-butyl group, and a phenyl group:

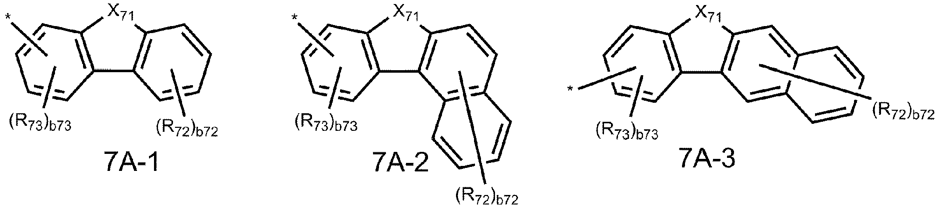

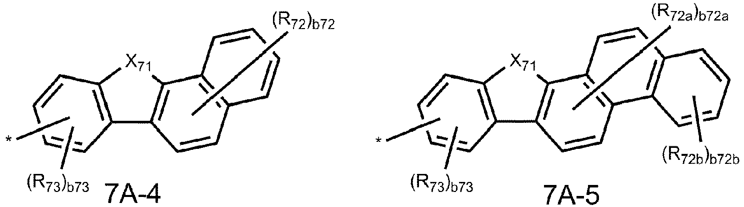

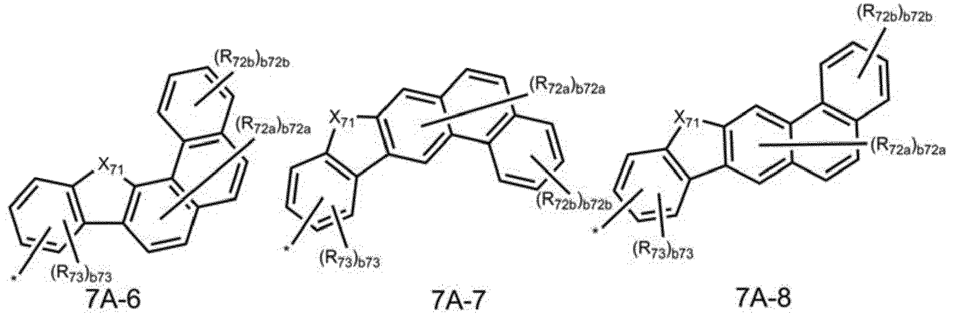

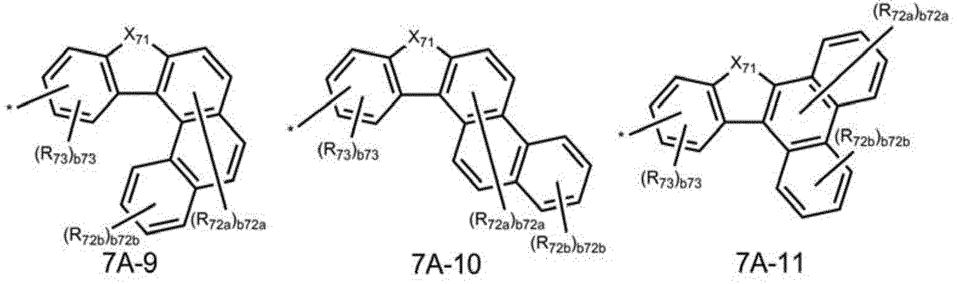

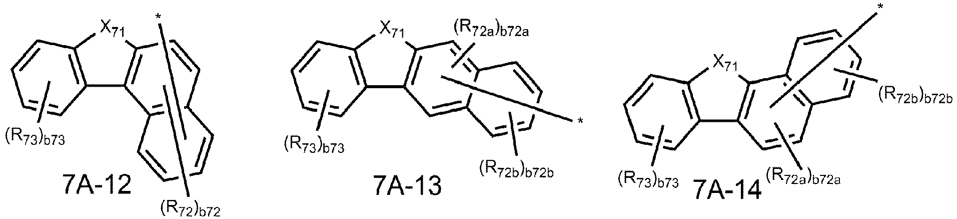

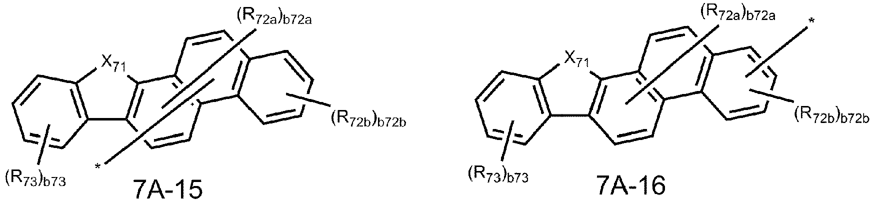

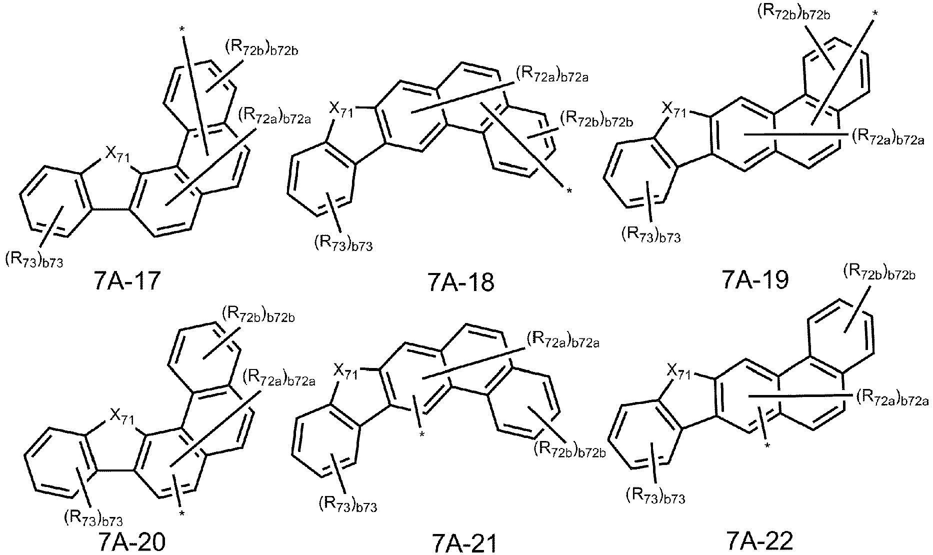

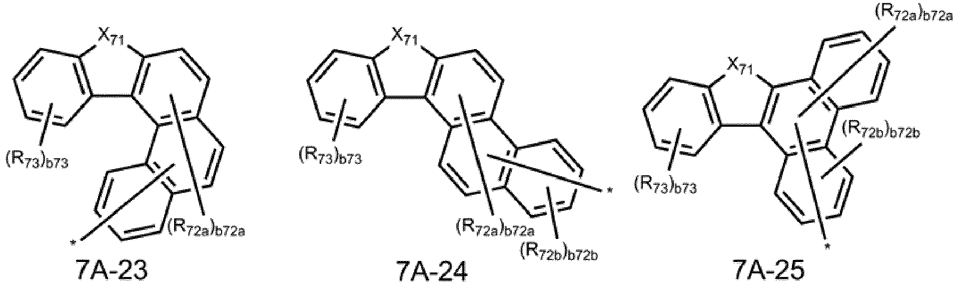

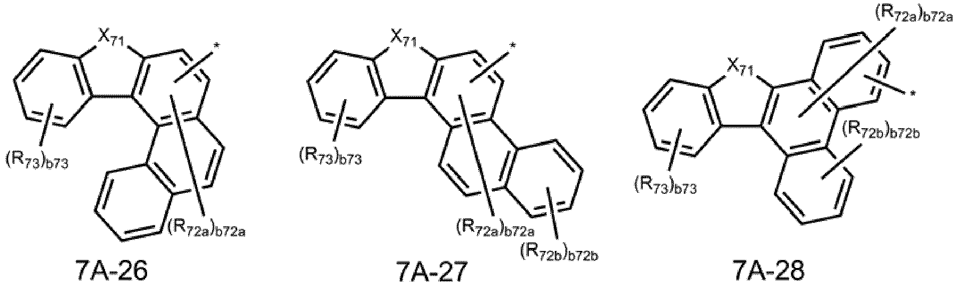

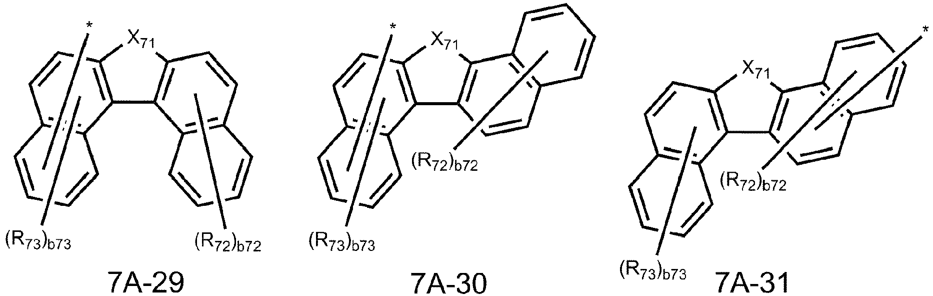

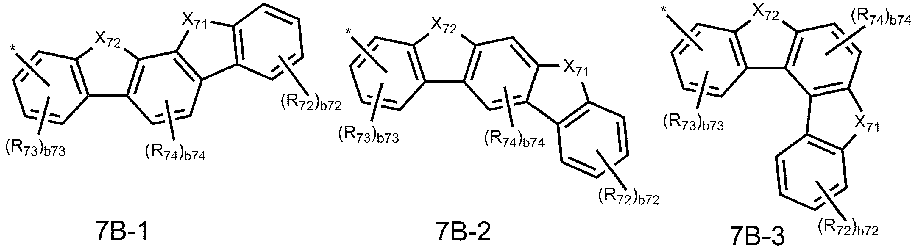

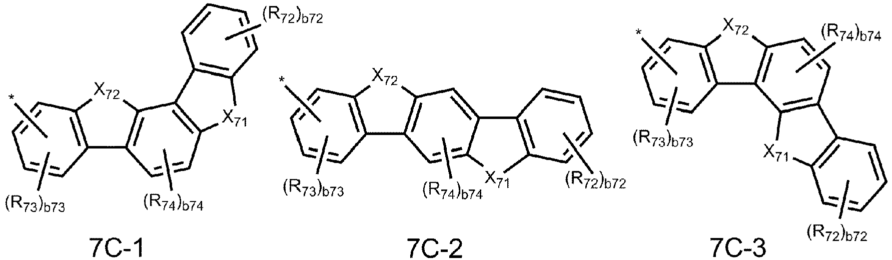

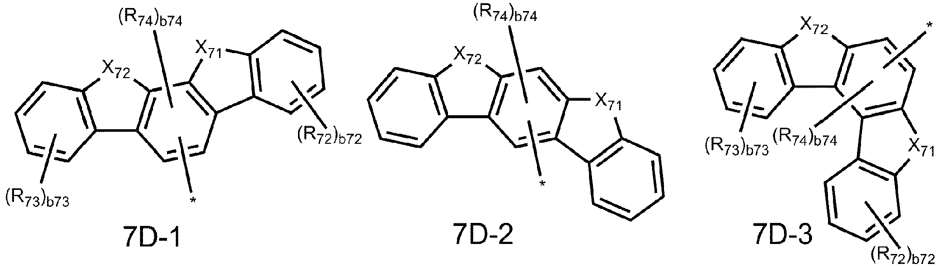

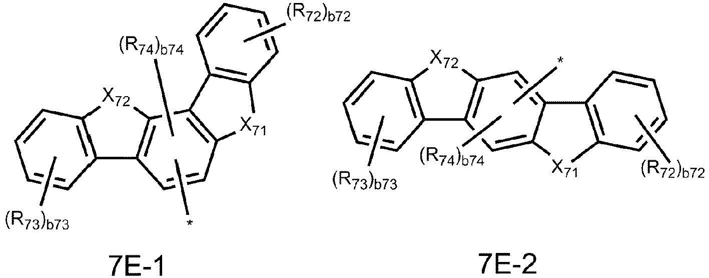

In Formulae 7A-1 to 7A-31, 7B-1 to 7B-3, 7C-1 to 7C-3, 7D-1 to 7D-3, 7E-1, and 7E-2,
X₇₁ is selected from O, S, N(R₇₅), and C(R₇₅)(R₇₆);
X₇₂ is selected from O, S, N(R₇₇), and C(R₇₇)(R₇₈);
R₇₂ to R₇₈, R₇₂ₐ, and R_{72b} are each independently selected from the group consisting of:
hydrogen, deuterium, a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group; and
a phenyl group, a biphenyl group, and a naphthyl group, each substituted with at least one selected from deuterium, a methyl group, an ethyl group, an n-propyl group, an iso-propyl group, an n-butyl group, a sec-butyl group, an iso-butyl group, a tert-butyl group, and a phenyl group;
R₇₅ and R₇₆ are optionally linked to form a ring;
R₇₇ and R₇₈ are optionally linked to form a ring;
b72 to b74, b72a, and b72b are each independently selected from 1, 2, 3, 4, 5, 6, 7, and 8; and
* indicates a binding site to a neighboring atom.

L₇₁ is selected from a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group;
a71 is selected from 0, 1, 2, and 3;
Ar₂₁ is a substituted or unsubstituted C₅-C₆₀ carbocyclic group or a substituted or unsubstituted C₁-C₆₀ heterocyclic group;
L₂₁ to L₂₃ are each independently selected from a substituted or unsubstituted C₆-C₆₀ arylene group and a substituted or unsubstituted C₁-C₆₀ heteroarylene group;
a₂₁ to a₂₃ are each independently selected from 0, 1, 2, and 3;
R₂₁ and R₂₂ are each independently selected from a group represented by Formula 8, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, provided that at least one selected from R₂₁ and R₂₂ is the group represented by Formula 8;
X₈₁ is selected from O and S;
R₈₁ and R₈₂ are each independently selected from the group consisting of:
-F, -Cl, -Br, -I, a cyano group, a C₁-C₆₀ alkyl group, a C₃-C₁₀ cycloalkyl group, a C₁-C₁₀ heterocycloalkyl group, a C₆-C₆₀ aryl group, a C₆-C₆₀ aryloxy group, a C₆-C₆₀ arylthio group, a C₁-C₆₀ heteroaryl group, and -Si(Q₁)(Q₂)(Q₃); and
a C₃-C₁₀ cycloalkyl group, a C₁-C₁₀ heterocycloalkyl group, a C₆-C₆₀ aryl group, a C₆-C₆₀ aryloxy group, a C₆-C₆₀ arylthio group, and a C₁-C₆₀ heteroaryl group, each substituted with at least one selected from deuterium,-F, -Cl, -Br, -I, a cyano group, a C₁-C₆₀ alkyl group, a C₆-C₆₀ aryl group, a C₁-C₆₀ heteroaryl group, and - Si(Q₃₁)(Q₃₂)(Q₃₃);
b81 is selected from 0, 1, 2, and 3; b82 is selected from 0, 1, 2, 3, and 4; a sum of b81 and b82 is 1 or more;
n21 is selected from 1, 2, and 3;
A₃₁ is a substituted or unsubstituted C₅-C₆₀ carbocyclic group or a substituted or unsubstituted C₁-C₆₀ heterocyclic group;
X₃₁ is selected from N and C(R₃₁), X₃₂ is selected from N and C(R₃₂), X₃₃ is selected from N and C(R₃₃), X₃₄ is selected from N and C(R₃₄);
Z₃₃ is selected from a single bond and C=Y₃₃; Z₃₄ is selected from a single bond and C=Y₃₄; Z₃₅ is selected from a single bond and C=Y₃₅; Z₃₆ is selected from a single bond and C=Y₃₆; at least one selected from Z₃₃ to Z₃₆ is not a single bond;
Y₃₁ to Y₃₉ are each independently selected from N(CN), C(CN)(R₉₁), C(R₉₁)(R₉₂), a group represented by Formula 9-1, and a group represented by Formula 9-2;
R₉₁ and R₉₂ are each independently selected from -F, -Cl, -Br, -I, a cyano group, a substituted or unsubstituted C₁-C₆₀ alkyl group, a substituted or unsubstituted C₆-C₆₀ aryl group, a substituted or unsubstituted C₁-C₆₀ heteroaryl group, and - C(=O)OR₉₇;
R₃₁ to R₃₈ and R₉₃ to R₉₇ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂),
wherein Q₁ to Q₃ and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group; and
* indicates a binding site to a neighboring atom.

At least some of the above and other features of the invention are set out in the claims.

### BRIEF DESCRIPTION OF THE DRAWINGS

These and/or other aspects will become apparent and more readily appreciated from the following description of the embodiments, taken in conjunction with the accompanying drawings in which:
FIG. 1 is a schematic cross-sectional view of an organic light-emitting device according to an embodiment;
FIG. 2 is a schematic cross-sectional view of an organic light-emitting device according to an embodiment;
FIG. 3 is a schematic cross-sectional view of an organic light-emitting device according to an embodiment; and
FIG. 4 is a schematic cross-sectional view of an organic light-emitting device according to an embodiment.

### DETAILED DESCRIPTION

The present embodiments may have different forms and should not be construed as being limited to the descriptions set forth herein. Accordingly, the embodiments are merely described below, by referring to the drawings, to explain aspects of the present description. Effect(s) and feature(s) of the present disclosure and methods of achieving them may be clarified by referring to embodiments explained in connection with the drawings. As used herein, the term "and/or" includes any and all combinations of one or more of the associated listed items. Expressions such as "at least one of", "one of", and "selected from", when preceding a list of elements, modify the entire list of elements and do not modify the individual elements of the list.

This invention may, however, be embodied in many different forms and should not be limited to the embodiments.

Hereinafter, reference will now be made in more detail to embodiments, examples of which are illustrated in the accompanying drawings, wherein like or corresponding reference numerals refer to like elements throughout and duplicative descriptions thereof may not be provided.

As used herein, the singular forms "a," "an" and "the" are intended to include the plural forms as well, unless the context clearly indicates otherwise.

In embodiments to be described hereinafter, the terms "have" or "include" indicate the presence of the stated features or elements, and do not exclude the presence of one or more other features or elements.

In embodiments to be described hereinafter, it will be understood that when films, regions, elements, etc. are referred to as being "on" another films, regions, elements, etc., it can be directly on the other films, regions, elements, etc., or intervening film(s), region(s), element(s), etc., may also be present.

Sizes of components in the drawings may be exaggerated for convenience of explanation. For example, sizes and thicknesses of components in the drawings are arbitrarily illustrated for convenience of explanation, and embodiments of the present disclosure are not limited thereto.

The expression "an (organic layer) includes a first compound" includes a case in which "an (organic layer) includes a first compound represented by Formula 1" and a case in which "an (organic layer) includes two or more different first compounds represented by Formula 1."

The term "an organic layer," as used herein refers to a single layer and/or a plurality of layers disposed between the first electrode and the second electrode of an organic light-emitting device. A material included in the "organic layer" is not limited to an organic material.

An organic light-emitting device according to an embodiment of the present disclosure includes a first electrode; a second electrode; and an organic layer between the first electrode and the second electrode.

The organic layer comprises: an emission layer; and a hole transport region between the emission layer and the first electrode, wherein the emission layer comprises the first compound represented by Formula 1. The hole transport region comprises the second compound represented by Formula 2 and the third compound represented by one selected from Formulae 3-1 to 3-3.

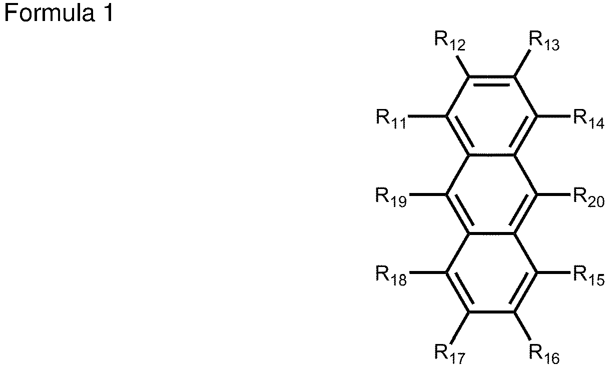

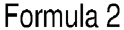

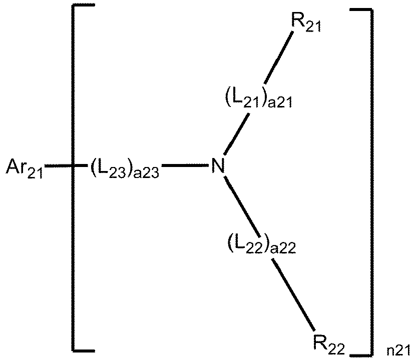

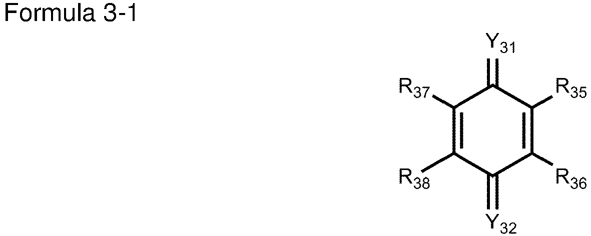

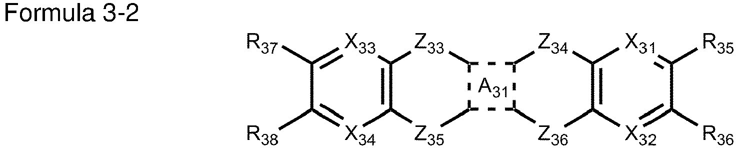

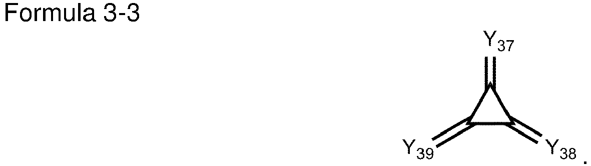

In Formula 1, R₁₁ to R₂₀ are each independently selected from a group represented by Formula 7, hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂), provided that at least one selected from R₁₁ to R₂₀ may be the group represented by Formula 7;
i) two neighboring groups selected from R₁₁ to R₂₀ are linked to form a ring, and R₇₁ is selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group; or
ii) R₇₁ is selected from a phenanthrenyl group, an anthracenyl group, a tetraphenyl group, a carbazolyl group and a group represented by one selected from Formulae 7A-1 to 7A-31, 7B-1 to 7B-3, 7C-1 to 7C-3, 7D-1 to 7D-3, 7E-1, and 7E-2;
a phenanthrenyl group, an anthracenyl group, a tetraphenyl group, a carbazolyl group, each substituted with at least one selected from deuterium, a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group; and
a phenanthrenyl group, an anthracenyl group, a tetraphenyl group, a carbazolyl group, each substituted with at least one substituent selected from a phenyl group and a naphthyl group, each of the at least one subsitutent is substituted with at least one selected from deuterium, a methyl group, an ethyl group, an n-propyl group, an iso-propyl group, an n-butyl group, a sec-butyl group, an iso-butyl group, a tert-butyl group, and a phenyl group:

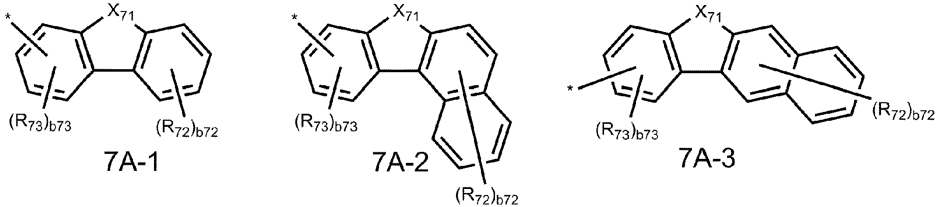

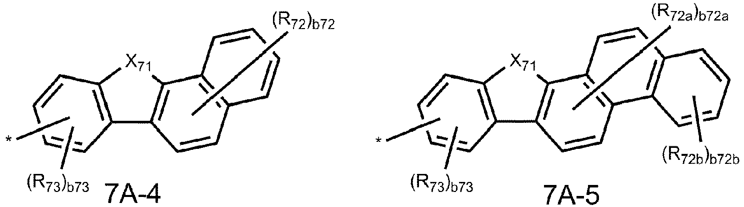

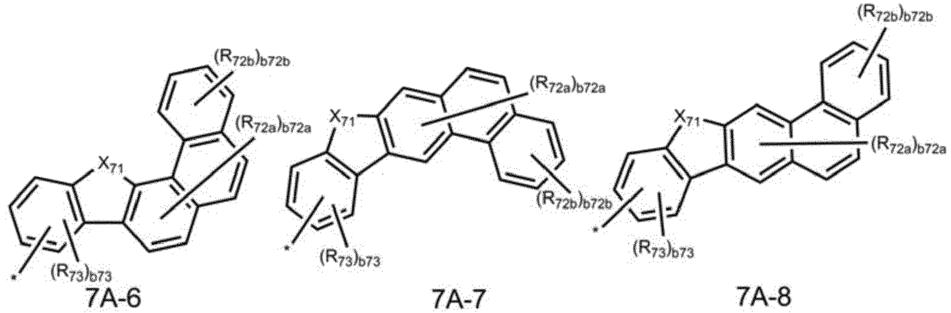

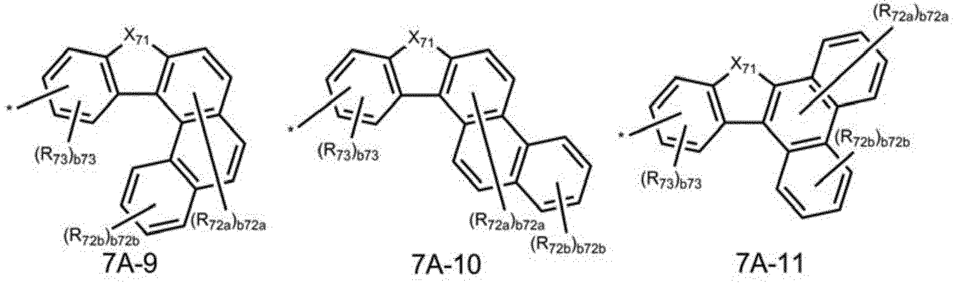

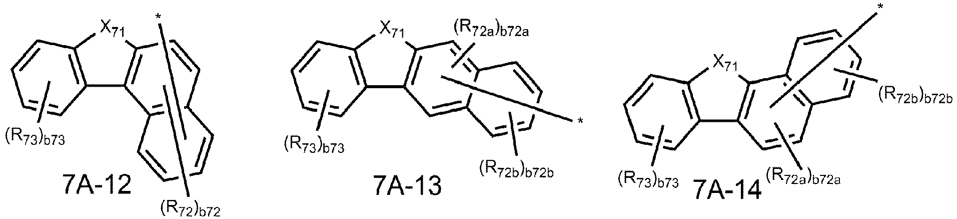

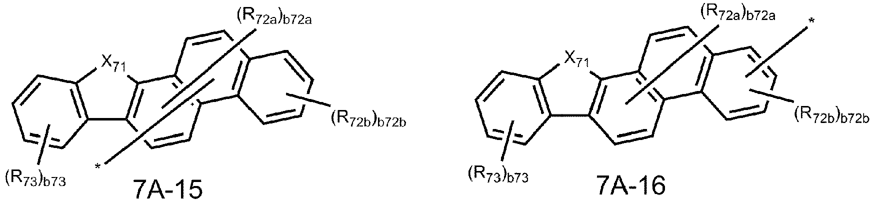

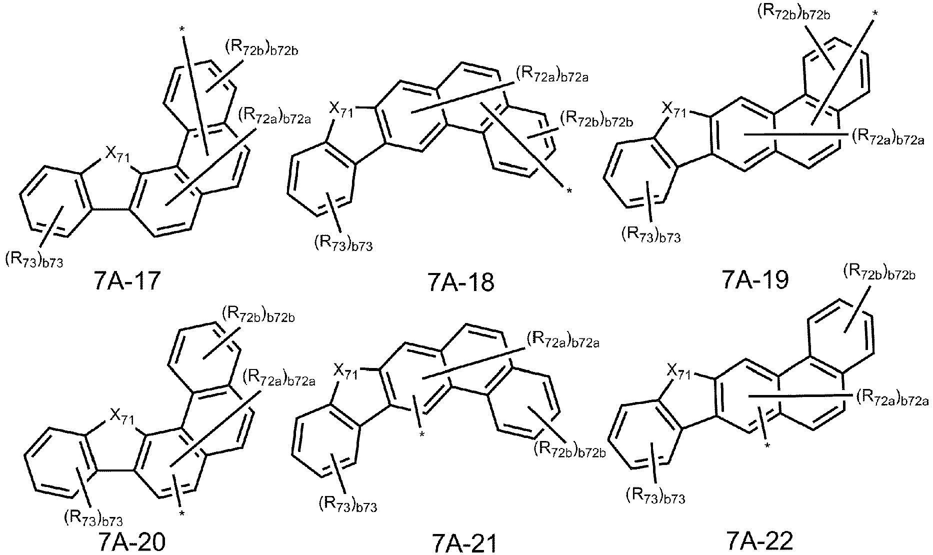

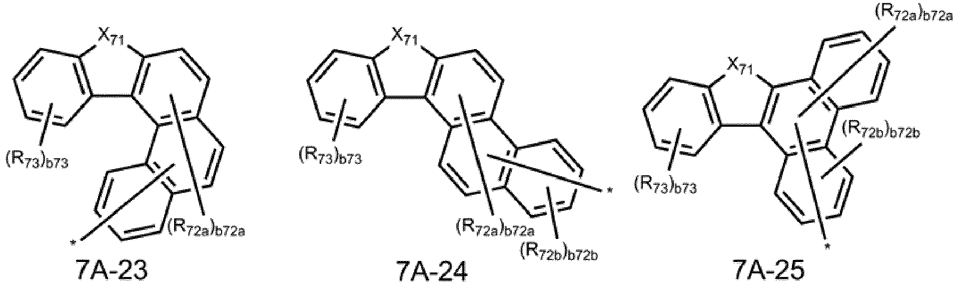

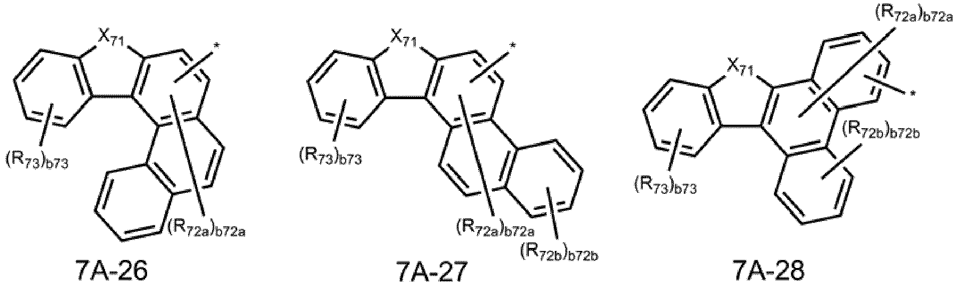

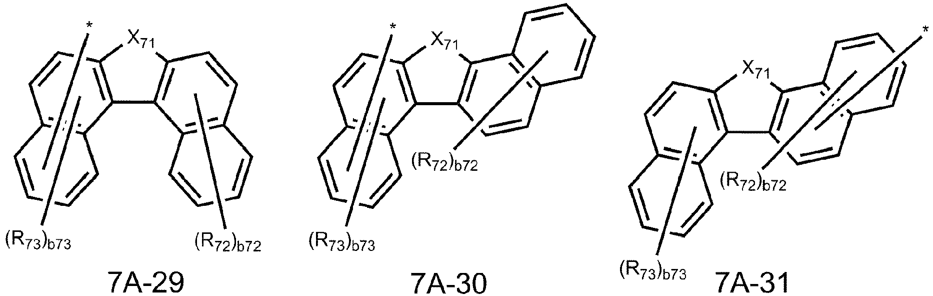

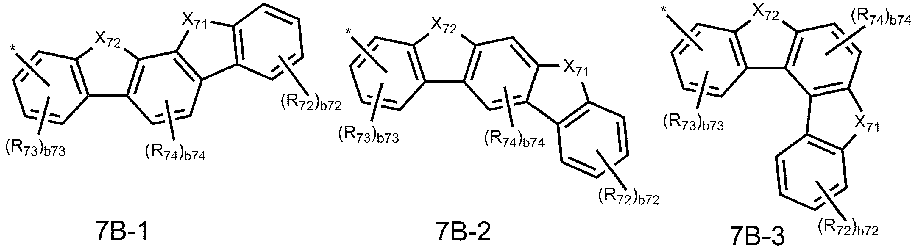

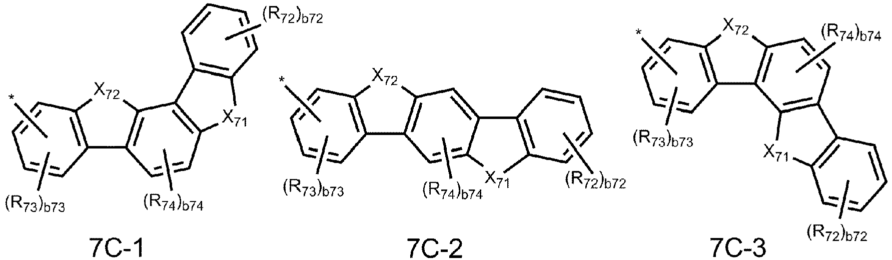

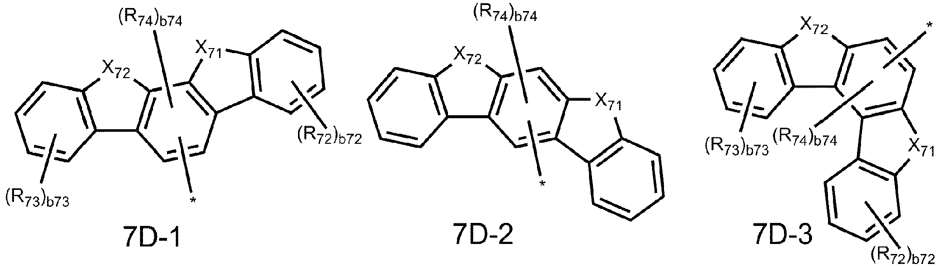

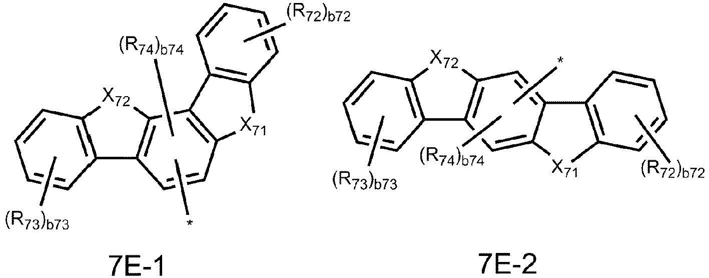

In Formulae 7A-1 to 7A-31, 7B-1 to 7B-3, 7C-1 to 7C-3, 7D-1 to 7D-3, 7E-1, and 7E-2,
X71 is selected from O, S, N(R₇₅), and C(R₇₅)(R₇₆);
X72 is selected from O, S, N(R₇₇), and C(R₇₇)(R₇₈);
R72 to R₇₈, R₇₂ₐ, and R_{72b} are each independently selected from the group consisting of:
hydrogen, deuterium, a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group; and
a phenyl group, a biphenyl group, and a naphthyl group, each substituted with at least one selected from deuterium, a methyl group, an ethyl group, an n-propyl group, an iso-propyl group, an n-butyl group, a sec-butyl group, an iso-butyl group, a tert-butyl group, and a phenyl group;
R₇₅ and R₇₆ are optionally linked to form a ring;
R₇₇ and R₇₈ are optionally linked to form a ring;
b72 to b74, b72a, and b72b are each independently selected from 1, 2, 3, 4, 5, 6, 7, and 8; and
* indicates a binding site to a neighboring atom.

Q₁ to Q₃ are each independently selected from hydrogen, deuterium, -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group:

Formula 7 *-(L₇₁)ₐ₇₁-R₇₁.

In Formula 7, L₇₁ and a71 are the same as described below; and
* indicates a binding site to a neighboring atom.

For example, R₂₀ in Formula 1 may be the group represented by Formula 7, but embodiments of the present disclosure are not limited thereto.

In one or more embodiments, R₁₉ and R₂₀ in Formula 1 may each be the group represented by Formula 7; and
R₁₉ and R₂₀ (e.g., the groups represented by Formula 7) may be identical to or different from each other, but embodiments of the present disclosure are not limited thereto.

In one or more embodiments, R₁₃ in Formula 1 may be the group represented by Formula 7, but embodiments of the present disclosure are not limited thereto.

In one or more embodiments, R₁₃ and R₁₇ in Formula 1 may each be the group represented by Formula 7; and

R₁₃ and R₁₇ (e.g., the groups represented by Formula 7) may be identical to or different from each other, but embodiments of the present disclosure are not limited thereto.

For example, R₁₁ to R₂₀ in Formula 1 may each independently be selected from the group consisting of:
the group represented by Formula 7, hydrogen, deuterium, -F, -Cl, -Br, -I, a cyano group, a C₁-C₆₀ alkyl group, a C₆-C₆₀ aryl group, a C₁-C₆₀ heteroaryl group, a monovalent non-aromatic condensed polycyclic group, a monovalent non-aromatic condensed heteropolycyclic group, and -Si(Q₁)(Q₂)(Q₃); and
a C₆-C₆₀ aryl group, a C₁-C₆₀ heteroaryl group, a monovalent non-aromatic condensed polycyclic group, and a monovalent non-aromatic condensed heteropolycyclic group, each substituted with at least one selected from a C₁-C₆₀ alkyl group, a C₆-C₆₀ aryl group, and a C₁-C₆₀ heteroaryl group;
wherein Q₁ to Q₃ may each independently be selected from a C₁-C₆₀ alkyl group, a C₆-C₆₀ aryl group, a biphenyl group, and a terphenyl group, but embodiments of the present disclosure are not limited thereto.

For example, R₁₁ to R₂₀ in Formula 1 may each independently be selected from the group consisting of:
the group represented by Formula 7, hydrogen, deuterium, -F, -Cl, -Br, -I, a cyano group, a C₁-C₁₀ (*e.g.* C₁-C₄) alkyl group, a C₆-C₃₀ aryl group, a C₁-C₂₀ heteroaryl group, and -Si(Q₁)(Q₂)(Q₃); and
a C₆-C₃₀ aryl group and a C₁-C₂₀ heteroaryl group, each substituted with at least one selected from a C₁-C₁₀ alkyl group, a C₆-C₃₀ aryl group, and a C₁-C₂₀ heteroaryl group;
wherein Q₁ to Q₃ may each independently be selected from a C₁-C₁₀ alkyl group, a C₆-C₃₀ aryl group, a biphenyl group, and a terphenyl group, but embodiments of the present disclosure are not limited thereto.

For example, R₁₁ to R₂₀ in Formula 1 may each independently be selected from the group consisting of:
the group represented by Formula 7, hydrogen, deuterium, -F, -CI, -Br, -I, a cyano group, a C₁-C₁₀ (e*.g.* C₁-C₄) alkyl group, a C₆-C₁₈ aryl group, a C₅-C₁₂ heteroaryl group, and -Si(Q₁)(Q₂)(Q₃); and
a C₆-C₁₈ aryl group and a C₅-C₁₂ heteroaryl group, each substituted with at least one selected from a C₁-C₁₀ alkyl group, a C₆-C₁₈ aryl group, and a C₅-C₁₂ heteroaryl group;
wherein Q₁ to Q₃ may each independently be selected from a C₁-C₁₀ alkyl group, a C₆-C₁₈ aryl group, a biphenyl group, and a terphenyl group, but embodiments of the present disclosure are not limited thereto.

In one or more embodiments, R₁₁ to R₂₀ in Formula 1 may each independently be selected from the group consisting of:
the group represented by Formula 7, hydrogen, deuterium, -F, -Cl, -Br, -I, a cyano group, a methyl group, an ethyl group, an n-propyl group, an iso-propyl group, an n-butyl group, a sec-butyl group, an iso-butyl group, a tert-butyl group, a phenyl group, a biphenyl group, a terphenyl group, a naphthyl group, a pyridinyl group, a fluorenyl group, a dibenzofuranyl group, a dibenzothiophenyl group, a carbazolyl group and -Si(Q₁)(Q₂)(Q₃); and
a fluorenyl group, a dibenzofuranyl group, a dibenzothiophenyl group, and a carbazolyl group, each substituted with at least one selected from a methyl group, an ethyl group, an n-propyl group, an iso-propyl group, an n-butyl group, a sec-butyl group, an iso-butyl group, a tert-butyl group, a phenyl group, a biphenyl group, a terphenyl group, a naphthyl group, and a pyridinyl group,
wherein Q₁ to Q₃ may each independently be selected from a methyl group, an ethyl group, an n-propyl group, an iso-propyl group, a phenyl group, a biphenyl group, and a terphenyl group, but embodiments of the present disclosure are not limited thereto.

L₇₁ in Formula 7 is selected from a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group.

For example, L₇₁ in Formula 7 may be selected from a substituted or unsubstituted C₆-C₂₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group.

For example, L₇₁ in Formula 7 may be selected from the group consisting of:
a phenylene group, a naphthylene group, a fluorenylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a benzofuranylene group, a benzothiophenylene group, a triazolylene group, a tetrazolylene group, a triazinylene group, a dibenzofuranylene group, and a dibenzothiophenylene group; and
a phenylene group, a naphthylene group, a fluorenylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a benzofuranylene group, a benzothiophenylene group, a triazolylene group, a tetrazolylene group, a triazinylene group, a dibenzofuranylene group, and a dibenzothiophenylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-fluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a carbazolyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, but embodiments of the present disclosure are not limited thereto.

In one or more embodiments, L₇₁ in Formula 7 may be selected from the group consisting of:
a phenylene group, a naphthylene group, a fluorenylene group, an anthracenylene group, a dibenzofuranylene group, and a dibenzothiophenylene group; and
a phenylene group, a naphthylene group, a fluorenylene group, an anthracenylene group, a dibenzofuranylene group, and a dibenzothiophenylene group, each substituted with at least one selected from deuterium, -F, -Cl, -Br, -I, a cyano group, a nitro group, a C₁-C₂₀ alkyl group, a phenyl group, and a naphthyl group, but embodiments of the present disclosure are not limited thereto.

In one or more embodiments, L₇₁ in Formula 7 may be represented by one selected from Formulae 4-1 to 4-25, but embodiments of the present disclosure are not limited thereto:

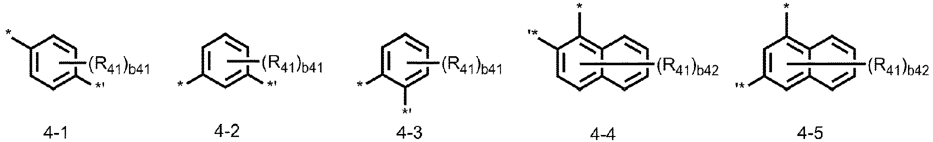

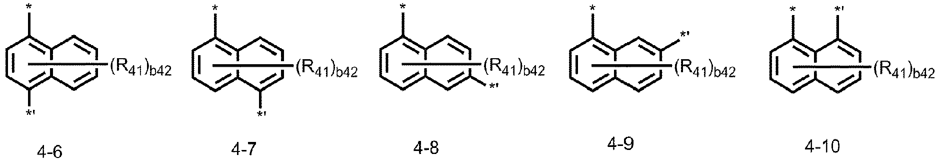

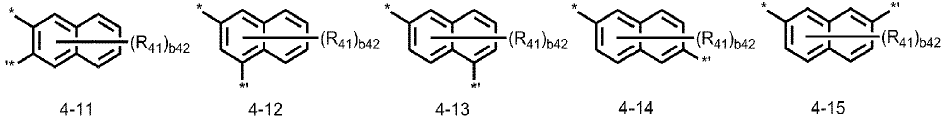

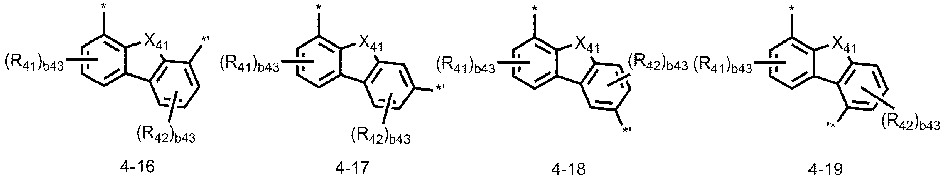

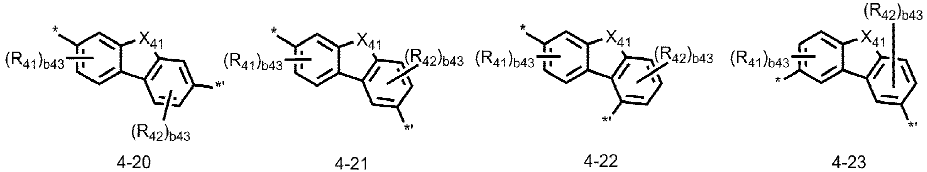

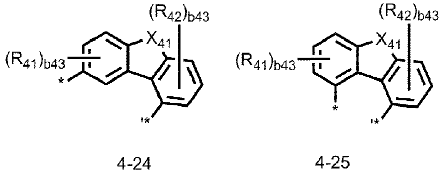

In Formulae 4-1 to 4-25,
X₄₁ is selected from O, S, and C(R₄₃)(R₄₄);
R₄₁ to R₄₄ are each independently selected from hydrogen, deuterium, -F, - Cl, -Br, -I, a cyano group, a nitro group, a methyl group, an ethyl group, an n-propyl group, an iso-propyl group, an n-butyl group, an iso-butyl group, a sec-butyl group, a tert-butyl group, a phenyl group, and a naphthyl group;
b41 is selected from 1, 2, 3, and 4;
b42 is selected from 1, 2, 3, 4, 5, and 6;
b43 is selected from 1, 2, and 3; and
* and *' each indicate a binding site to a neighboring atom.

In one or more embodiments, L₇₁ in Formula 7 may be a group represented by one selected from Formulae 5-1 to 5-41, but embodiments of the present disclosure are not limited thereto:

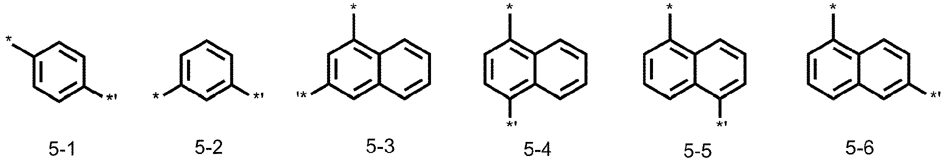

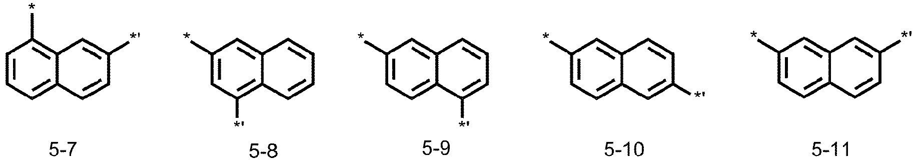

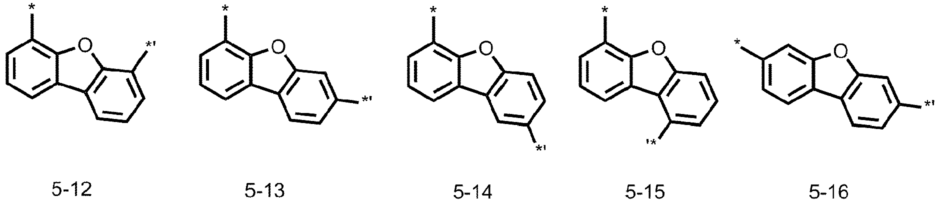

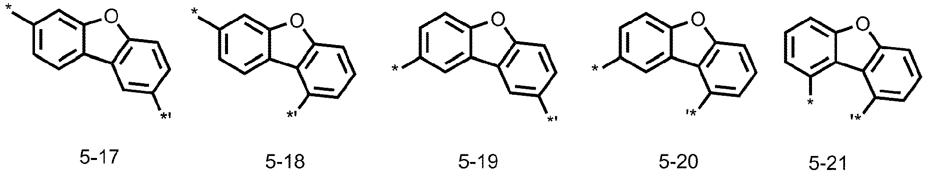

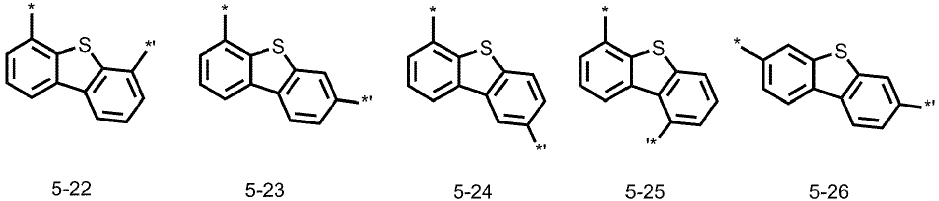

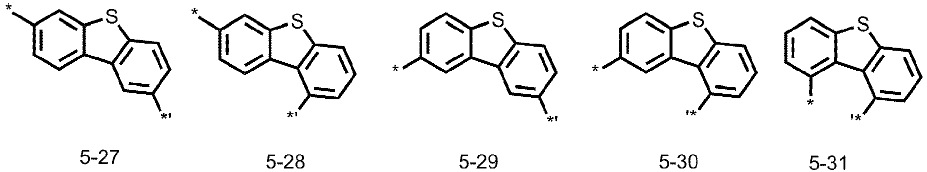

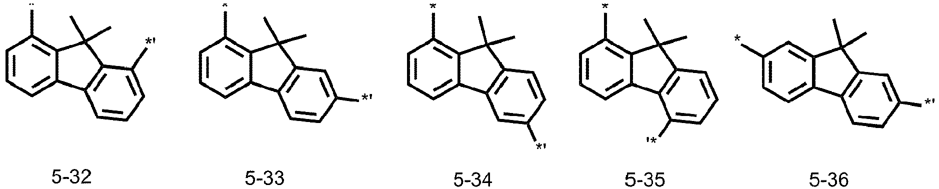

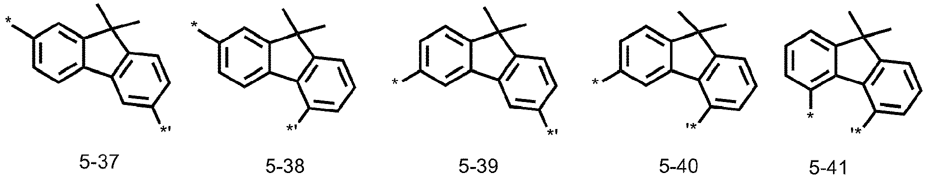

In Formulae 5-1 to 5-41,
* and *' each indicate a binding site to a neighboring atom.

In Formula 7, a71 indicates the number of L₇₁(s), and a71 is selected from 0, 1, 2, and 3. When a71 is 0, (L₇₁)ₐ₇₁ indicates a single bond. When a71 is two or more, a plurality of L₇₁(S) may be identical to or different from each other.

For example, a71 in Formula 7 may be selected from 0 and 1, but embodiments of the present disclosure are not limited thereto.

When the first compound has two neighboring groups selected from R₁₁ and R₂₀ as being linked to form a ring, than R₇₁ in Formula 7 is selected from a substituted or unsubstituted C₆-C₆₀ ary group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

For example, R₇₁ in Formula 7 may be selected from a substituted or unsubstituted C₆-C₃₀ aryl group, a substituted or unsubstituted C₁-C₂₀ heteroaryl group, a substituted or unsubstituted monovalent non-aromatic condensed polycyclic group, and a substituted or unsubstituted monovalent non-aromatic condensed heteropolycyclic group.

Alternatively, the first compound has R₇₁ in Formula 7 selected from the group consisting of

a phenanthrenyl group, an anthracenyl group, a tetraphenyl group, a carbazolyl group and a group represented by one selected from Formulae 7A-1 to 7A-31, 7B-1 to 7B-3, 7C-1 to 7C-3, 7D-1 to 7D-3, 7E-1, and 7E-2;

a phenanthrenyl group, an anthracenyl group, a tetraphenyl group, carbazolyl group, each substituted with at least one selected from deuterium, a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group; and

a phenanthrenyl group, an anthracenyl group, a tetraphenyl group, a carbazolyl group, each substituted with at least one substituent selected from a phenyl group and a naphthyl group, each of the at least one subsitutent is substituted with at least one selected from deuterium, a methyl group, an ethyl group, an n-propyl group, an iso-propyl group, an n-butyl group, a sec-butyl group, an iso-butyl group, a tert-butyl group, and a phenyl group:

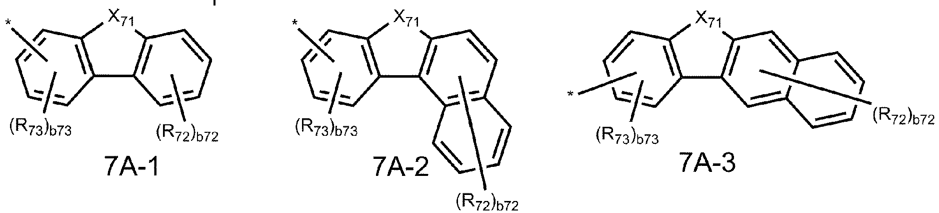

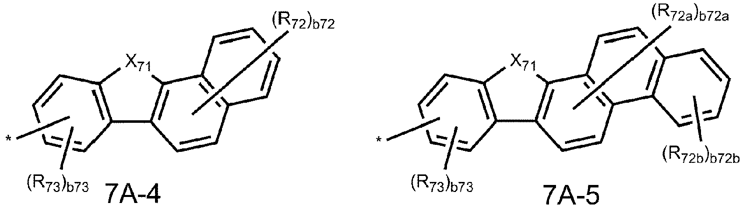

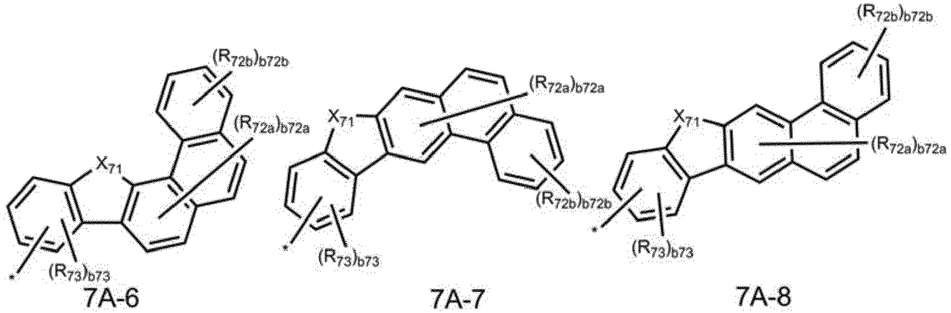

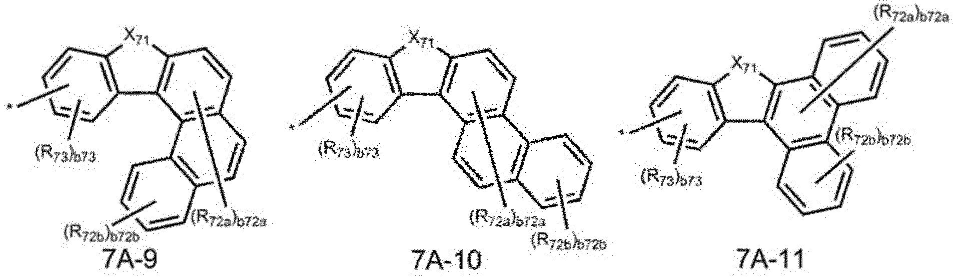

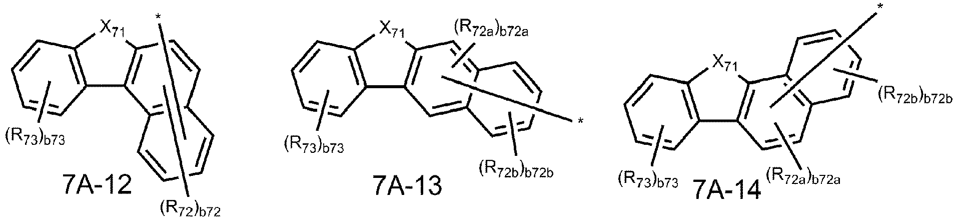

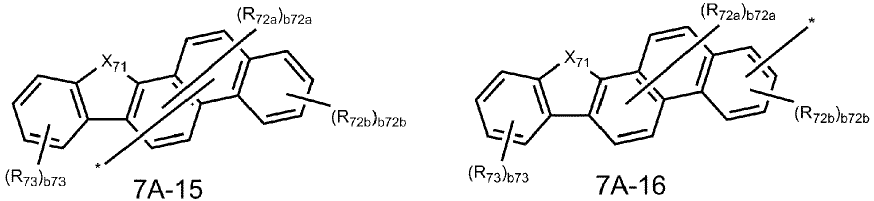

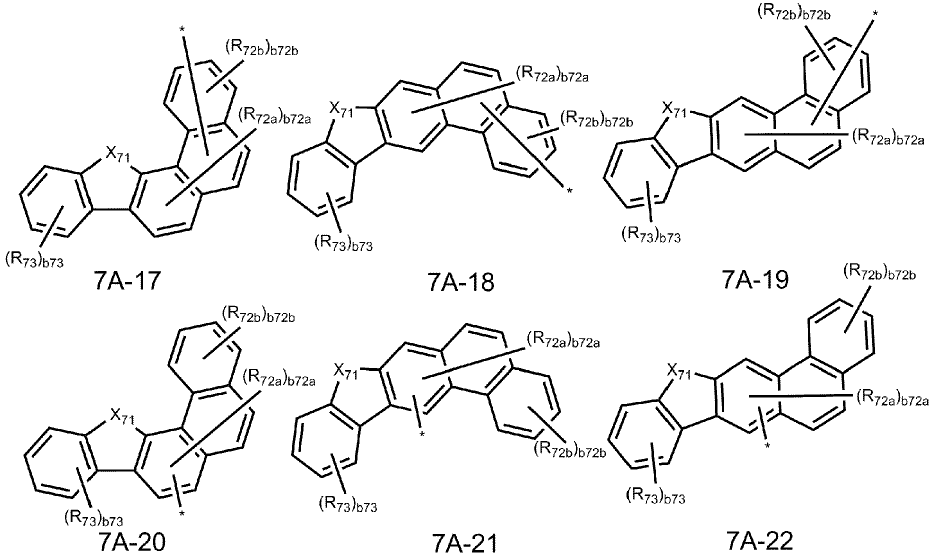

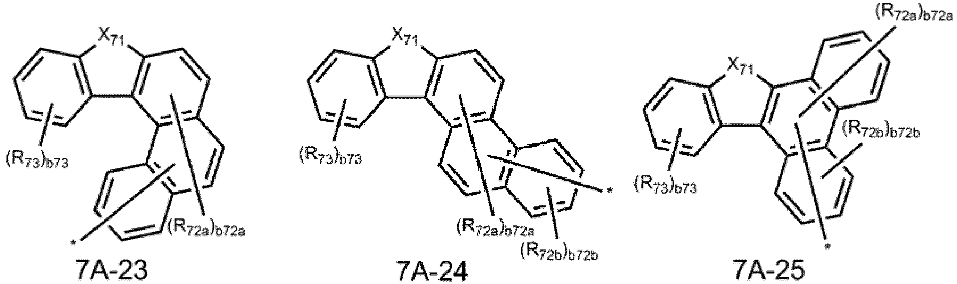

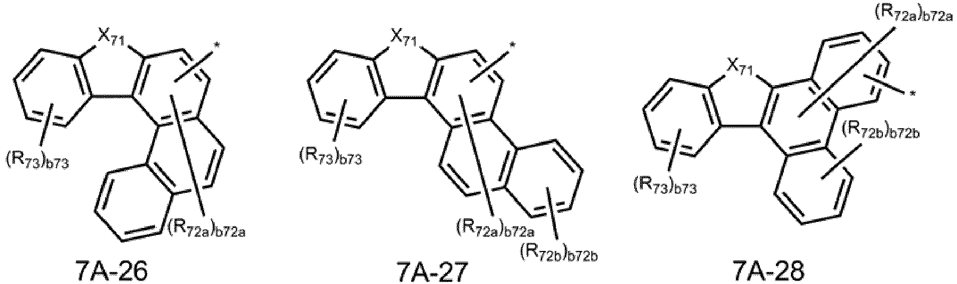

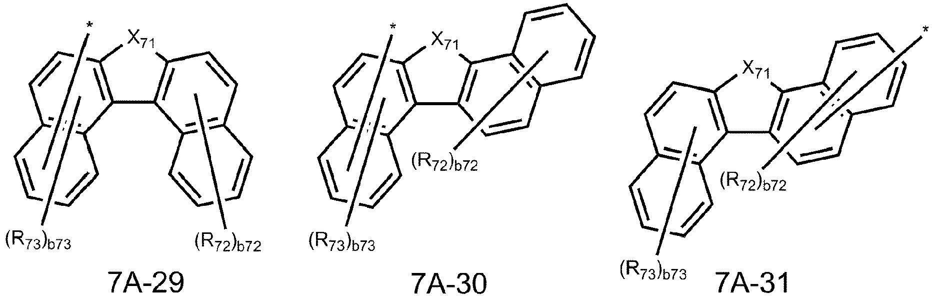

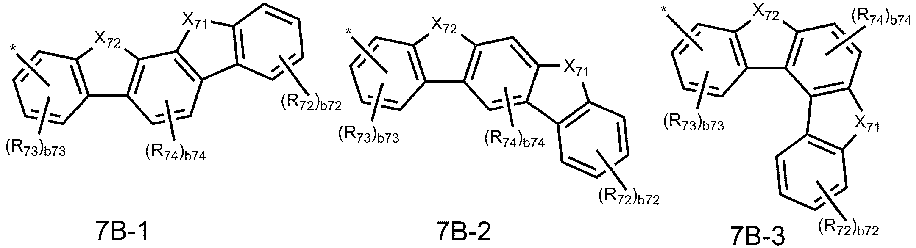

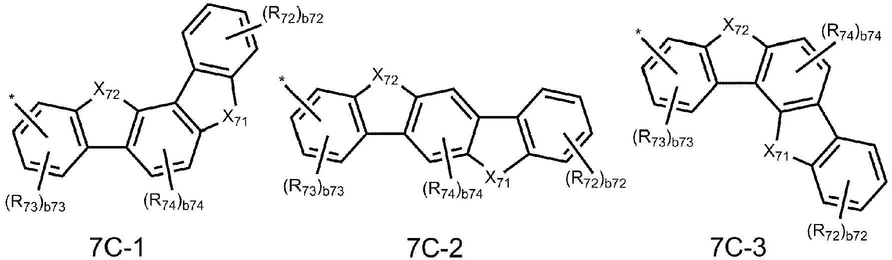

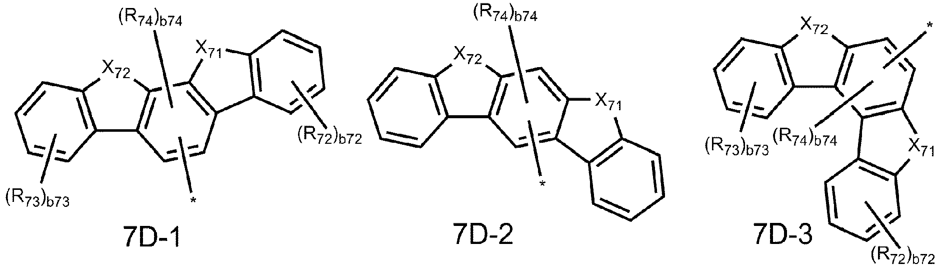

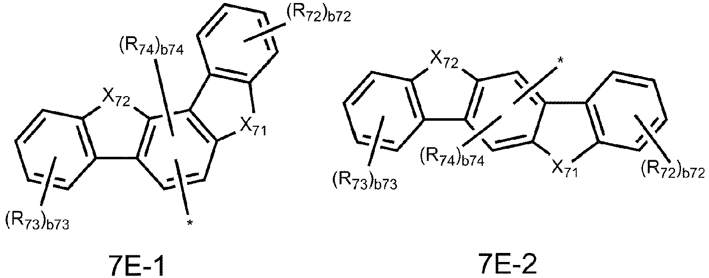

In Formulae 7A-1 to 7A-31, 7B-1 to 7B-3, 7C-1 to 7C-3, 7D-1 to 7D-3, 7E-1, and 7E-2,
X₇₁ is selected from O, S, N(R₇₅), and C(R₇₅)(R₇₆);
X₇₂ is selected from O, S, N(R₇₇), and C(R₇₇)(R₇₈);
R₇₂ to R₇₈, R₇₂ₐ, and R_{72b} are each independently selected from the group consisting of:
hydrogen, deuterium, a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group; and
a phenyl group, a biphenyl group, and a naphthyl group, each substituted with at least one selected from deuterium, a methyl group, an ethyl group, an n-propyl group, an iso-propyl group, an n-butyl group, a sec-butyl group, an iso-butyl group, a tert-butyl group, and a phenyl group;
R₇₅ and R₇₆ may optionally be linked to form a ring;
R₇₇ and R₇₈ may optionally be linked to form a ring;
b72 to b74, b72a, and b72b are each independently selected from 1, 2, 3, 4, 5, 6, 7, and 8; and
* indicates a binding site to a neighboring atom.

In one or more embodiments, R₇₁ in Formula 7 may be represented by one selected from Formulae 7-4 to 7-12, 7-17 to 7-186 and 7-194 to 7-202, but embodiments of the present disclosure are not limited thereto:

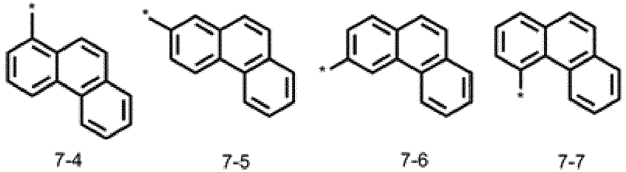

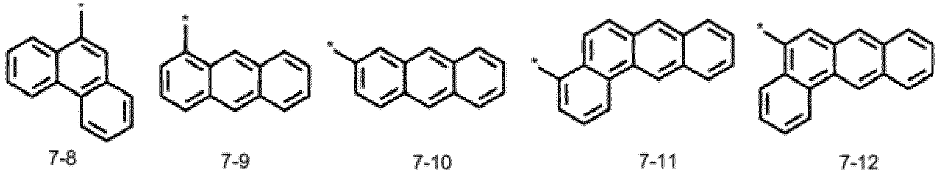

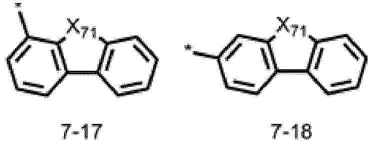

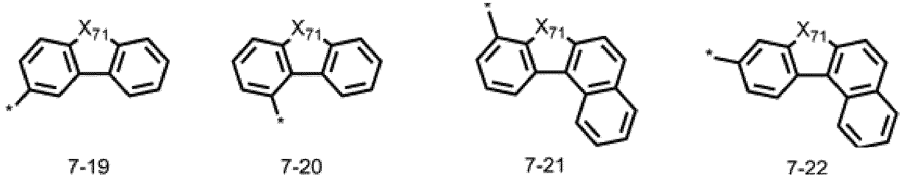

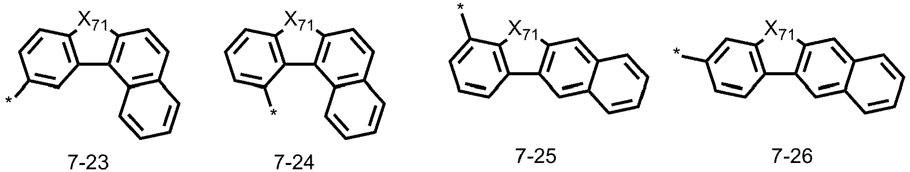

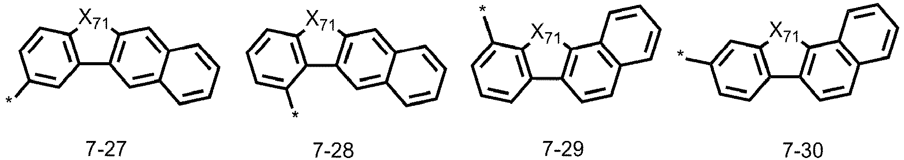

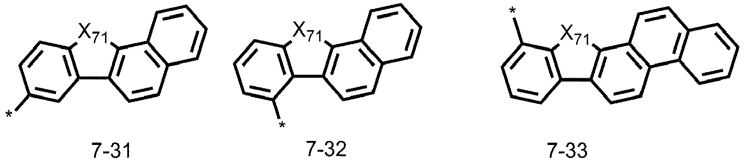

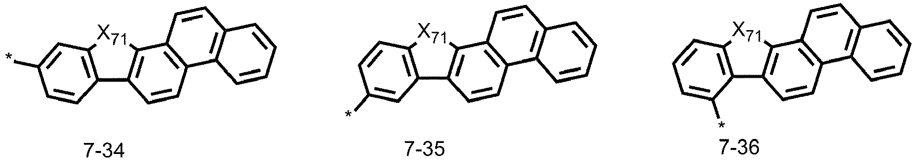

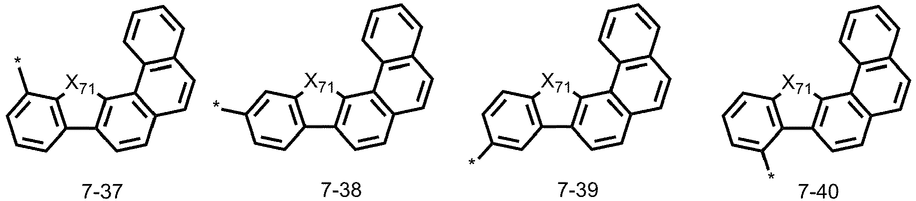

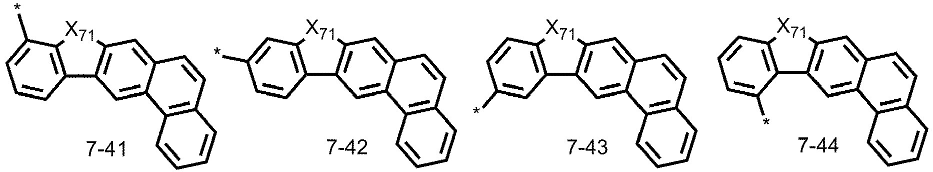

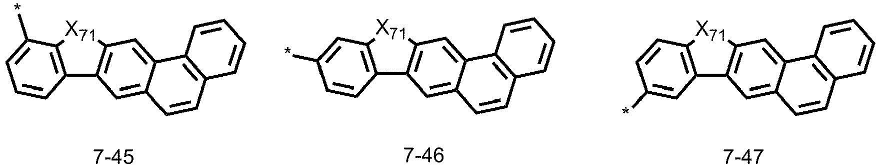

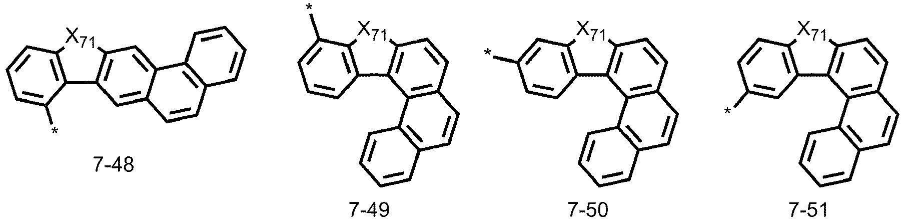

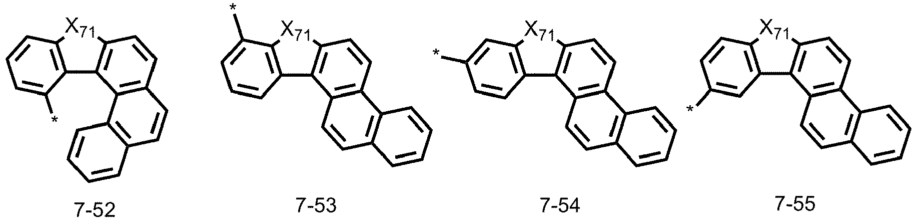

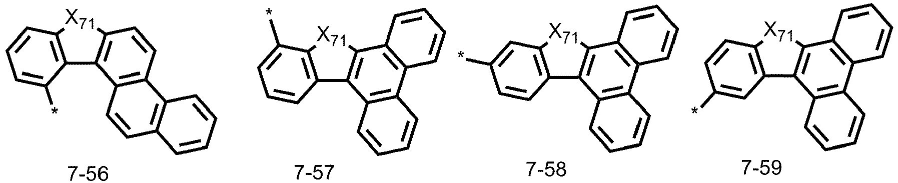

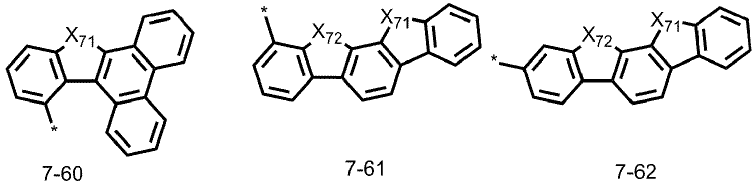

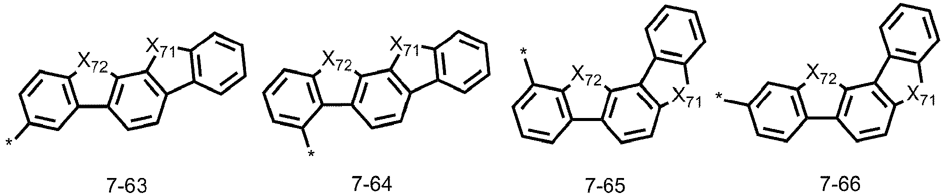

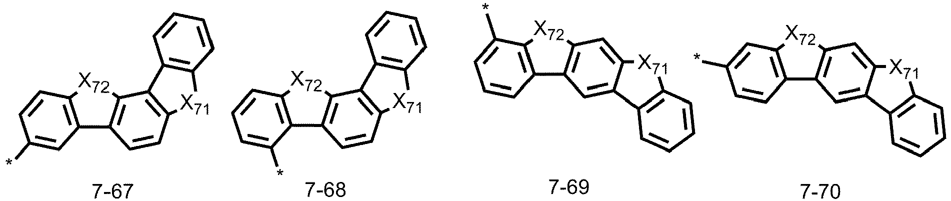

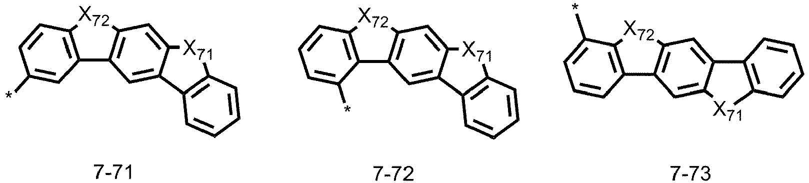

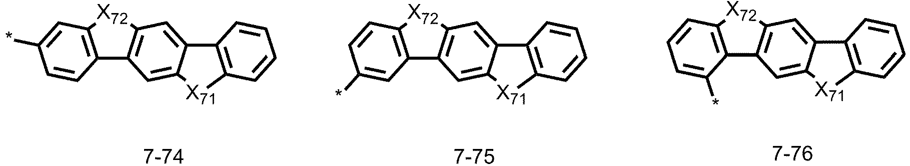

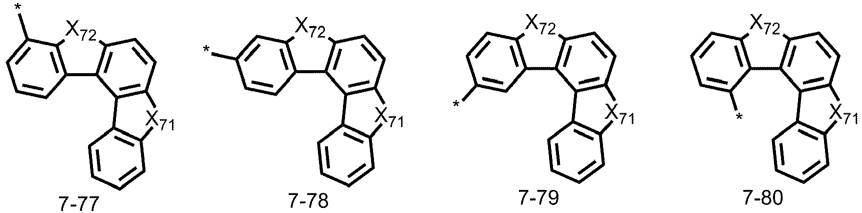

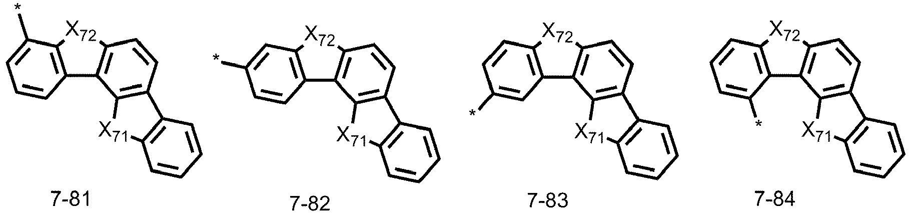

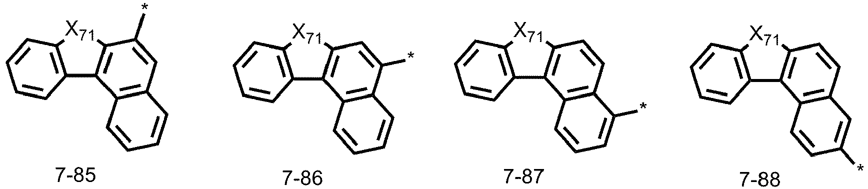

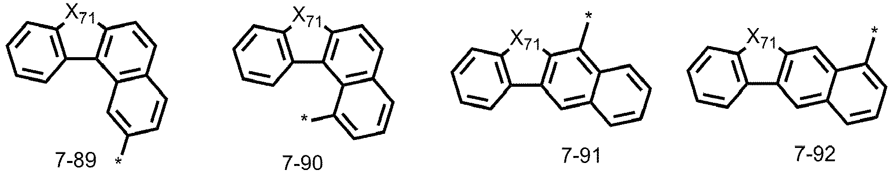

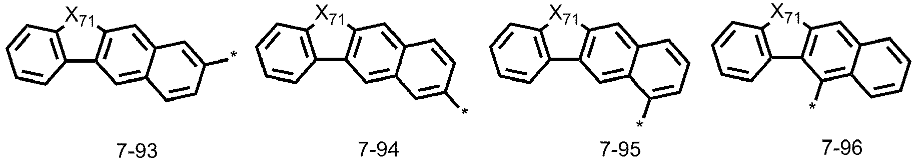

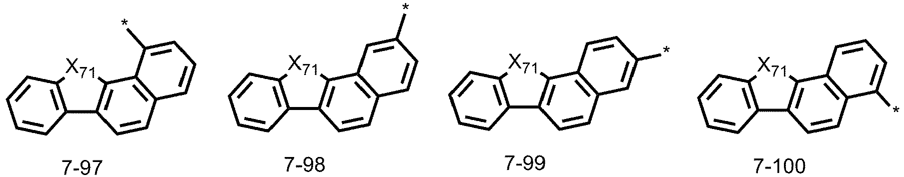

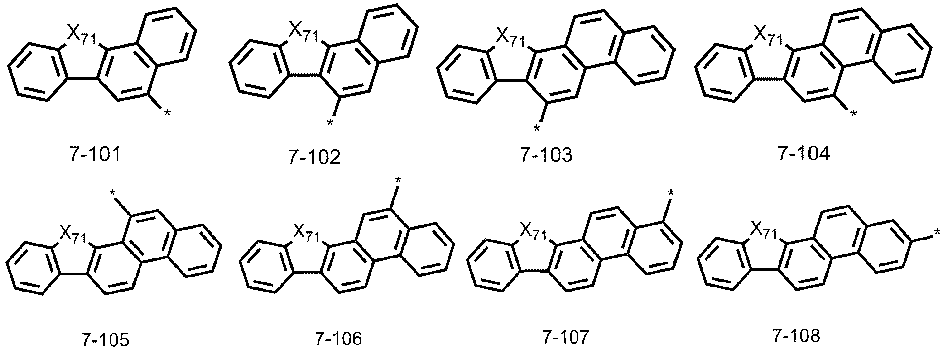

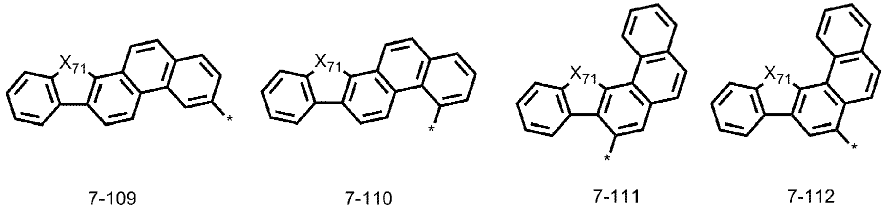

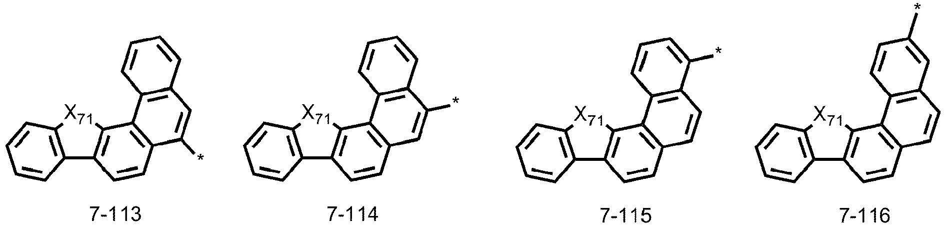

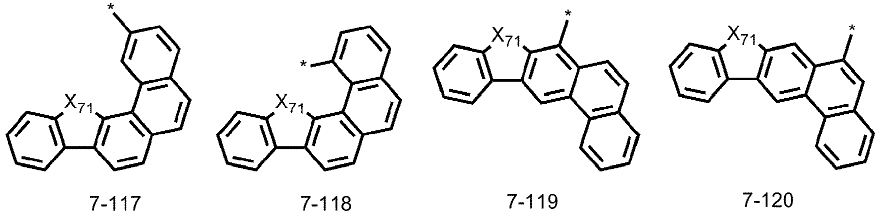

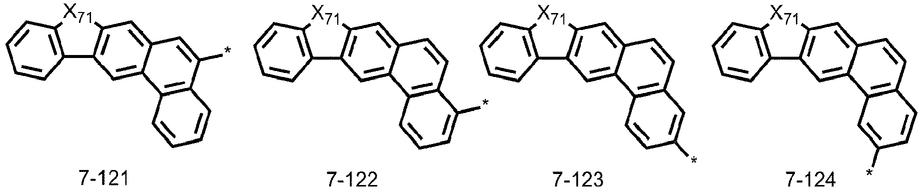

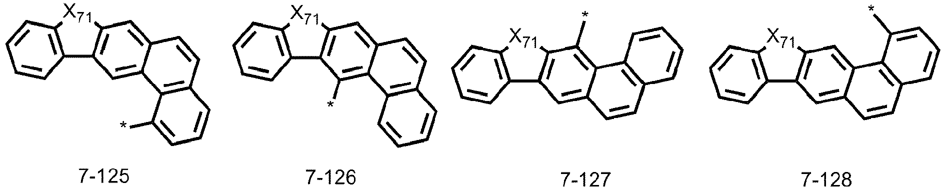

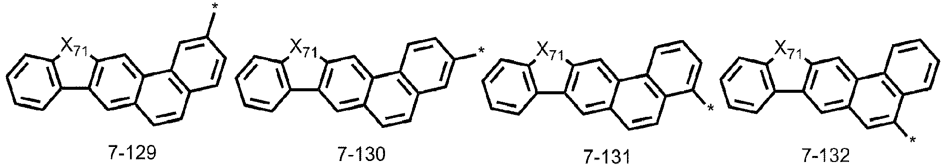

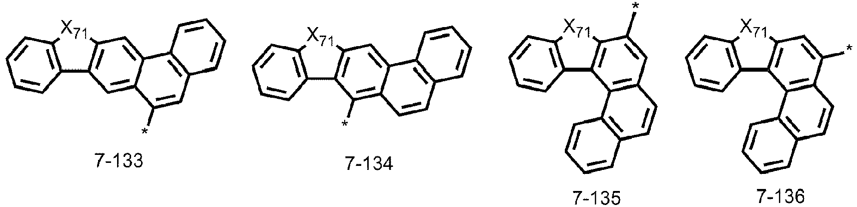

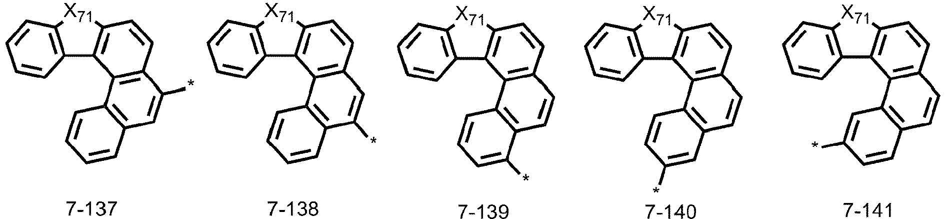

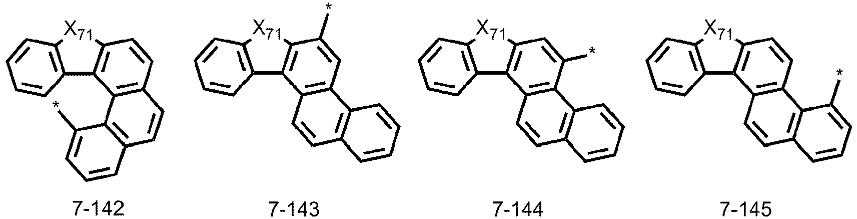

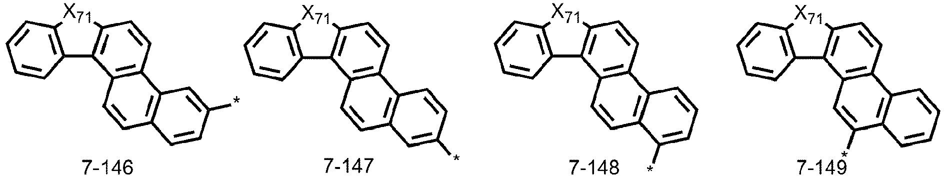

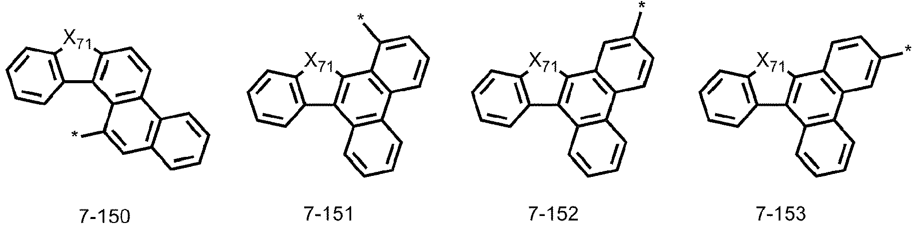

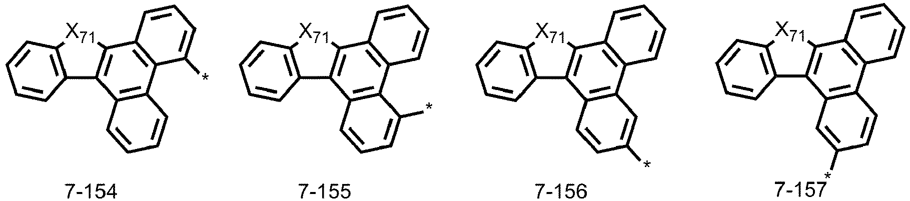

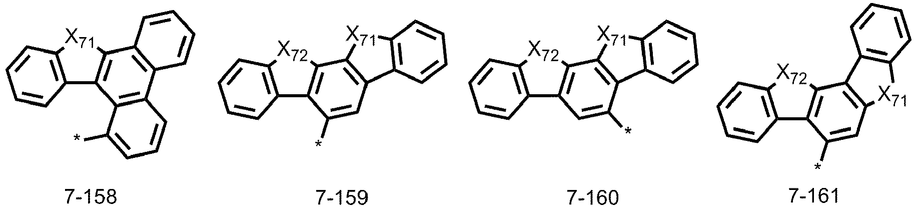

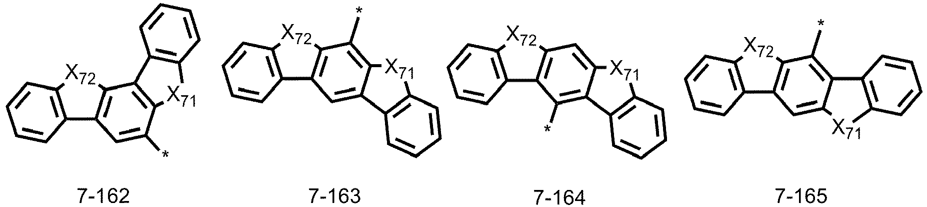

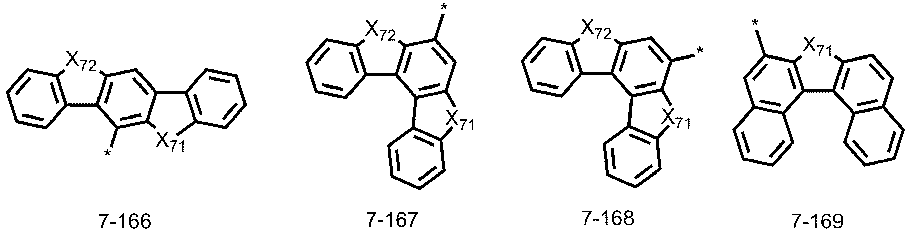

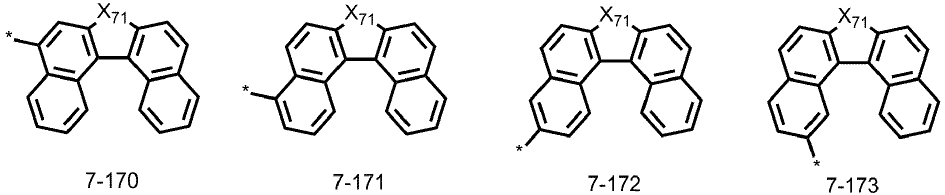

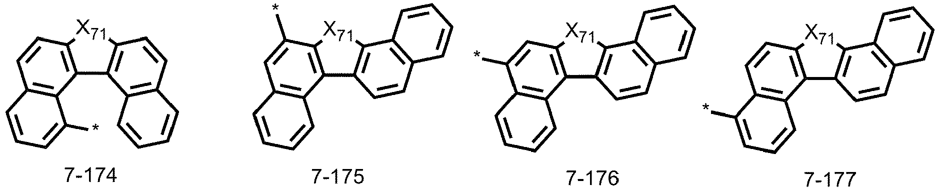

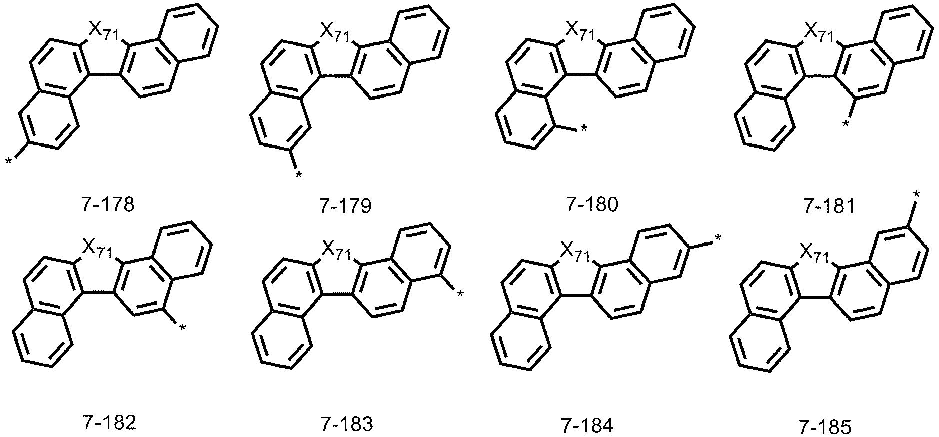

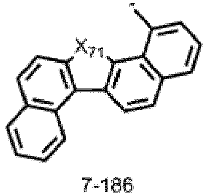

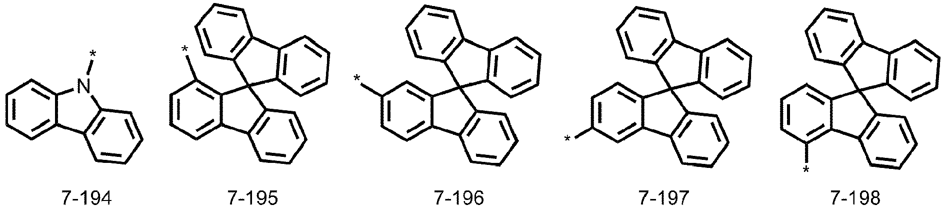

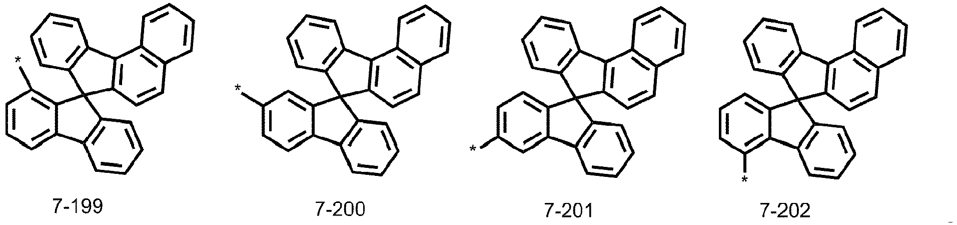

In Formulae 7-4 to 7-12, 7-17 to 7-186 and 7-194 to 7-202,
X₇₁ and X₇₂ are each independently selected from O, S, N(Ph), N(D₆-Ph), N(2-biPh), N(3-biPh), N(4-biPh), C(CH₃)₂, C(CH₃)(Ph), and C(Ph)₂; and
* indicates a binding site to a neighboring atom.

Ar₂₁ in Formula 2 is selected from a substituted or unsubstituted C₅-C₆₀ carbocyclic group and a substituted or unsubstituted C₁-C₆₀ heterocyclic group.

For example, Ar₂₁ in Formula 2 may be selected from a substituted or unsubstituted C₅-C₃₀ carbocyclic group and a substituted or unsubstituted C₁-C₂₀ heterocyclic group.

For example, Ar₂₁ in Formula 2 may be selected from the group consisting of:
a benzene group, a naphthalene group, a fluorene group, a spiro-bifluorene group, a phenanthrene group, an anthracene group, a triphenylene group, a pyridine group, a pyrazine group, a pyrimidine group, a pyridazine group, a quinoline group, an isoquinoline group, a carbazole group, a dibenzofuran group, and a dibenzothiophene group; and
a benzene group, a naphthalene group, a fluorene group, a spiro-bifluorene group, a phenanthrene group, an anthracene group, a triphenylene group, a pyridine group, a pyrazine group, a pyrimidine group, a pyridazine group, a quinoline group, an isoquinoline group, a carbazole group, a dibenzofuran group, and a dibenzothiophene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -N(O₃₁)(O₃₂),-B(Q₃₁)(Q₃₂), -C(=O)(Q₃₁), -S(=O)₂(Q₃₁), and -P(=O)(Q₃₁)(Q₃₂);
Q₃₁ to Q₃₃ may each independently be selected from the group consisting of:
   a C₁-C₁₀ alkyl group, a phenyl group, a biphenyl group, a terphenyl group, a naphthyl group, a fluorenyl group, a dibenzofuranyl group, a dibenzothiophenyl group, and a carbazolyl group; and
   a phenyl group, a biphenyl group, a terphenyl group, a naphthyl group, a fluorenyl group, a dibenzofuranyl group, a dibenzothiophenyl group, and a carbazolyl group, each substituted with at least one selected from a C₁-C₁₀ alkyl group, a phenyl group, and a naphthyl group, but embodiments of the present disclosure are not limited thereto.

In one or more embodiments, Ar₂₁ in Formula 2 may be selected from the group consisting of:
a benzene group, a naphthalene group, a fluorene group, a spiro-bifluorene group, a phenanthrene group, an anthracene group, a triphenylene group, a carbazole group, a dibenzofuran group, and a dibenzothiophene group; and
a benzene group, a naphthalene group, a fluorene group, a spiro-bifluorene group, a phenanthrene group, an anthracenegroup, a triphenylene group, a carbazole group, a dibenzofuran group, and a dibenzothiophene group, each substituted with at least one selected from a C₁-C₂₀ alkyl group, a phenyl group, a biphenyl group, a terphenyl group, a naphthyl group, and -N(Q₃₁)(Q₃₂),
wherein Q₃₁ and Q₃₂ may each independently be selected from the group consisting of:
a phenyl group, a biphenyl group, a terphenyl group, a naphthyl group, a fluorenyl group, a dibenzofuranyl group, a dibenzothiophenyl group, and a carbazolyl group; and
a phenyl group, a biphenyl group, a terphenyl group, a naphthyl group, a fluorenyl group, a dibenzofuranyl group, a dibenzothiophenyl group, and a carbazolyl group, each substituted with at least one selected from a methyl group, a phenyl group, and a naphthyl group, but embodiments of the present disclosure are not limited thereto.

L₂₁ to L₂₃ in Formula 2 are each independently selected from a substituted or unsubstituted C₆-C₆₀ arylene group and a substituted or unsubstituted C₁-C₆₀ heteroarylene group.

For example, L₂₁ to L₂₃ in Formula 2 may each independently be selected from a substituted or unsubstituted C₆-C₂₀ arylene group and a substituted or unsubstituted C₁-C₁₅ heteroarylene group.

For example, L₂₁ to L₂₃ in Formula 2 may each independently be selected from the group consisting of:
a phenylene group, a naphthylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a triazolylene group, a tetrazolylene group, and a triazinylene group; and
a phenylene group, a naphthylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a triazolylene group, a tetrazolylene group, and a triazinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-fluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a carbazolyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group, but embodiments of the present disclosure are not limited thereto.

In one or more embodiments, L₂₁ to L₂₃ in Formula 2 may each independently be selected from the group consisting of:
a phenylene group and a naphthylene group; and
a phenylene group and a naphthylene group, each substituted with at least one selected from deuterium, -F, -Cl, -Br, -I, a cyano group, a nitro group, a C₁-C₂₀ alkyl group, a phenyl group, and a naphthyl group, but embodiments of the present disclosure are not limited thereto.

In one or more embodiments, L₂₁ to L₂₃ in Formula 2 may each independently be represented by one selected from Formulae 4-1 to 4-15, but embodiments of the present disclosure are not limited thereto:

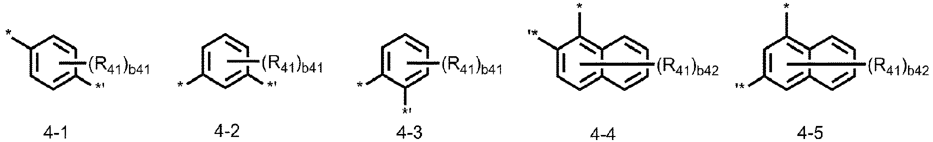

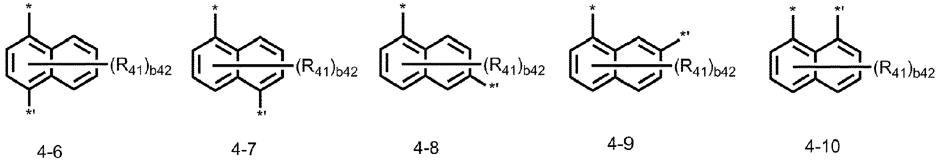

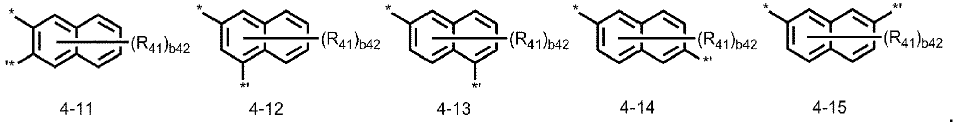

In Formulae 4-1 to 4-15,
R₄₁ is selected from hydrogen, deuterium, -F, -Cl, -Br, -I, a cyano group, a nitro group, a methyl group, an ethyl group, an n-propyl group, an iso-propyl group, an n-butyl group, an iso-butyl group, a sec-butyl group, a tert-butyl group, a phenyl group, and a naphthyl group;
b41 is selected from 1, 2, 3, and 4;
b42 is selected from 1, 2, 3, 4, 5, and 6; and
* and *' each indicate a binding site to a neighboring atom.

In one or more embodiments, L₂₁ to L₂₃ in Formula 2 may each independently be represented by one selected from Formulae 5-1 to 5-11 and 5-42 to 5-44, but embodiments of the present disclosure are not limited thereto:

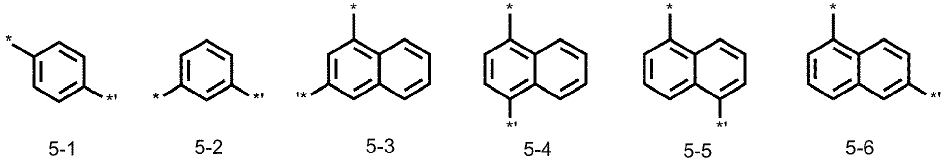

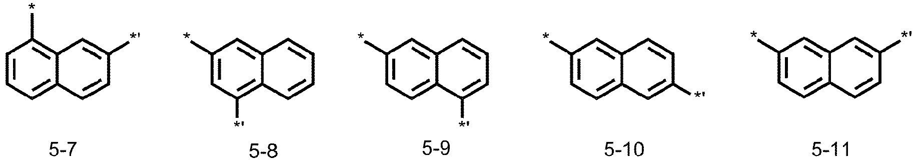

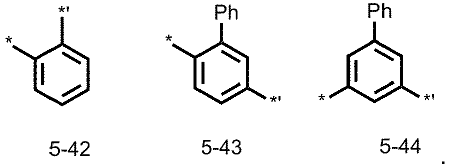

In Formula 5-1 to 5-11 and 5-42 to 5-44,
* and *' each indicate a binding site to a neighboring atom.

a21 in Formula 2 indicates the number of L₂₁(s), and a21 is selected from 0, 1, 2, and 3. When a21 is 0, (L₂₁)ₐ₂₁ indicates a single bond. When a21 is two or more, a plurality of L₂₁(s) may be identical to or different from each other.

a22 in Formula 2 indicates the number of L₂₂(s), and a22 is selected from 0, 1, 2, and 3. When a22 is 0, (L₂₂)ₐ₂₂ indicates a single bond. When a22 is two or more, a plurality of L₂₂(s) may be identical to or different from each other.

a23 in Formula 2 indicates the number of L₂₃(s), and a23 is selected from 0, 1, 2, and 3. When a23 is 0, (L₂₃)ₐ₂₃ indicates a single bond. When a23 is two or more, a plurality of L₂₃(s) may be identical to or different from each other.

For example, a21 to a23 in Formula 2 may each independently be selected from 0, 1, and 2, but embodiments of the present disclosure are not limited thereto.

R₂₁ and R₂₂ in Formula 2 are each independently selected from a group represented by Formula 8, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, provided that at least one selected from R₂₁ and R₂₂ may be the group represented by Formula 8:

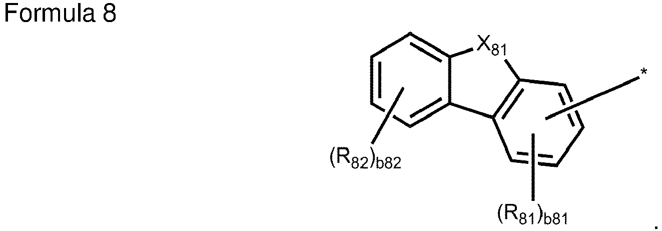

X₈₁, R₈₁, R₈₂, b81, and b82 in Formula 8 are the same as described below.

For example, R₂₁ and R₂₂ in Formula 2 may each independently be selected from a group represented by Formula 8, a substituted or unsubstituted C₆-C₃₀ aryl group, a substituted or unsubstituted C₁-C₂₀ heteroaryl group, a substituted or unsubstituted monovalent non-aromatic condensed polycyclic group, and a substituted or unsubstituted monovalent non-aromatic condensed heteropolycyclic group, provided that at least one selected from R₂₁ and R₂₂ may be the group represented by Formula 8.

For example, R₂₁ and R₂₂ in Formula 2 may each independently be selected from the group consisting of:
the group represented by Formula 8, a phenyl group, a biphenyl group, a terphenyl group, a naphthyl group, a fluorenyl group, a benzofluorenyl group, a dibenzofluorenyl group, a spiro-bifluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a carbazolyl group, a benzocarbazolyl group, a dibenzocarbazolyl group, a benzofuranyl group, a benzothiophenyl group, a dibenzofuranyl group, and a dibenzothiophenyl group; and
a phenyl group, a biphenyl group, a terphenyl group, a naphthyl group, a fluorenyl group, a benzofluorenyl group, a dibenzofluorenyl group, a spiro-bifluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a carbazolyl group, a benzocarbazolyl group, a dibenzocarbazolyl group, a benzofuranyl group, a benzothiophenyl group, a dibenzofuranyl group, and a dibenzothiophenyl group, each substituted with at least one selected from deuterium, - F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group, but embodiments of the present disclosure are not limited thereto.

In one or more embodiments, R₂₁ and R₂₂ in Formula 2 may each independently be selected from the group consisting of:
the group represented by Formula 8, a phenyl group, a biphenyl group, a terphenyl group, a naphthyl group, a fluorenyl group, a spiro-bifluorenyl group, a phenanthrenyl group, an anthracenyl group, a triphenylenyl group, a carbazolyl group, a dibenzofuranyl group, and a dibenzothiophenyl group; and
a phenyl group, a biphenyl group, a terphenyl group, a naphthyl group, a fluorenyl group, a spiro-bifluorenyl group, a phenanthrenyl group, an anthracenyl group, a triphenylenyl group, a carbazolyl group, a dibenzofuranyl group, and a dibenzothiophenyl group, each substituted with at least one selected from deuterium, a C₁-C₂₀ alkyl group, a phenyl group, a biphenyl group, a terphenyl group, and a naphthyl group, but embodiments of the present disclosure are not limited thereto.

In one or more embodiments, R₂₁ and R₂₂ in Formula 2 may each independently be selected from the group represented by Formula 8 and a group represented by one selected from Formulae 6-1 to 6-39, but embodiments of the present disclosure are not limited thereto:

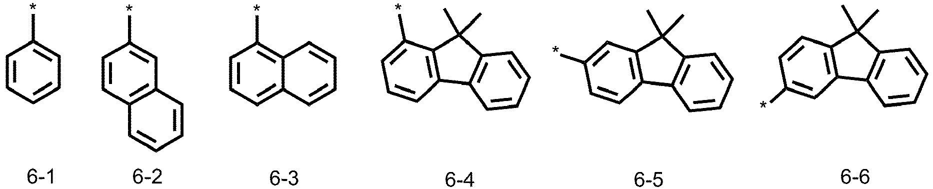

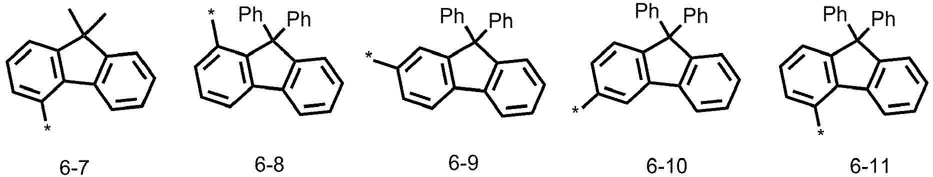

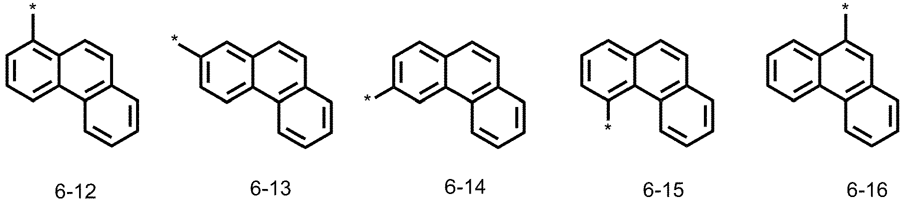

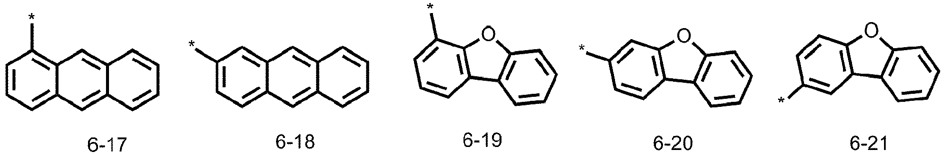

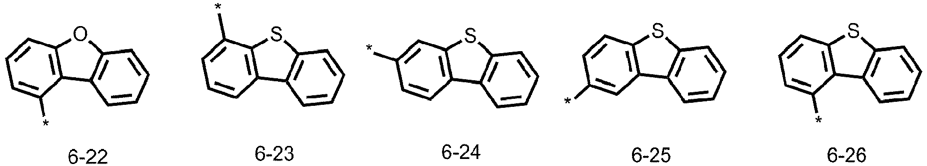

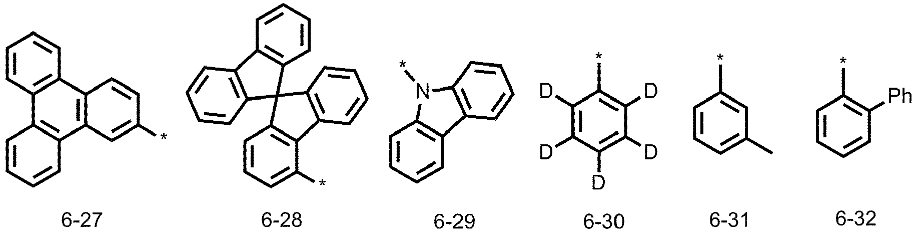

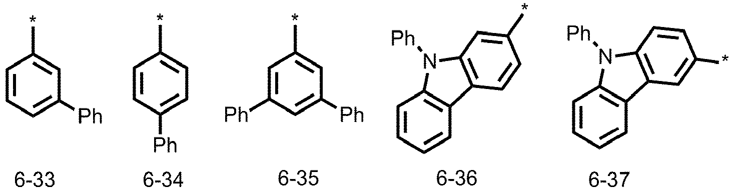

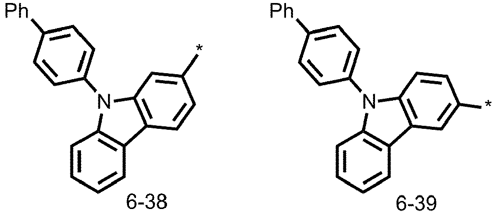

In Formulae 6-1 to 6-39,
* indicates a binding site to a neighboring atom.

X₈₁ in Formula 8 is selected from O and S.

R₈₁ and R₈₂ in Formula 8 are each independently selected from the group consisting of:
-F, -Cl, -Br, -I, a cyano group, a C₁-C₆₀ alkyl group, a C₃-C₁₀ cycloalkyl group, a C₁-C₁₀ heterocycloalkyl group, a C₆-C₆₀ aryl group, a C₆-C₆₀ aryloxy group, a C₆-C₆₀ arylthio group, a C₁-C₆₀ heteroaryl group, and -Si(Q₁)(Q₂)(Q₃); and
a C₃-C₁₀ cycloalkyl group, a C₁-C₁₀ heterocycloalkyl group, a C₆-C₆₀ aryl group, a C₆-C₆₀ aryloxy group, a C₆-C₆₀ arylthio group, and a C₁-C₆₀ heteroaryl group, each substituted with at least one selected from deuterium, -F, -Cl, -Br, -I, a cyano group, a C₁-C₆₀ alkyl group, a C₆-C₆₀ aryl group, a C₁-C₆₀ heteroaryl group, and - Si(Q₃₁)(Q₃₂)(Q₃₃),
wherein Q₁ to Q₃ and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

For example, R₈₁ and R₈₂ in Formula 8 may each independently be selected from the group consisting of:
-F, -Cl, -Br, -I, a cyano group, a C₁-C₁₀ alkyl group, a C₃-C₁₀ cycloalkyl group, a C₁-C₁₀ heterocycloalkyl group, a C₆-C₂₀ aryl group, a C₆-C₂₀ aryloxy group, a C₆-C₂₀ arylthio group, a C₁-C₂₀ heteroaryl group, and -Si(Q₁)(Q₂)(Q₃); and
a C₃-C₁₀ cycloalkyl group, a C₁-C₁₀ heterocycloalkyl group, a C₆-C₂₀ aryl group, a C₆-C₂₀ aryloxy group, a C₆-C₂₀ arylthio group, and a C₁-C₂₀ heteroaryl group, each substituted with at least one selected from deuterium, -F, -Cl, -Br, -I, a cyano group, a C₁-C₁₀ alkyl group, a C₆-C₂₀ aryl group, a C₁-C₂₀ heteroaryl group, and - Si(Q₃₁)(Q₃₂)(Q₃₃),
wherein Q₁ to Q₃ and Q₃₁ to Q₃₃ may each independently be selected from hydrogen, deuterium, -F, -CI, -Br, -I, a hydroxyl group, a cyano group, a nitro group, an amidino group, a hydrazino group, a hydrazono group, a C₁-C₁₀ alkyl group, a C₂-C₁₀ alkenyl group, a C₂-C₁₉ alkynyl group, a C₁-C₁₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₂₀ aryl group, a C₁-C₂₀ heteroaryl group, a monovalent non-aromatic condensed polycyclic group, a monovalent non-aromatic condensed heteropolycyclic group, a biphenyl group, and a terphenyl group.

For example, R₈₁ and R₈₂ in Formula 8 may each independently be selected from the group consisting of:
-F, -Cl, -Br, -I, a cyano group, a methyl group, an ethyl group, an n-propyl group, an iso-propyl group, an n-butyl group, an iso-butyl group, a sec-butyl group, a tert-butyl group, an n-pentyl group, a cyclopentyl group, a cyclohexyl group, a cycloheptyl group, a phenyl group, a biphenyl group, a terphenyl group, a naphthyl group, a phenanthrenyl group, a pyridinyl group, a pyrimidinyl group, a pyridazinyl group, a triazinyl group, a quinolinyl group, an isoquinolinyl group, and -Si(Q₁)(Q₂)(Q₃); and
a cyclopentyl group, a cyclohexyl group, a cycloheptyl group, a phenyl group, a biphenyl group, a terphenyl group, a naphthyl group, a phenanthrenyl group, a pyridinyl group, a pyrimidinyl group, a pyridazinyl group, a triazinyl group, a quinolinyl group, and an isoquinolinyl group, each substituted with at least one selected from deuterium, -F, -Cl, -Br, -I, a cyano group, a methyl group, an ethyl group, an n-propyl group, an iso-propyl group, an n-butyl group, an iso-butyl group, a sec-butyl group, a tert-butyl group, a phenyl group, a biphenyl group, a terphenyl group, a naphthyl group, and -Si(Q₃₁)(Q₃₂)(Q₃₃),
wherein Q₁ to Q₃ and Q₃₁ to Q₃₃ may each independently be selected from a methyl group, an ethyl group, an n-propyl group, an iso-propyl group, a phenyl group, a biphenyl group, and a terphenyl group, but embodiments of the present disclosure are not limited thereto.

In one or more embodiments, R₈₁ and R₈₂ in Formula 8 may each independently be selected from the group consisting of:
-F, -Cl, -Br, -I, a cyano group, a phenyl group, a biphenyl group, a terphenyl group, a naphthyl group, -Si(CH₃)₃, and -Si(Ph)₃; and
a phenyl group, a biphenyl group, a terphenyl group, a naphthyl group, and a phenanthrenyl group, each substituted with at least one selected from deuterium, -F,-Cl, -Br, -I, a cyano group, a methyl group, an ethyl group, an n-propyl group, an iso-propyl group, an n-butyl group, an iso-butyl group, a sec-butyl group, a tert-butyl group, a phenyl group, a naphthyl group, -Si(CH₃)₃, and -Si(Ph)₃, but embodiments of the present disclosure are not limited thereto.

b81 in Formula 8 indicates the number of R₈₁(s), and is selected from 0, 1, 2, and 3. When b81 is 0, a benzene moiety in Formula 8 is unsubstituted (e.g., not substituted) with R₈₁. When b81 is two or more, a plurality of R₈₁(s) may be identical to or different from each other.

b82 in Formula 8 indicates the number of R₈₂(s), and is selected from 0, 1, 2, 3, and 4. When b82 is 0, a benzene moiety in Formula 8 is unsubstituted (e.g., not substituted) with R₈₂. When b82 is two or more, a plurality of R₈₂(s) may be identical to or different from each other.

The sum of b81 and b82 in Formula 8 is 1 or more.

Since the sum of b81 and b82 in Formula 8 is 1 or more, the group represented by Formula 8 necessarily includes a dibenzofuran structure or a dibenzothiophene structure with an additional substituent. Due to the additional substituent, a steric structure of the second compound represented by Formula 2 may be adjusted, leading to a decrease in intermolecular aggregation and/or stacking. Accordingly, when a thin film is formed by utilizing the second compound represented by Formula 2, amorphous characteristics of the thin film may be improved and, thus, charge mobility may be improved.

For example, the sum of b81 and b82 in Formula 8 may be 1, but embodiments of the present disclosure are not limited thereto.

For example, the group represented by Formula 8 may be represented by one selected from Formulae 8-1 to 8-11, but embodiments of the present disclosure are not limited thereto:

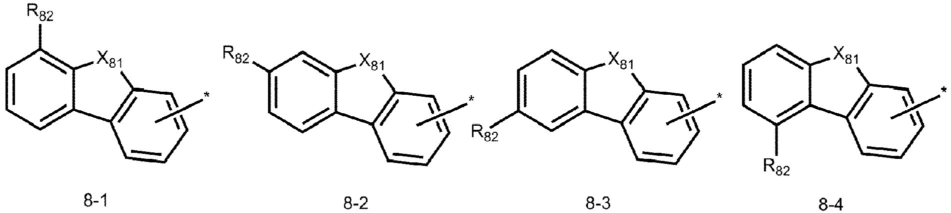

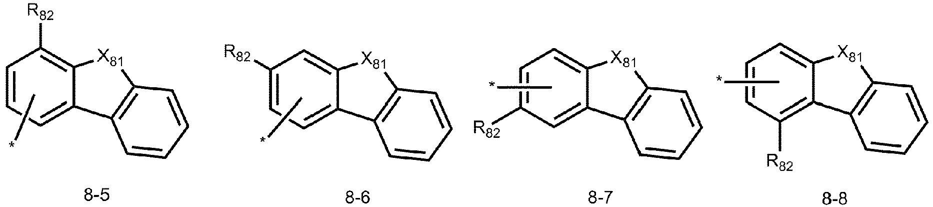

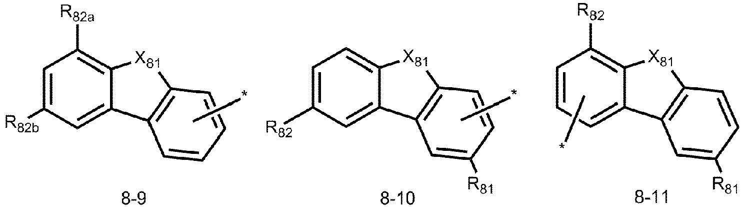

In Formulae 8-1 to 8-11,
X₈₁ is selected from O and S;
R₈₁, R₈₂, R₈₂ₐ, and R_{82b} are each independently selected from the group consisting of:
-F, -CI, -Br, -I, a cyano group, a phenyl group, a biphenyl group, a terphenyl group, a naphthyl group, -Si(CH₃)₃, and -Si(Ph)₃; and
a phenyl group, a biphenyl group, a terphenyl group, a naphthyl group, and a phenanthrenyl group, each substituted with at least one selected from deuterium, -F, - Cl, -Br, -I, a cyano group, a methyl group, an ethyl group, an n-propyl group, an iso-propyl group, an n-butyl group, an iso-butyl group, a sec-butyl group, a tert-butyl group, a phenyl group, a naphthyl group, -Si(CH₃)₃, and -Si(Ph)₃.

n21 in Formula 2 indicates the number of groups represented by *-(L₂₃)ₐ₂₃-N[(L₂₁)ₐ₂₁-R₂₁][(L₂₂)ₐ₂₂-R₂₂], and n21 is selected from 1, 2, and 3. When n21 is two or more, a plurality of groups represented by *-(L₂₃)ₐ₂₃-N[(L₂₁)ₐ₂₁-R₂₁][(L₂₂)ₐ₂₂-R₂₂] may be identical to or different from each other.

For example, n21 in Formula 2 may be 1, but embodiments of the present disclosure are not limited thereto.

The third compound represented by one selected from Formulae 3-1 to 3-3 may necessarily include at least one substituent selected from the group consisting of:
a cyano group, -F, -Cl, -Br, and -I; and
a C₁-C₂₀ alkyl group, substituted with at least one selected from -F, -Cl, -Br, and -I.

The third compound represented by one selected from Formulae 3-1 to 3-3 may include a plurality of electron withdrawing groups, and the third compound represented by one selected from Formulae 3-1 to 3-3 may have an energy level of a lowest unoccupied molecular orbital (LUMO) of -4.0 eV or less. Accordingly, due to the inclusion of the third compound represented by one selected from Formulae 3-1 to 3-3 in a hole transport region, the manufactured organic light-emitting device may have high hole mobility. Also, since the third compound represented by one selected from Formulae 3-1 to 3-3 has relatively high polarity, the third compound may relatively diffuse less in an organic layer in the organic light-emitting device. Accordingly, the organic light-emitting device including the third compound may have improved stability.

A₃₁ in Formula 3-2 is a substituted or unsubstituted C₅-C₆₀ carbocyclic group or a substituted or unsubstituted C₁-C₆₀ heterocyclic group.

For example, A₃₁ in Formula 3-2 may be a substituted or unsubstituted C₅-C₂₀ carbocyclic group or a substituted or unsubstituted C₁-C₂₀ heterocyclic group.

For example, A₃₁ in Formula 3-2 may be a substituted or unsubstituted C₅-C₁₀ carbocyclic group or a substituted or unsubstituted C₁-C₁₀ heterocyclic group.

For example, A₃₁ in Formula 3-2 may be a substituted or unsubstituted C₆-C₁₀ carbocyclic group or a substituted or unsubstituted C₄-C₉ heterocyclic group.

For example, A₃₁ in Formula 3-2 may be selected from the group consisting of:
a benzene group, a naphthalene group, a pyridine group, a pyrazine group, a pyrimidine group, a pyridazine group, a quinoline group, and an isoquinoline group; and
a benzene group, a naphthalene group, a pyridine group, a pyrazine group, a pyrimidine group, a pyridazine group, a quinoline group, and an isoquinoline group, each substituted with at least one selected from deuterium, -F, -Cl, -Br, -I, a cyano group, a C₁-C₂₀ alkyl group, a phenyl group, a biphenyl group, a terphenyl group, and a naphthyl group, but embodiments of the present disclosure are not limited thereto.

In one or more embodiments, A₃₁ in Formula 3-2 may be selected from a benzene group, a pyridine group, a pyrimidine group, and a pyridazine group, but embodiments of the present disclosure are not limited thereto.

In one or more embodiments, A₃₁ in Formula 3-2 may be a pyridazine group, but embodiments of the present disclosure are not limited thereto. X₃₁ in Formula 3-2 may be selected from N and C(R₃₁), X₃₂ may be selected from N and C(R₃₂), X₃₃ may be selected from N and C(R₃₃), X₃₄ may be selected from N and C(R₃₄), and R₃₁ to R₃₄ may be the same as described below.

For example, X₃₁ in Formula 3-2 may be C(R₃₁), X32 may be C(R₃₂), X₃₃ may be C(R₃₃), and X₃₄ may be C(R₃₄), but embodiments of the present disclosure are not limited thereto.

Z₃₃ in Formula 3-2 is selected from a single bond and C=Y₃₃; Z₃₄ may be selected from a single bond and C=Y₃₄; Z₃₅ may be selected from a single bond and C=Y₃₅; Z₃₆ may be selected from a single bond and C=Y₃₆; and at least one selected from Z₃₃ to Z₃₆ may not be a single bond.

For example, Z₃₃ in Formula 3-2 may be a single bond, Z₃₄ may be C=Y₃₄; Z₃₅ may be C=Y₃₅; and Z₃₆ may be a single bond, but embodiments of the present disclosure are not limited thereto.

In one or more embodiments, Z₃₃ may be a single bond; Z₃₄ may be C=Y₃₄; Z35 may be C=Y₃₅; and Z₃₆ may be C=Y₃₆, but embodiments of the present disclosure are not limited thereto.

In an embodiment, Formula 3-2 may be represented by one selected from Formulae 3-2a or 3-2b:

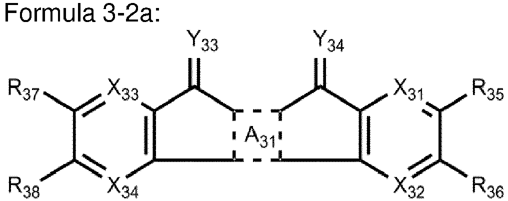

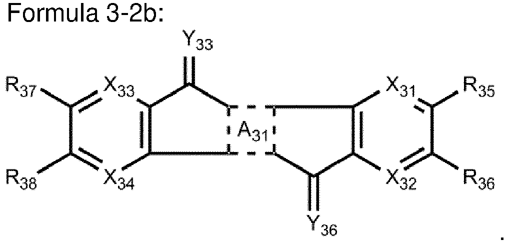

In Formulae 3-2a and 3-2b, A₃₁, R₃₅ to R₃₈, X₃₁ to X₃₄, Y₃₃, Y₃₄ and Y₃₆ are defined as described herein.

Y₃₁ to Y₃₉ in Formulae 3-1 to 3-3 are each independentlyselected from N(CN), C(CN)(R₉₁), C(R₉₁)(R₉₂), a group represented by Formula 9-1, and a group represented by Formula 9-2, wherein R₉₁ and R₉₂ are the same as described below:

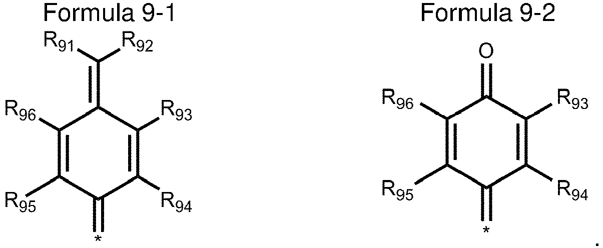

In Formulae 9-1 and 9-2,
R₉₁ to R₉₆ are the same as described below; and
* indicates a binding site to a neighboring atom.

R₉₁ and R₉₂ in C(CN)(R₉₁), C(R₉₁)(R₉₂) and in Formula 9-1 are each independently selected from -F, -Cl, -Br, -I, a cyano group, a substituted or unsubstituted C₁-C₆₀ alkyl group, a substituted or unsubstituted C₆-C₆₀ aryl group, a substituted or unsubstituted C₁-C₆₀ heteroaryl group, and -C(=O)OR₉₇; and R₉₇ is the same as described below.

For example, R₉₁ and R₉₂ in C(CN)(R₉₁), C(R₉₁)(R₉₂) and in Formula 9-1 may each independently be selected from the group consisting of:
-F, -Cl, -Br, -I, a cyano group, a C₁-C₆₀ alkyl group, a C₆-C₆₀ aryl group, a C₁-C₆₀ heteroaryl group; and
a C₁-C₆₀ alkyl group, a C₆-C₆₀ aryl group, and a C₁-C₆₀ heteroaryl group, each substituted with at least one selected from -F, a cyano group, and a C₁-C₆₀ alkyl group substituted with -F, but embodiments of the present disclosure are not limited thereto. R₃₁ to R₃₈ and R₉₃ to R₉₇ in Formulae 3-1 to 3-3, 9-1 and 9-2 may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂),
wherein Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

For example, R₃₁ to R₃₈ and R₉₃ to R₉₇ in Formulae 3-1 to 3-3, 9-1 and 9-2 may each independently be selected from the group consisting of:
hydrogen, -F, -Cl, -Br, -I, a cyano group, a C₁-C₆₀ alkyl group, a C₆-C₆₀ aryl group, and a C₁-C₆₀ heteroaryl group; and
a C₁-C₆₀ alkyl group, a C₆-C₆₀ aryl group, and a C₁-C₆₀ heteroaryl group, each substituted with at least one selected from -F, a cyano group, and a substituted C₁-C₆₀ alkyl group substituted with -F, but embodiments of the present disclosure are not limited thereto.

For example, R₃₁ to R₃₈ and R₉₃ to R₉₇ in Formulae 3-1 to 3-3, 9-1 and 9-2 may each independently be selected from the group consisting of:
hydrogen, -F, -Cl, -Br, -I, a cyano group, a C₁-C₁₀ alkyl group, a C₆-C₂₀ aryl group, and a C₁-C₂₀ heteroaryl group; and
a C₁-C₁₀ alkyl group, a C₆-C₂₀ aryl group, and a C₁-C₂₀ heteroaryl group, each substituted with at least one selected from -F, a cyano group, and a substituted C₁-C₁₀ alkyl group substituted with -F, but embodiments of the present disclosure are not limited thereto.

For example, Y₃₇ to Y₃₉ in Formula 3-3 may each independently be selected from N(CN), C(CN)(R₉₁), C(R₉₁)(R₉₂), and the group represented by Formula 9-1;
R₉₁ and R₉₂ may each independently be selected from the group consisting of:
-F, -Cl, -Br, -I, a cyano group, a C₁-C₆₀ alkyl group, a C₆-C₆₀ aryl group, and a C₁-C₆₀ heteroaryl group; and
a C₁-C₆₀ alkyl group, a C₆-C₆₀ aryl group, and a C₁-C₆₀ heteroaryl group, each substituted with at least one selected from -F, a cyano group, and a C₁-C₆₀ alkyl group substituted with -F, but embodiments of the present disclosure are not limited thereto.

For example, R₉₁ and R₉₂ may each independently be selected from the group consisting of:
-F, -Cl, -Br, -I, a cyano group, a C₁-C₁₀ alkyl group, a C₆-C₂₀ aryl group, a C₁-C₂₀ heteroaryl group; and
a C₁-C₁₀ alkyl group, a C₆-C₂₀ aryl group, and a C₁-C₂₀ heteroaryl group, each substituted with at least one selected from -F, a cyano group, and a C₁-C₁₀ alkyl group substituted with -F, but embodiments of the present disclosure are not limited thereto.

For example, the first compound represented by Formula 1 may be represented by Formula 1-1, but embodiments of the present disclosure are not limited thereto:

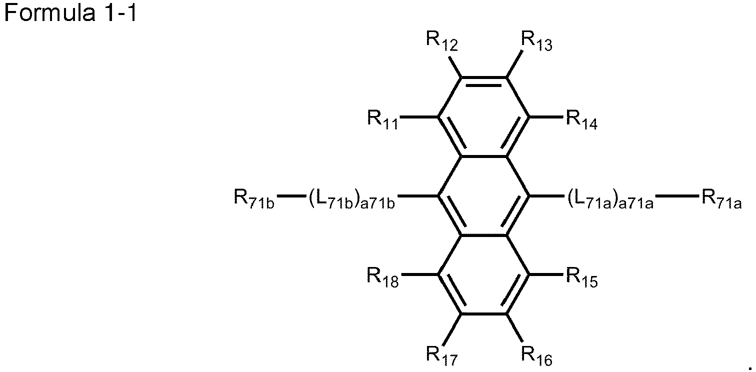

In Formula 1-1,
R₁₁ to R₁₈ are each independently selected from hydrogen, deuterium, -F,-Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁),-S(=O)₂(Q₁), and -P(=O)(O₁)(O₂);
i) R₁₁ and R₁₂, R₁₂ and R₁₃, or R₁₃ and R₁₄ are linked to form a ring, and R₇₁ₐ and R_{71b} are each independently selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group; or
ii) R₇₁ₐ and R_{71b} are each independently selected from a phenanthrenyl group, an anthracenyl group, a tetraphenyl group, a carbazolyl group and a group represented by one selected from Formulae 7A-1 to 7A-31, 7B-1 to 7B-3, 7C-1 to 7C-3, 7D-1 to 7D-3, 7E-1, and 7E-2;
a phenanthrenyl group, an anthracenyl group, a tetraphenyl group, a carbazolyl group, each substituted with at least one selected from deuterium, a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group; and
a phenanthrenyl group, an anthracenyl group, a tetraphenyl group, a carbazolyl group, each substituted with at least one substituent selected from a phenyl group and a naphthyl group, each of the at least one subsitutent is substituted with at least one selected from deuterium, a methyl group, an ethyl group, an n-propyl group, an iso-propyl group, an n-butyl group, a sec-butyl group, an iso-butyl group, a tert-butyl group, and a phenyl group:

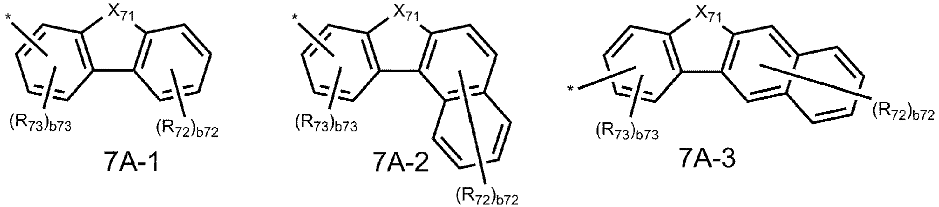

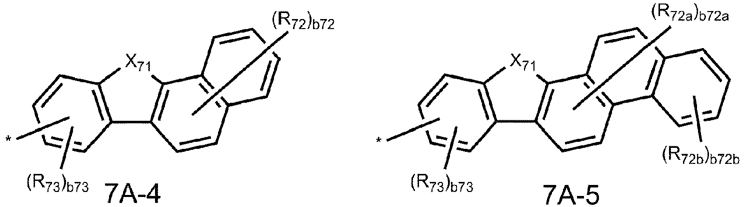

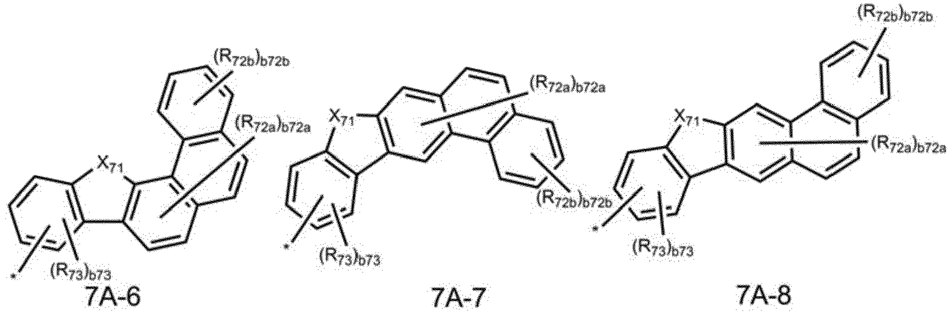

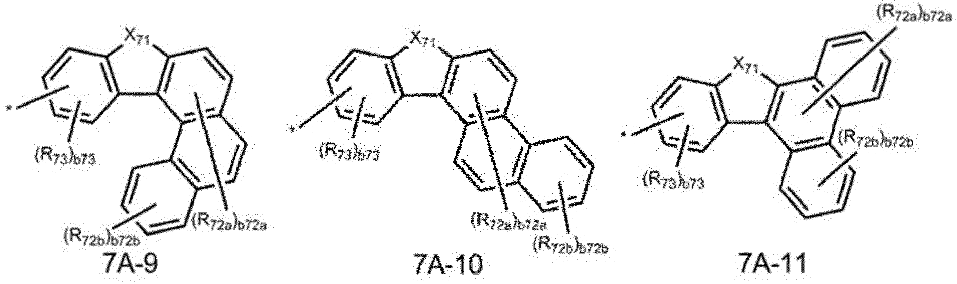

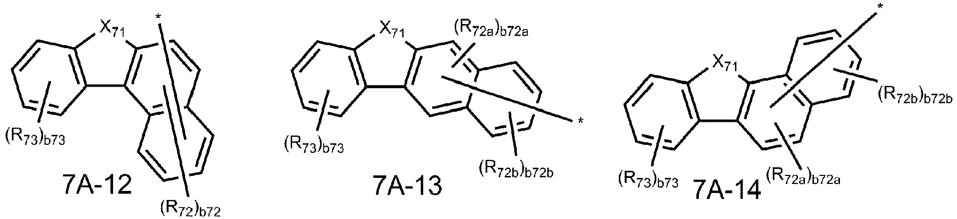

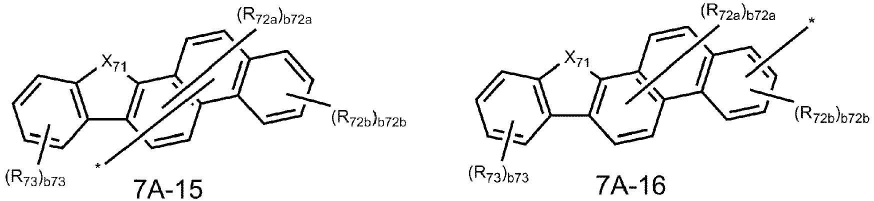

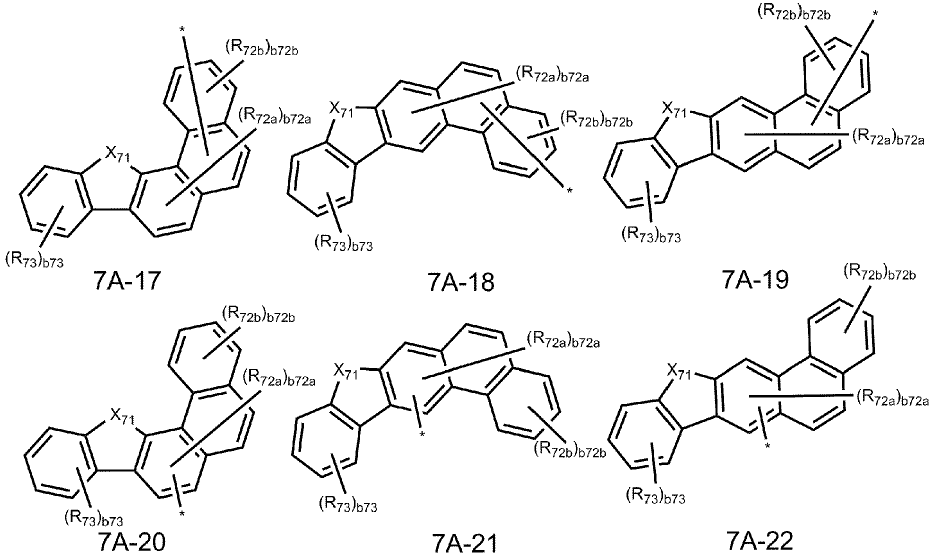

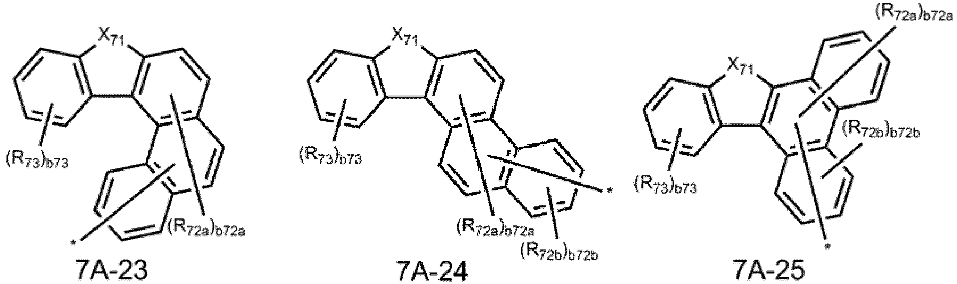

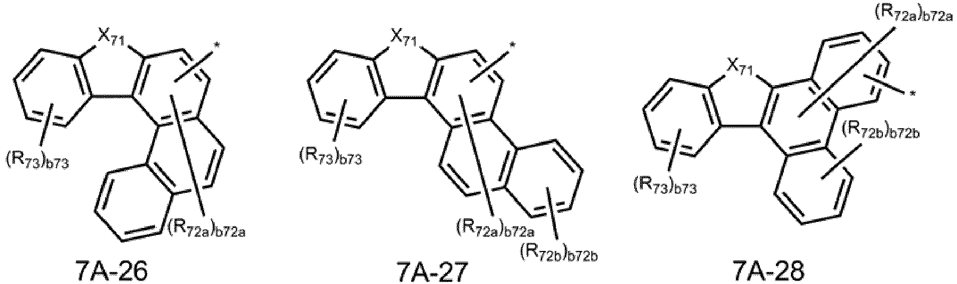

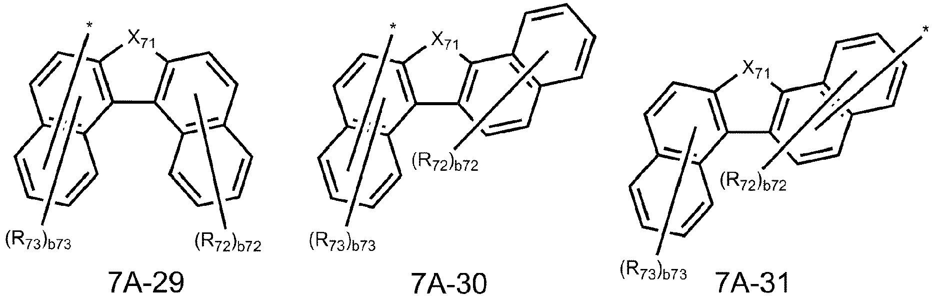

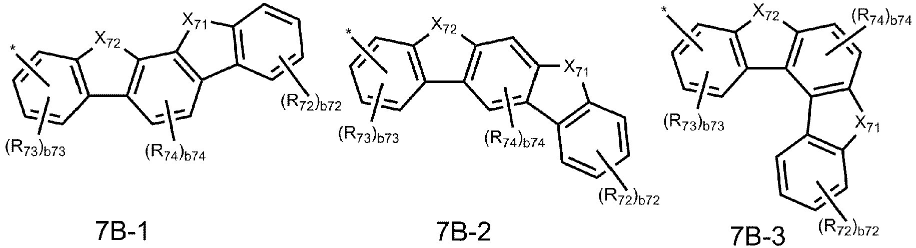

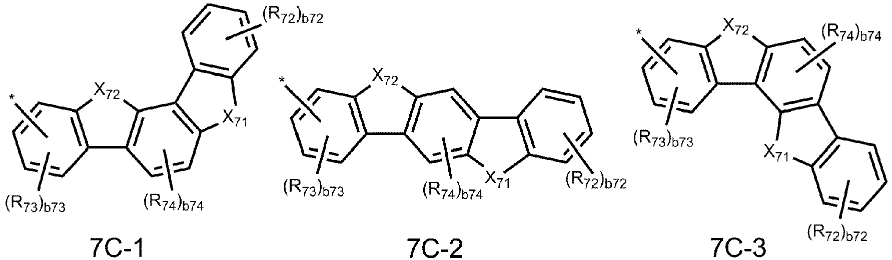

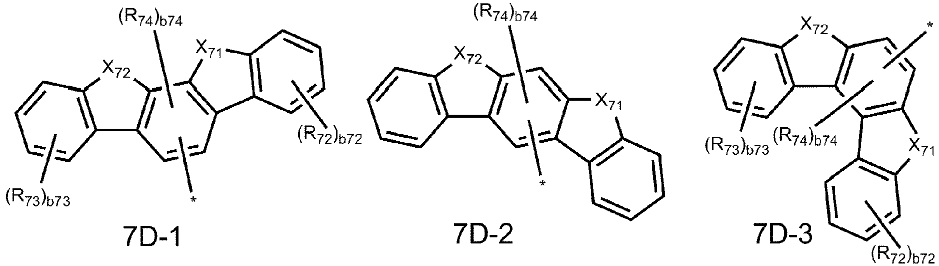

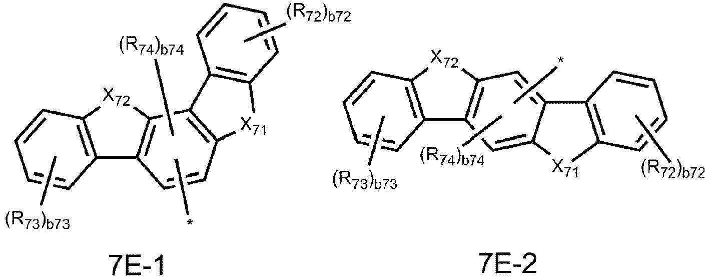

In Formulae 7A-1 to 7A-31, 7B-1 to 7B-3, 7C-1 to 7C-3, 7D-1 to 7D-3, 7E-1, and 7E-2,
X₇₁ is selected from O, S, N(R₇₅), and C(R₇₅)(R₇₆);
X₇₂ is selected from O, S, N(R₇₇), and C(R₇₇)(R₇₈);
R₇₂ to R₇₈, R₇₂ₐ, and R_{72b} are each independently selected from the group consisting of:
hydrogen, deuterium, a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group; and
a phenyl group, a biphenyl group, and a naphthyl group, each substituted with at least one selected from deuterium, a methyl group, an ethyl group, an n-propyl group, an iso-propyl group, an n-butyl group, a sec-butyl group, an iso-butyl group, a tert-butyl group, and a phenyl group;
R₇₅ and R₇₆ are optionally linked to form a ring;
R₇₇ and R₇₈ are optionally linked to form a ring;
b72 to b74, b72a, and b72b are each independently selected from 1, 2, 3, 4, 5, 6, 7, and 8; and
* indicates a binding site to a neighboring atom;
L₇₁ₐ and L_{71b} are each independently selected from a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group;
a71a and a71b are each independently selected from 0, 1, 2, and 3; and
wherein Q₁ to Q₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

For example, R₁₁ to R₁₈ may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₁₀ alkyl group, a substituted or unsubstituted C₂-C₁₀ alkenyl group, a substituted or unsubstituted C₂-C₁₉ alkynyl group, a substituted or unsubstituted C₁-C₁₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂); R₁₁ and R₁₂, R₁₂ and R₁₃, and/or R₁₃ and R₁₄ may optionally be linked to form a ring.

For example, L₇₁ₐ and L_{71b} may each independently be selected from a substituted or unsubstituted C₆-C₂₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group.

For example, Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₁₀ alkyl group, a C₂-C₁₉ alkenyl group, a C₂-C₁₉ alkynyl group, a C₁-C₁₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₂₀ aryl group, a C₁-C₂₀ heteroaryl group, a monovalent non-aromatic condensed polycyclic group, a monovalent non-aromatic condensed heteropolycyclic group, a biphenyl group, and a terphenyl group.

In one or more embodiments, R₁₁ to R₁₈ in Formula 1-1 may each independently be selected from the group consisting of:
hydrogen, deuterium, -F, -Cl, -Br, -I, a cyano group, a methyl group, an ethyl group, an n-propyl group, an iso-propyl group, an n-butyl group, a sec-butyl group, an iso-butyl group, a tert-butyl group, a phenyl group, a biphenyl group, a terphenyl group, a naphthyl group, a pyridinyl group, a fluorenyl group, a dibenzofuranyl group, a dibenzothiophenyl group, a carbazolyl group, and -Si(Q₁)(Q₂)(Q₃); and
a fluorenyl group, a dibenzofuranyl group, a dibenzothiophenyl group, and a carbazolyl group, each substituted with at least one selected from a methyl group, an ethyl group, an n-propyl group, an iso-propyl group, an n-butyl group, a sec-butyl group, an iso-butyl group, a tert-butyl group, a phenyl group, a biphenyl group, a terphenyl group, a naphthyl group, and a pyridinyl group,
wherein Q₁ to Q₃ may each independently be selected from a methyl group, an ethyl group, an n-propyl group, an iso-propyl group, a phenyl group, a biphenyl group, and a terphenyl group;
L₇₁ₐ and L_{71b} may each independently be selected from the group consisting of:
   a phenylene group, a naphthylene group, a phenanthrene group, a fluorenylene group, an anthracenylene group, a dibenzofuranylene group, and a dibenzothiophenylene group; and
   a phenylene group, a naphthylene group, a phenanthrene group, a fluorenylene group, an anthracenylene group, a dibenzofuranylene group, and a dibenzothiophenylene group, each substituted with at least one selected from deuterium, -F, -Cl, -Br, -I, a cyano group, a nitro group, a C₁-C₂₀ alkyl group, a phenyl group, and a naphthyl group;
   a71a and a71b may each independently be selected from 0 and 1;

In one or more embodiments, the first compound represented by Formula 1 may be selected from Compounds H5, H6, H12, H16, H17, H24, H26 to H30, H35, H39, H45 to H102, H109, H110, H112, H114 to H190, but embodiments of the present disclosure are not limited thereto:

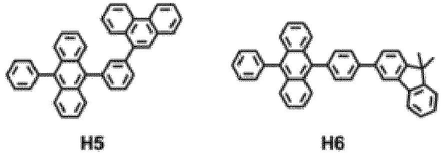

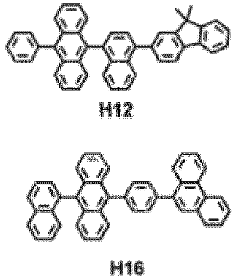

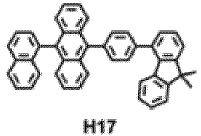

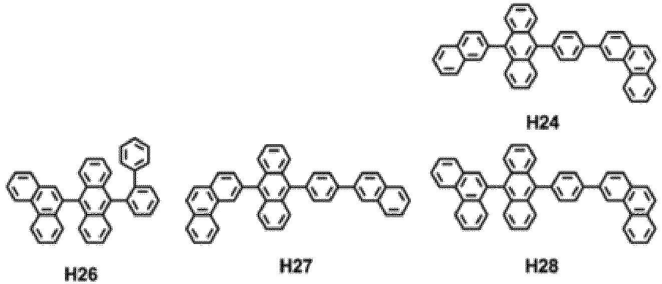

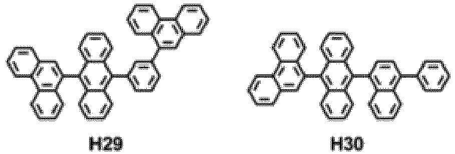

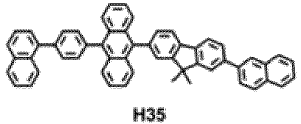

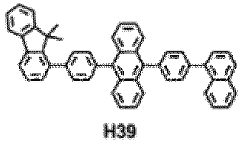

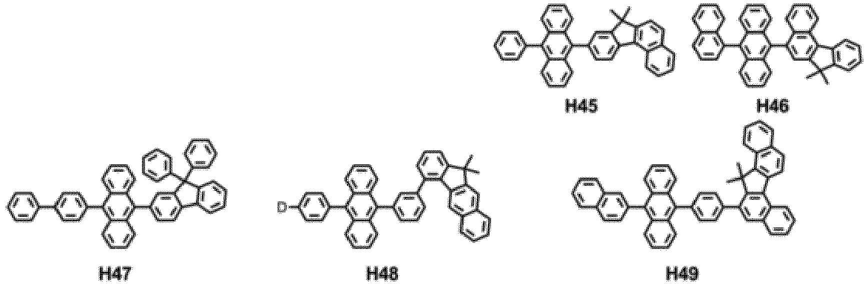

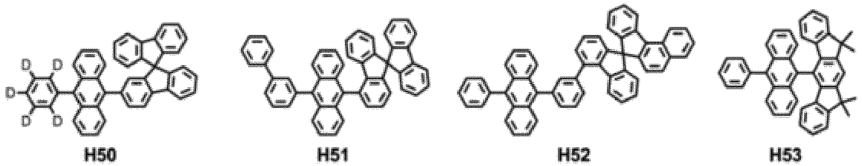

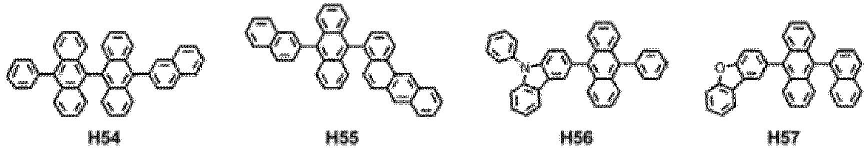

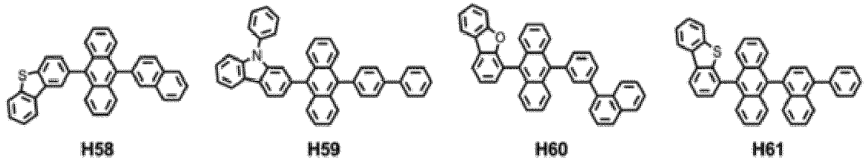

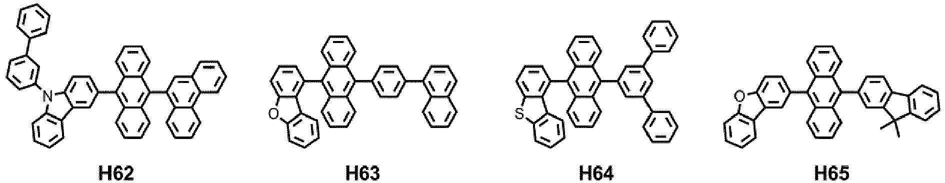

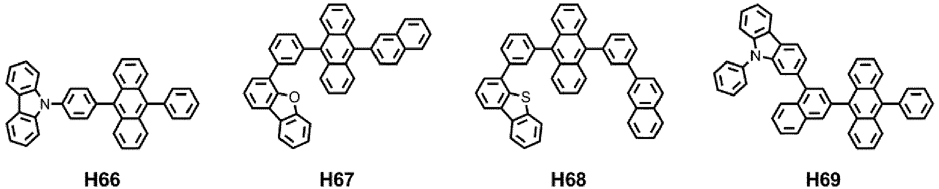

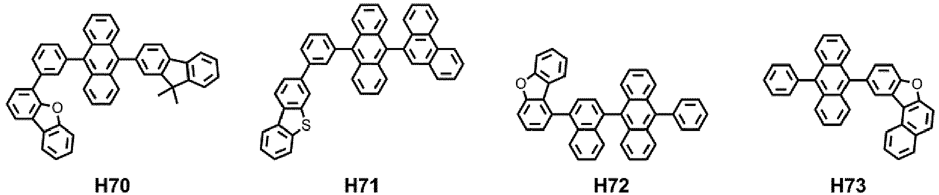

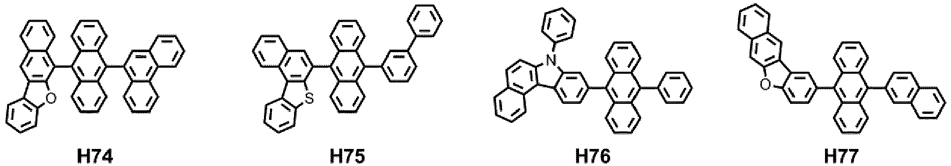

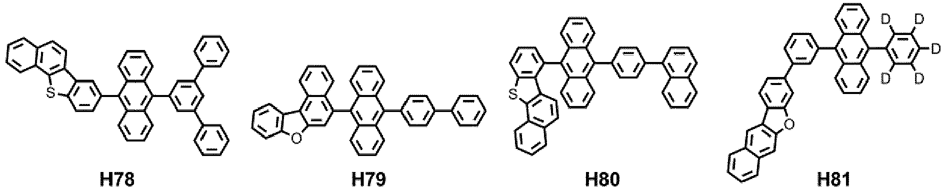

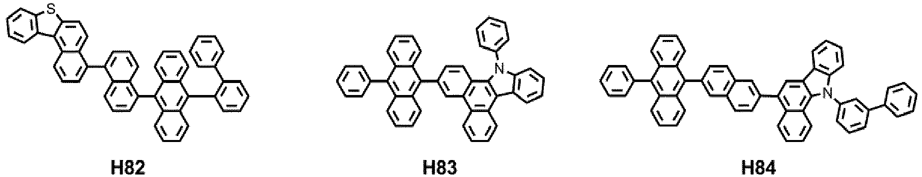

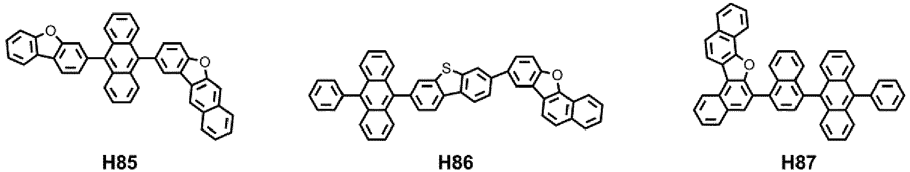

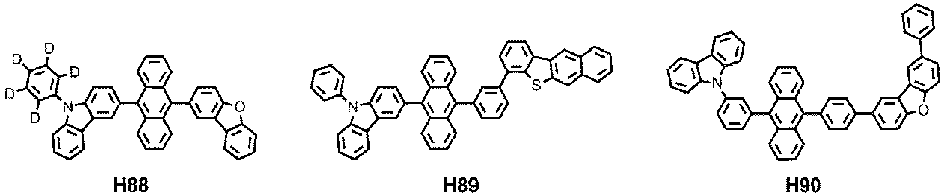

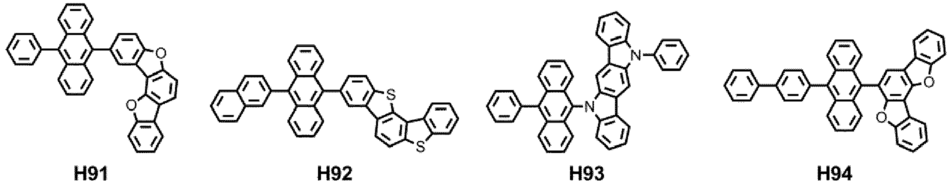

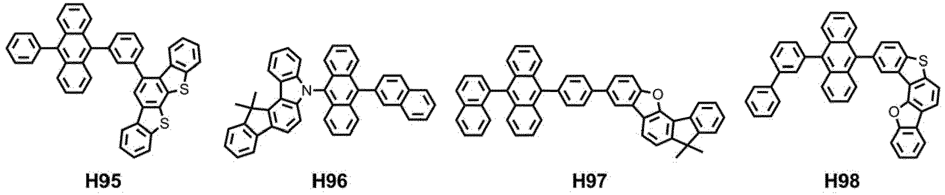

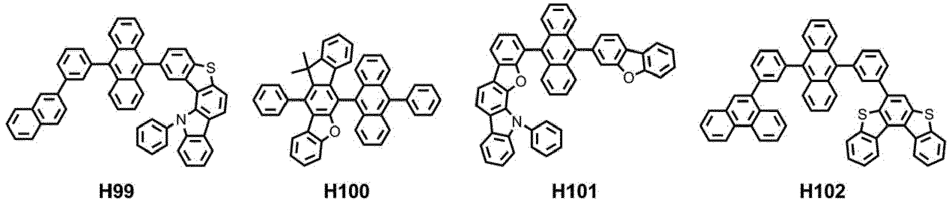

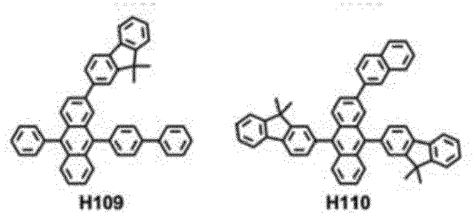

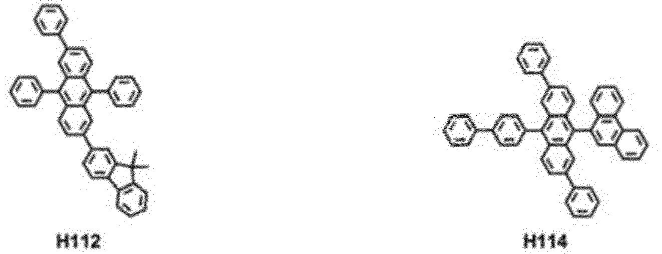

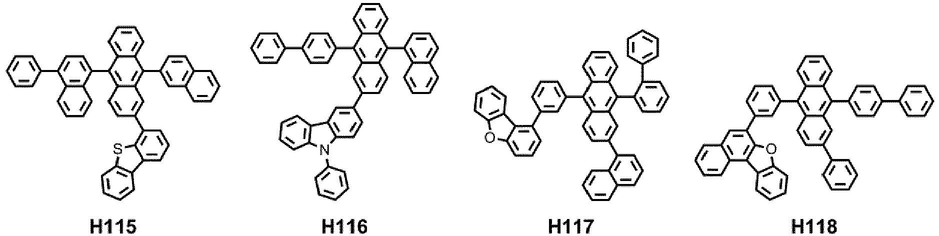

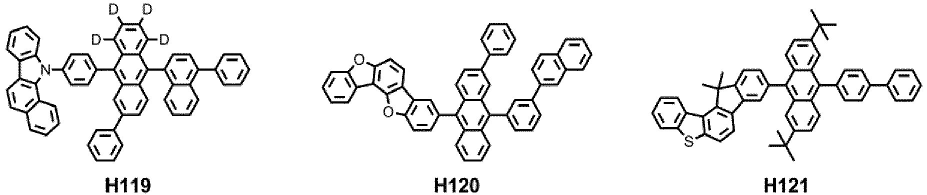

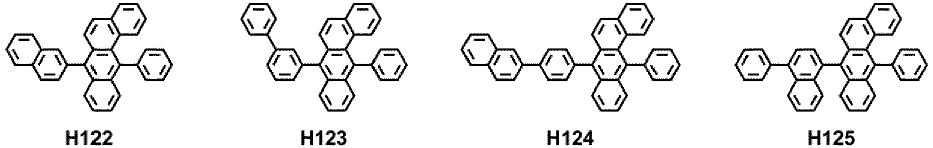

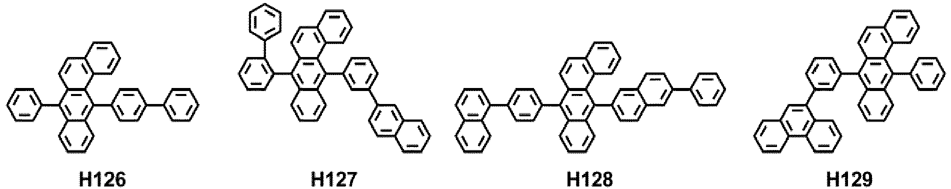

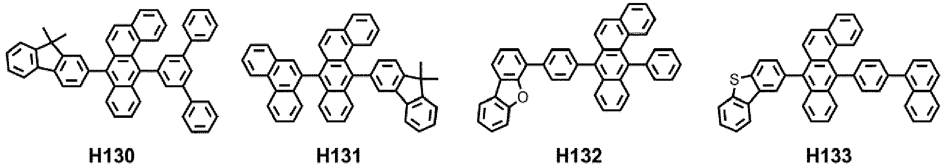

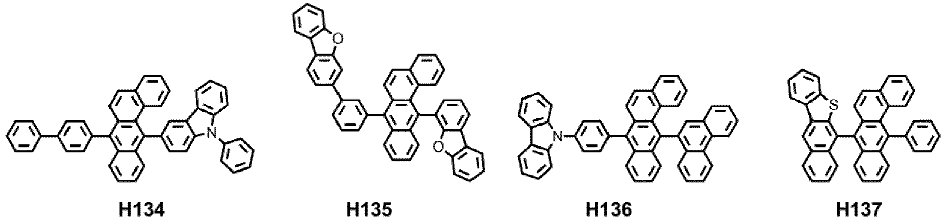

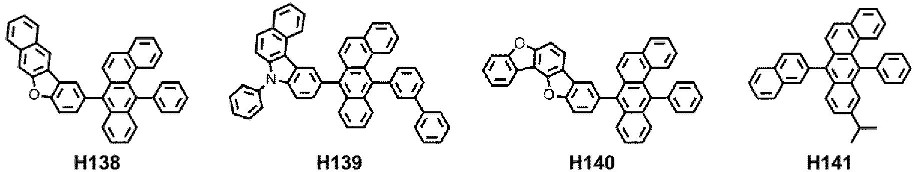

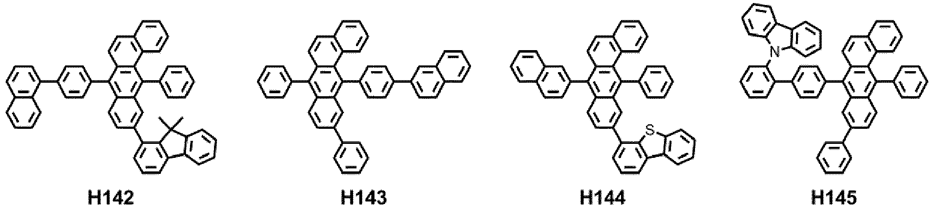

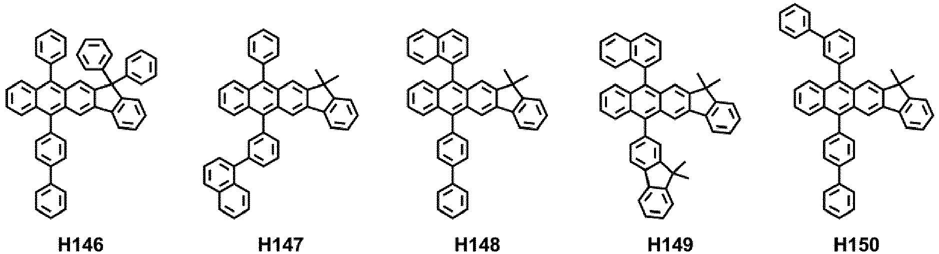

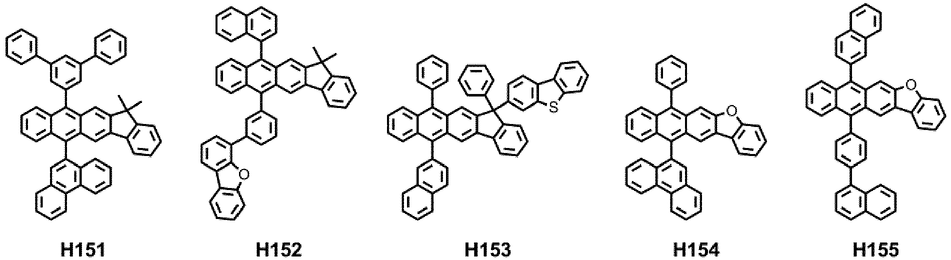

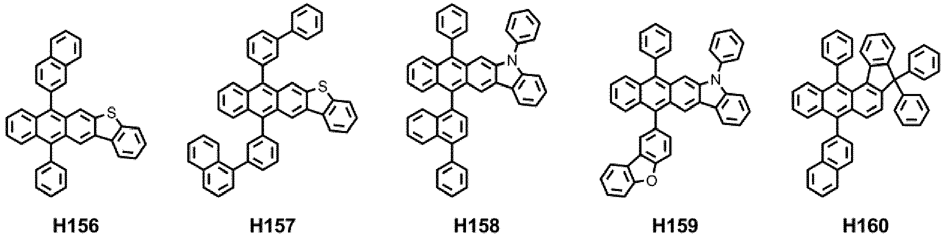

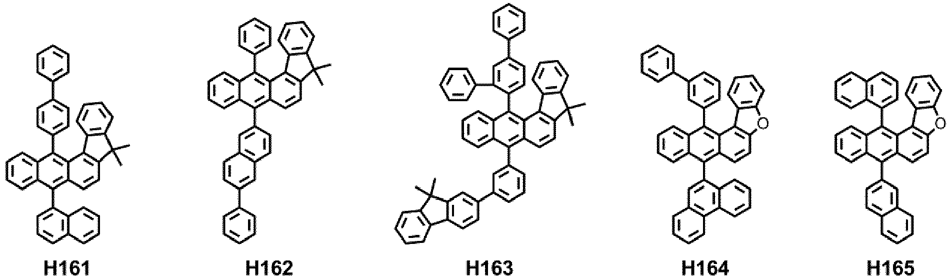

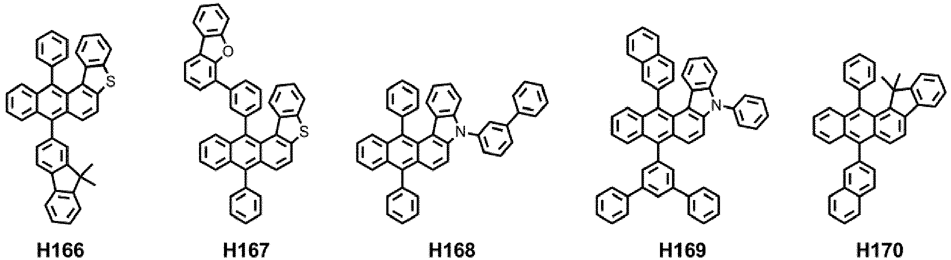

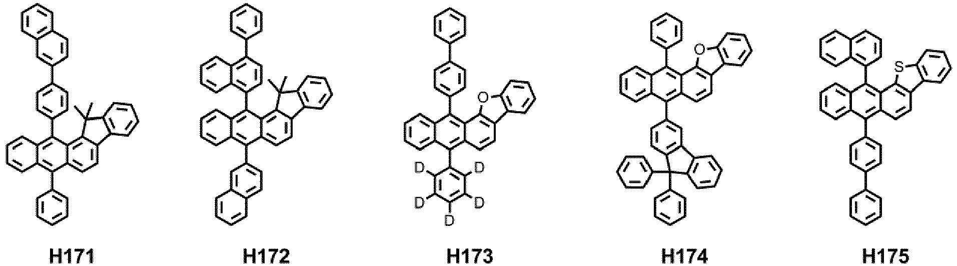

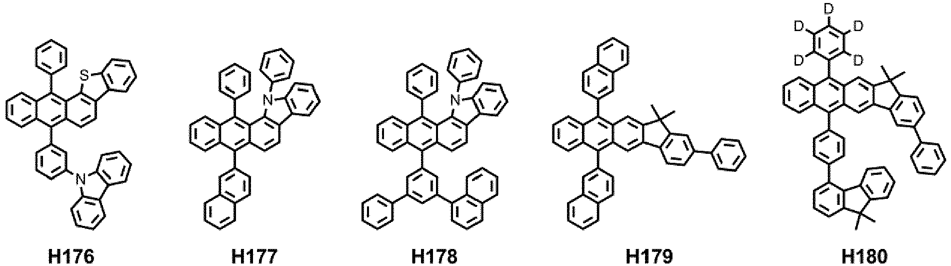

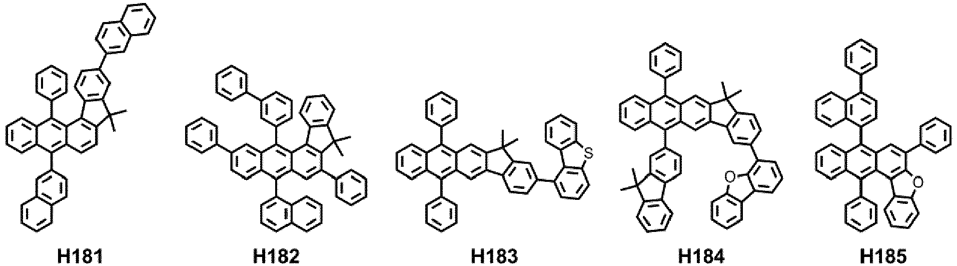

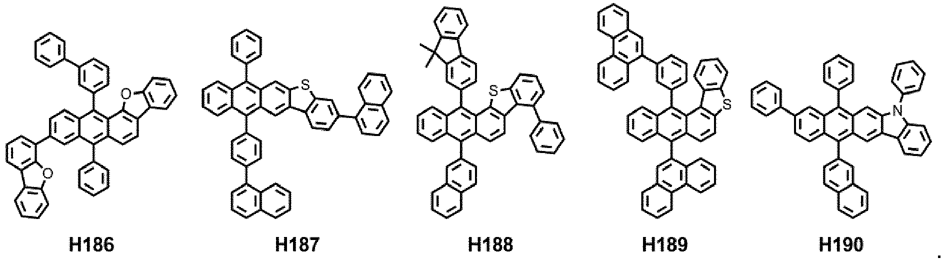

For example, the second compound represented by Formula 2 may be represented by one selected from Formula 2-1 and 2-2, but embodiments of the present disclosure are not limited thereto:

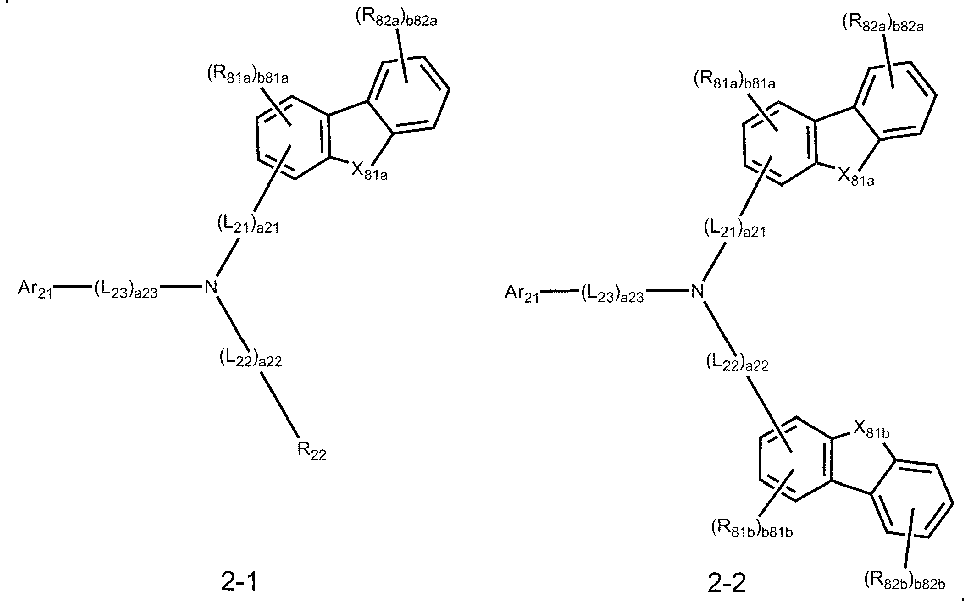

In Formulae 2-1 and 2-2,
Ar₂₁ isselected from a substituted or unsubstituted C₅-C₆₀ carbocyclic group and a substituted or unsubstituted C₁-C₆₀ heterocyclic group,
L₂₁ to L₂₃ are each independently selected from a substituted or unsubstituted C₆-C₆₀ arylene group and a substituted or unsubstituted C₁-C₆₀ heteroarylene group;
a21 to a23 are each independently selected from 0, 1, 2, and 3;
R₂₂ is selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group;
X₈₁ₐ and X_{81b} are each independently selected from O and S;
R₈₁ₐ, R_{81b}, R₈₂ₐ, and R_{82b} are each independently selected from the group consisting of:
-F, -CI, -Br, -I, a cyano group, a C₁-C₆₀ alkyl group, a C₃-C₁₀ cycloalkyl group, a C₁-C₁₀ heterocycloalkyl group, a C₆-C₆₀ aryl group, a C₆-C₆₀ aryloxy group, a C₆-C₆₀ arylthio group, a C₁-C₆₀ heteroaryl group, and -Si(Q₁)(Q₂)(Q₃); and
a C₃-C₁₀ cycloalkyl group, a C₁-C₁₀ heterocycloalkyl group, a C₆-C₆₀ aryl group, a C₆-C₆₀ aryloxy group, a C₆-C₆₀ arylthio group, and a C₁-C₆₀ heteroaryl group, each substituted with at least one selected from -F, -CI, -Br, -I, a cyano group, and a C₁-C₆₀ alkyl group;
b81a and b81b are each independently selected from 0, 1, 2, and 3;
b82a and b82b are each independently selected from 0, 1, 2, 3, and 4;
the sum of b81a and b82a is 1 or more; and
the sum of b81b and b82b is 1 or more,
wherein Q₁ to Q₃ are each independently selected from hydrogen, deuterium, -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

For example, Ar₂₁ may be selected from a substituted or unsubstituted C₅-C₃₀ carbocyclic group and a substituted or unsubstituted C₁-C₂₀ heterocyclic group.

For example, L₂₁ to L₂₃ may each independently be selected from a substituted or unsubstituted C₆-C₂₀ arylene group and a substituted or unsubstituted C₁-C₁₅ heteroarylene group.

For example, R₂₂ may be selected from a substituted or unsubstituted C₆-C₃₀ aryl group, a substituted or unsubstituted C₁-C₂₀ heteroaryl group, a substituted or unsubstituted monovalent non-aromatic condensed polycyclic group, and a substituted or unsubstituted monovalent non-aromatic condensed heteropolycyclic group.

For example, R₈₁ₐ, R_{81b}, R₈₂ₐ and R_{82b} may each independently be selected from the group consisting of:
-F, -CI, -Br, -I, a cyano group, a C₁-C₁₀ alkyl group, a C₃-C₁₀ cycloalkyl group, a C₁-C₁₀ heterocycloalkyl group, a C₆-C₂₀ aryl group, a C₆-C₂₀ aryloxy group, a C₆-C₂₀ arylthio group, a C₁-C₂₀ heteroaryl group, and -Si(Q₁)(Q₂)(Q₃); and
a C₃-C₁₀ cycloalkyl group, a C₁-C₁₀ heterocycloalkyl group, a C₆-C₂₀ aryl group, a C₆-C₂₀ aryloxy group, a C₆-C₂₀ arylthio group, and a C₁-C₂₀ heteroaryl group, each substituted with at least one selected from deuterium, -F, -CI, -Br, -I, a cyano group, a C₁-C₁₀ alkyl group.

For example, Q₁ to Q₃ may each independently be selected from hydrogen, deuterium, -F, -CI, -Br, -I, a hydroxyl group, a cyano group, a nitro group, an amidino group, a hydrazino group, a hydrazono group, a C₁-C₁₀ alkyl group, a C₂-C₁₀ alkenyl group, a C₂-C₁₀ alkynyl group, a C₁-C₁₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₂₀ aryl group, a C₁-C₂₀ heteroaryl group, a monovalent non-aromatic condensed polycyclic group, a monovalent non-aromatic condensed heteropolycyclic group, a biphenyl group, and a terphenyl group.

In one or more embodiments, Ar₂₁ in Formulae 2-1 and 2-2 may be selected from the group consisting of:
a benzene group, a naphthalene group, a fluorene group, a spiro-bifluorene group, a phenanthrene group, an anthracene group, a triphenylene group, a carbazole group, a dibenzofuran group, and a dibenzothiophene group; and
a benzene group, a naphthalene group, a fluorene group, a spiro-bifluorene group, a phenanthrene group, an anthracenegroup, a triphenylene group, a carbazole group, a dibenzofuran group, and a dibenzothiophene group, each substituted with at least one selected from a C₁-C₂₀ alkyl group, a phenyl group, a biphenyl group, a terphenyl group, a naphthyl group, and -N(Q₃₁)(Q₃₂),
wherein Q₃₁ and Q₃₂ may each independently be selected from the group consisting of:
a phenyl group, a biphenyl group, a terphenyl group, a naphthyl group, a fluorenyl group, a dibenzofuranyl group, a dibenzothiophenyl group, and a carbazolyl group; and
a phenyl group, a biphenyl group, a terphenyl group, a naphthyl group, a fluorenyl group, a dibenzofuranyl group, a dibenzothiophenyl group, and a carbazolyl group, each substituted with at least one selected from a methyl group, a phenyl group, and a naphthyl group;
L₂₁ to L₂₃ may each independently be selected from the group consisting of:
   a phenylene group and a naphthylene group; and
   a phenylene group and a naphthylene group, each substituted with at least one selected from deuterium, -F, -CI, -Br, -I, a cyano group, a nitro group, a C₁-C₂₀ alkyl group, a phenyl group, and a naphthyl group;
   a21 to a23 may each independently be selected from 0, 1, and 2;
   R₂₂ may be selected from the group consisting of:
   a phenyl group, a biphenyl group, a terphenyl group, a naphthyl group, a fluorenyl group, a spiro-bifluorenyl group, a phenanthrenyl group, an anthracenyl group, a triphenylenyl group, a carbazolyl group, a dibenzofuranyl group, and a dibenzothiophenyl group; and
   a phenyl group, a biphenyl group, a terphenyl group, a naphthyl group, a fluorenyl group, a spiro-bifluorenyl group, a phenanthrenyl group, an anthracenyl group, a triphenylenyl group, a carbazolyl group, a dibenzofuranyl group, and a dibenzothiophenyl group, each substituted with at least one selected from deuterium, a C₁-C₂₀ alkyl group, a phenyl group, a biphenyl group, a terphenyl group, and a naphthyl group;
   X₈₁ₐ and X_{81b} may each independently be selected from O and S;
   R₈₁ₐ, R_{81b}, R₈₂ₐ, and R_{82b} may each independently be selected from the group consisting of:
      -F, -CI, -Br, -I, a cyano group, a phenyl group, a biphenyl group, a terphenyl group, and a naphthyl group; and
      a phenyl group, a biphenyl group, a terphenyl group, and a naphthyl group, each substituted with at least one selected from -F, -CI, -Br, -I, a cyano group, a methyl group, an ethyl group, an n-propyl group, an iso-propyl group, an n-butyl group, an isobutyl group, a sec-butyl group, and a tert-butyl group;
      b81a and b81b may each independently be selected from 0, 1, 2, and 3;
      b82a and b82b may each independently be selected from 0, 1, 2, 3, and 4;
      the sum of b81a and b82a may be 1 or more; and
      the sum of b81b and b82b may be 1 or more, but embodiments of the present disclosure are not limited thereto.

In one or more embodiments, the second compound represented by Formula 2 may be selected from Compounds A1 to A98, but embodiments of the present disclosure are not limited thereto:

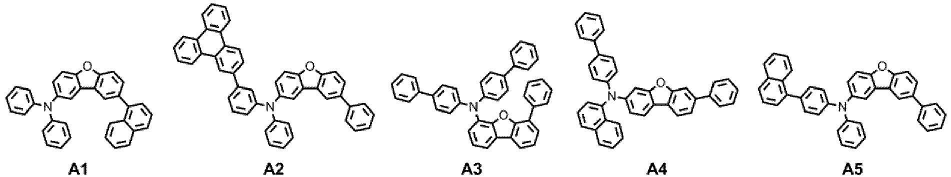

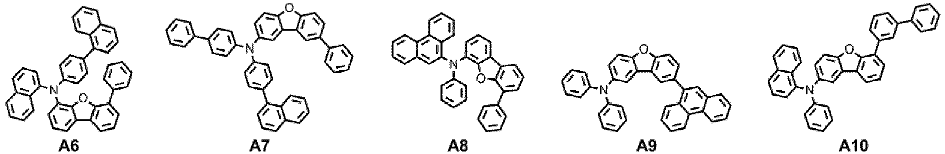

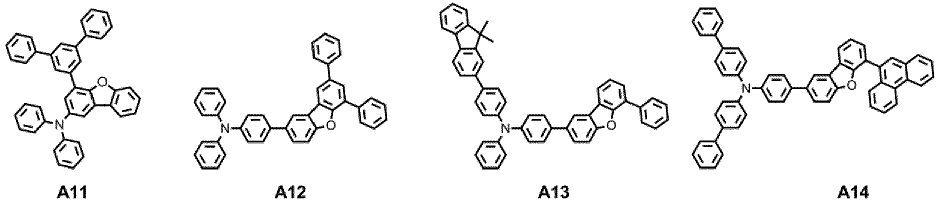

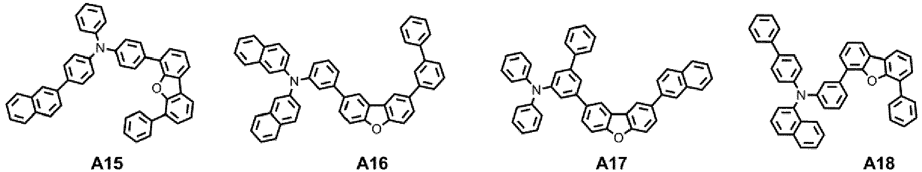

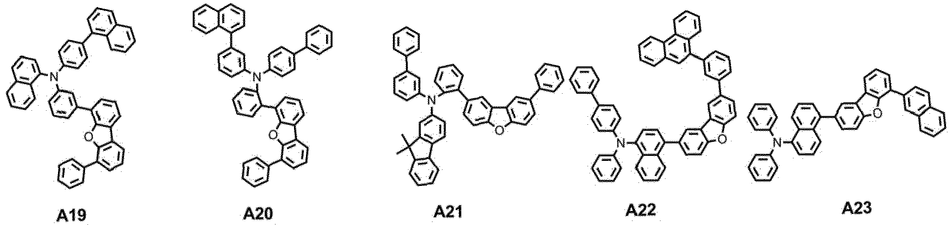

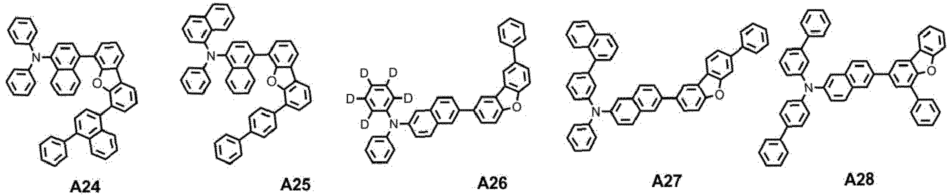

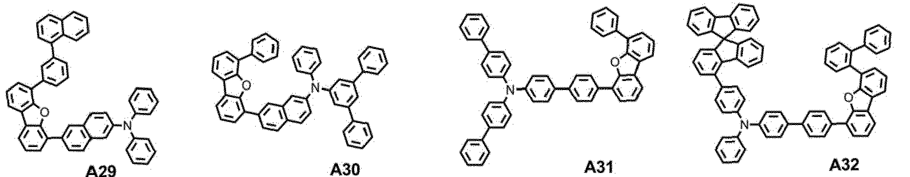

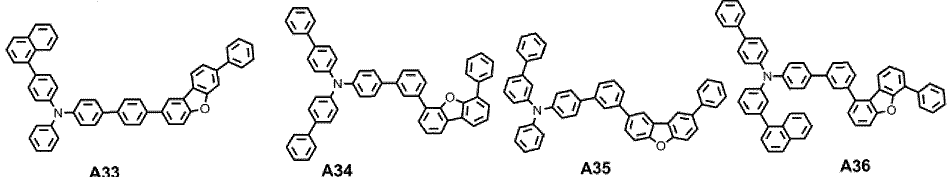

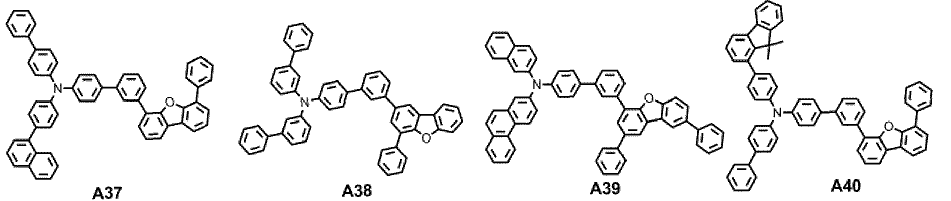

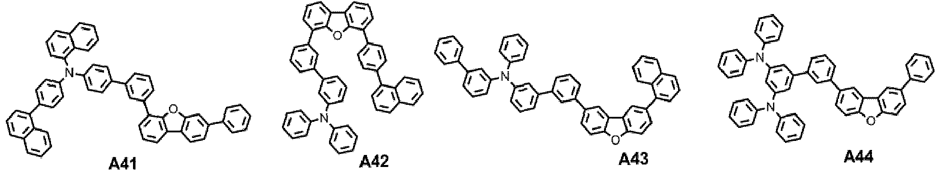

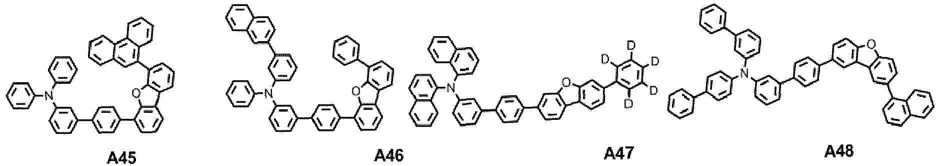

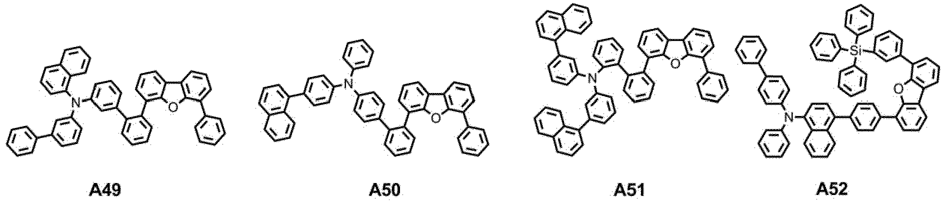

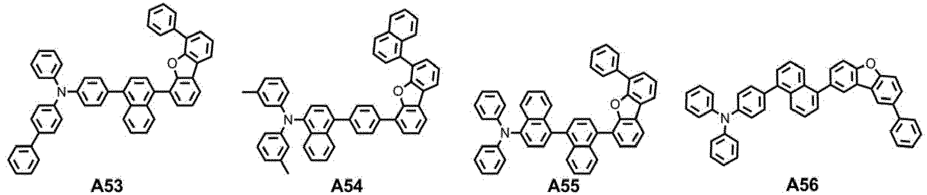

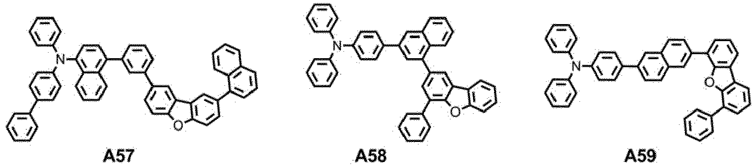

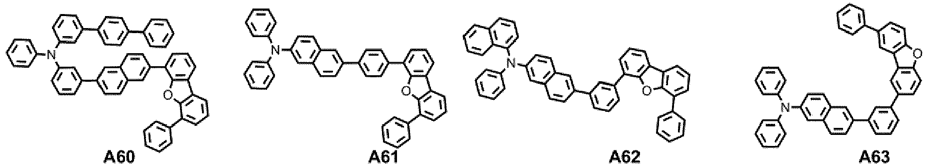

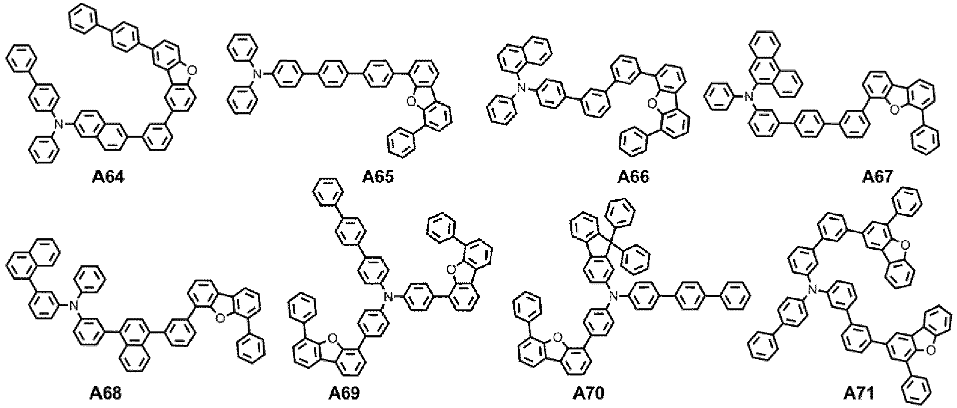

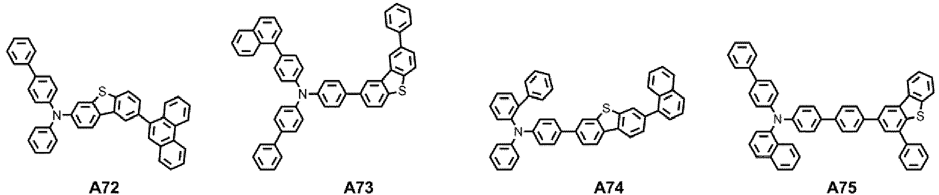

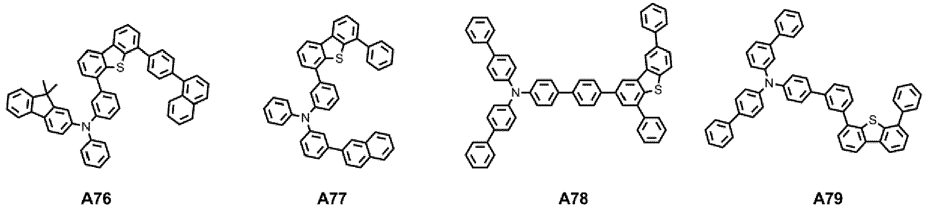

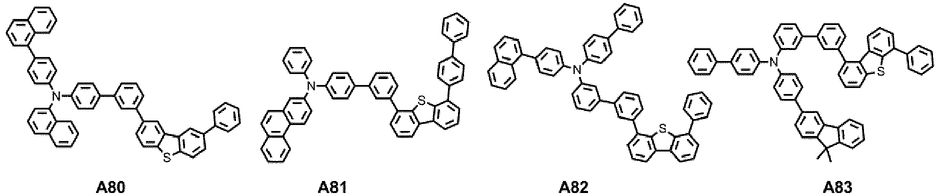

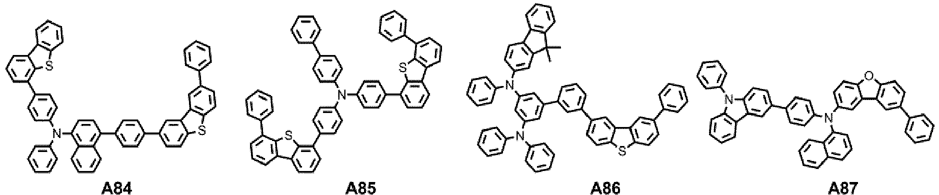

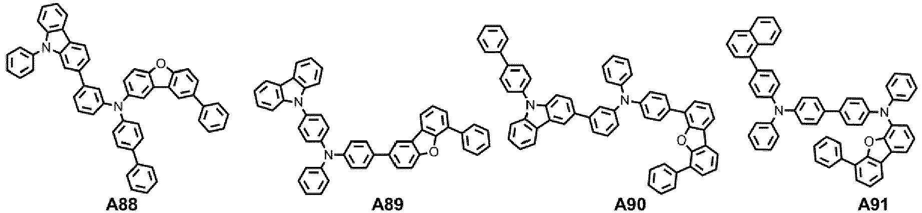

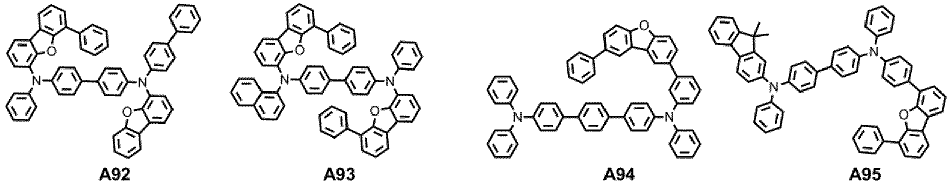

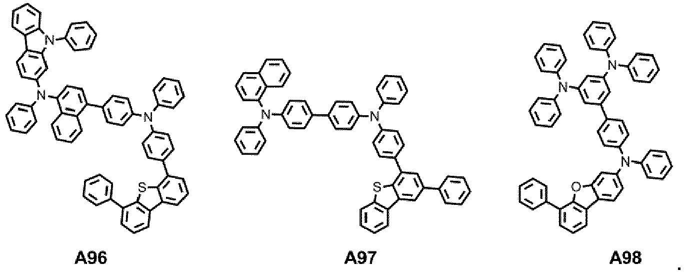

For example, the third compound represented by one selected from Formulae 3-1 to 3-3 may be selected from Compounds P1 to P31, but embodiments of the present disclosure are not limited thereto.

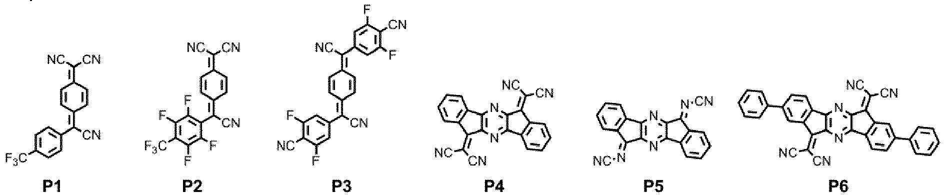

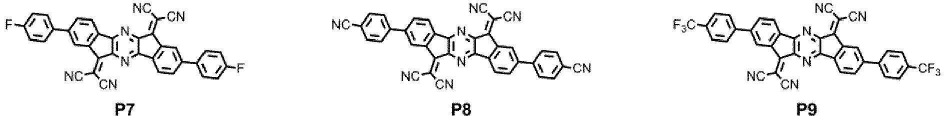

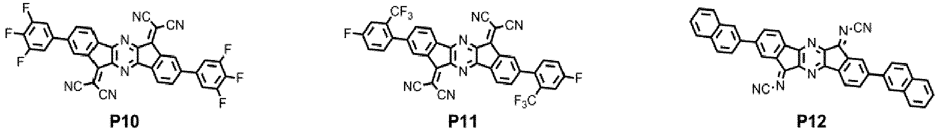

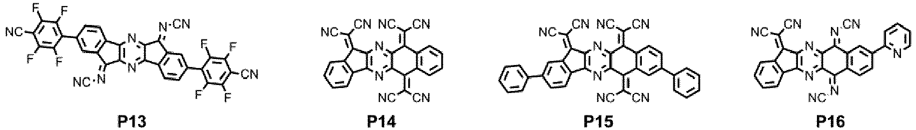

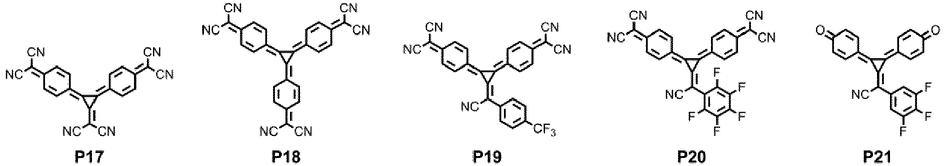

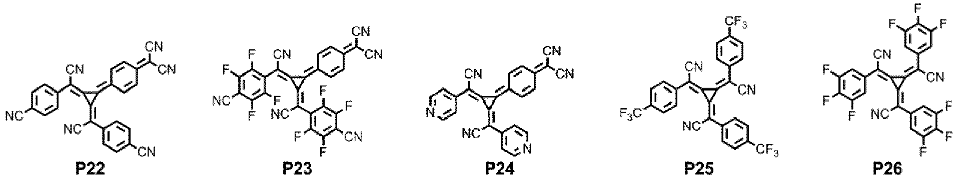

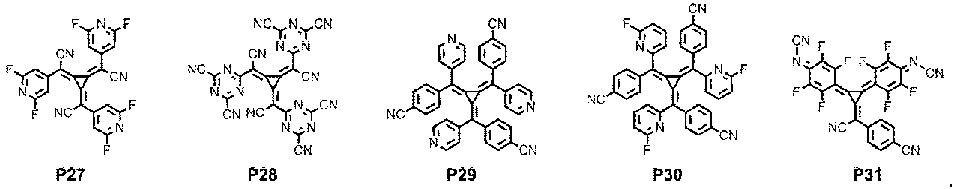

In general, it is known that since an anthracene-based compound having a symmetric structure has high crystallinity, the anthracene-based compound provides poor film-forming properties. However, since the first compound represented by Formula 1 has an asymmetric structure, film-forming properties may be improved. In the first compound represented by Formula 1, a substituent that is bulkier than a phenyl group is located at the 10^{th} carbon of the anthracene, and thus, the first compound may be less associated with a dopant, and efficiency and lifespan of the manufactured organic light-emitting device may be improved.

The second compound represented by Formula 2 has a relatively large band gap and relatively high hole-transporting properties. That is, the second compound represented by Formula 2 has a relatively high LUMO energy level (for example, the LUMO energy level of the second compound is higher than that of a compound included in an emission layer). Due to the high LUMO energy level of the second compound represented by Formula 2, in the case of an organic light-emitting device including the second compound, electrons may be sufficiently trapped inside the emission layer. Therefore, efficiency of the organic light-emitting device may be improved. The second compound represented by Formula 2 has a high glass transition temperature (Tg), and the second compound represented by Formula 2 has a structure having a large steric hindrance (leading to the prevention of intermolecular agglomeration). Accordingly, an organic light-emitting device including the second compound may have a longer lifespan.

The third compound represented by one selected from Formulae 3-1 to 3-3 may contribute to an increase in conductivity of an organic layer including the third compound, and facilitating hole mobility. Accordingly, an organic light-emitting device including the third compound may have improved efficiency. The third compound represented by one selected from Formulae 3-1 to 3-3 has high polarity, and thus, diffusion thereof may be suppressed in an organic layer. Accordingly, an organic light-emitting device including the third compound may have a longer lifespan.

An organic light-emitting device including the first compound, the second compound, and the third compound concurrently, according to an embodiment, may have a low driving voltage, high efficiency, and long lifespan characteristics.

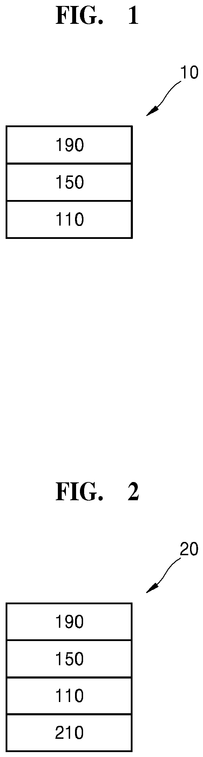

### Description of FIG. 1

FIG. 1 is a schematic view of an organic light-emitting device 10 according to an embodiment. The organic light-emitting device 10 includes a first electrode 110, an organic layer 150, and a second electrode 190.

Hereinafter, the structure of the organic light-emitting device 10 according to an embodiment and a method of manufacturing the organic light-emitting device 10 according to an embodiment will be described in connection with FIG. 1.

### First electrode 110

In FIG. 1, a substrate may be additionally disposed under the first electrode 110 or above the second electrode 190. The substrate may be a glass substrate or a plastic substrate, each having excellent mechanical strength, thermal stability, transparency, surface smoothness, ease of handling, and/or water-resistance.

The first electrode 110 may be formed by depositing or sputtering a material for forming the first electrode 110 on the substrate. When the first electrode 110 is an anode, the material for forming the first electrode may be selected from materials with a high work function to facilitate hole injection.

The first electrode 110 may be a reflective electrode, a semi-transmissive electrode, or a transmissive electrode. When the first electrode 110 is a transmissive electrode, a material for forming the first electrode may be selected from indium tin oxide (ITO), indium zinc oxide (IZO), tin oxide (SnO₂), zinc oxide (ZnO), and combinations thereof, but embodiments of the present disclosure are not limited thereto. When the first electrode 110 is a semi-transmissive electrode or a reflective electrode, as a material for forming the first electrode 110, magnesium (Mg), silver (Ag), aluminium (Al), aluminium-lithium (Al-Li), calcium (Ca), magnesium-indium (Mg-In), magnesium-silver (Mg-Ag), or a combination thereof may be utilized. However, the material for forming the first electrode 110 is not limited thereto.

The first electrode 110 may have a single-layered structure, or a multi-layered structure including two or more layers. For example, the first electrode 110 may have a three-layered structure of ITO/Ag/ITO, but the structure of the first electrode 110 is not limited thereto.

### Organic layer 150

The organic layer 150 is disposed on the first electrode 110. The organic layer 150 includes an emission layer.

The organic layer 150 further includes a hole transport region between the first electrode 110 and the emission layer, and an electron transport region between the emission layer and the second electrode 190.

### Hole transport region in organic layer 150

The hole transport region may have i) a single-layered structure including a single layer including a single material, ii) a single-layered structure including a single layer including a plurality of different materials, or iii) a multi-layered structure having a plurality of layers including a plurality of different materials.

The hole transport region may include at least one layer selected from a hole injection layer (HIL), a hole transport layer (HTL), an emission auxiliary layer, and an electron blocking layer (EBL).

For example, the hole transport region may have a single-layered structure including a single layer including a plurality of different materials, or a multi-layered structure having a structure of hole injection layer/hole transport layer, hole injection layer/hole transport layer/emission auxiliary layer, hole injection layer/emission auxiliary layer, hole transport layer/emission auxiliary layer or hole injection layer/hole transport layer/electron blocking layer, wherein for each structure, constituting layers are sequentially stacked from the first electrode 110 in each stated order, but the structure of the hole transport region is not limited thereto.

The hole transport region includes the second compound represented by Formula 2 and the third compound represented by one selected from Formulae 3-1 to 3-3.

For example, the hole transport region may include a first layer and a second layer;

the first layer may be disposed between the first electrode and the second layer; and

the first layer may include the second compound represented by Formula 2 and the third compound represented by one selected from Formulae 3-1 to 3-3, but embodiments of the hole transport region are not limited thereto. In the present embodiment, the first layer may be a hole transport layer, and the second layer may be an emission auxiliary layer, but the first layer and the second layer are not limited thereto. The first layer and the second layer may be disposed adjacent to each other, but the configuration of the first layer and the second layer is not limited thereto.

In one or more embodiments, the hole transport region may include a first layer, a second layer, and a third layer;
the first layer may be disposed between the first electrode and the second layer;
the second layer may be disposed between the first layer and the third layer; and
the first layer may include the third compound represented by one selected from Formulae 3-1 to 3-3, and the third layer may include the second compound represented by Formula 2, but embodiments are not limited thereto. In the present embodiment, the first layer may be a hole injection layer, the second layer may be a hole transport layer, and the third layer may be an emission auxiliary layer, but embodiments are not limited thereto. The first layer, the second layer, and the third layer may be disposed in this stated order, being adjacent to each other, but embodiments of the present disclosure are not limited thereto.

In one or more embodiments, the hole transport region may include, in addition to the second compound represented by Formula 2 and the third compound represented by one selected from Formulae 3-1 to 3-3, at least one selected from m-MTDATA, TDATA, 2-TNATA, NPB(NPD), β-NPB, TPD, Spiro-TPD, Spiro-NPB, methylated-NPB, TAPC, HMTPD, TCTA (4,4',4"-tris(N-carbazolyl)triphenylamine), Pani/DBSA (polyaniline/dodecylbenzenesulfonic acid), PEDOT/PSS (poly(3,4-ethylenedioxythiophene)/poly(4-styrenesulfonate)), Pani/CSA (polyaniline/camphor sulfonic acid), Pani/PSS (polyaniline/poly(4-styrenesulfonate)), a compound represented by Formula 201, and a compound represented by Formula 202:

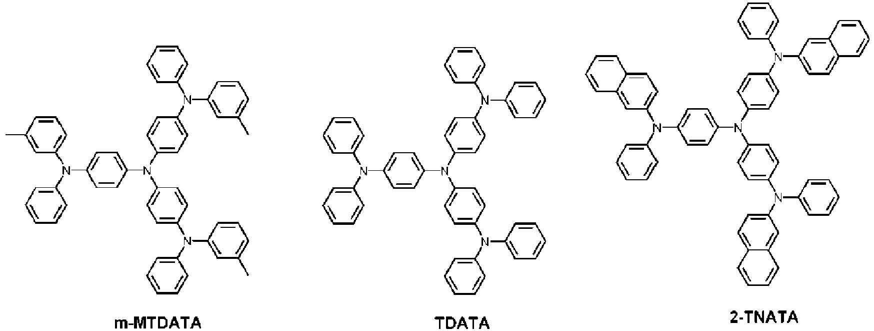

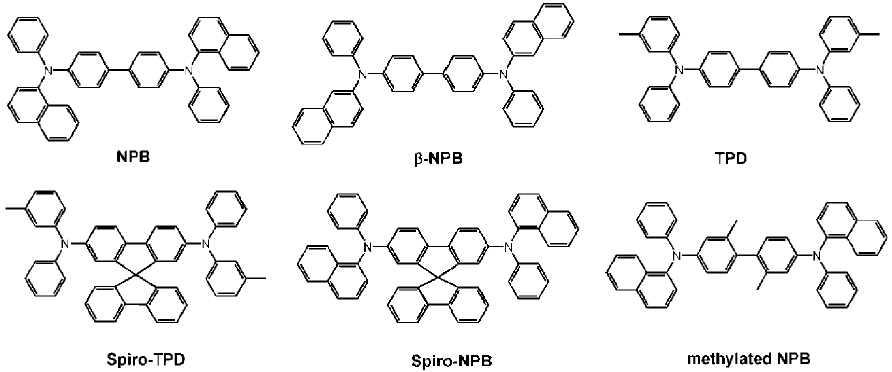

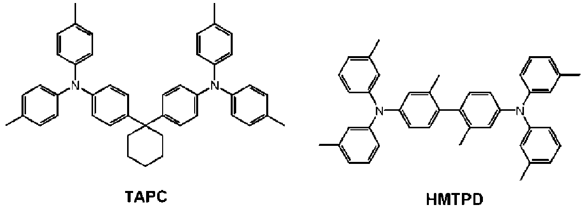

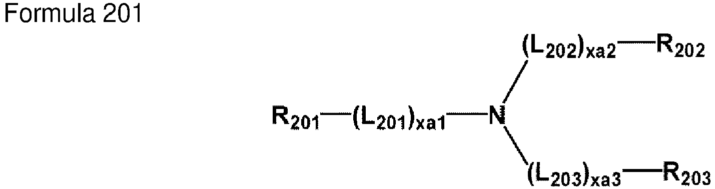

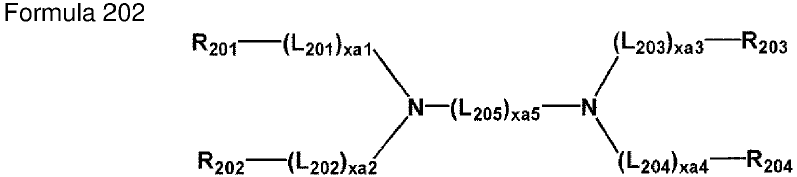

In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e*.*g*. C₆-C₃₂) arylene group, a substituted or unsubstituted C₁-C₆₀ (*e*.*g*. C₁-C₂₀) heteroarylene group, a substituted or unsubstituted divalent non-aromatic condensed polycyclic group, and a substituted or unsubstituted divalent non-aromatic condensed heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e*.*g*. C₆-C₃₂) arylene group, a substituted or unsubstituted C₁-C₆₀ (*e*.*g*. C₁-C₂₀) heteroarylene group, a substituted or unsubstituted divalent non-aromatic condensed polycyclic group, and a substituted or unsubstituted divalent non-aromatic condensed heteropolycyclic group,
xa1 to xa4 may each independently be an integer selected from 0 to 3,
xa5 may be an integer selected from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e*.*g*. C₆-C₃₂) aryl group, a substituted or unsubstituted C₆-C₆₀ (*e.g.* C₆-C₃₂) aryloxy group, a substituted or unsubstituted C₆-C₆₀ (*e.g.* C₆-C₃₂) arylthio group, a substituted or unsubstituted C₁-C₆₀ (*e*.*g*. C₁-C₂₀) heteroaryl group, a substituted or unsubstituted monovalent non-aromatic condensed polycyclic group, and a substituted or unsubstituted monovalent non-aromatic condensed heteropolycyclic group.

For example, in Formula 202, R₂₀₁ and R₂₀₂ may be optionally linked to each other via a single bond, a dimethyl-methylene group, or a diphenyl-methylene group, and R₂₀₃ and R₂₀₄ may be optionally linked to each other via a single bond, a dimethyl-methylene group, or a diphenyl-methylene group.

In one or more embodiments, in Formulae 201 and 202,
L₂₀₁ to L₂₀₅ may each independently be selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, dibenzosilolylene group, and a pyridinylene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xa1 to xa4 may each independently be 0, 1, or 2.

In one or more embodiments, xa5 may be 1, 2, 3, or 4.

In one or more embodiments, R₂₀₁ to R₂₀₄ and Q₂₀₁ may each independently be selected from the group consisting of:
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ are the same as described above.

In one or more embodiments, at least one selected from R₂₀₁ to R₂₀₃ in Formula 201 may each independently be selected from the group consisting of:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments are not limited thereto.

In one or more embodiments, in Formula 202, i) R₂₀₁ and R₂₀₂ may be linked to each other via a single bond, and/or ii) R₂₀₃ and R₂₀₄ may be linked to each other via a single bond.

In one or more embodiments, at least one selected from R₂₀₁ to R₂₀₄ in Formula 202 may be selected from the group consisting of:
a carbazolyl group; and
a carbazolyl group, substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments are not limited thereto.

The compound represented by Formula 201 may be represented by Formula 201A:

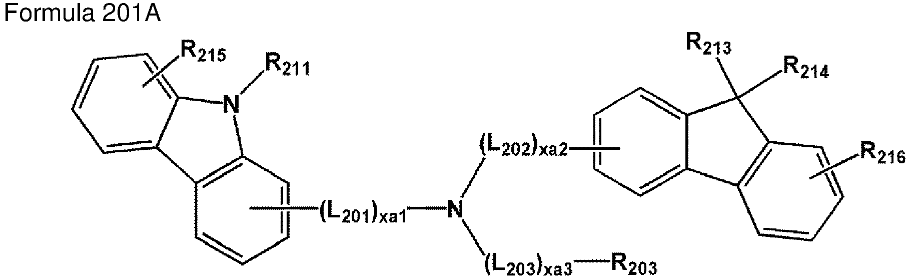

In one embodiment, the compound represented by Formula 201 may be represented by Formula 201A(1) below, but embodiments of the present disclosure are not limited thereto:

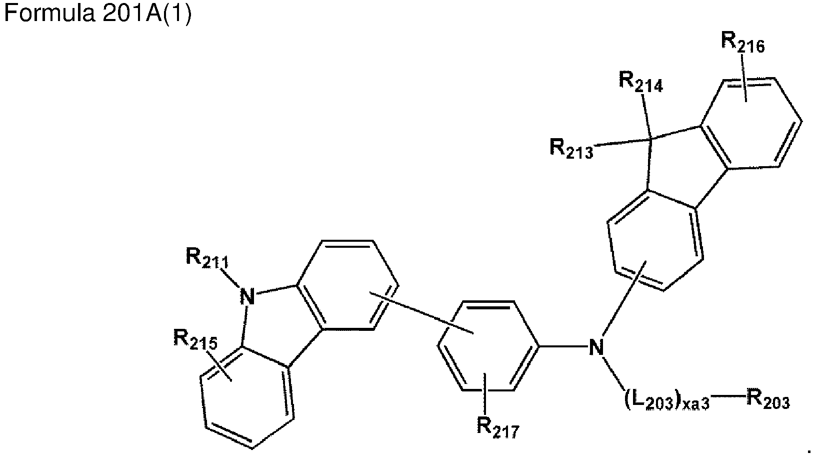

In one embodiment, the compound represented by Formula 201 may be represented by Formula 201A-1 below, but embodiments of the present disclosure are not limited thereto:

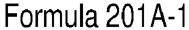

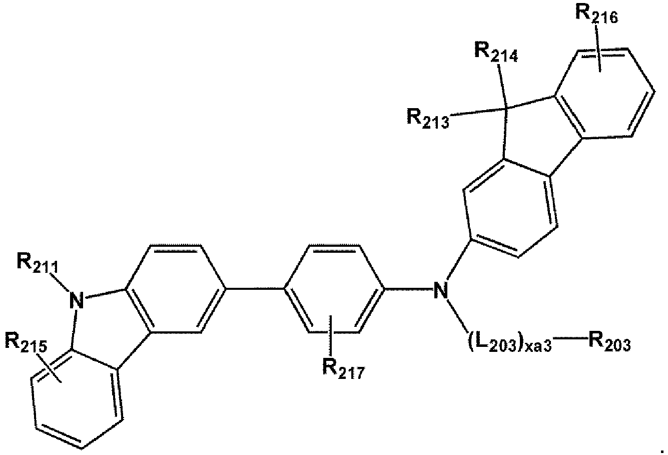

In one embodiment, the compound represented by Formula 202 may be represented by Formula 202A:

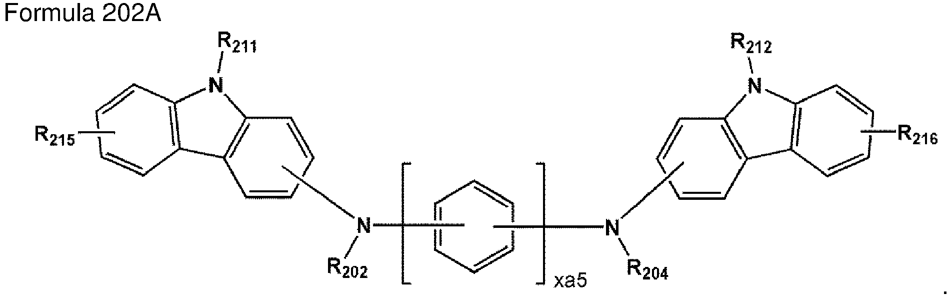

In one embodiment, the compound represented by Formula 202 may be represented by Formula 202A-1:

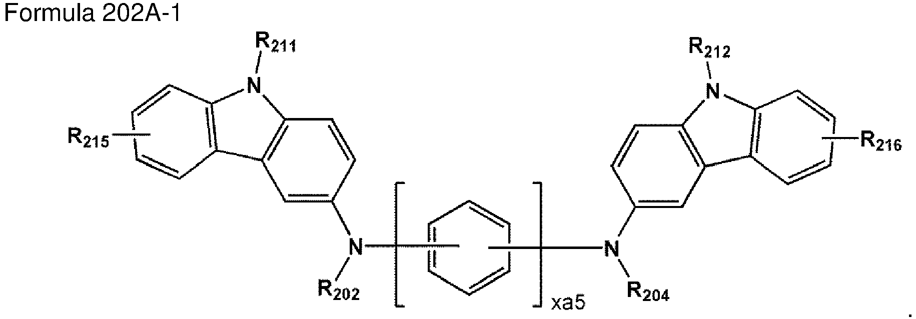

In Formulae 201A, 201A(1), 201A-1, 202A, and 202A-1,
L₂₀₁ to L₂₀₃, xa1 to xa3, xa5, and R₂₀₂ to R₂₀₄ are the same as described above,
R₂₁₁ and R₂₁₂ may each independently be the same as described in connection with R₂₀₃.

R₂₁₃ to R₂₁₇ may each independently be selected from hydrogen, deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a tetraphenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from Compounds HT1 to HT39, but embodiments of the present disclosure are not limited thereto:

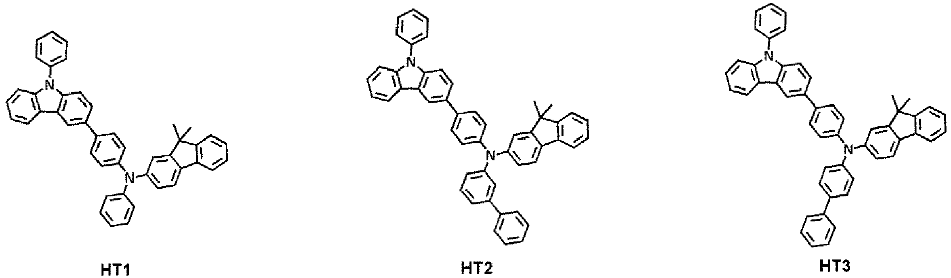

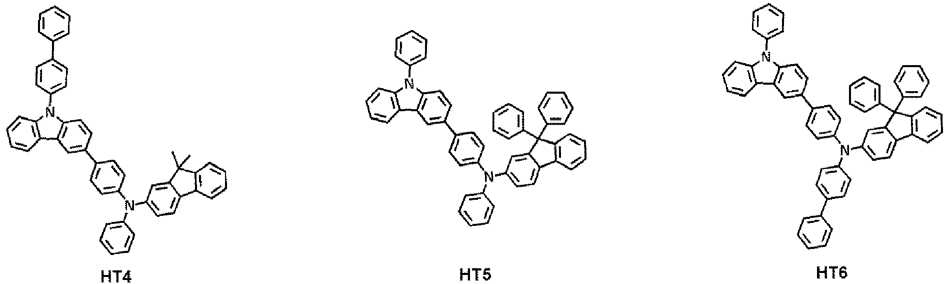

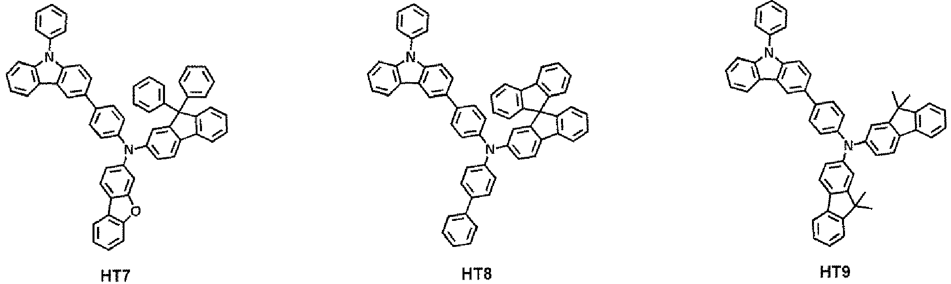

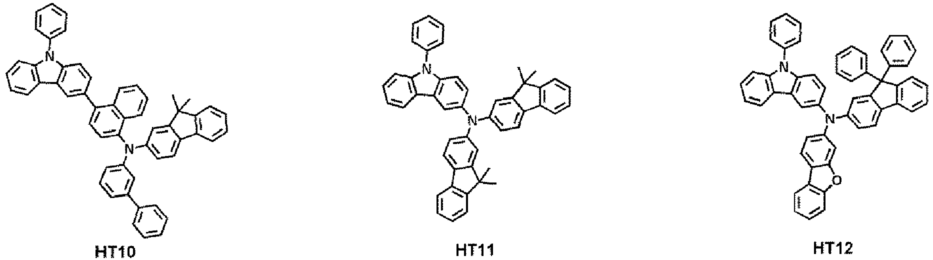

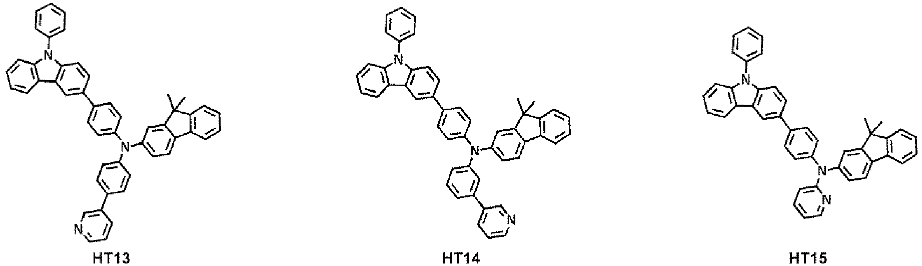

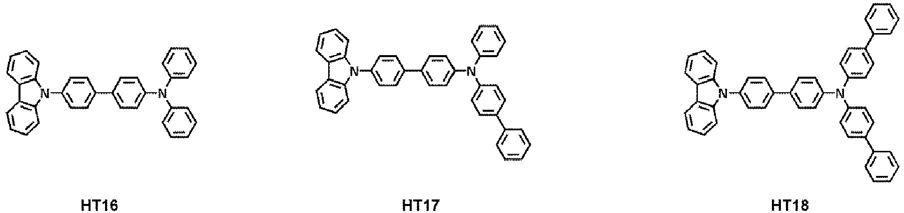

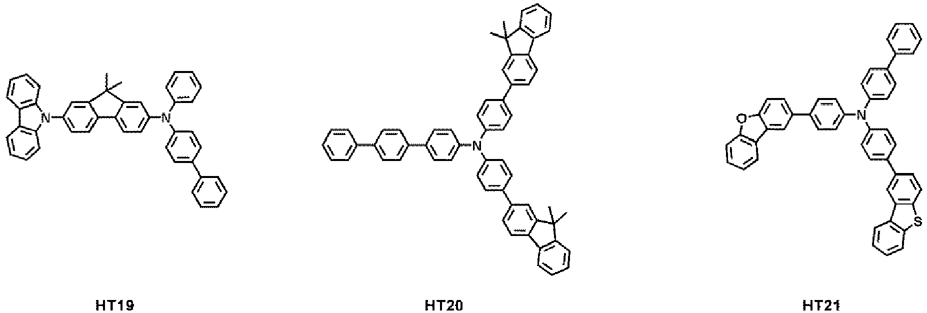

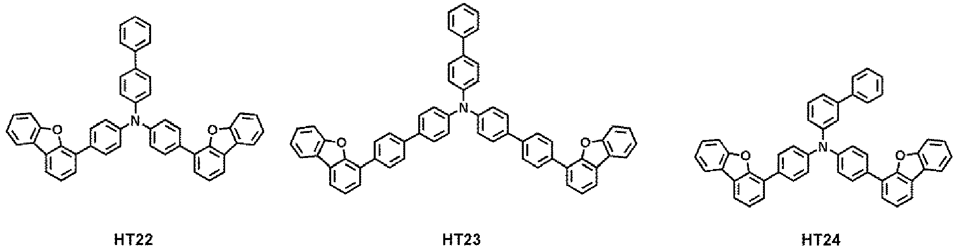

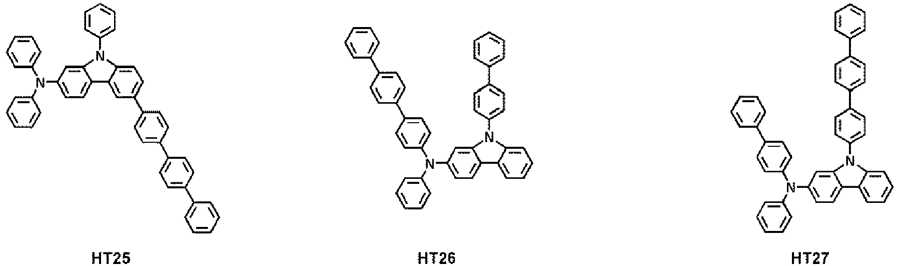

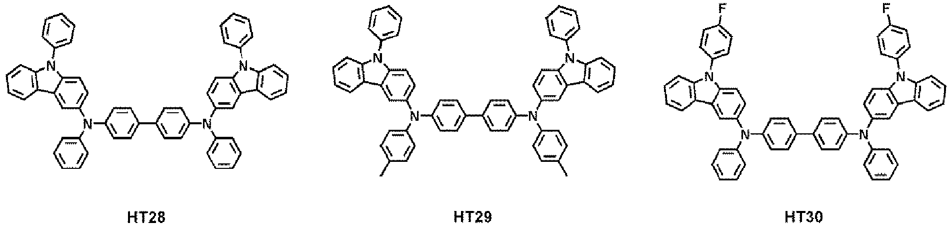

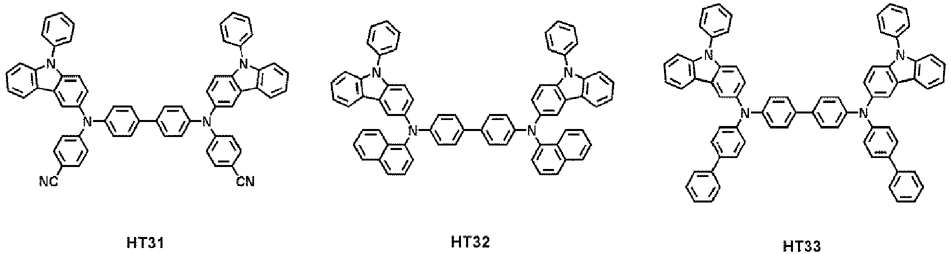

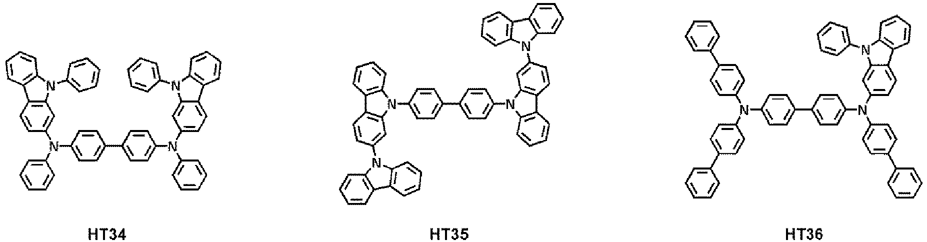

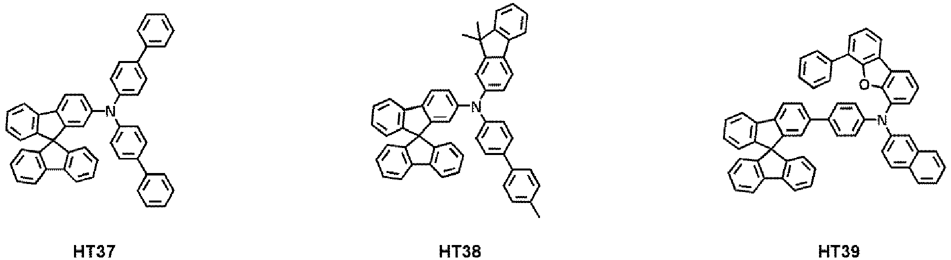

A thickness of the hole transport region may be in a range of about 10 nm (100 Å) to about 1000 nm (10,000 Å), for example, about 10 nm (100 Å) to about 700 nm (7000 Å), about 10 nm (100 Å) to about 500 nm (5000 Å), about 10 nm (100 Å) to about 300 nm (3000 Å) or about 10 nm (100 Å) to about 100 nm (1,000 Å). When the hole transport region includes at least one of a hole injection layer and a hole transport layer, the thickness of the hole injection layer may be in a range of about 10 nm (100 Å) to about 900 nm (9,000 Å), for example, about 10 nm (100 Å) to about 900 nm (9,000 Å), about 10 nm (100 Å) to about 700 nm (7,000 Å), about 10 nm (100 Å) to about 500 nm (5,000 Å), about 10 nm (100 Å) to about 300 nm (3,000 Å) or about 10 nm (100 Å) to about 100 nm (1,000 Å) (e.g. about 10 nm (100 Å) to about 30 nm (300 Å)), and the thickness of the hole transport layer may be in a range of about 5 nm (50 Å) to about 200 nm (2,000 Å), and for example, about 10 nm (100 Å) to about 150 nm (1,500 Å) (e.g. about 10 nm (100 Å) to about 100 nm (1,000 Å), about 20 nm (200 Å) to about 80 nm (800 Å), about 30 nm (300 Å) to about 80 nm (800 Å), about 50 nm (500 Å) to about 80 nm (800 Å), about 60 nm (600 Å) to about 80 nm (800 Å) or about 60 nm (600 Å) to about 70 nm (700 Å)). When the hole transport region includes an emission auxiliary layer, a thickness of the emission auxiliary layer may be in a range of about 5 nm (50 Å) to about 30 nm (300 Å), and in some embodiments, about 5 nm (50 Å) to about 20 nm (200 Å). When thicknesses of the hole transport region, the hole injection layer, the hole transport layer, and the emission auxiliary layer are within these ranges, satisfactory transporting characteristics may be obtained without a substantial increase in driving voltage.

The emission auxiliary layer may increase light-emission efficiency by compensating for an optical resonance distance according to the wavelength of light emitted from an emission layer, and the electron blocking layer may block the flow of electrons from an electron transport region. The emission auxiliary layer and the electron blocking layer may include the materials as described above.

### p-dopant

The hole transport region may further include, in addition to these materials described above, a charge-generation material for the improvement of conductive properties. The charge-generation material may be homogeneously or non-homogeneously dispersed in the hole transport region.

The charge-generation material may be, for example, a p-dopant.

The p-dopant may include at least one selected from a quinone derivative, a metal oxide, and a cyano group-containing compound, but embodiments are not limited thereto.

For example, the p-dopant may, in addition to the third compound represented by one selected from Formulae 3-1 to 3-3, include at least one metal oxide selected from tungsten oxide and molybdenum oxide, but embodiments are not limited thereto.

When the third compound represented by one selected from Formulae 3-1 to 3-3 is utilized as a p-dopant, the third compound may be included in a concentration of about 0.5 to about 20 wt% in the hole transport region. When the concentration of the third compound included in the hole transport region is less than 0.5 wt%, hole mobility may not be sufficiently improved, and when the concentration of the third compound included in the hole transport region exceeds 20 wt%, due to high polarity of the third compound, intermolecular interaction may be too strong, leading to a decrease in the lifespan of an organic light-emitting device.

### Emission layer in organic layer 150

When the organic light-emitting device 10 is a full color organic light-emitting device, the emission layer may be patterned into a red emission layer, a green emission layer, or a blue emission layer, according to a sub pixel. In one or more embodiments, the emission layer may have a stacked structure of two or more layers selected from a red emission layer, a green emission layer, and a blue emission layer, in which the two or more layers contact each other or are separated from each other. In one or more embodiments, the emission layer may include two or more materials selected from a red-light emission material, a green-light emission material, and a blue-light emission material, in which the two or more materials are mixed with each other in a single layer to emit white light.

In one embodiment, the emission layer of the organic light-emitting device 10 may be a first color light-emission layer,
the organic layer may further include at least one second color light-emission layer;
a first color light of the first color light-emission layer and a second color light of the second color light-emission layer may be identical to or different from each other; and
the first color light and the second color light may be emitted as mixed light.

Herein, the phrase "the first color light is different from the second color light" refers to that a maximum luminance wavelength of the first color light is different from a maximum luminance wavelength of the second color light.

For example, the mixed light may be white light, but embodiments of the present disclosure are not limited thereto.

In one or more embodiments, the emission layer of the organic light-emitting device 10 may be a first color light-emission layer;
the organic layer may further include at least one second color light-emission layer and at least one third color light-emission layer;
the first color light, the second color light, and a third color light of the third color light-emission layer may be identical to or different from one another; and
the first color light, the second color light, and the third color light may be emitted as mixed light.

Herein, the phrase "the first color light, the second color light, and the third color light are different from one another" refers to that a maximum luminance wavelength of the first color light, a maximum luminance wavelength of the second color light, a maximum luminance wavelength of the third color light are different from one another.

For example, the mixed light may be white light, but embodiments of the present disclosure are not limited thereto.

The emission layer may include a host and a dopant. The dopant may include at least one selected from a phosphorescent dopant and a fluorescent dopant.

An amount of the dopant in the emission layer may be, in general, in a range of about 0.01 to about 15 parts by weight based on 100 parts by weight of the host, but embodiments of the present disclosure are not limited thereto.

A thickness of the emission layer may be in a range of about 10 nm (100 Å) to about 100 nm (1,000 Å), for example, about 20 nm (200 Å) to about 60 nm (600 Å) or about 20 nm (200 Å) to about 40 nm (400 Å) (*e*.*g*. about 30 nm (300 Å)). When the thickness of the emission layer is within this range, excellent light-emission characteristics may be obtained without a substantial increase in driving voltage.

### Host in emission layer

The host may include the first compound represented by Formula 1.

### Fluorescent dopant in emission layer

The fluorescent dopant may include an arylamine compound or styrylamine compound.

The fluorescent dopant may include a compound represented by Formula 501 below.

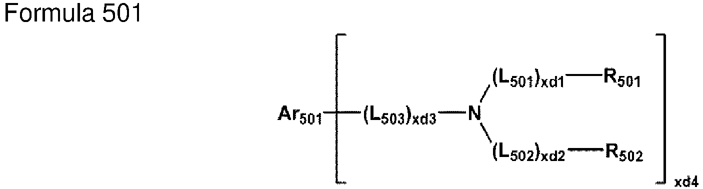

In Formula 501,
Ar₅₀₁ may be a substituted or unsubstituted C₅-C₆₀ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xd1 to xd3 may each independently be an integer of 0 to 3;
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group,
xd4 may be an integer of 1 to 6.

For example, Ar₅₀₁ may be a substituted or unsubstituted C₅-C₃₀ carbocyclic group or a substituted or unsubstituted C₁-C₂₀ heterocyclic group.

In one embodiment, Ar₅₀₁ in Formula 501 may be selected from the group consisting of:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

For, example, L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group.

In one or more embodiments, L₅₀₁ to L₅₀₃ in Formula 501 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, dibenzosilolylene group, and a pyridinylene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

For example, R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, and a substituted or unsubstituted monovalent non-aromatic condensed heteropolycyclic group.

In one or more embodiments, R₅₀₁ and R₅₀₂ in Formula 501 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and -Si(Q₃₁)(Q₃₂)(Q₃₃),
wherein Q₃₁ to Q₃₃ may each be selected from a C₁-C₁₀ alkyl group, a C₁-C₁₀ alkoxy group, a phenyl group, a biphenyl group, a terphenyl group, and a naphthyl group.

In one or more embodiments, xd4 in Formula 501 may be 2, but embodiments of the present disclosure are not limited thereto.

For example, the fluorescent dopant may be selected from Compounds FD1 to FD22:

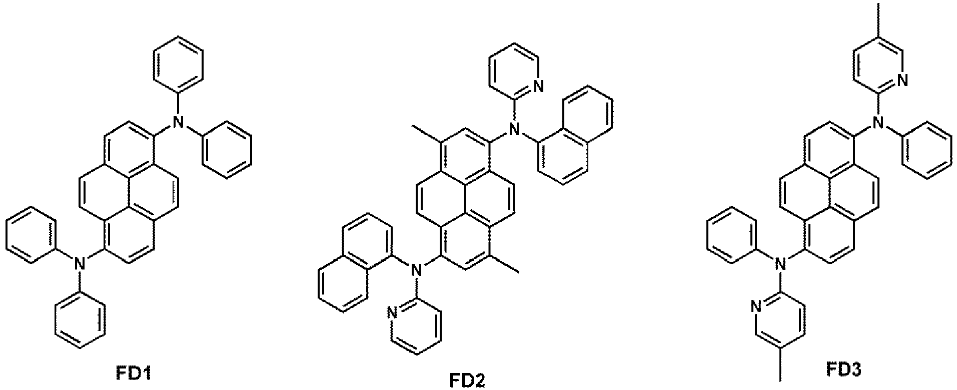

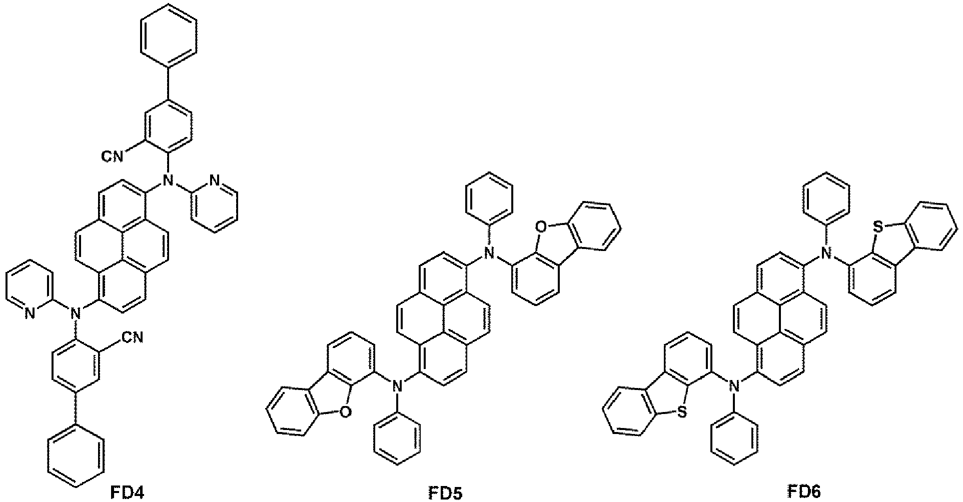

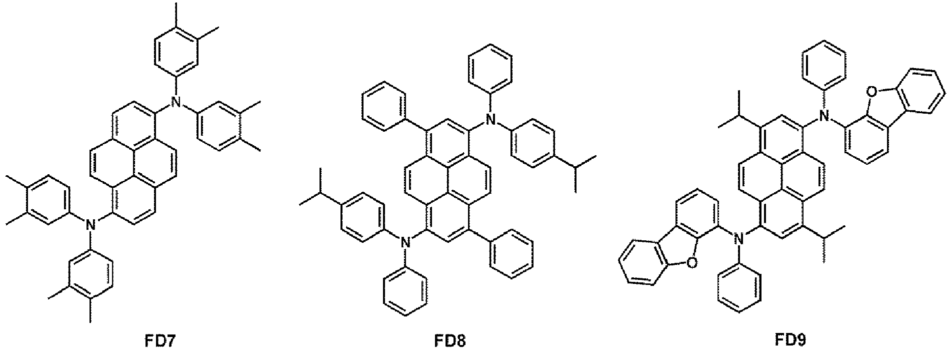

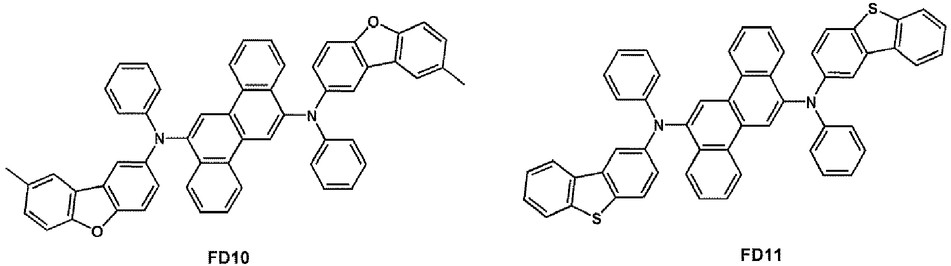

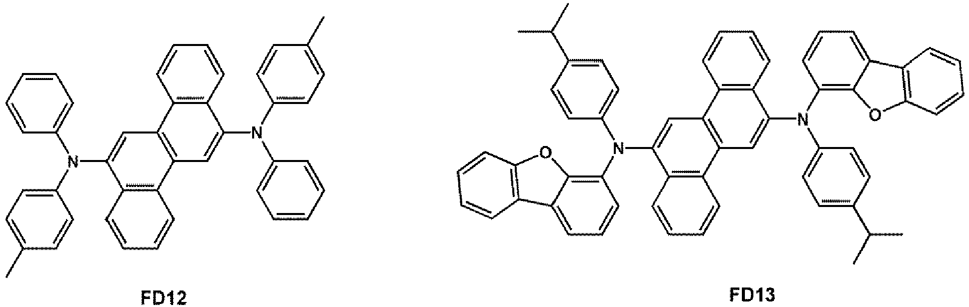

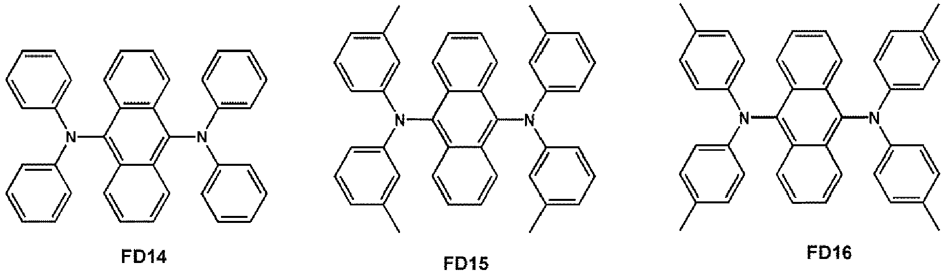

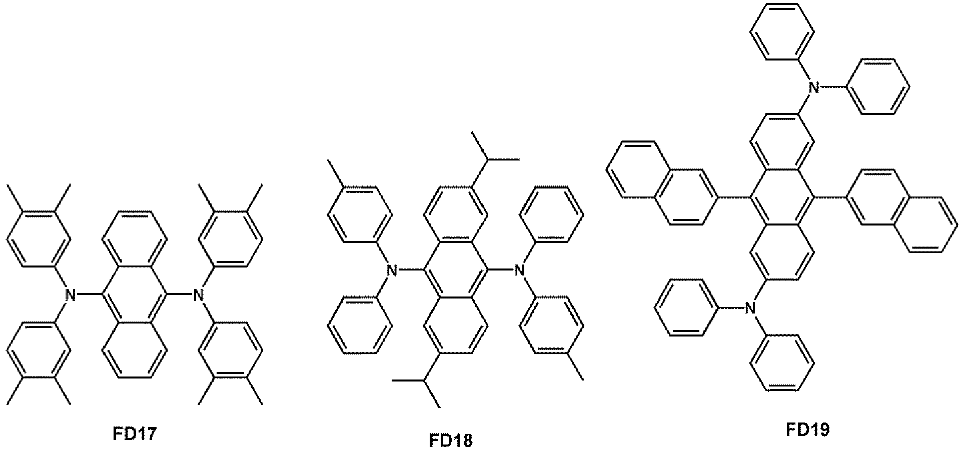

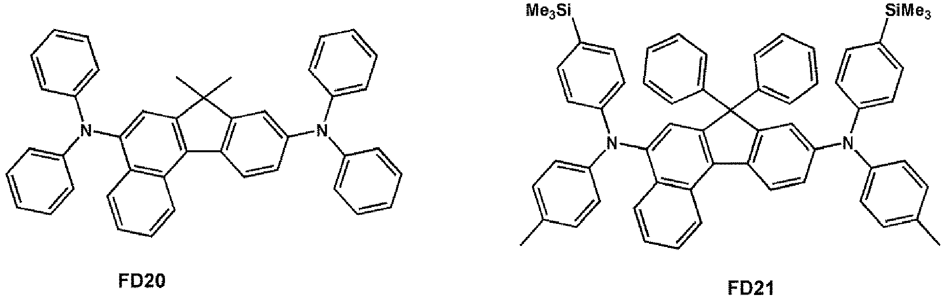

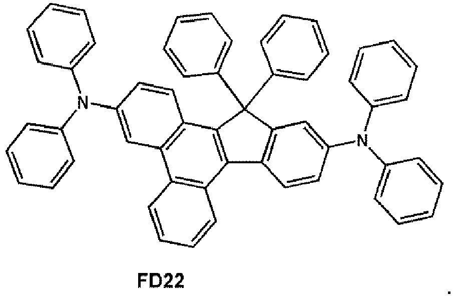

In one or more embodiments, the fluorescent dopant may be selected from the following compounds, but embodiments of the present disclosure are not limited thereto.

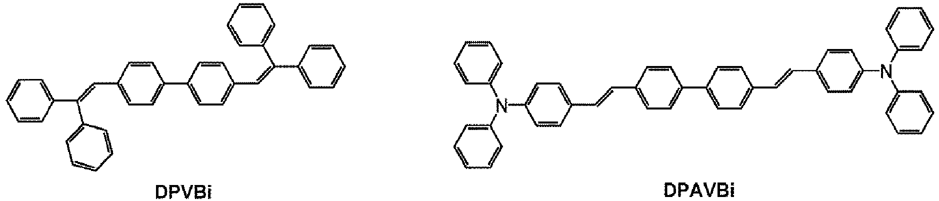

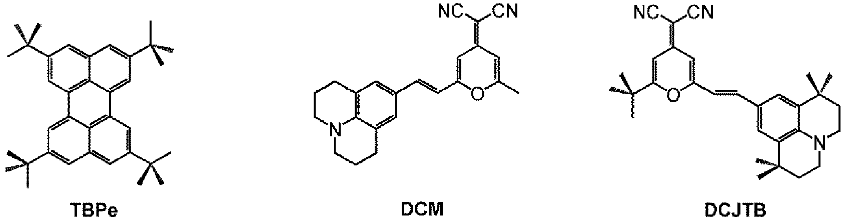

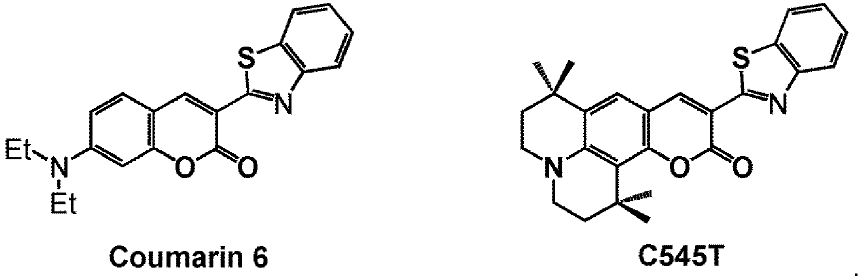

### Electron transport region in organic layer 150

The electron transport region may have i) a single-layered structure including a single layer including a single material, ii) a single-layered structure including a single layer including a plurality of different materials, or iii) a multi-layered structure having a plurality of layers including a plurality of different materials.

The electron transport region may include at least one selected from a buffer layer, a hole blocking layer, an electron control layer, an electron transport layer, and an electron injection layer, but embodiments of the present disclosure are not limited thereto.

For example, the electron transport region may have a structure of electron transport layer/electron injection layer, a structure of hole blocking layer/electron transport layer/electron injection layer, a structure of electron control layer/electron transport layer/electron injection layer, or a structure of buffer layer/electron transport layer/electron injection layer, wherein the layers of these structures are sequentially stacked in each stated order on an emission layer. However, embodiments of the structure of the electron transport region are not limited thereto.

The electron transport region (for example, a buffer layer, a hole blocking layer, an electron control layer, or an electron transport layer in the electron transport region) may include a metal-free compound containing at least one π electron-depleted nitrogen-containing ring.

The "π electron-depleted nitrogen-containing ring" indicates a C₁-C₆₀ heterocyclic group (*e*.*g*. a C₁-C₃₀ heterocyclic group) having at least one *-N=*' moiety as a ring-forming moiety.

For example, the "π electron-depleted nitrogen-containing ring" may be i) a 5-membered to 7-membered hetero monocyclic group having at least one *-N=*' moiety, ii) a heteropolycyclic group in which two or more 5-membered to 7-membered hetero monocyclic groups each having at least one *-N=*' moiety are condensed with each other, or iii) a heteropolycyclic group in which at least one of 5-membered to 7-membered hetero monocyclic groups, each having at least one *-N=*' moiety, is condensed with at least one C₅-C₆₀ carbocyclic group.

Examples of the π electron-depleted nitrogen-containing ring include an imidazole, a pyrazole, a thiazole, an isothiazole, an oxazole, an isoxazole, a pyridine, a pyrazine, a pyrimidine, a pyridazine, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzimidazole, an isobenzothiazole, a benzoxazole, an isobenzoxazole, a triazole, a tetrazole, an oxadiazole, a triazine, a thiadiazol, an imidazopyridine, an imidazopyrimidine, and an azacarbazole, but embodiments of the present disclosure are not limited thereto.

For example, the electron transport region may include a compound represented by Formula 601:

Formula 601 [Ar₆₀₁]ₓₑ₁₁-[(L₆₀₁)ₓₑ₁-R₆₀₁]xe₂₁.

In Formula 601,
Ar₆₀₁ may be a substituted or unsubstituted C₅-C₆₀ carbocyclic group or a substituted or unsubstituted C₁-C₆₀ heterocyclic group,
xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group;
xe1 may be an integer selected from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂),
Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe21 may be an integer selected from 1 to 5.

In one embodiment, at least one of Ar₆₀₁(s) in the number of xe11 and/or at least one of R₆₀₁(s) in the number of xe21 may include the π electron-depleted nitrogen-containing ring.

For example, Ar₆₀₁ may be a substituted or unsubstituted C₅-C₃₀ carbocyclic group or a substituted or unsubstituted C₁-C₂₀ heterocyclic group.

In one embodiment, ring Ar₆₀₁ in Formula 601 may be selected from the group consisting of:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazol group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazol group, an imidazopyridine group, an imidazopyrimidine group, and an azacarbazole group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is two or more, two or more Ar₆₀₁(s) may be linked to each other via a single bond.

In one or more embodiments, Ar₆₀₁ in Formula 601 may be an anthracene group.

In one or more embodiments, a compound represented by Formula 601 may be represented by Formula 601-1:

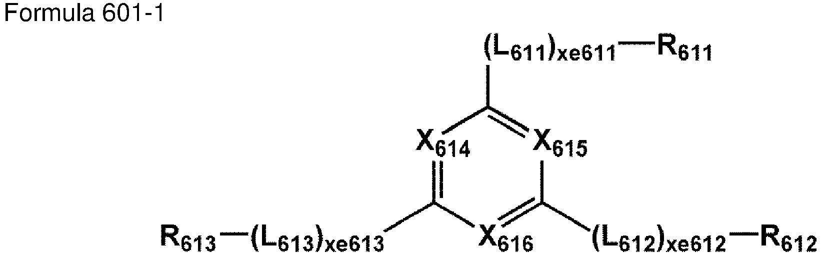

In Formula 601-1,
X614 may be N or C(R₆₁₄), X615 may be N or C(R₆₁₅), X616 may be N or C(R616), and at least one selected from X614 to X616 may be N,
L₆₁₁ to L₆₁₃ may be each independently the same as described in connection with L₆₀₁,
xe611 to xe613 may be each independently the same as described in connection with xe1,
R₆₁₁ to R₆₁₃ may be each independently the same as described in connection with R₆₀₁,
R₆₁₄ to R₆₁₆ may each independently be selected from hydrogen, deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

For example, L₆₀₁ and L₆₁₁ to L₆₁₃ in Formulae 601 and 601-1 may each independently be selected from: a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group.

In one embodiment, L₆₀₁ and L₆₁₁ to L₆₁₃ in Formulae 601 and 601-1 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
but embodiments are not limited thereto.

In one or more embodiments, xe1 and xe611 to xe613 in Formulae 601 and 601-1 may each independently be 0, 1, or 2.

For example, R₆₀₁ and R₆₁₁ to R₆₁₃ in Formulae 601 and 601-1 may each independently be selected from: a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂).

In one or more embodiments, R₆₀₁ and R₆₁₁ to R₆₁₃ in Formula 601 and 601 - 1 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁), and -P(=O)(Q₆₀₁)(Q₆₀₂),
wherein Q₆₀₁ and Q₆₀₂ are the same as described above.

The electron transport region may include at least one compound selected from Compounds ET1 to ET36, but embodiments of the present disclosure are not limited thereto:

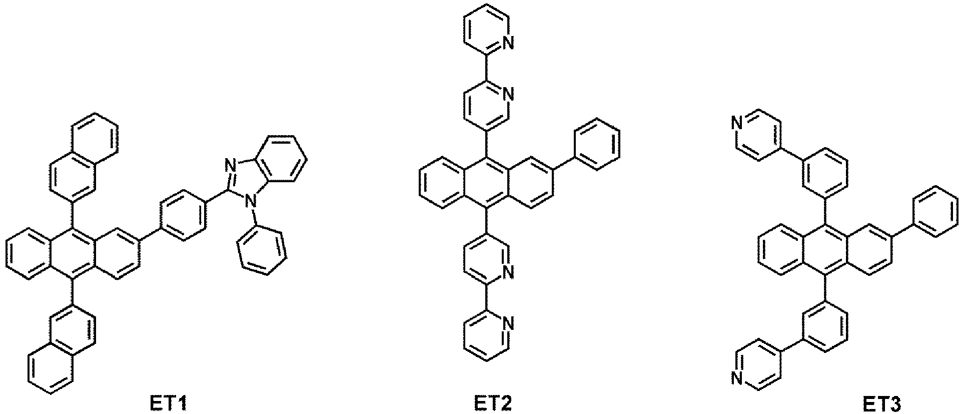

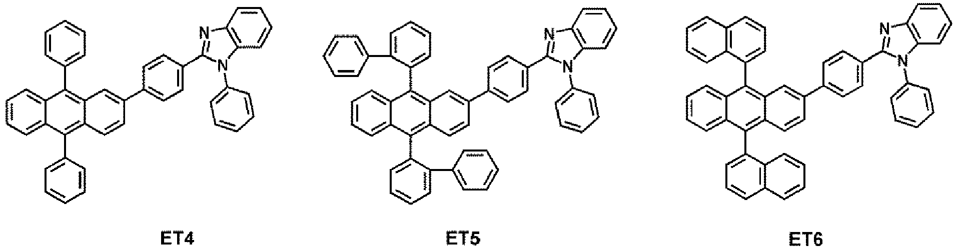

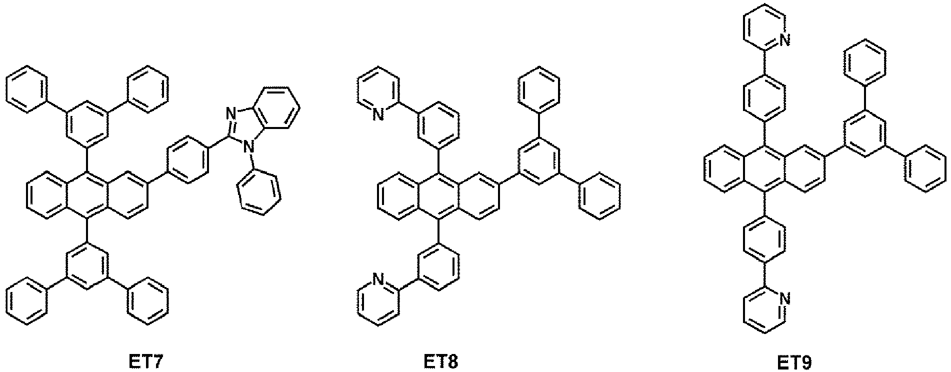

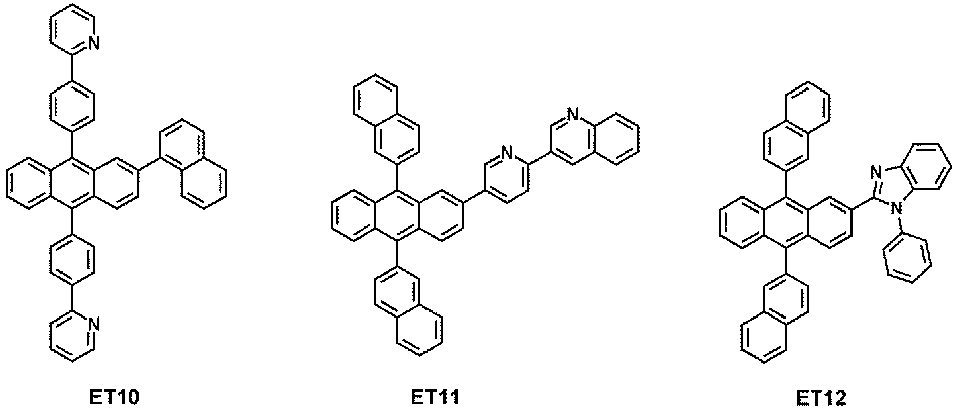

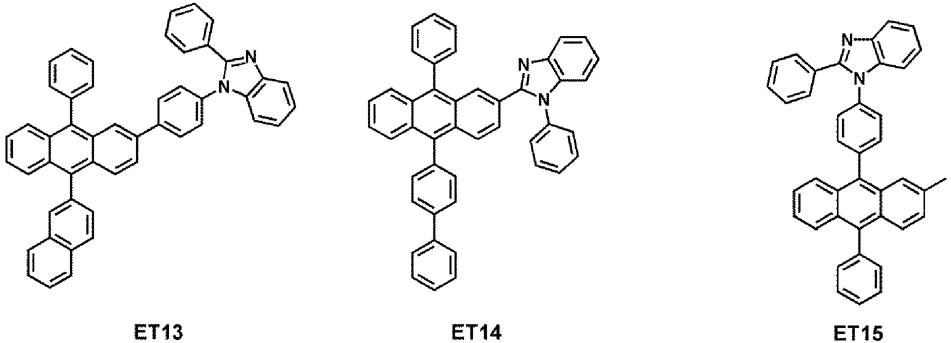

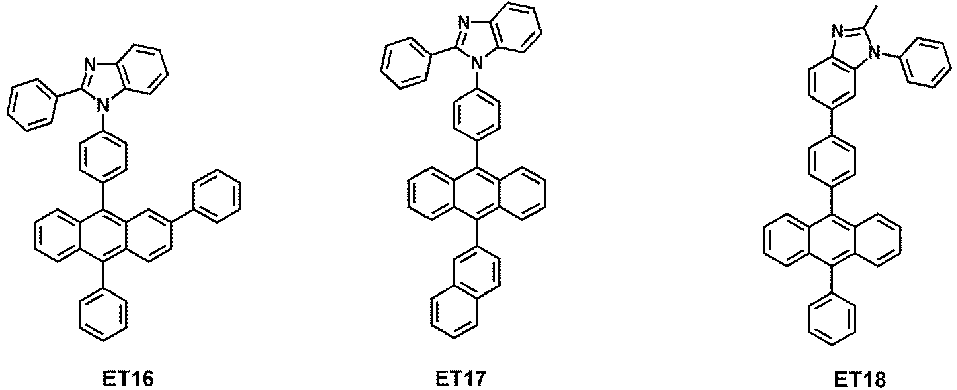

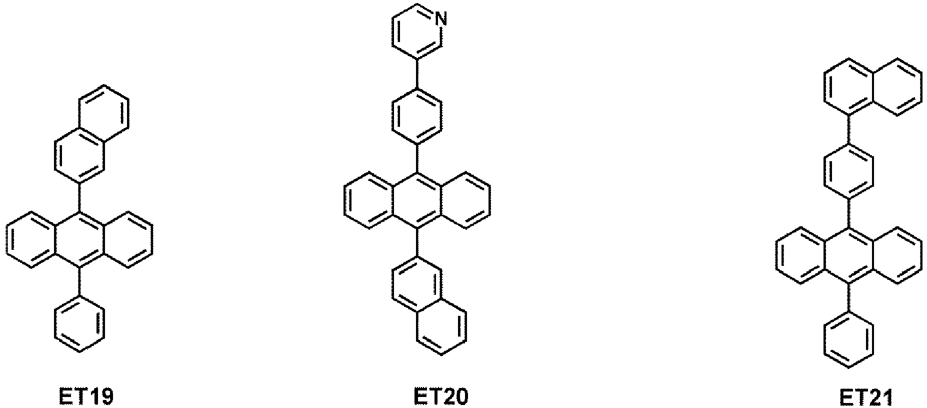

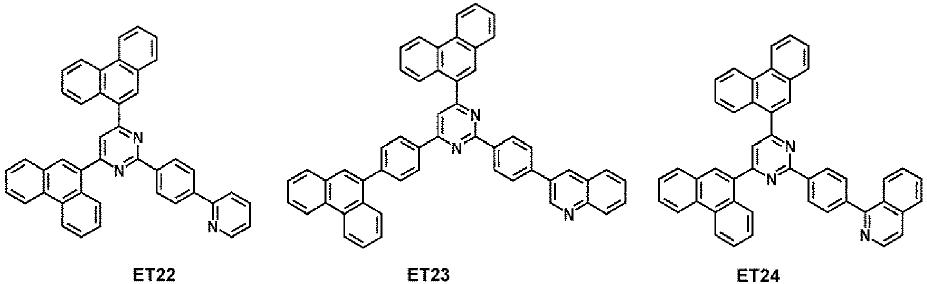

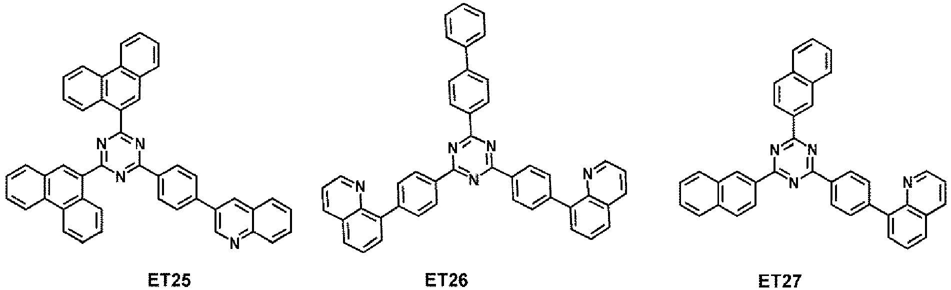

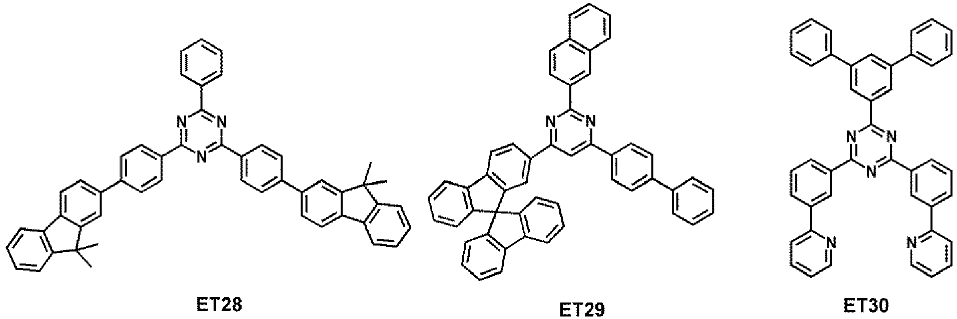

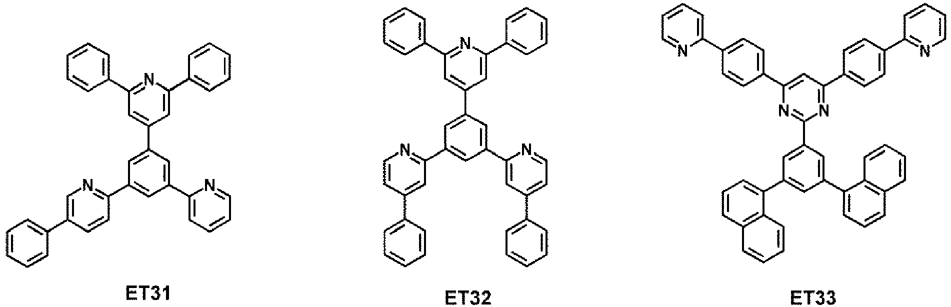

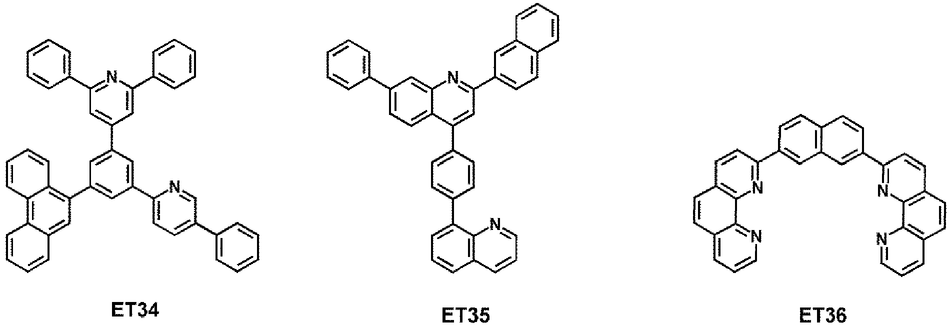

In one or more embodiments, the electron transport region may include at least one selected from 2,9-dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-tert-butylphenyl)-4-phenyl-4H-1,2,4-triazole (TAZ), and NTAZ.

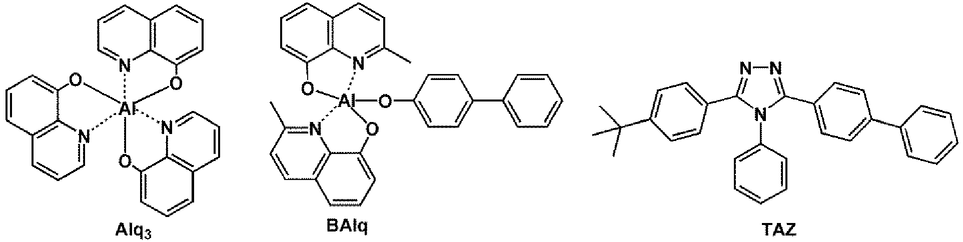

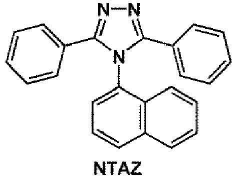

The thickness of the buffer layer, the hole blocking layer, or the electron control layer may each independently be in a range of about 20 Å to about 1,000Å, for example, about 2 nm (20 **Å**) to about 70 nm (700 Å), about 2 nm (20 **Å**) to about 50 nm (500 **Å**), about 2 nm (20 **Å**) to about 40 nm (400 **Å**), about 3 nm (30 **Å**) to about 40 nm (400 **Å**), or about 3 nm (30 Å) to about 30 nm (300 Å). When the thicknesses of the buffer layer, the hole blocking layer, and the electron control layer are within these ranges, the buffer layer, the hole blocking layer may have excellent hole blocking characteristics or electron control characteristics without a substantial increase in driving voltage.

A thickness of the electron transport layer may be in a range of about 10 nm (100 Å) to about 100 nm (1,000 Å), for example, about 10 nm (100 **Å**) to about 70 nm (700 **Å**), about 10 nm (100 **Å**) to about 60 nm (600 **Å**) about 15 nm (150 **Å**) to about 60 nm (600 Å) or about 15 nm (150 Å) to about 50 nm (500 Å). When the thickness of the electron transport layer is within the ranges described above, the electron transport layer may have satisfactory electron transporting characteristics without a substantial increase in driving voltage.

The electron transport region (for example, the electron transport layer in the electron transport region) may further include, in addition to the materials described above, a metal-containing material.

The metal-containing material may include alkali metal, alkali-earth metal, rare-earth metal, alkali metal compound, alkali-earth metal compound, rare-earth metal compound, alkali metal complex, alkali-earth metal complex, rare-earth metal complex, or a combination thereof.

The alkali metal may be selected from Li, Na, K, Rb, and Cs. In one embodiment, the alkali metal may be Li, Na, or Cs. In one or more embodiments, the alkali metal may be Li or Cs, but embodiments of the present disclosure are not limited thereto.

The alkali-earth metal may be selected from Mg, Ca, Sr, and Ba.

The rare-earth metal may be selected from Sc, Y, Ce, Tb, Yb, Gd, and Tb.

The alkali metal compound, the alkali-earth metal compound, and the rare-earth metal compound may be selected from oxides and halides (for example, fluorides, chlorides, bromides, or iodides) of the alkali metal, the alkali-earth metal and rare-earth metal.

The alkali metal compound may be selected from alkali metal oxides, such as Li₂O, Cs₂O, and/or K₂O, and alkali metal halides, such as LiF, NaF, CsF, KF, Lil, Nal, Csl, and/or Kl. In one embodiment, the alkali metal compound may be selected from LiF, Li₂O, NaF, Lil, Nal, Csl, and Kl, but embodiments of the present disclosure are not limited thereto.

The alkali-earth metal compound may be selected from alkali-earth metal compounds, such as BaO, SrO, CaO, BaₓSr₁₋ₓO(0<x<1), and/or BaₓCa₁₋ₓO(0<x<1). In one embodiment, the alkali earth-metal compound may be selected from BaO, SrO, and CaO, but embodiments of the present disclosure are not limited thereto.

The rare-earth metal compound may be selected from YbF₃, ScF₃, ScO₃, Y₂O₃, Ce₂O₃, GdF₃, and TbF₃. In one embodiment, the rare-earth metal compound may be selected from YbF₃, ScF₃, TbF₃, Ybl₃, Scl₃, and Tbl₃, but embodiments of the present disclosure are not limited thereto.

The alkali metal complex may include a metal ion selected from an Li ion, a Na ion, a K ion, a Rb ion, and a Cs ion, and the alkali-earth metal complex may include a metal ion selected from a Be ion, a Mg ion, a Ca ion, an Sr ion, and a Ba ion. A ligand coordinated with the metal ion of the alkali metal complex or the alkali earth-metal complexmay be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazol, a hydroxy phenylpyridine, a hydroxy phenylbenzimidazole, a hydroxy phenylbenzothiazole, a bipyridine, a phenanthroline, and a cyclopentadiene, but embodiments of the present disclosure are not limited thereto.

For example, the metal-containing material may include a Li complex. The Li complex may include, for example, Compound ET-D1 (lithium quinolate, LiQ) or ET-D2.

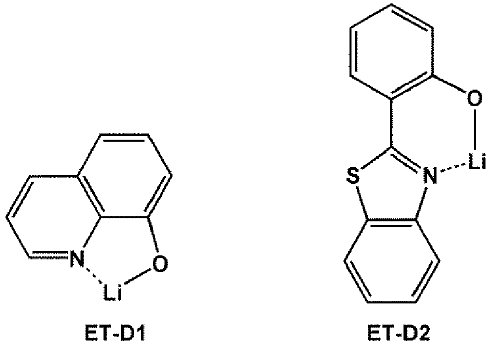

The electron transport region may include an electron injection layer that facilitates injection of electrons from the second electrode 190. The electron injection layer may directly contact the second electrode 190.

The electron injection layer may have i) a single-layered structure including a single layer including a single material, ii) a single-layered structure including a single layer including a plurality of different materials, or iii) a multi-layered structure having a plurality of layers including a plurality of different materials.

The electron injection layer may include alkali metal, alkali-earth metal, rare-earth metal, alkali metal compound, alkali-earth metal compound, rare-earth metal compound, alkali metal complex, alkali-earth metal complex, rare-earth metal complex, or a combination thereof.

The alkali metal, the alkali-earth metal, and the rare-earth metal may be the same as those alkali metals, alkali-earth metals, and rare-earth metals described above, but embodiments of the present disclosure are not limited thereto.

The alkali metal compound, the alkali-earth metal compound, and the rare-earth metal compound may be the same as those alkali metal compounds, alkali-earth metal compounds, and rare-earth metal compounds, but embodiments of the present disclosure are not limited thereto.

The alkali metal complex, the alkali-earth metal complex, and the rare-earth metal complex may include an ion of alkali metal, alkali-earth metal, and rare-earth metal as described above, and a ligand coordinated with a metal ion of the alkali metal complex, the alkali-earth metal complex, and the rare-earth metal complex may each independently be selected from hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazole, hydroxy phenylpyridine, hydroxy phenylbenzimidazole, hydroxy phenylbenzothiazole, bipyridine, and a phenanthroline and cyclopentadiene, but embodiments of the present disclosure are not limited thereto.

The electron injection layer may include (e.g., consist of) alkali metal, alkali-earth metal, rare-earth metal, alkali metal compound, alkali-earth metal compound, rare-earth metal compound, alkali metal complex, alkali-earth metal complex, rare-earth metal complex or a combination thereof, as described above. In one or more embodiments, the electron injection layer may further include an organic material. When the electron injection layer further includes an organic material, the alkali metal, the alkali-earth metal, the rare-earth metal, the alkali metal compound, the alkali-earth metal compound, the rare-earth metal compound, the alkali metal complex, the alkali-earth metal complex, the rare-earth metal complex, or the combination thereof may be homogeneously or non-homogeneously dispersed in a matrix including the organic material.

A thickness of the electron injection layer may be in a range of about 0.1 nm (1 Å) to about 10 nm (100 Å), for example, about 0.1 nm (1 Å) to about 9.5 nm (95 Å), about 0.2 nm (2 Å) to about 9.5 nm (95 Å) or about 0.3 nm (3 Å) to about 9 nm (90 Å). For example, a thickness of the electron injection layer may be in the range of about 0.1 nm (1 Å) to about 5 nm (50 Å), about 0.2 nm (2 Å) to about 5 nm (50 Å), about 0.3 nm (3 Å) to about 5 nm (50 Å), about 0.3 nm (3 Å) to about 2 nm (20 Å), about 0.3 nm (3 Å) to about 1.5 nm (15 Å), about 0.5 nm (5 Å) to about 1.5 nm (15 Å), or about 0.8 nm (8 Å) to about 1.2 nm (12 Å) (e.g. about 1 nm (10 Å)). When the thickness of the electron injection layer is within the ranges described above, the electron injection layer may have satisfactory electron injection characteristics without a substantial increase in driving voltage.

### Second electrode 190

The second electrode 190 may be disposed on the organic layer 150 having such a structure. The second electrode 190 may be a cathode that is an electron injection electrode, and in this regard, a material for forming the second electrode 190 may be a material having a low work function, and such a material may be metal, alloy, an electrically conductive compound, or a combination thereof.

The second electrode 190 may include at least one selected from lithium (Li), silver (Ag), magnesium (Mg), aluminium (Al), aluminium-lithium (Al-Li), calcium (Ca), magnesium-indium (Mg-In), magnesium-silver (Mg-Ag), ITO, and IZO, but embodiments of the present disclosure are not limited thereto. The second electrode 190 may be a transmissive electrode, a semi-transmissive electrode, or a reflective electrode.

The second electrode 190 may have a single-layered structure, or a multi-layered structure including two or more layers.

### Description of FIGS. 2 to 4

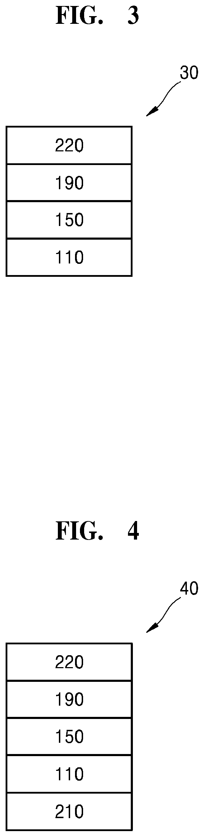

An organic light-emitting device 20 of FIG. 2 includes a first capping layer 210, a first electrode 110, an organic layer 150, and a second electrode 190 which are sequentially stacked in this stated order, an organic light-emitting device 30 of FIG. 3 includes a first electrode 110, an organic layer 150, a second electrode 190, and a second capping layer 220 which are sequentially stacked in this stated order, and an organic light-emitting device 40 of FIG. 4 includes a first capping layer 210, a first electrode 110, an organic layer 150, a second electrode 190, and a second capping layer 220.

Regarding FIGS. 2 to 4, the first electrode 110, the organic layer 150, and the second electrode 190 may be understood by referring to the description presented in connection with FIG. 1.

In the organic layer 150 of each of the organic light-emitting devices 20 and 40, light generated in an emission layer may pass through the first electrode 110, which is a semi-transmissive electrode or a transmissive electrode, and the first capping layer 210 toward the outside, and in the organic layer 150 of each of the organic light-emitting devices 30 and 40, light generated in an emission layer may pass through the second electrode 190, which is a semi-transmissive electrode or a transmissive electrode, and the second capping layer 220 toward the outside.

The first capping layer 210 and the second capping layer 220 may increase external luminescent efficiency according to the principle of constructive interference.

The first capping layer 210 and the second capping layer 220 may each independently be an organic capping layer including an organic material, an inorganic capping layer including an inorganic material, or a composite capping layer including an organic material and an inorganic material.

At least one selected from the first capping layer 210 and the second capping layer 220 may each independently include at least one material selected from carbocyclic compounds, heterocyclic compounds, amine-based compounds, porphyrin derivatives, phthalocyanine derivatives, naphthalocyanine derivatives, alkali metal complexes, and alkali earth-based complexes. The carbocyclic compound, the heterocyclic compound, and the amine-based compound may be optionally substituted with a substituent containing at least one element selected from O, N, S, Se, Si, F, Cl, Br, and I. In one embodiment, at least one selected from the first capping layer 210 and the second capping layer 220 may each independently include an amine-based compound.

In one embodiment, at least one selected from the first capping layer 210 and the second capping layer 220 may each independently include the compound represented by Formula 201 or the compound represented by Formula 202.

In one or more embodiments, at least one selected from the first capping layer 210 and the second capping layer 220 may each independently include a compound selected from Compounds HT28 to HT33 and Compounds CP1 to CP5, but embodiments of the present disclosure are not limited thereto.

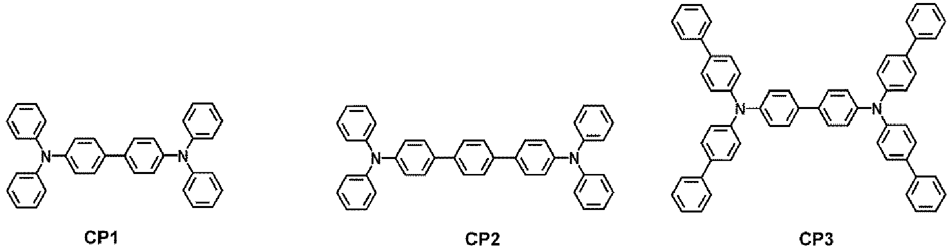

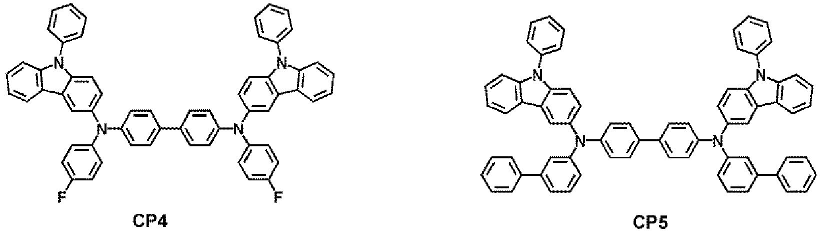

Hereinbefore, the organic light-emitting device according to an embodiment has been described in connection with FIGS. 1-4. However, embodiments are not limited thereto.

Layers constituting the hole transport region, the emission layer, and layers constituting the electron transport region may each independently be formed in a certain region by utilizing one or more suitable methods selected from vacuum deposition, spin coating, casting, langmuir-blodgett (LB) deposition, ink-jet printing, laser-printing, and laser-induced thermal imaging (LITI).

When the respective layers of the hole transport region, the emission layer, and the respective layers of the electron transport region are formed by vacuum deposition, the deposition may be performed at a deposition temperature of about 100°C to about 500°C, at a vacuum degree of about 1.333 x10⁻⁶ (10⁻⁸ torr) to about 0.1333 Pa (10⁻³ torr), and at a deposition rate of about 0.001 nm/sec (0.01 Å/sec) to about 10 nm/sec (100 Å/sec) by taking into account a compound for forming a layer to be deposited, and a structure of the layer to be formed.

When layers constituting the hole transport region, the emission layer, and layers constituting the electron transport region are formed by spin coating, the spin coating may be performed at a coating speed of about 2,000 rpm to about 5,000 rpm and at a heat treatment temperature of about 80°C to 200°C by taking into account a compound to be included in a layer to be formed, and a structure of the layer to be formed.

### General definition of substituents

The term "C₁-C₆₀ alkyl group," as used herein, refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an iso-amyl group, and a hexyl group. The term "C₁-C₆₀ alkylene group," as used herein, refers to a divalent group having substantially the same structure as the C₁-C₆₀ alkyl group. Corresponding definitions apply to other ranges given for the number of carbon atoms in an alkyl/alkylene group.

The term "C₂-C₆₀ alkenyl group," as used herein, refers to a hydrocarbon group having at least one carbon-carbon double bond at one or more positions along the hydrocarbon chain (e.g., in the middle or at the terminus of the C₂-C₆₀ alkyl group), and non-limiting examples thereof include an ethenyl group, a propenyl group, and a butenyl group. The term "C₂-C₆₀ alkenylene group," as used herein, refers to a divalent group having substantially the same structure as the C₂-C₆₀ alkenyl group. Corresponding definitions apply to other ranges given for the number of carbon atoms in an alkenyl/alkenylene group.

The term "C₂-C₆₀ alkynyl group," as used herein, refers to a hydrocarbon group having at least one carbon-carbon triple bond at one or more positions along the hydrocarbon chain (e.g., in the middle or at the terminus of the C₂-C₆₀ alkyl group), and non-limiting examples thereof include an ethynyl group, and a propynyl group. The term "C₂-C₆₀ alkynylene group," as used herein, refers to a divalent group having substantially the same structure as the C₂-C₆₀ alkynyl group. Corresponding definitions apply to other ranges given for the number of carbon atoms in an alkynyl/alkynylene group.

The term "C₁-C₆₀ alkoxy group," as used herein, refers to a monovalent group represented by -OA₁₀₁ (wherein A₁₀₁ is the C₁-C₆₀ alkyl group), and non-limiting examples thereof include a methoxy group, an ethoxy group, and an isopropyloxy group. Corresponding definitions apply to other ranges given for the number of carbon atoms in an alkoxy group.

The term "C₃-C₁₀ cycloalkyl group," as used herein, refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "C₃-C₁₀ cycloalkylene group," as used herein, refers to a divalent group having substantially the same structure as the C₃-C₁₀ cycloalkyl group.

The term "C₁-C₁₀ heterocycloalkyl group," as used herein, refers to a monovalent saturated monocyclic group having at least one heteroatom selected from N, O, Si, P, and S as a ring-forming atom in addition to 1 to 10 carbon atoms, and non-limiting examples thereof include a 1,2,3,4-oxatriazolidinyl group, a tetrahydrofuranyl group, and a tetrahydrothiophenyl group. The term "C₁-C₁₀ heterocycloalkylene group," as used herein, refers to a divalent group having substantially the same structure as the C₁-C₁₀ heterocycloalkyl group.

The term "C₃-C₁₀ cycloalkenyl group," as used herein, refers to a monovalent monocyclic group that has 3 to 10 carbon atoms and at least one carbon-carbon double bond in the ring thereof and does not have aromaticity, and non-limiting examples thereof include a cyclopentenyl group, a cyclohexenyl group, and a cycloheptenyl group. The term "C₃-C₁₀ cycloalkenylene group," as used herein, refers to a divalent group having substantially the same structure as the C₃-C₁₀ cycloalkenyl group.

The term "C₁-C₁₀ heterocycloalkenyl group," as used herein, refers to a monovalent monocyclic group that has at least one heteroatom selected from N, O, Si, P, and S as a ring-forming atom in addition to 1 to 10 carbon atoms, and at least one double bond, preferably at least one carbon-carbon double bond in its ring. Non-limiting examples of the C₁-C₁₀ heterocycloalkenyl group are a 4,5-dihydro-1,2,3,4-oxatriazolyl group, a 2,3-dihydrofuranyl group and a 2,3-dihydrothiophenyl group. The term "C₁-C₁₀ heterocycloalkenylene group," as used herein, refers to a divalent group having substantially the same structure as the C₁-C₁₀ heterocycloalkenyl group.

The term "C₆-C₆₀ aryl group," as used herein, refers to a monovalent group having a carbocyclic aromatic system having 6 to 60 carbon atoms, and the term "C₆-C₆₀ arylene group," as used herein, refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each independently include two or more rings, the respective rings may be fused to each other. Corresponding definitions apply to other ranges given for the number of carbon atoms in an aryl/arylene group.

The term "C₁-C₆₀ heteroaryl group," as used herein, refers to a monovalent group having a heterocyclic aromatic system that has at least one heteroatom selected from N, O, Si, P, and S as a ring-forming atom, in addition to 1 to 60 carbon atoms. The term "C₁-C₆₀ heteroarylene group," as used herein, refers to a divalent group having a heterocyclic aromatic system that has at least one heteroatom selected from N, O, Si, P, and S as a ring-forming atom, in addition to 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each independently include two or more rings, the respective rings may be fused to each other. Corresponding definitions apply to other ranges given for the number of carbon atoms in a heteroaryl/heteroarylene group.

The term "C₆-C₆₀ aryloxy group," as used herein, refers to a group represented by -OA₁₀₂ (wherein A₁₀₂ is the C₆-C₆₀ aryl group), and a "C₆-C₆₀ arylthio group", as used herein, refers to a group represented by -SA₁₀₃ (wherein A₁₀₃ is the C₆-C₆₀ aryl group). Corresponding definitions apply to other ranges given for the number of carbon atoms in an aryloxy group and an arylthio group.

The term "monovalent non-aromatic condensed polycyclic group," as used herein, refers to a monovalent group (for example, having 8 to 60 carbon atoms) that has two or more rings condensed with each other, has only carbon atoms as ring-forming atoms, and has non-aromaticity in the entire molecular structure. A detailed example of the monovalent non-aromatic condensed polycyclic group is a fluorenyl group. The term "divalent non-aromatic condensed polycyclic group," as used herein, refers to a divalent group having substantially the same structure as the monovalent non-aromatic condensed polycyclic group.

The term "monovalent non-aromatic condensed heteropolycyclic group," as used herein, refers to a monovalent group (for example, having 1 to 60 carbon atoms) that has two or more rings condensed to each other, has at least one heteroatom selected from N, O, Si, P, and S in addition to carbon atoms, as a ring-forming atom, and has non-aromaticity in the entire molecular structure. An example of the monovalent non-aromatic condensed heteropolycyclic group is a carbazolyl group. The term "divalent non-aromatic condensed heteropolycyclic group," as used herein, refers to a divalent group having substantially the same structure as the monovalent non-aromatic condensed heteropolycyclic group.

The term "C₅-C₆₀ carbocyclic group," as used herein, refers to a monocyclic or polycyclic group having 5 to 60 carbon atoms in which the ring-forming atoms include only carbon atoms. The C₅-C₆₀ carbocyclic group may be an aromatic carbocyclic group or a non-aromatic carbocyclic group. The C₅-C₆₀ carbocyclic group may be a ring, such as benzene, a monovalent group, such as a phenyl group, or a divalent group, such as a phenylene group. In one or more embodiments, depending on the number of substituents connected to the C₅-C₆₀ carbocyclic group, the C₅-C₆₀ carbocyclic group may be a trivalent group or a quadrivalent group. Corresponding definitions apply to other ranges given for the number of carbon atoms in a carbocyclic group.

The term "C₁-C₆₀ heterocyclic group," as used herein, refers to a group having substantially the same structure as the C₅-C₆₀ carbocyclic group, except that as a ring-forming atom, at least one heteroatom selected from N, O, Si, P, and S is used in addition to carbon (the number of carbon atoms may be in a range of 1 to 60). Corresponding definitions apply to other ranges given for the number of carbon atoms in a heterocyclic group.

At least one of substituents of the substituted C₅-C₆₀ carbocyclic group, substituted C₁-C₆₀ heterocyclic group, substituted C₃-C₁₀ cycloalkylene group, substituted C₁-C₁₀ heterocycloalkylene group, substituted C₃-C₁₀ cycloalkenylene group, substituted C₁-C₁₀ heterocycloalkenylene group, substituted C₆-C₆₀ arylene group, substituted C₁-C₆₀ heteroarylene group, substituted divalent non-aromatic condensed polycyclic group, substituted divalent non-aromatic condensed heteropolycyclic group, substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group, and substituted monovalent non-aromatic condensed heteropolycyclic group may be selected from the group consisting of:
deuterium(-D), -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, - Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C2-C60 alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂); and [00540] -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₁₁ to Q₁₃, Q₂₁ to Q₂₃ and Q₃₁ to Q₃₃ may each independently be selected from hydrogen, deuterium, -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

The term "Ph", as used herein, may refer to a phenyl group; the term "Me", as used herein, may refer to a methyl group; the term "Et", as used herein, may refer to an ethyl group; the terms "ter-Bu" or "Bu^{t}", as used herein, may refer to a tert-butyl group; the term "D," as used herein, may refer to deuterium; and the term "OMe," as used herein, may refer to a methoxy group. The term "D₅-Ph," as used herein, refers to a substituent having the following structure:

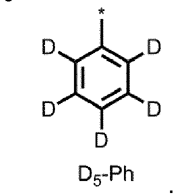

The term "biphenyl group," as used therein, refers to "a phenyl group substituted with a phenyl group." In other words, the "biphenyl group" is a substituted phenyl group having a "C₆-C₆₀ aryl group" as a substituent. The terms "2-biPh, 3-biPh, and 4-biPh," as used herein, respectively refer to the following structures:

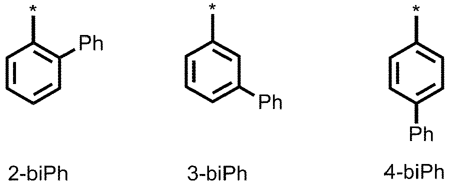

The term "terphenyl group," as used herein, refers to "a phenyl group substituted with a biphenyl group." The "terphenyl group" belongs to "a substituted phenyl group" having "a C₆-C₆₀ aryl group substituted with a C₆-C₆₀ aryl group."

* and *', as used herein, unless defined otherwise, each refer to a binding site to a neighboring atom in a corresponding formula.

Hereinafter, a compound according to embodiments and an organic light-emitting device according to embodiments will be described in detail with reference to Synthesis Examples and Examples. The phrase "B was utilized instead of A" utilized in describing Synthesis Examples refers to that a molar equivalent of B identical to a molar equivalent of A was utilized in place of A.

### Example

### Reference Example 1-1

As an anode, a Corning 15 Ω/cm² (120 nm (1,200 Å)) ITO glass substrate was cut to a size of 50 mm x 50 mm x 0.7 mm, sonicated utilizing isopropyl alcohol and pure water for 5 minutes each, cleaned by exposure to ultraviolet rays for 30 minutes, cleaned by exposure to ozone, and mounted on a vacuum deposition apparatus.

Compound A15 and Compound P7 were co-deposited at a weight ratio of 95:5 on the substrate to form a hole injection layer having a thickness of 10 nm (100 Å), and Compound HT3 was vacuum-deposited on the hole injection layer to form a hole transport layer having a thickness of 70 nm (700 Å) to complete the formation of a hole transport region.

Then, Compound H1 (host) and FD1 (dopant) were co-deposited at a weight ratio of 95:5 to form an emission layer having a thickness of 30 nm (300 Å).

Then, Compound Alq3 was deposited on the emission layer to form an electron transport layer having a thickness of 30 nm (300 Å), and LiF was deposited on the electron transport layer to form an electron injection layer having a thickness of 1 nm (10 Å), thereby completing the formation of an electron transport region. Al was vacuum-deposited thereon to form a cathode having a thickness of 200 nm (2,000 Å), thereby completing the manufacture of an organic light-emitting device.

### Reference Examples 1-2 to 1-3, 1-11 to 1-15; Examples 1-4 to 1-10, 1-16 to 1-20; and Comparative Examples 1-1 to 1-3

An organic light-emitting device was manufactured in substantially the same manner as in Reference Example 1-1, except that in forming a hole injection layer and an emission layer, compounds shown in Table 1 were utilized instead of Compounds A15, P7, and H1.

### Comparative Example 1-4

An organic light-emitting device was manufactured in substantially the same manner as in Reference Example 1-1, except that in forming the hole injection layer, HAT-CN was utilized instead of Compound A15 and Compound P7, and deposited to a thickness of 10 nm (100 Å).

**Table 1**

| | Emission layer | hole injection layer | |
|---|---|---|---|
| Reference Example1-1 | H1 | A15 | P7 |
| Reference Example1-2 | H7 | A15 | P27 |
| Reference Example1-3 | H21 | A15 | P7 |
| Example1-4 | H50 | A15 | P27 |
| Example1-5 | H57 | A15 | P7 |
| Example1-6 | H66 | A15 | P27 |
| Example1-7 | H80 | A15 | P7 |
| Example1-8 | H88 | A15 | P27 |
| Example1-9 | H91 | A15 | P7 |
| Example1-10 | H96 | A15 | P27 |
| Reference Example1-11 | H7 | A6 | P7 |
| Reference Example1-12 | H7 | A25 | P27 |
| Reference Example1-13 | H7 | A36 | P7 |
| Reference Example1-14 | H7 | A67 | P27 |
| Reference Example1-15 | H7 | A92 | P7 |
| Example1-16 | H73 | A6 | P27 |
| Example1-17 | H73 | A25 | P7 |
| Example1-18 | H73 | A67 | P27 |
| Example1-19 | H73 | A92 | P7 |
| Example1-20 | H73 | A95 | P27 |
| Comparative Example 1-1 | B | A | P7 |
| Comparative Example 1-2 | B | A15 | P7 |
| Comparative Example 1-3 | H1 | A | P7 |
| Comparative Example 1-4 | H1 | HAT-CN | |

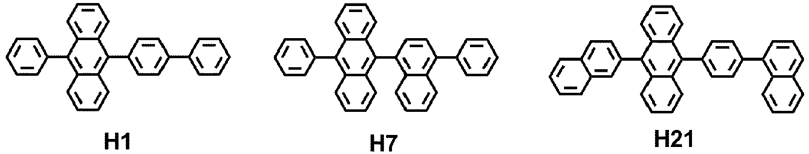

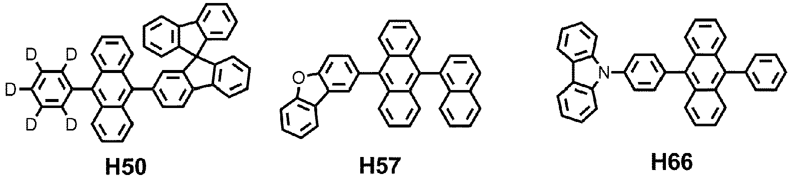

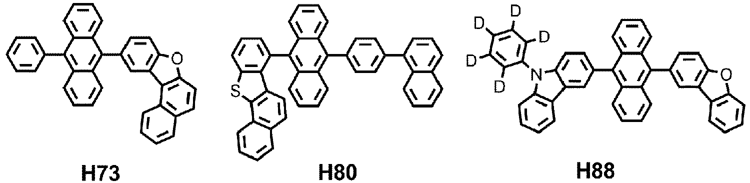

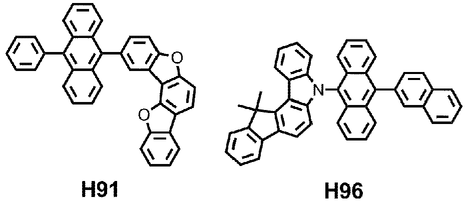

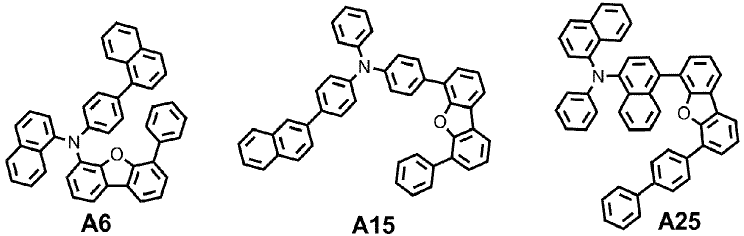

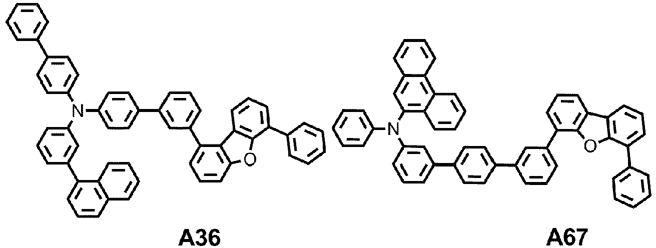

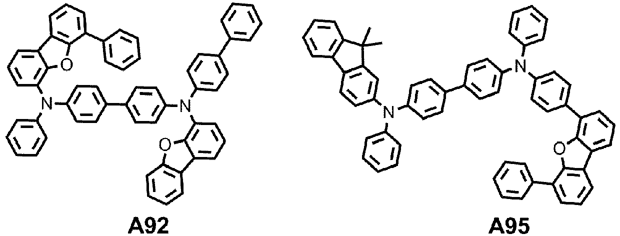

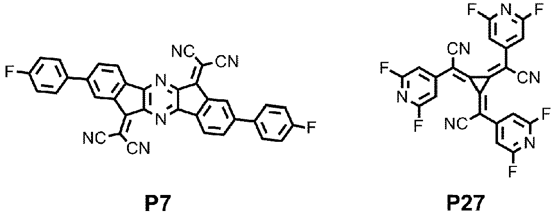

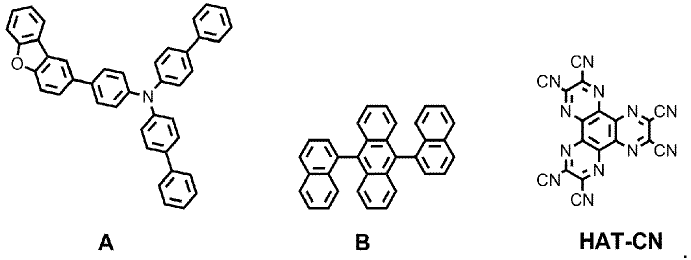

### Reference Example 2-1

As an anode, a Corning 15 Ω/cm² (120 nm (1,200 Å)) ITO glass substrate was cut to a size of 50 mm x 50 mm x 0.7 mm, sonicated utilizing isopropyl alcohol and pure water for 5 minutes each, cleaned by exposure to ultraviolet rays for 30 minutes, cleaned by exposure to ozone, and mounted on a vacuum deposition apparatus.

Compound HT3 and Compound P4 were co-deposited on the substrate at a weight ratio of 95:5 to form a hole injection layer having a thickness of 10 nm (100 Å), Compound HT3 was deposited on the hole injection layer to form a hole transport layer having a thickness of 60 nm (600 Å), and then, Compound A31 was vacuum-deposited on the hole transport layer to form an emission auxiliary layer having a thickness of 10 nm (100 Å), thereby completing the formation of a hole transport region.

Then, Compound H1 (host) and FD1 (dopant) were co-deposited thereon at a weight ratio of 95:5 to form an emission layer having a thickness of 30 nm (300 Å).

Then, Compound Alq3 was deposited on the emission layer to form an electron transport layer having a thickness of 30 nm (300 Å), and LiF was deposited on the electron transport layer to form an electron injection layer having a thickness of 1 nm (10 Å), thereby completing the formation of an electron transport region. Al was vacuum-deposited thereon to form a cathode having a thickness of 200 nm (2,000 Å) (cathode), thereby completing the manufacture of an organic light-emitting device.

### Reference Examples 2-3, 2-11 to 2-15; Examples 2-2, 2-4 to 2-10, 2-16 to 2-20; and Comparative Examples 2-1 to 2-4

An organic light-emitting device was manufactured in substantially the same manner as in Reference Example 2-1, except that in forming a hole transport layer and an emission layer, compounds shown in Table 2 were utilized instead of Compounds A31 and H1.

**Table 2**

| | Emission layer | Emission auxiliary layer |
|---|---|---|
| Reference Example2-1 | H1 | A31 |
| Example2-2 | H5 | A31 |
| Reference Example2-3 | H13 | A31 |
| Example2-4 | H30 | A31 |
| Example2-5 | H47 | A31 |
| Example2-6 | H60 | A31 |
| Example2-7 | H65 | A31 |
| Example2-8 | H76 | A31 |
| Example2-9 | H78 | A31 |
| Example2-10 | H94 | A31 |
| Reference Example2-11 | H7 | A66 |
| Reference Example2-12 | H7 | A70 |
| Reference Example2-13 | H7 | A80 |
| Reference Example2-14 | H7 | A87 |
| Reference Example2-15 | H7 | A98 |
| Example2-16 | H73 | A66 |
| Example2-17 | H73 | A70 |
| Example2-18 | H73 | A80 |
| Example2-19 | H73 | A87 |
| Example2-20 | H73 | A98 |
| Comparative Example 2-1 | B | A |
| Comparative Example 2-2 | B | A31 |
| Comparative Example 2-3 | H1 | A |
| Comparative Example 2-4 | H1 | A31 |

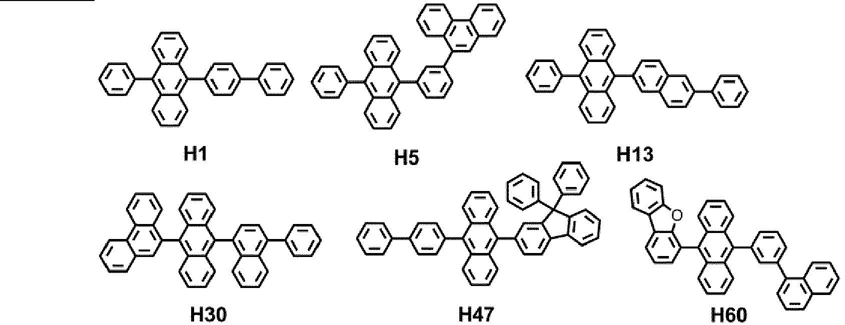

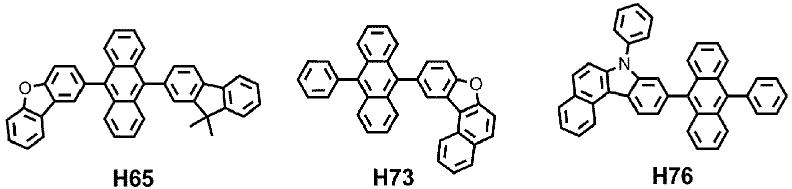

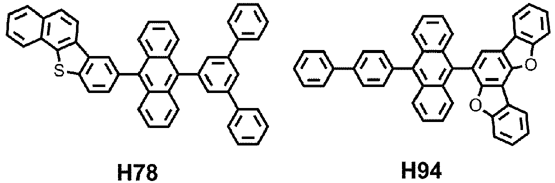

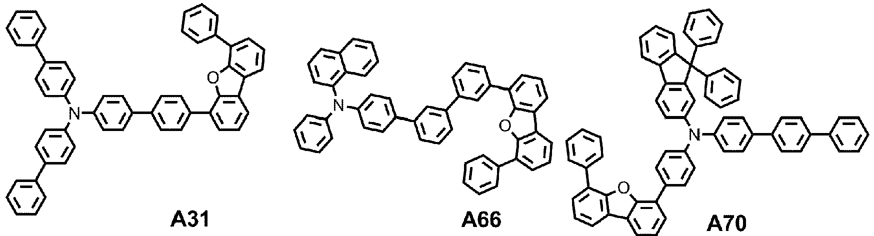

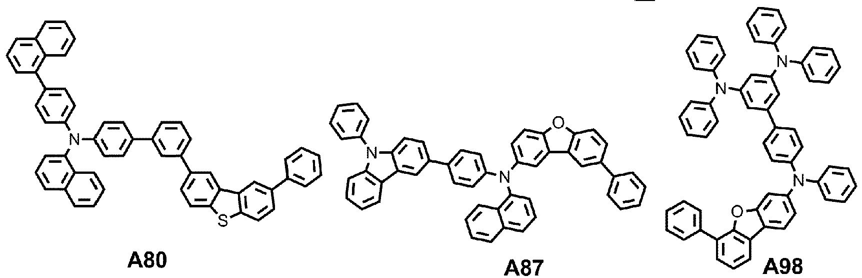

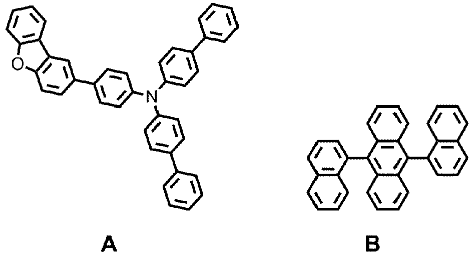

### Reference Example 3-1

As an anode, a Corning 15 Ω/cm² (120 nm (1,200 Å)) ITO glass substrate was cut to a size of 50 mm x 50 mm x 0.7 mm, sonicated utilizing isopropyl alcohol and pure water for 5 minutes each, cleaned by exposure to ultraviolet rays for 30 minutes, cleaned by exposure to ozone, and mounted on a vacuum deposition apparatus.

Compound HT3 and Compound P20 were co-deposited on the substrate at a weight ratio of 95:5 to form a hole injection layer having a thickness of 10 nm (100 Å), and then, Compound HT3 was deposited on the hole injection layer to form a hole transport layer having a thickness of 60 nm (600 Å), and then, Compound A13 was vacuum-deposited on the hole transport layer to form an emission auxiliary layer having a thickness of 10 nm (100 Å), thereby completing the formation of a hole transport region.

Then, Compound H1 (host) and FD19 (dopant) were co-deposited at a weight ratio of 95:5 to form an emission layer having a thickness of 30 nm (300 Å).

Then, Compound Alq3 was deposited on the emission layer to form an electron transport layer having a thickness of 30 nm (300 Å), and then, LiF was deposited on the electron transport layer to form an electron injection layer having a thickness of 1 nm (10 Å), thereby completing the formation of an electron transport region. Al was vacuum-deposited thereon to form a cathode having a thickness of 200 nm (2,000 Å), thereby completing the manufacture of an organic light-emitting device.

### Reference Example 3-2; Examples 3-3 to 3-10; and Comparative Examples 3-1 to 3-3

An organic light-emitting device was manufactured in substantially the same manner as in Reference Example 3-1, except that in forming an emission auxiliary and an emission layer, compounds shown in Table 3 were utilized instead of Compounds A13 and H1.

**Table 3**

| | Emission layer | Emission auxiliary layer |
|---|---|---|
| Reference Example3-1 | H1 | A13 |
| Reference Example3-2 | H108 | A13 |
| Example3-3 | H115 | A13 |
| Example3-4 | H132 | A13 |
| Example3-5 | H146 | A13 |
| Example3-6 | H179 | A19 |
| Example3-7 | H179 | A26 |
| Example3-8 | H179 | A63 |
| Example3-9 | H179 | A85 |
| Example3-10 | H179 | A94 |
| Comparative Example 3-1 | B | A |
| Comparative Example 3-2 | B | A13 |
| Comparative Example 3-3 | H1 | A |

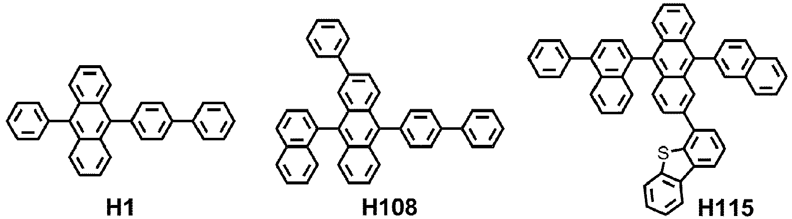

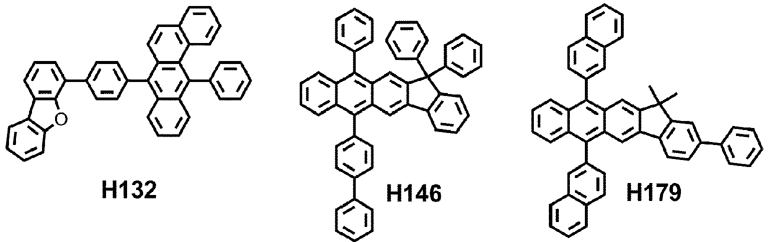

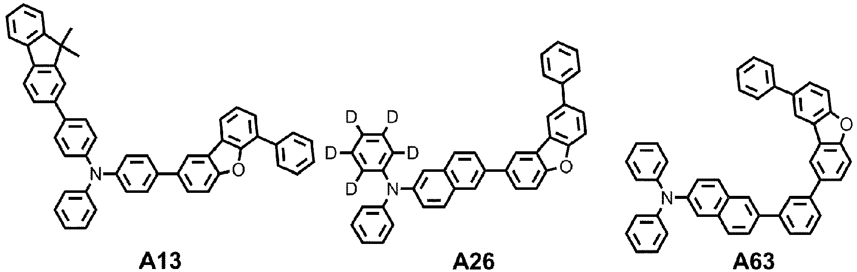

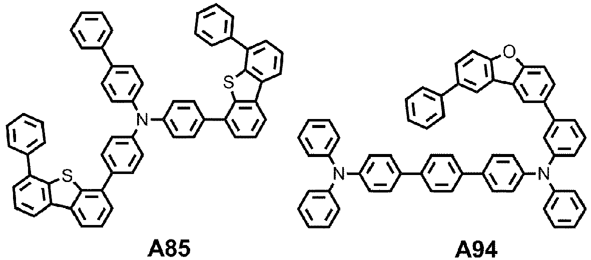

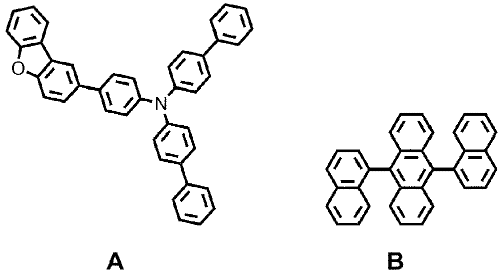

### Evaluation Example

Efficiency (at the current density of 10 mA/cm²) and lifespan T₉₀ (at the current density of 10 mA/cm²) of each of the organic light-emitting devices of Reference Examples 1-1 to 1-3 and 1-11 to 1-15; Examples 1-4 to 1-10 and 1-16 to 1-20, Reference Examples 2-1, 2-3 and 2-11 to 2-15; Examples 2-2, 2-4 to 2-10 and 2-16 to 2-20, Reference Examples 3-1 and 3-2; Examples 3-3 to 3-10, Comparative Examples 1-1 to 1-4, Comparative Examples 2-1 to 2-4, and Comparative Examples 3-1 to 3-3 were measured by utilizing Keithley 2400 and Minolta Cs-1000A. T₉₀ refers to a time that has elapsed until the luminance is reduced to 90% of the initial luminance. The results thereof are shown in Tables 4 to 6.

**Table 4**

| | Emission layer | Hole injection layer | | Driving voltage (V) | Efficiency (cd/A) | Lifespan (T₉₀, hours) |
|---|---|---|---|---|---|---|
| Reference Example1-1 | H1 | A15 | P7 | 4.5 | 5.2 | 127 |
| Reference Example1-2 | H7 | A15 | P27 | 4.5 | 5.2 | 130 |
| Reference Example1-3 | H21 | A15 | P7 | 4.6 | 5.3 | 115 |
| Example1-4 | H50 | A15 | P27 | 4.4 | 5.4 | 120 |
| Example1-5 | H57 | A15 | P7 | 4.3 | 5.3 | 123 |
| Example1-6 | H66 | A15 | P27 | 4.5 | 5.3 | 98 |
| Example1-7 | H80 | A15 | P7 | 4.3 | 5.2 | 89 |
| Example1-8 | H88 | A15 | P27 | 4.4 | 5.4 | 80 |
| Example1-9 | H91 | A15 | P7 | 4.3 | 5.4 | 101 |
| Example1-10 | H96 | A15 | P27 | 4.4 | 5.3 | 105 |
| Reference Example1-11 | H7 | A6 | P7 | 4.5 | 5.4 | 135 |
| Reference Example1-12 | H7 | A25 | P27 | 4.6 | 5.5 | 122 |
| Reference Example1-13 | H7 | A36 | P7 | 4.5 | 5.4 | 130 |
| Reference Example1-14 | H7 | A67 | P27 | 4.5 | 5.3 | 124 |
| Reference Example1-15 | H7 | A92 | P7 | 4.5 | 5.6 | 116 |
| Example1-16 | H73 | A6 | P27 | 4.2 | 5.4 | 105 |
| Example1-17 | H73 | A25 | P7 | 4.4 | 5.3 | 95 |
| Example1-18 | H73 | A67 | P27 | 4.2 | 5.3 | 97 |
| Example1-19 | H73 | A92 | P7 | 4.2 | 5.4 | 88 |
| Example1-20 | H73 | A95 | P27 | 4.4 | 5.2 | 109 |
| Comparative Example 1-1 | B | A | P7 | 4.9 | 4.6 | 45 |
| Comparative Example 1-2 | B | A15 | P7 | 4.9 | 5.0 | 57 |
| Comparative Example 1-3 | H1 | A | P7 | 5.0 | 4.8 | 73 |
| Comparative Example 1-4 | H1 | HAT-CN | | 5.2 | 4.8 | 38 |

**Table 5**

| | Emission layer | Emission auxiliary layer | Driving voltage (V) | Efficiency (cd/A) |
|---|---|---|---|---|
| Reference Example2-1 | H1 | A31 | 4.5 | 5.5 |
| Example2-2 | H5 | A31 | 4.4 | 5.6 |
| Reference Example2-3 | H13 | A31 | 4.6 | 5.4 |
| Example2-4 | H30 | A31 | 4.6 | 5.5 |
| Example2-5 | H47 | A31 | 4.5 | 5.5 |
| Example2-6 | H60 | A31 | 4.1 | 5.4 |
| Example2-7 | H65 | A31 | 4.2 | 5.3 |
| Example2-8 | H76 | A31 | 4.2 | 5.3 |
| Example2-9 | H78 | A31 | 4.1 | 5.4 |
| Example2-10 | H94 | A31 | 4.3 | 5.5 |
| Reference Example2-11 | H7 | A66 | 4.4 | 5.6 |
| Reference Example2-12 | H7 | A70 | 4.5 | 5.6 |
| Reference Example2-13 | H7 | A80 | 4.4 | 5.4 |
| Reference Example2-14 | H7 | A87 | 4.5 | 5.5 |
| Reference Example2-15 | H7 | A98 | 4.6 | 5.5 |
| Example2-16 | H73 | A66 | 4.2 | 5.5 |
| Example2-17 | H73 | A70 | 4.3 | 5.4 |
| Example2-18 | H73 | A80 | 4.2 | 5.4 |
| Example2-19 | H73 | A87 | 4.1 | 5.3 |
| Example2-20 | H73 | A98 | 4.2 | 5.4 |
| Comparative Example 2-1 | B | A | 4.8 | 4.7 |
| Comparative Example 2-2 | B | A31 | 4.7 | 5.0 |
| Comparative Example 2-3 | H1 | A | 4.8 | 4.9 |
| Comparative Example 2-4 | H1 | A31 | 4.7 | 5.2 |

**Table 6**

| | Emission layer | Emission auxiliary layer | Driving voltage (V) | Efficiency (cd/A) |
|---|---|---|---|---|
| Reference Example3-1 | H1 | A13 | 5.1 | 22.3 |
| Reference Example3-2 | H108 | A13 | 5.0 | 23.7 |
| Example3-3 | H115 | A13 | 4.8 | 22.8 |
| Example3-4 | H132 | A13 | 4.7 | 21.9 |
| Example3-5 | H146 | A13 | 5.0 | 22.0 |
| Example3-6 | H179 | A19 | 4.9 | 23.1 |
| Example3-7 | H179 | A26 | 5.0 | 23.5 |
| Example3-8 | H179 | A63 | 5.0 | 22.8 |
| Example3-9 | H179 | A85 | 5.0 | 23.1 |
| Example3-10 | H179 | A94 | 4.9 | 22.5 |
| Comparative Example 3-1 | B | A | 5.4 | 18.7 |
| Comparative Example 3-2 | B | A13 | 5.3 | 19.8 |
| Comparative Example 3-3 | H1 | A | 5.3 | 19.5 |

Referring to Table 4, it is seen that the organic light-emitting devices of Reference Examples 1-1 to 1-3 and 1-11 to 1-15, and Examples 1-4 to 1-10 and 1-16 to 1-20 each have a lower driving voltage, higher efficiency, and longer lifespan than the organic light-emitting devices of Comparative Examples 1-1 to 1-4.

Referring to Table 5, it is seen that the organic light-emitting devices of Reference Examples 2-1, 2-3 and 2-11 to 2-15, and Examples 2-2, 2-4 to 2-10 and 2-16 to 2-20 each have a lower driving voltage and higher efficiency than the organic light-emitting devices of Comparative Examples 2-1 to 2-4.

Referring to Table 6, it is seen that the organic light-emitting devices of Reference Examples 3-1 and 3-2 and Examples 3-3 to 3-10 each have lower driving voltage and higher efficiency than the organic light-emitting devices of Comparative Example 3-1 to 3-3.

An organic light-emitting device according to an embodiment may have improved efficiency and lifespan characteristics.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope as defined by the following claims.

## Claims

1. An organic light-emitting device (10) comprising:
a first electrode (110);
a second electrode (190) facing the first electrode (110); and
an organic layer (150) between the first electrode (110) and the second electrode (190),
wherein the organic layer (150) comprises:
an emission layer; and
a hole transport region between the emission layer and the first electrode (110),
wherein the emission layer comprises the first compound represented by Formula 1; and
the hole transport region comprises the second compound represented by Formula 2 and the third compound represented by one selected from Formulae 3-1 to 3-3: 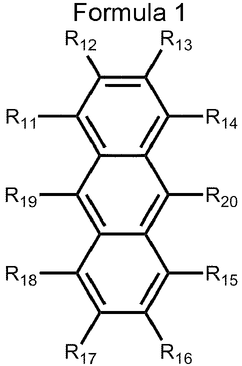 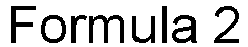 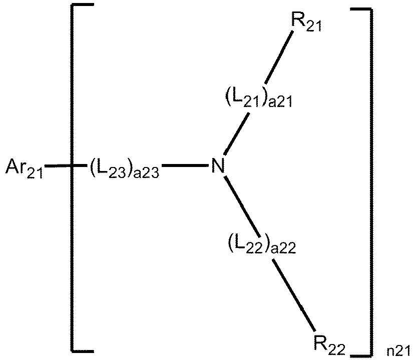 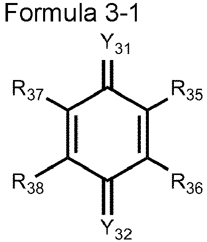 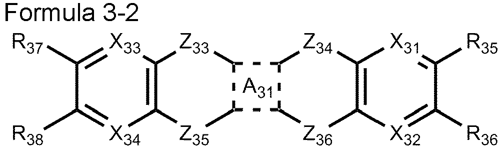 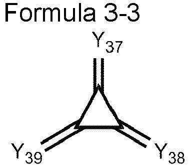 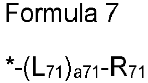 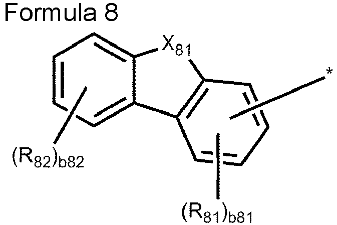 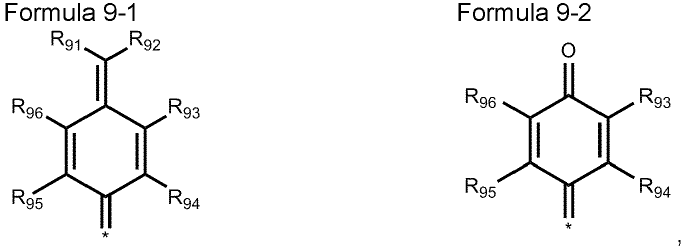 wherein, in Formulae 1, 2, 3-1 to 3-3, 7, 8, 9-1, and 9-2,
R₁₁ to R₂₀ are each independently selected from a group represented by Formula 7, hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), - C(=O)(Q₁), -S(=O)₂(Q₁), and -P(=O)(Q₁)(Q₂), provided that at least one selected from R₁₁ to R₂₀ is the group represented by Formula 7;
i) two neighboring groups selected from R₁₁ to R₂₀ are linked to form a ring, and R₇₁ is selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group; or
ii) R₇₁ is selected from a phenanthrenyl group, an anthracenyl group, a tetraphenyl group, a carbazolyl group and a group represented by one selected from Formulae 7A-1 to 7A-31, 7B-1 to 7B-3, 7C-1 to 7C-3, 7D-1 to 7D-3, 7E-1, and 7E-2;
a phenanthrenyl group, an anthracenyl group, a tetraphenyl group, a carbazolyl group, each substituted with at least one selected from deuterium, a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group; and
a phenanthrenyl group, an anthracenyl group, a tetraphenyl group, a carbazolyl group, each substituted with at least one substituent selected from a phenyl group and a naphthyl group, each of the at least one subsitutent is substituted with at least one selected from deuterium, a methyl group, an ethyl group, an n-propyl group, an iso-propyl group, an n-butyl group, a sec-butyl group, an iso-butyl group, a tert-butyl group, and a phenyl group: 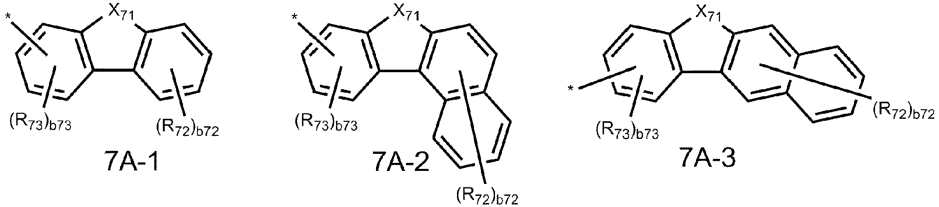 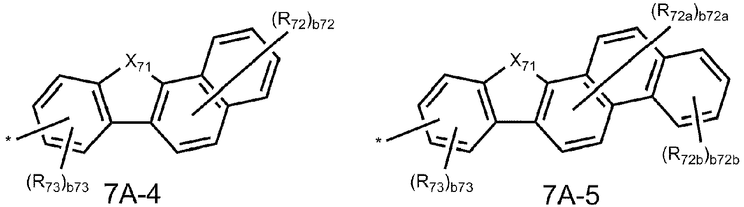 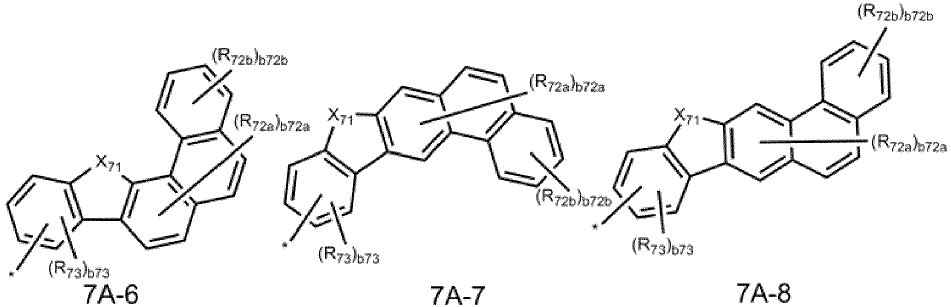 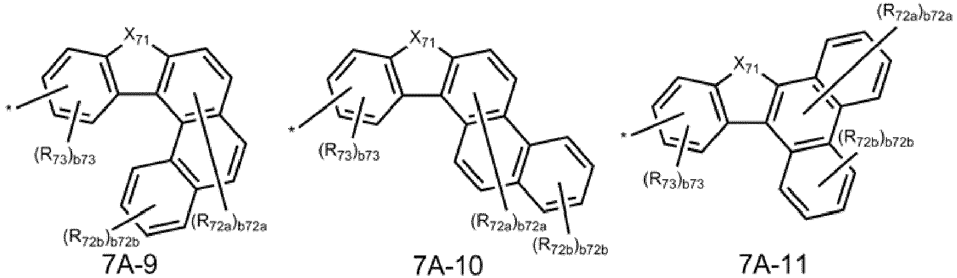 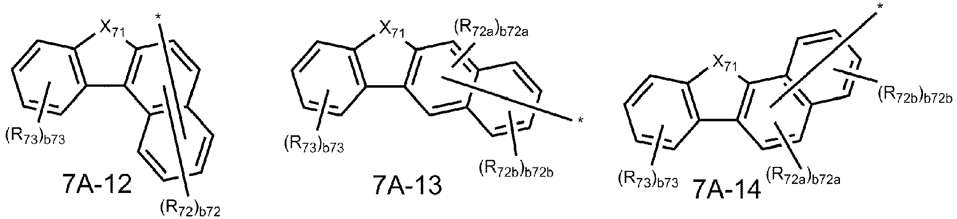 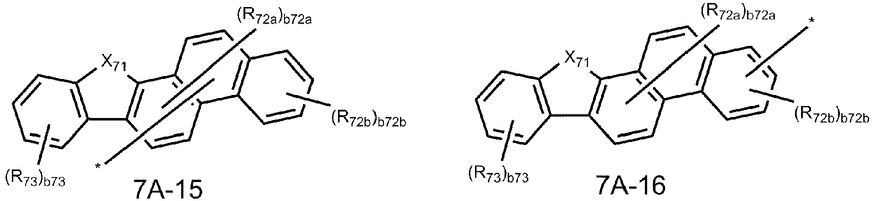 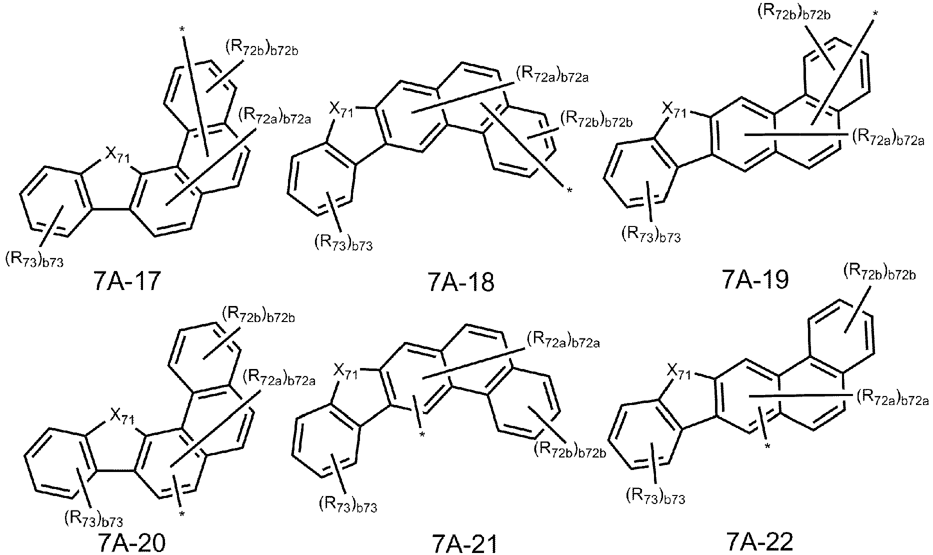 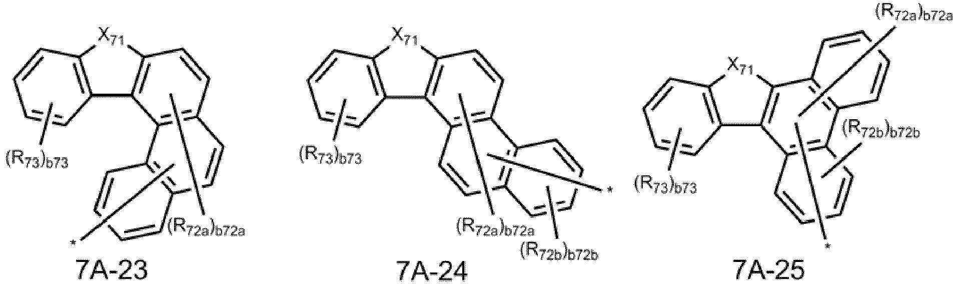 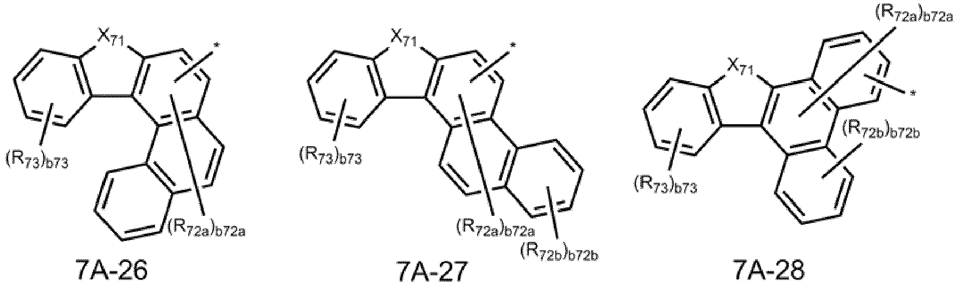 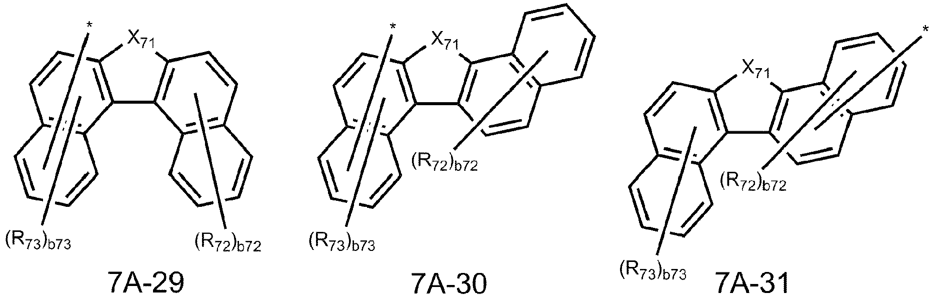 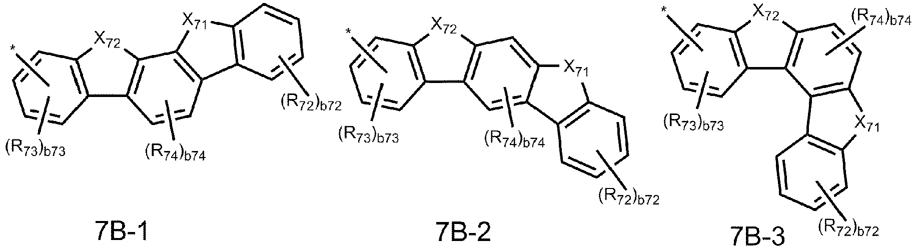 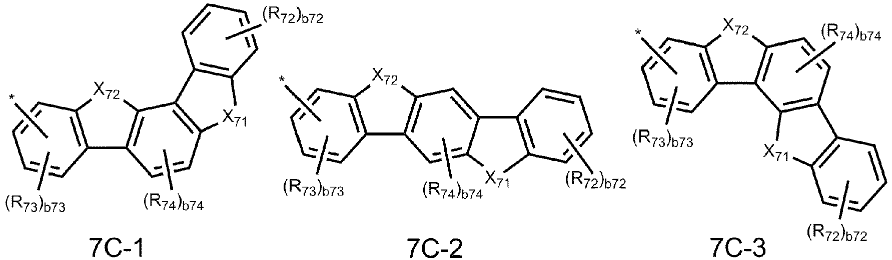 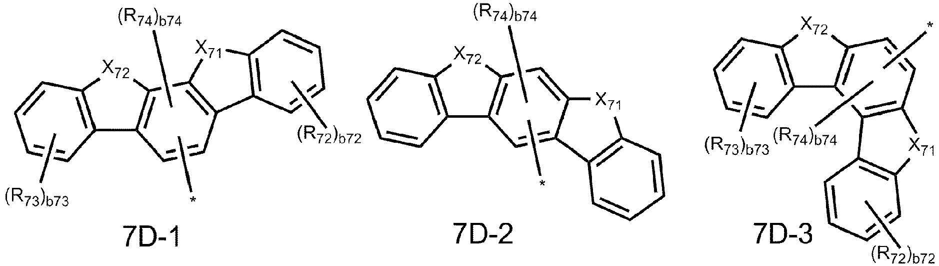 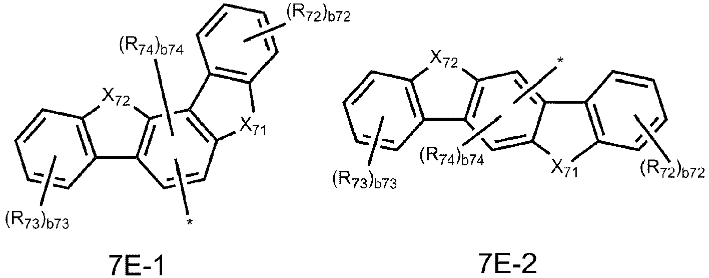
In Formulae 7A-1 to 7A-31, 7B-1 to 7B-3, 7C-1 to 7C-3, 7D-1 to 7D-3, 7E-1, and 7E-2,
X₇₁ is selected from O, S, N(R₇₅), and C(R₇₅)(R₇₆);
X₇₂ is selected from O, S, N(R₇₇), and C(R₇₇)(R₇₈);
R₇₂ to R₇₈, R₇₂ₐ, and R_{72b} are each independently selected from the group consisting of:
hydrogen, deuterium, a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group; and
a phenyl group, a biphenyl group, and a naphthyl group, each substituted with at least one selected from deuterium, a methyl group, an ethyl group, an n-propyl group, an iso-propyl group, an n-butyl group, a sec-butyl group, an iso-butyl group, a tert-butyl group, and a phenyl group;
R₇₅ and R₇₆ are optionally linked to form a ring;
R₇₇ and R₇₈ are optionally linked to form a ring;
b72 to b74, b72a, and b72b are each independently selected from 1, 2, 3, 4, 5, 6, 7, and 8; and
* indicates a binding site to a neighboring atom;
L₇₁ is selected from a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group;
a71 is selected from 0, 1, 2, and 3;
Ar₂₁ is a substituted or unsubstituted C₅-C₆₀ carbocyclic group or a substituted or unsubstituted C₁-C₆₀ heterocyclic group;
L₂₁ to L₂₃ are each independently selected from a substituted or unsubstituted C₆-C₆₀ arylene group and a substituted or unsubstituted C₁-C₆₀ heteroarylene group;
a21 to a23 are each independently selected from 0, 1, 2, and 3;
R₂₁ and R₂₂ are each independently selected from a group represented by Formula 8, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, provided that at least one selected from R₂₁ and R₂₂ is the group represented by Formula 8;
X₈₁ is selected from O and S;
R₈₁ and R₈₂ are each independently selected from the group consisting of:
-F, -Cl, -Br, -I, a cyano group, a C₁-C₆₀ alkyl group, a C₃-C₁₀ cycloalkyl group, a C1-C10 heterocycloalkyl group, a C₆-C₆₀ aryl group, a C₆-C₆₀ aryloxy group, a C₆-C₆₀ arylthio group, a C₁-C₆₀ heteroaryl group, and -Si(Q₁)(Q₂)(Q₃); and
a C₃-C₁₀ cycloalkyl group, a C₁-C₁₀ heterocycloalkyl group, a C₆-C₆₀ aryl group, a C₆-C₆₀ aryloxy group, a C₆-C₆₀ arylthio group, and a C₁-C₆₀ heteroaryl group, each substituted with at least one selected from deuterium, -F, -Cl, -Br, -I, a cyano group, a C₁-C₆₀ alkyl group, a C₆-C₆₀ aryl group, a C₁-C₆₀ heteroaryl group, and - Si(Q₃₁)(Q₃₂)(Q₃₃);
b81 is selected from 0, 1, 2, and 3; b82 is selected from 0, 1, 2, 3, and 4; a sum of b81 and b82 is 1 or more;
n21 is selected from 1, 2, and 3;
A₃₁ is selected from a substituted or unsubstituted C₅-C₆₀ carbocyclic group and a substituted or unsubstituted C₁-C₆₀ heterocyclic group;
X₃₁ is selected from N and C(R₃₁), X₃₂ is selected from N and C(R₃₂), X₃₃ is selected from N and C(R₃₃), X₃₄ is selected from N and C(R₃₄);
Z₃₃ is selected from a single bond and C=Y₃₃; Z₃₄ is selected from a single bond and C=Y₃₄; Z₃₅ is selected from a single bond and C=Y₃₅; Z₃₆ is selected from a single bond and C=Y₃₆; at least one selected from Z₃₃ to Z₃₆ is not a single bond;
Y₃₁ to Y₃₉ are each independently selected from N(CN), C(CN)(R₉₁), C(R₉₁)(R₉₂), a group represented by Formula 9-1, and a group represented by Formula 9-2;
R₉₁ and R₉₂ are each independently selected from -F, -Cl, -Br, -I, a cyano group, a substituted or unsubstituted C₁-C₆₀ alkyl group, a substituted or unsubstituted C₆-C₆₀ aryl group, a substituted or unsubstituted C₁-C₆₀ heteroaryl group, and -C(=O)OR₉₇; and
R₃₁ to R₃₈ and R₉₃ to R₉₇ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂),
wherein Q₁ to Q₃ and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group; and
* indicates a binding site to a neighboring atom.

2. An organic light-emitting device (10) according to claim 1, wherein
the third compound necessarily includes at least one substituent selected from the group consisting of:
a cyano group, -F, -Cl, -Br, and -I; and
a C₁-C₂₀ alkyl group, substituted with at least one selected from -F, -Cl, -Br, and -I.

3. An organic light-emitting device according to claim 1 or claim 2, wherein
R₁₁ to R₂₀ are each independently selected from the group represented by Formula 7, hydrogen, deuterium, -F, -Cl, -Br, -I, a cyano group, a C₁-C₆₀ alkyl group, a C₆-C₆₀ aryl group, a C₁-C₆₀ heteroaryl group, and -Si(Q₁)(Q₂)(Q₃),
wherein Q₁ to Q₃ are each independently selected from a C₁-C₆₀ alkyl group, a C₆-C₆₀ aryl group, a biphenyl group, and a terphenyl group.

4. An organic light-emitting device (10) according to any one of claims 1 to 3, wherein
L₇₁ is selected from the group consisting of:
a phenylene group, a naphthylene group, a fluorenylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a benzofuranylene group, a benzothiophenylene group, a triazolylene group, a tetrazolylene group, a triazinylene group, a dibenzofuranylene group, and a dibenzothiophenylene group; and
a phenylene group, a naphthylene group, a fluorenylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a benzofuranylene group, a benzothiophenylene group, a triazolylene group, a tetrazolylene group, a triazinylene group, a dibenzofuranylene group, and a dibenzothiophenylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-fluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a carbazolyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group.

5. An organic light-emitting device (10) according to any one of claims 1 to 4, wherein
R₇₁ is selected from Formulae 7-4 to 7-12, 7-17 to 7-186 and 7-194 to 7-202: 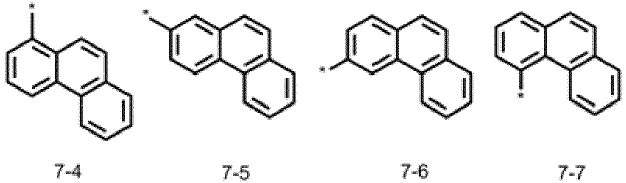 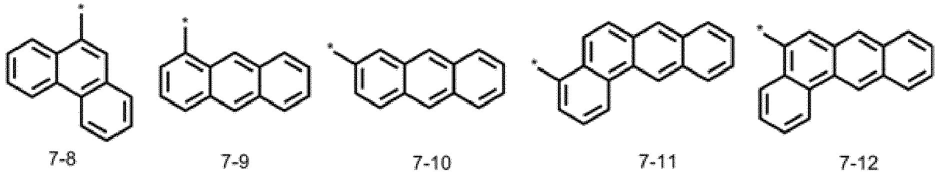 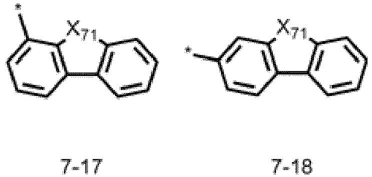 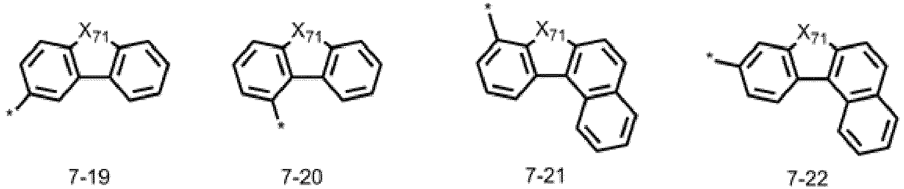 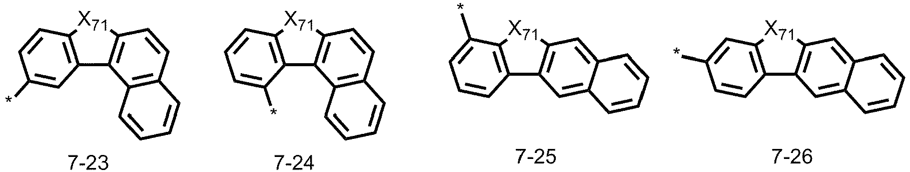 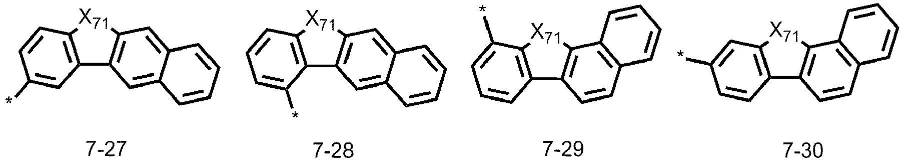 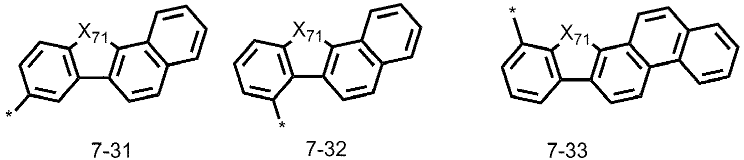 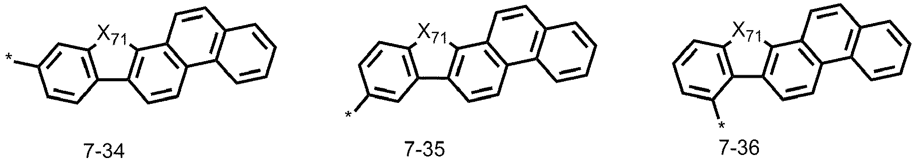 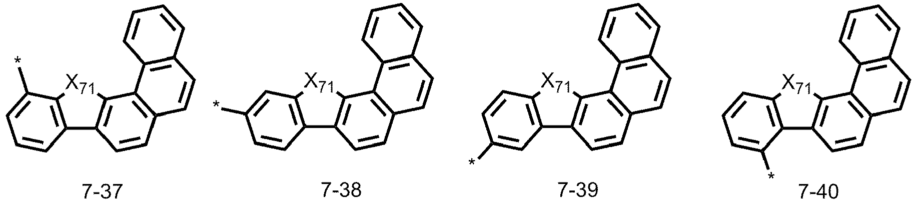 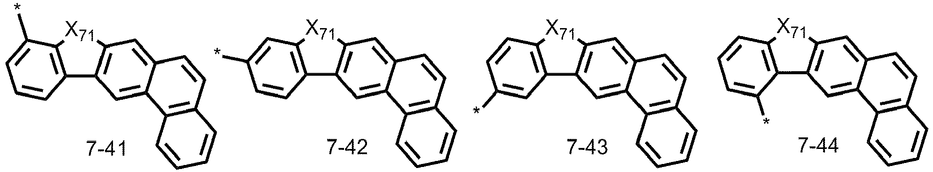 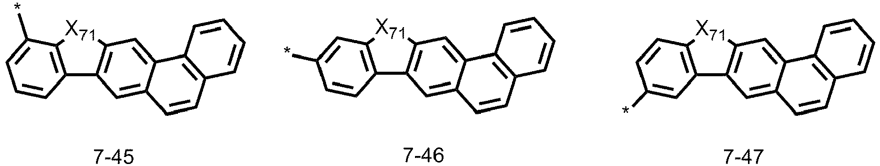 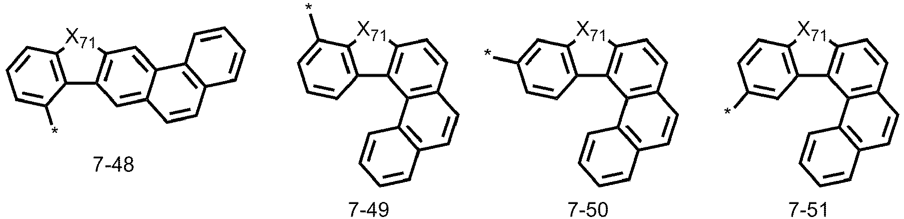 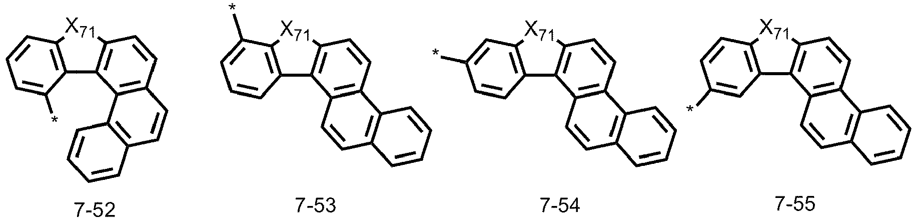 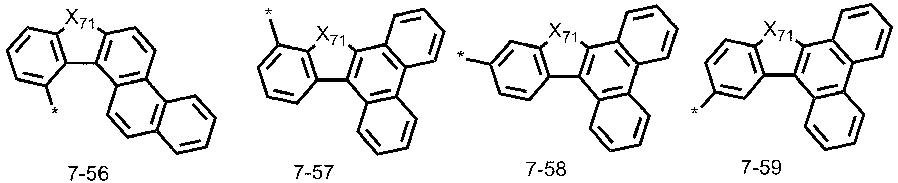 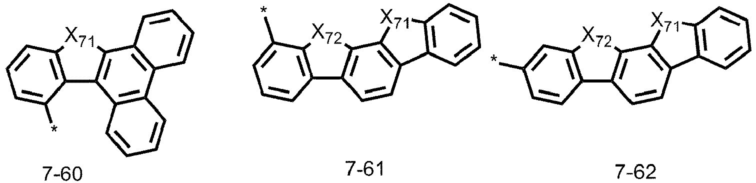 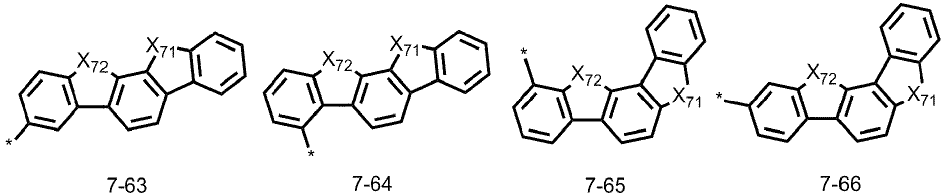 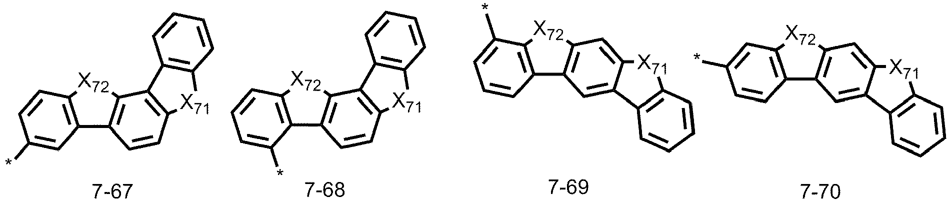 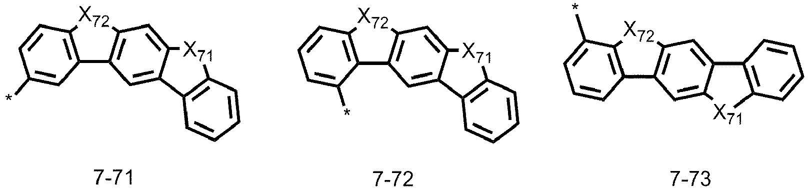 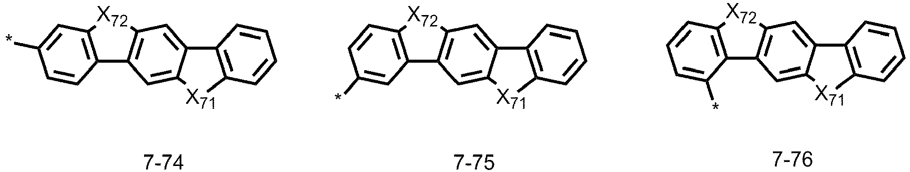 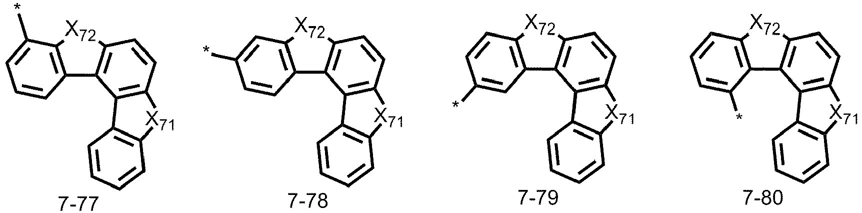 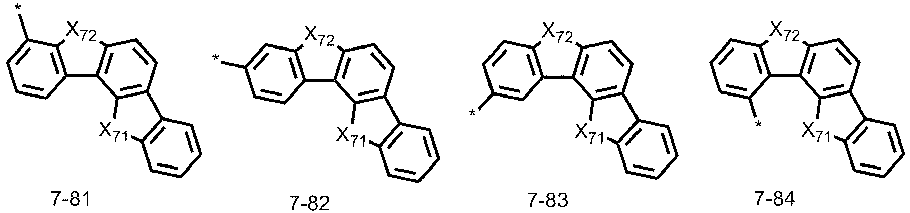 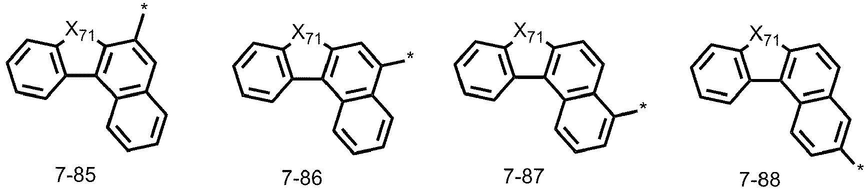 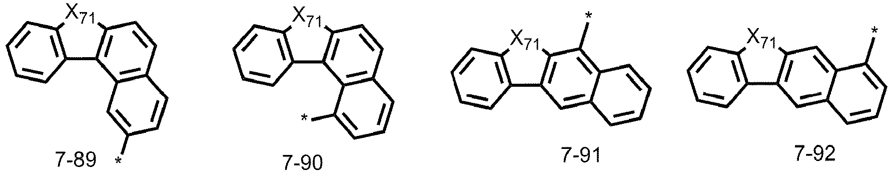 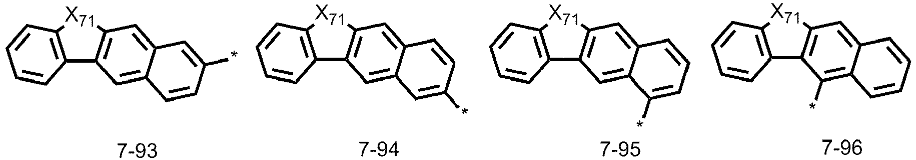 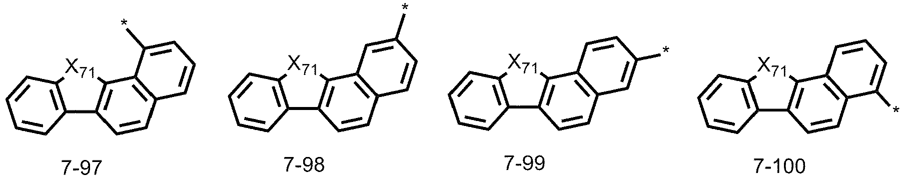 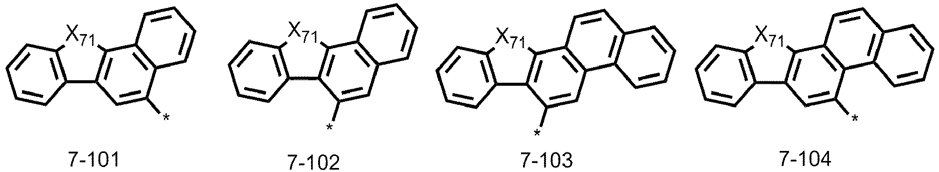 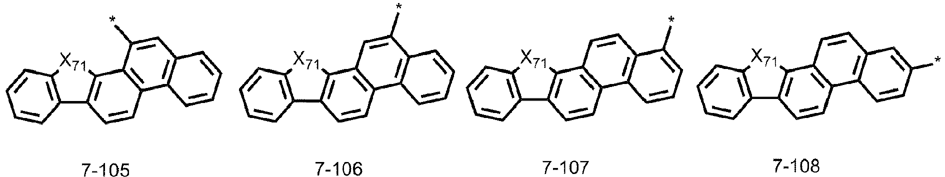 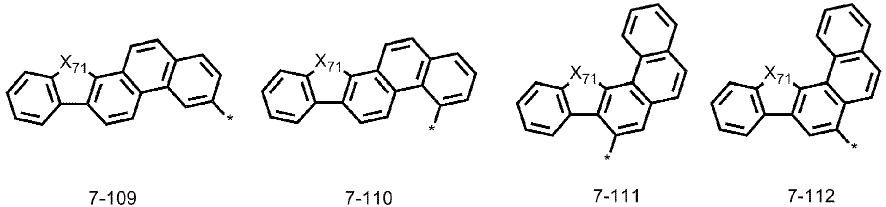 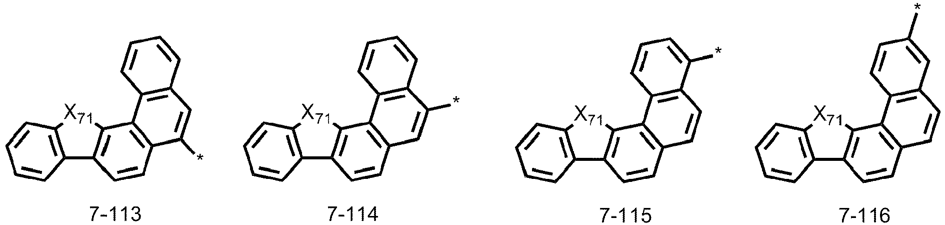 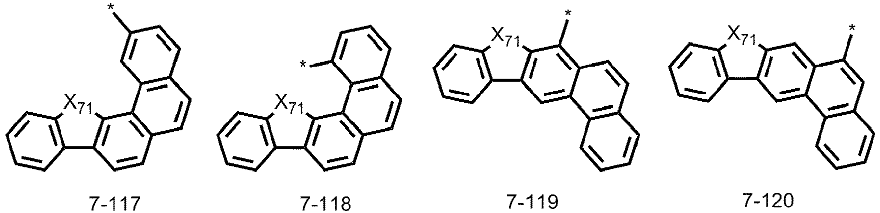 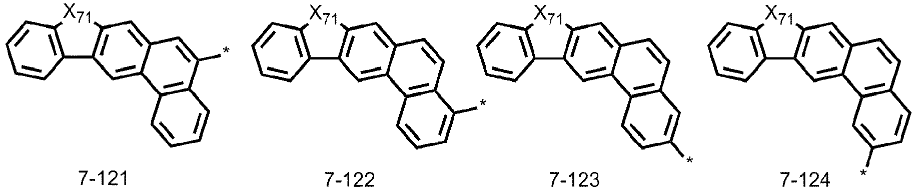 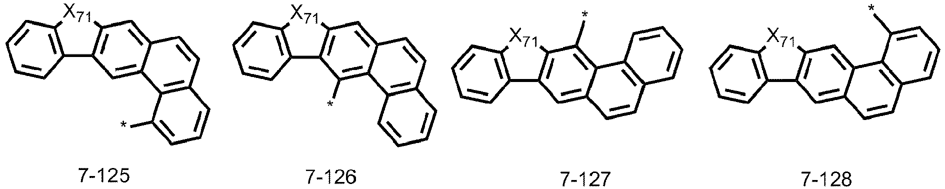 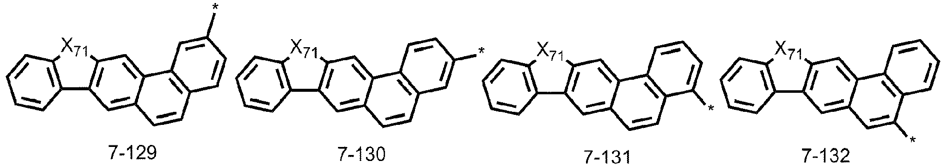 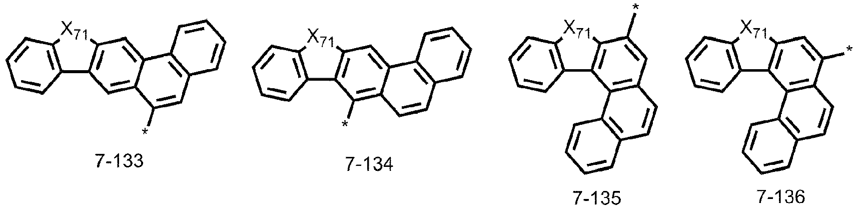 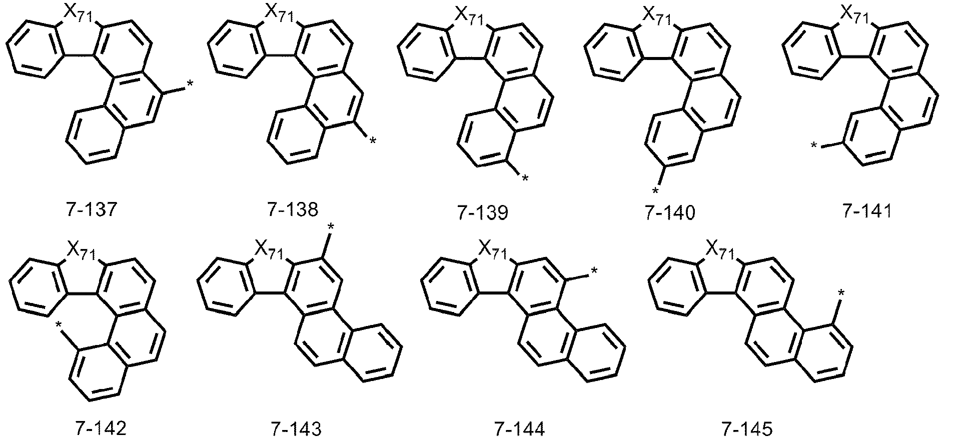 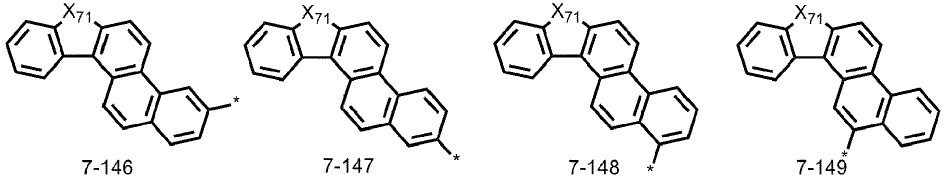 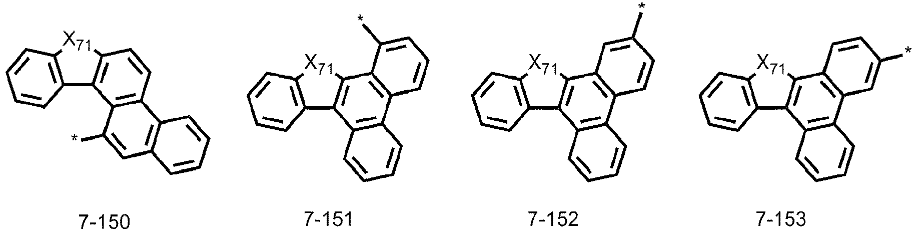 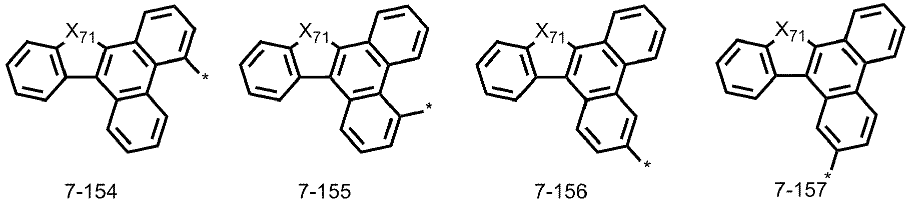 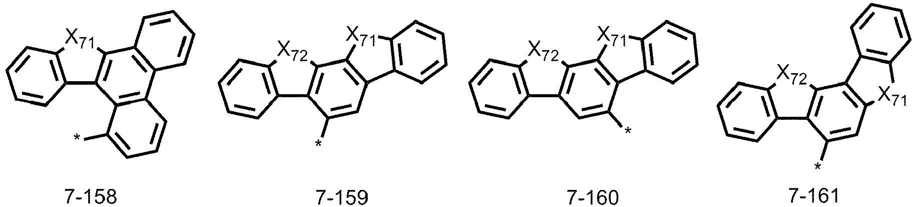 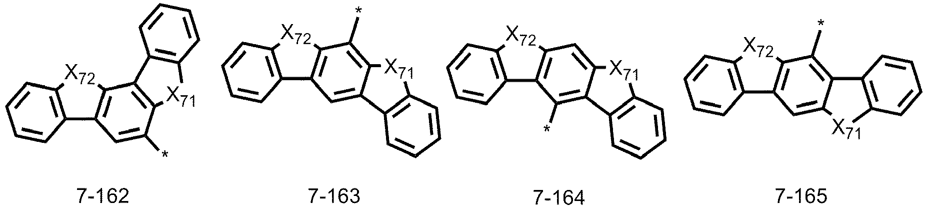 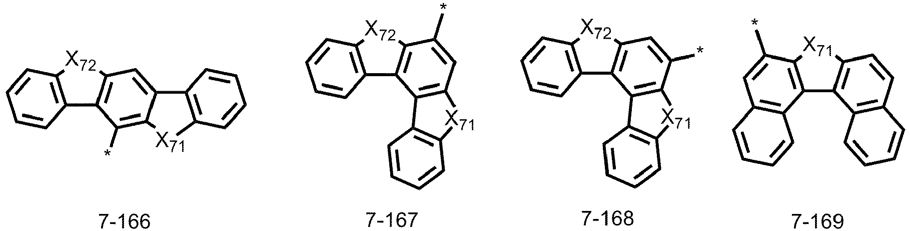 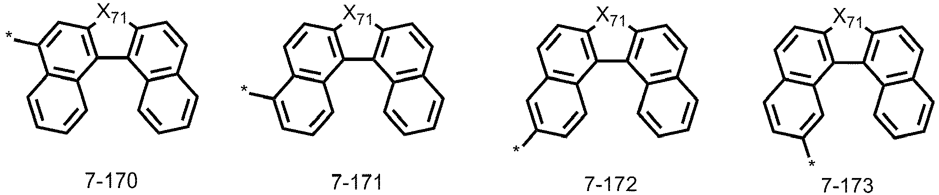 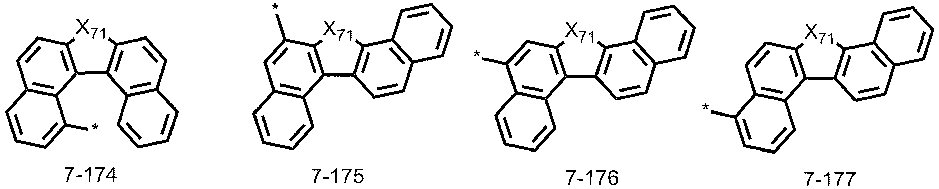 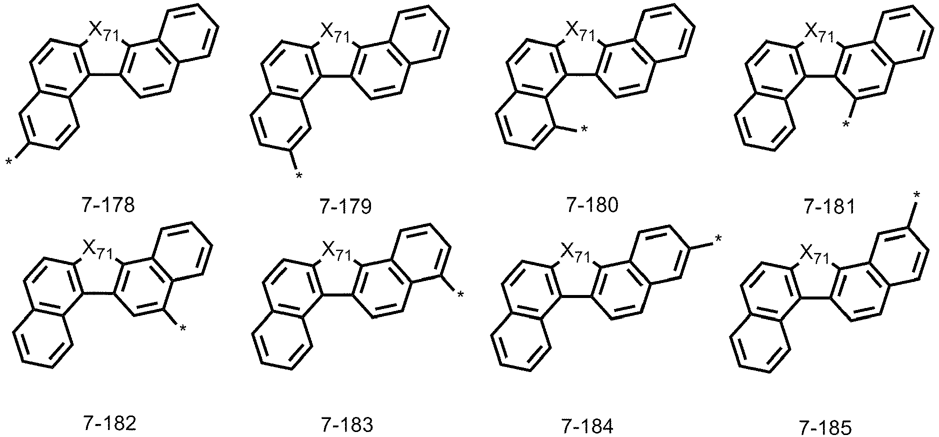 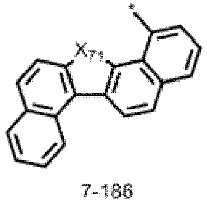 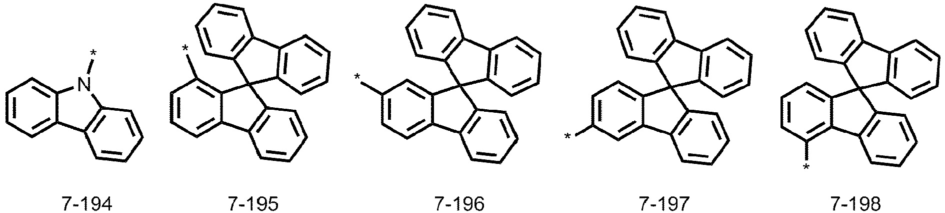 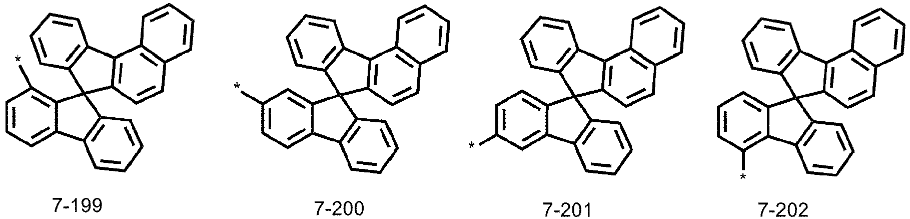 In Formulae 7-4 to 7-12, 7-17 to 7-186 and 7-194 to 7-202,
X₇₁ and X₇₂ are each independently selected from O, S, N(Ph), N(D₆-Ph), N(2-biPh), N(3-biPh), N(4-biPh), C(CH₃)₂, C(CH₃)(Ph), and C(Ph)₂; and
* indicates a binding site to a neighboring atom

6. An organic light-emitting device (10) according to any one of claims 1 to 5, wherein
Ar₂₁ is selected from the group consisting of:
a benzene group, a naphthalene group, a fluorene group, a spiro-bifluorene group, a phenanthrene group, an anthracene group, a triphenylene group, a pyridine group, a pyrazine group, a pyrimidine group, a pyridazine group, a quinoline group, an isoquinoline group, a carbazole group, a dibenzofuran group, and a dibenzothiophene group; and
a benzene group, a naphthalene group, a fluorene group, a spiro-bifluorene group, a phenanthrene group, an anthracene group, a triphenylene group, a pyridine group, a pyrazine group, a pyrimidine group, a pyridazine group, a quinoline group, an isoquinoline group, a carbazole group, a dibenzofuran group, and a dibenzothiophene group, each substituted with at least one selected from deuterium, -F, -CI, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂),
wherein Q₃₁ to Q₃₃ are each independently selected from a C₁-C₁₀ alkyl group, a phenyl group, a biphenyl group, a terphenyl group, a naphthyl group, a fluorenyl group, a dibenzofuranyl group, a dibenzothiophenyl group, and a carbazolyl group; and
a phenyl group, a biphenyl group, a terphenyl group, a naphthyl group, a fluorenyl group, a dibenzofuranyl group, a dibenzothiophenyl group, and a carbazolyl group, each substituted with at least one selected from a C₁-C₁₀ alkyl group, a phenyl group, and a naphthyl group.

7. An organic light-emitting device (10) according to any one of claims 1 to 6, wherein
L₂₁ to L₂₃ are each independently selected from the group consisting of:
a phenylene group, a naphthylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a triazolylene group, a tetrazolylene group, and a triazinylene group; and
a phenylene group, a naphthylene group, a phenanthrenylene group, an anthracenylene group, a triphenylenylene group, a pyrenylene group, a chrysenylene group, a pyrrolylene group, a thiophenylene group, a furanylene group, an imidazolylene group, a pyridinylene group, a pyrazinylene group, a pyrimidinylene group, a pyridazinylene group, an indolylene group, a quinolinylene group, an isoquinolinylene group, a benzoquinolinylene group, a phenanthridinylene group, an acridinylene group, a phenanthrolinylene group, a triazolylene group, a tetrazolylene group, and a triazinylene group, each substituted with at least one selected from deuterium, -F, -Cl, -Br, -I, a hydroxyl group, a cyano group, a nitro group, an amidino group, a hydrazine group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-fluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an indazolyl group, a quinolinyl group, an isoquinolinyl group, a carbazolyl group, a benzoquinolinyl group, a phthalazinyl group, a naphthyridinyl group, a quinoxalinyl group, a quinazolinyl group, a phenanthridinyl group, an acridinyl group, a phenanthrolinyl group, a phenazinyl group, a benzimidazolyl group, a benzofuranyl group, a benzothiophenyl group, a benzoxazolyl group, a triazolyl group, a tetrazolyl group, an oxadiazolyl group, a triazinyl group, a dibenzofuranyl group, a dibenzothiophenyl group, a benzocarbazolyl group, and a dibenzocarbazolyl group.

8. An organic light-emitting device (10) according to any one of claims 1 to 7, wherein
R₂₁ and R₂₂ are each independently selected from the group consisting of:
the group represented by Formula 8, a phenyl group, a biphenyl group, a terphenyl group, a naphthyl group, a fluorenyl group, a benzofluorenyl group, a dibenzofluorenyl group, a spiro-bifluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a carbazolyl group, a benzocarbazolyl group, a dibenzocarbazolyl group a benzofuranyl group, a benzothiophenyl group, a dibenzofuranyl group, and a dibenzothiophenyl group; and
a phenyl group, a biphenyl group, a terphenyl group, a naphthyl group, a fluorenyl group, a benzofluorenyl group, a dibenzofluorenyl group, a spiro-bifluorenyl group, a phenalenyl group, a phenanthrenyl group, an anthracenyl group, a fluoranthenyl group, a triphenylenyl group, a pyrenyl group, a tetraphenyl group, a chrysenyl group, a perylenyl group, a pentaphenyl group, a hexacenyl group, a pentacenyl group, a carbazolyl group, a benzocarbazolyl group, a dibenzocarbazolyl group a benzofuranyl group, a benzothiophenyl group, a dibenzofuranyl group, and a dibenzothiophenyl group, each substituted with at least one selected from deuterium, - F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

9. An organic light-emitting device (10) according to any one of claims 1 to 8, wherein
R₈₁ and R₈₂ are each independently selected from the group consisting of:
-F, -Cl, -Br, -I, a cyano group, a methyl group, an ethyl group, an n-propyl group, an iso-propyl group, an n-butyl group, an iso-butyl group, a sec-butyl group, a tert-butyl group, an n-pentyl group, a cyclopentyl group, a cyclohexyl group, a cycloheptyl group, a phenyl group, a biphenyl group, a terphenyl group, a naphthyl group, a phenanthrenyl group, a pyridinyl group, a pyrimidinyl group, a pyridazinyl group, a triazinyl group, a quinolinyl group, an isoquinolinyl group, and -Si(Q₁)(Q₂)(Q₃); and
a cyclopentyl group, a cyclohexyl group, a cycloheptyl group, a phenyl group, a biphenyl group, a terphenyl group, a naphthyl group, a phenanthrenyl group, a pyridinyl group, a pyrimidinyl group, a pyridazinyl group, a triazinyl group, a quinolinyl group, and an isoquinolinyl group, each substituted with at least one selected from deuterium, -F, -Cl, -Br, -I, a cyano group, a methyl group, an ethyl group, an n-propyl group, an iso-propyl group, an n-butyl group, an iso-butyl group, a sec-butyl group, a tert-butyl group, a phenyl group, a biphenyl group, a terphenyl group, a naphthyl group, and - Si(Q₃₁)(Q₃₂)(Q₃₃),
wherein Q₁ to Q₃ and Q₃₁ to Q₃₃ are each independently selected from a methyl group, an ethyl group, an n-propyl group, an iso-propyl group, a phenyl group, a biphenyl group, and a terphenyl group.

10. An organic light-emitting device (10) according to any one of claims 1 to 9, wherein
the group represented by Formula 8 is represented by one selected from Formulae 8-1 to 8-11: 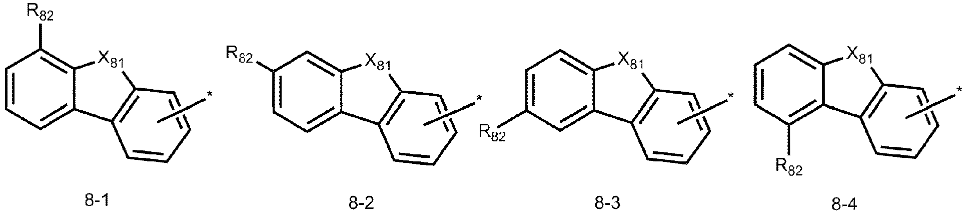 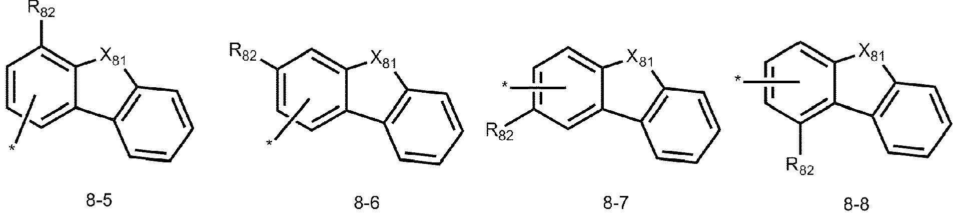 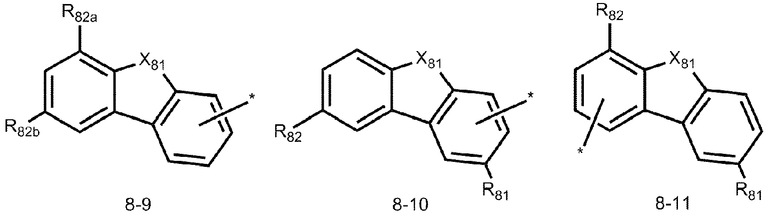 wherein, in Formulae 8-1 to 8-11,
X₈₁ is selected from O and S; and
R₈₁, R₈₂, R₈₂ₐ, and R_{82b} are each independently selected from the group consisting of:
-F, -Cl, -Br, -I, a cyano group, a phenyl group, a biphenyl group, a terphenyl group, a naphthyl group, -Si(CH₃)₃, and -Si(Ph)₃; and
a phenyl group, a biphenyl group, a terphenyl group, a naphthyl group, and a phenanthrenyl group, each substituted with at least one selected from deuterium, -F,-Cl, -Br, -I, a cyano group, a methyl group, an ethyl group, an n-propyl group, an iso-propyl group, an n-butyl group, an iso-butyl group, a sec-butyl group, a tert-butyl group, a phenyl group, a naphthyl group, -Si(CH₃)₃, and -Si(Ph)₃.

11. An organic light-emitting device (10) according to any one of claims 1 to 10, wherein
A₃₁ is selected from the group consisting of:
a benzene group, a naphthalene group, a pyridine group, a pyrazine group, a pyrimidine group, a pyridazine group, a quinoline group, and an isoquinoline group; and
a benzene group, a naphthalene group, a pyridine group, a pyrazine group, a pyrimidine group, a pyridazine group, a quinoline group, and an isoquinoline group, each substituted with at least one selected from deuterium, -F, -CI, -Br, -I, a cyano group, a C₁-C₂₀ alkyl group, a phenyl group, a biphenyl group, a terphenyl group, and a naphthyl group.

12. An organic light-emitting device (10) according to any one of claims 1 to 11, wherein
R₃₁ to R₃₈ and R₉₃ to R₉₇ are each independently selected from the group consisting of:
hydrogen, -F, -Cl, -Br, -I, a cyano group, a C₁-C₆₀ alkyl group, a C₆-C₆₀ aryl group, and a C₁-C₆₀ heteroaryl group; and
a C₁-C₆₀ alkyl group, a C₆-C₆₀ aryl group, and a C₁-C₆₀ heteroaryl group, each substituted with at least one selected from -F, a cyano group, and a C₁-C₆₀ alkyl group substituted with -F.

13. An organic light-emitting device (10) according to any one of claims 1 to 12, wherein
the first compound represented by Formula 1 is represented by Formula 1-1: 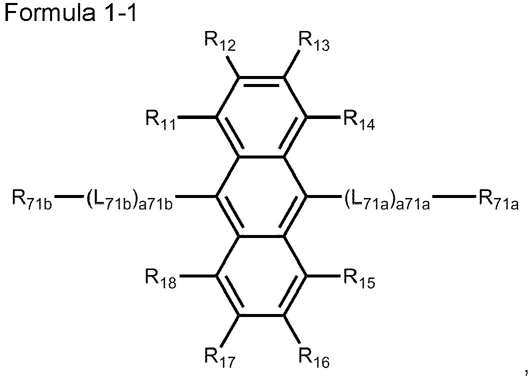 wherein, in Formula 1-1,
R₁₁ to R₁₈ are each independently selected from hydrogen, deuterium, -F, -Cl,-Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), - S(=O)₂(Q₁), and -P(=O)(Q₁)(Q₂);
i) R₁₁ and R₁₂, R₁₂ and R₁₃, or R₁₃ and R₁₄ are linked to form a ring, and R₇₁ₐ and R_{71b} are each independently selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group; or
ii) R₇₁ₐ and R_{71b} are each independently selected from a phenanthrenyl group, an anthracenyl group, a tetraphenyl group, a carbazolyl group and a group represented by one selected from Formulae 7A-1 to 7A-31, 7B-1 to 7B-3, 7C-1 to 7C-3, 7D-1 to 7D-3, 7E-1, and 7E-2;
a phenanthrenyl group, an anthracenyl group, a tetraphenyl group, a carbazolyl group, each substituted with at least one selected from deuterium, a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group; and
a phenanthrenyl group, an anthracenyl group, a tetraphenyl group, a carbazolyl group, each substituted with at least one substituent selected from a phenyl group and a naphthyl group, each of the at least one subsitutent is substituted with at least one selected from deuterium, a methyl group, an ethyl group, an n-propyl group, an iso-propyl group, an n-butyl group, a sec-butyl group, an iso-butyl group, a tert-butyl group, and a phenyl group: 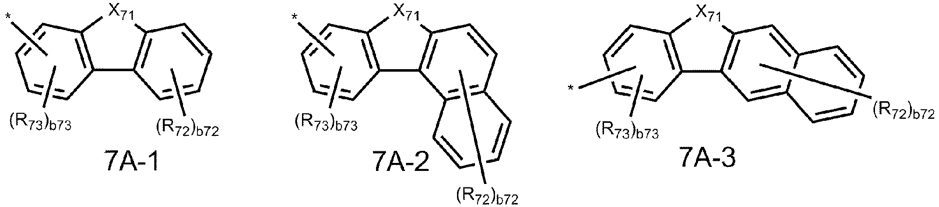 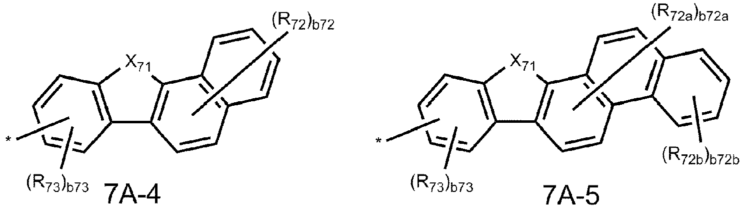 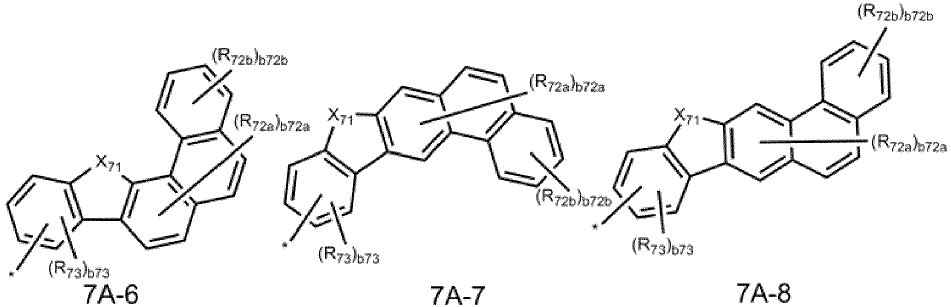 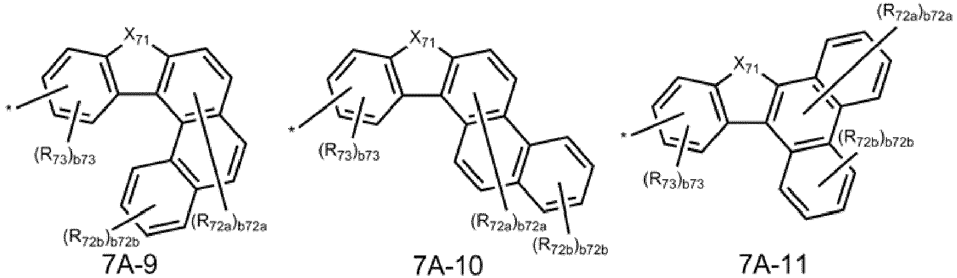 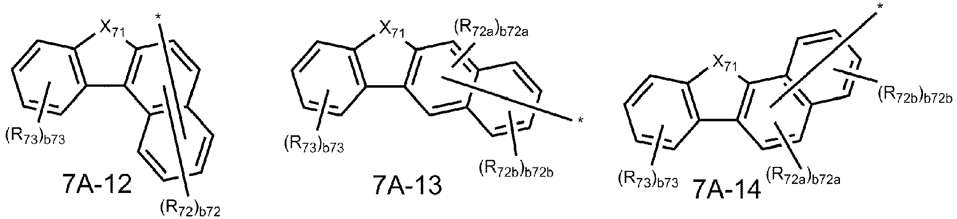 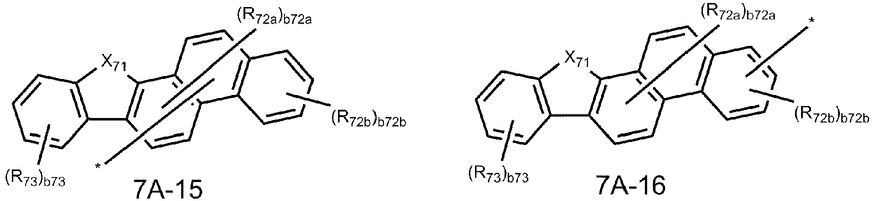 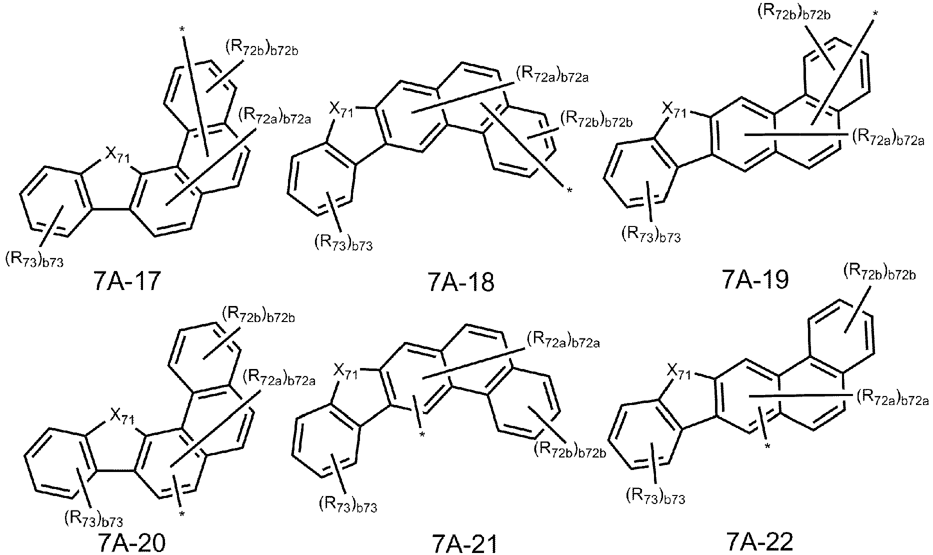 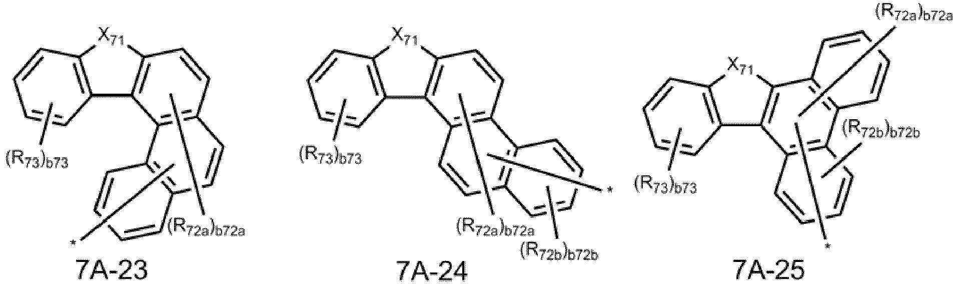 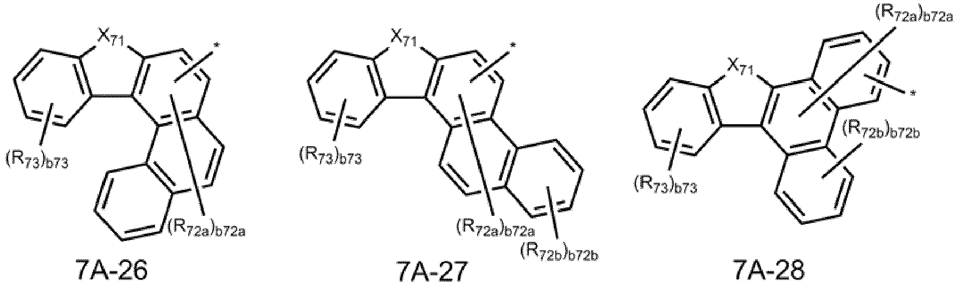 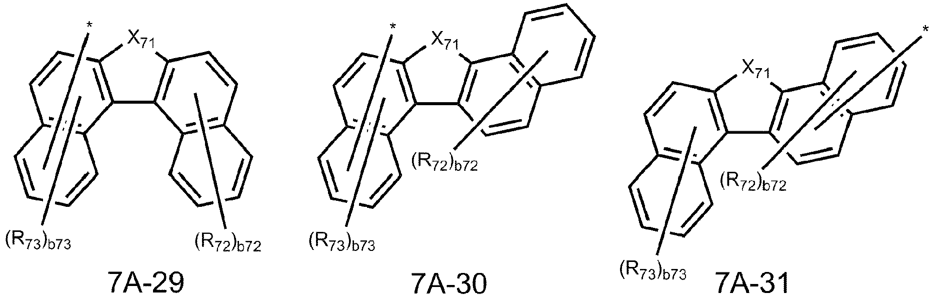 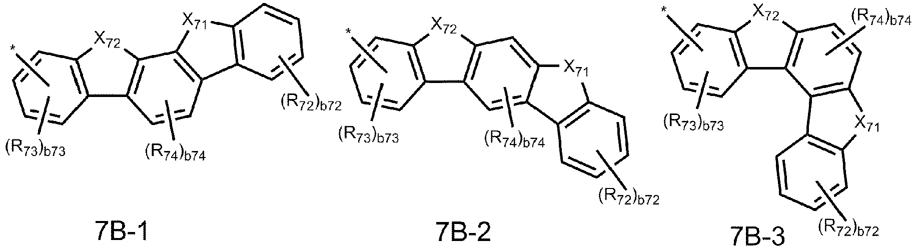 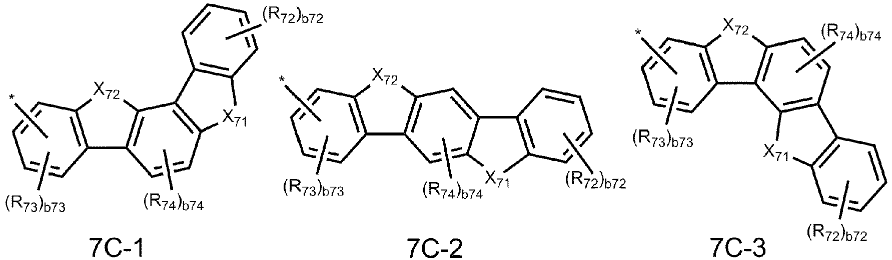 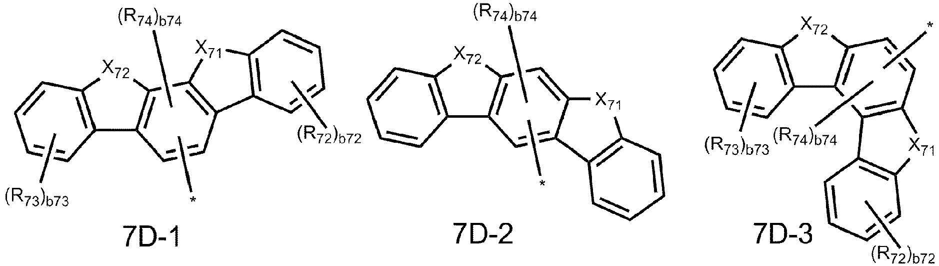 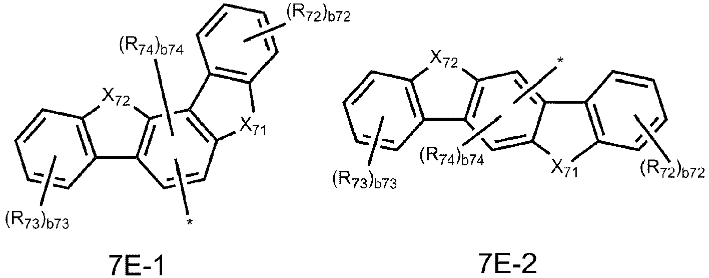
In Formulae 7A-1 to 7A-31, 7B-1 to 7B-3, 7C-1 to 7C-3, 7D-1 to 7D-3, 7E-1, and 7E-2,
X₇₁ is selected from O, S, N(R₇₅), and C(R₇₅)(R₇₆);
X₇₂ is selected from O, S, N(R₇₇), and C(R₇₇)(R₇₈);
R₇₂ to R₇₈, R₇₂ₐ, and R_{72b} are each independently selected from the group consisting of:
hydrogen, deuterium, a methyl group, an ethyl group, an n-propyl group, an iso-propyl group, an n-butyl group, a sec-butyl group, an iso-butyl group, a tert-butyl group, a phenyl group, a biphenyl group, a terphenyl group, and a naphthyl group; and
a phenyl group, a biphenyl group, and a naphthyl group, each substituted with at least one selected from deuterium, a methyl group, an ethyl group, an n-propyl group, an iso-propyl group, an n-butyl group, a sec-butyl group, an iso-butyl group, a tert-butyl group, and a phenyl group;
R₇₅ and R₇₆ are optionally linked to form a ring;
R₇₇ and R₇₈ are optionally linked to form a ring;
b72 to b74, b72a, and b72b are each independently selected from 1, 2, 3, 4, 5, 6, 7, and 8; and
* indicates a binding site to a neighboring atom; L₇₁ₐ and L_{71b} are each independently selected from a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group;
a71a and a71b are each independently selected from 0, 1, 2, and 3; and
wherein Q₁ to Q₃ are each independently selected from hydrogen, deuterium, - F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

14. An organic light-emitting device (10) according to any one of claims 1 to 13, wherein
the second compound represented by Formula 2 is represented by one selected from Formulae 2-1 and 2-2: 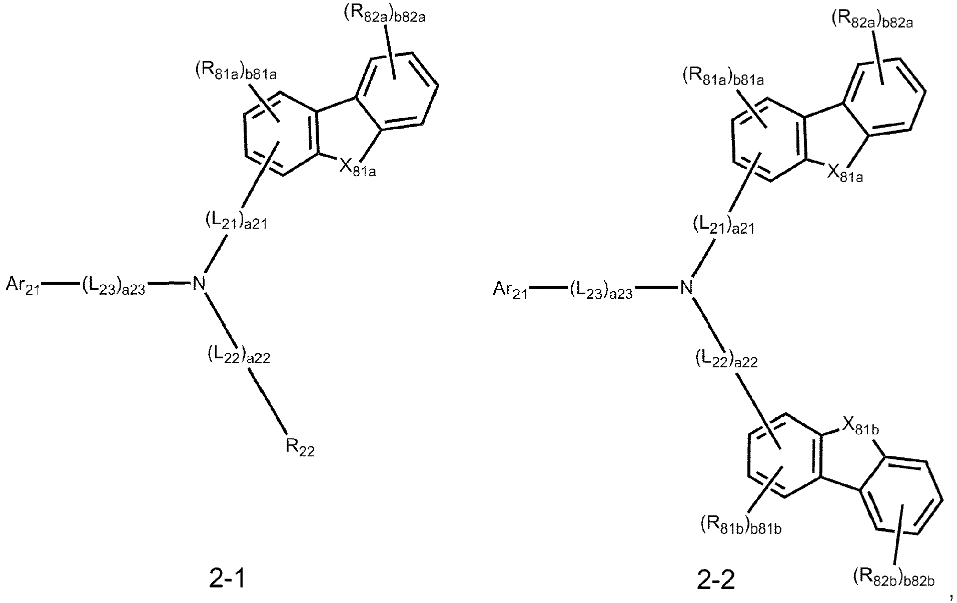 wherein, in Formulae 2-1 and 2-2,
Ar₂₁ is selected from a substituted or unsubstituted C₅-C₆₀ carbocyclic group and a substituted or unsubstituted C₁-C₆₀ heterocyclic group,
L₂₁ to L₂₃ are each independently selected from a substituted or unsubstituted C₆-C₆₀ arylene group, and a substituted or unsubstituted C₁-C₆₀ heteroarylene group;
a21 to a23 are each independently selected from 0, 1, 2, and 3;
R₂₂ is selected from a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group;
X₈₁ₐ and X_{81b} are each independently selected from O and S;
R₈₁ₐ, R_{81b}, R₈₂ₐ, and R_{82b} are each independently selected from the group consisting of:
-F, -Cl, -Br, -I, a cyano group, a C₁-C₆₀ alkyl group, a C₃-C₁₀ cycloalkyl group, a C₁-C₁₀ heterocycloalkyl group, a C₆-C₆₀ aryl group, a C₆-C₆₀ aryloxy group, a C₆-C₆₀ arylthio group, a C₁-C₆₀ heteroaryl group, and -Si(Q₁)(Q₂)(Q₃); and
a C₃-C₁₀ cycloalkyl group, a C₁-C₁₀ heterocycloalkyl group, a C₆-C₆₀ aryl group, a C₆-C₆₀ aryloxy group, a C₆-C₆₀ arylthio group, and a C₁-C₆₀ heteroaryl group, each substituted with at least one selected from -F, -Cl, -Br, -I, a cyano group, and a C₁-C₆₀ alkyl group;
b81a and b81b are each independently selected from 0, 1, 2, and 3;
b82a and b82b are each independently selected from 0, 1, 2, 3, and 4;
a sum of b81a and b82a is 1 or more;
a sum of b81b and b82b is 1 or more; and
Q₁ to Q₃ are each independently selected from hydrogen, deuterium, -F, -Cl, - Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ aalkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, and a terphenyl group.

15. An organic light-emitting device (10) according to any one of claims 1 to 14, wherein
the organic layer (150) comprises an emission layer;
the emission layer comprises the first compound and a dopant; and
the dopant comprises an arylmine compound or a styrylamine compound.

16. An organic light-emitting device (10) according to any one of claims 1 to 15, wherein
the organic layer (150) comprises an emission layer;
the emission layer comprises the first compound and a compound represented by Formula 501: 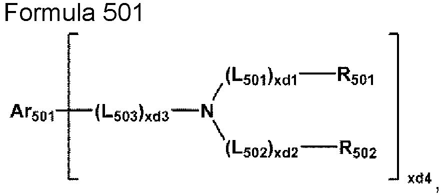 wherein, in Formula 501,
Ar₅₀₁ is selected from a substituted or unsubstituted C₅-C₆₀ carbocyclic group and a substituted or unsubstituted C₁-C₆₀ heterocyclic group,
L₅₀₁ to L₅₀₃ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xd1 to xd3 are each independently an integer selected from 0 to 3;
R₅₀₁ and R₅₀₂ are each independently selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, and
xd4 is an integer selected from 1 to 6.

17. An organic light-emitting device (10) according to any one of claims 1 to 16, wherein
the organic layer (150) comprises:
an emission layer; and
an electron transport region between the emission layer and the second electrode (190),
wherein the electron transport region comprises alkali metal, alkali-earth metal, rare-earth metal, an alkali metal compound, an alkali-earth metal compound, a rare-earth metal compound, an alkali metal complex, an alkali earth metal complex, a rare-earth metal complex, or a combination thereof.

18. An organic light-emitting device (10) according to claim 17, wherein
the electron transport region comprises an electron transport layer and an electron injection layer,
wherein at least one selected from the electron transport layer and the electron injection layer comprises alkali metal, alkali-earth metal, rare-earth metal, an alkali metal compound, an alkali-earth metal compound, a rare-earth metal compound, an alkali metal complex, an alkali earth metal complex, a rare-earth metal complex, or a combination thereof.

19. An organic light-emitting device (10) according to any one of claims 15 to 18, wherein
the emission layer is a first color light-emission layer; and
the organic layer (150) further comprises i) at least one second color light-emission layer or ii) at least one second color light-emission layer and at least one third color light-emission layer,
wherein a first color light of the first color light-emission layer and a second color light of the second color light-emission layer are identical to or different from each other; or the first color light, the second color light, and a third color light of the third color light-emission layer are identical to or different from one another; and
the first color light and the second color light are emitted as mixed light; or the first color light, the second color light, and the third color light are emitted as mixed light.

## Patentansprüche

1. Organische lichtemittierende Vorrichtung (10), umfassend:
eine erste Elektrode (110);
eine zweite Elektrode (190), die zu der ersten Elektrode (110) weist; und
eine organische Schicht (150) zwischen der ersten Elektrode (110) und der zweiten Elektrode (190),
wobei die organische Schicht (150) umfasst:
eine Emissionsschicht; und
eine Lochtransportregion zwischen der Emissionsschicht und der ersten Elektrode (110),
wobei die Emissionsschicht die durch Formel 1 repräsentierte erste Verbindung umfasst; und
die Lochtransportregion die durch Formel 2 repräsentierte zweite Verbindung und die durch eine aus den Formeln 3-1 bis 3-3 ausgewählte repräsentierte dritte Verbindung umfasst: 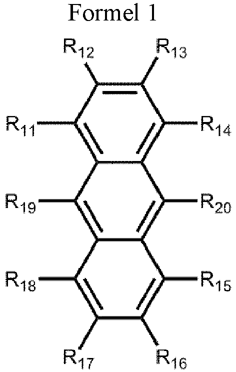 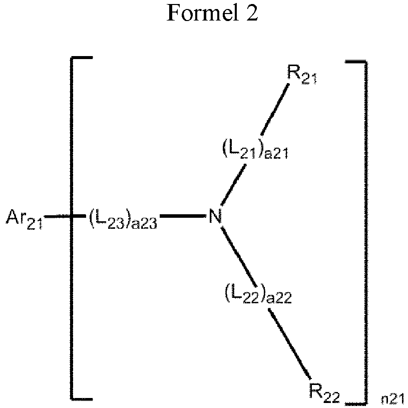 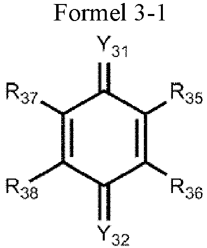 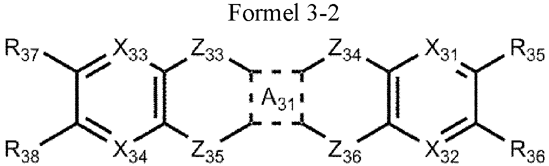 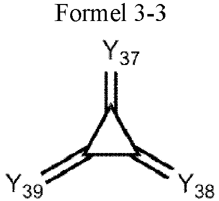
Formel 7 *-(L₇₁)ₐ₇₁-R₇₁ 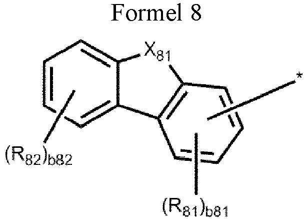 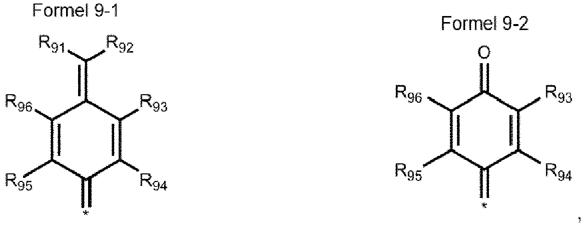
wobei in den Formeln 1, 2, 3-1 bis 3-3, 7, 8, 9-1 und 9-2
R₁₁ bis R₂₀ jeweils unabhängig aus einer durch Formel 7 repräsentierten Gruppe, Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer substituierten oder nicht substituierten C₁-C₆₀-Alkylgruppe, einer substituierten oder nicht substituierten C₂-C₆₀-Alkenylgruppe, einer substituierten oder nicht substituierten C₂-C₆₀-Alkynylgruppe, einer substituierten oder nicht substituierten C₁-C₆₀-Alkoxygruppe, einer substituierten oder nicht substituierten C₃-C₁₀-Cycloalkylgruppe, einer substituierten oder nicht substituierten C₁-C₁₀-Heterocycloalkylgruppe, einer substituierten oder nicht substituierten C₃-C₁₀-Cycloalkenylgruppe, einer substituierten oder nicht substituierten C₁-C₁₀-Heterocycloalkenylgruppe, einer substituierten oder nicht substituierten C₆-C₆₀-Arylgruppe, einer substituierten oder nicht substituierten C₆-C₆₀-Aryloxygruppe, einer substituierten oder nicht substituierten C₆-C₆₀-Arylthiogruppe, einer substituierten oder nicht substituierten C₁-C₆₀-Heteroarylgruppe, einer substituierten oder nicht substituierten monovalenten, nichtaromatischen, kondensierten, polycyclischen Gruppe, einer substituierten oder nicht substituierten monovalenten, nichtaromatischen, kondensierten, heteropolycyclischen Gruppe, -Si(Q₁)(Q₂)(Q₃), -N(Q₁)(Q₂), -B(Q₁)(Q₂), - C(=O)(Q₁), -S(=O)₂(Q₁) und -P(=O)(Q₁)(Q₂) ausgewählt sind, mit der Maßgabe, dass mindestens eine aus R₁₁ bis R₂₀ ausgewählte die durch Formel 7 repräsentierte Gruppe ist;
i) zwei benachbarte Gruppen, ausgewählt aus R₁₁ bis R₂₀, verknüpft sind, um einen Ring zu bilden, und R₇₁ aus einer substituierten oder nicht substituierten C₆-C₆₀-Arylgruppe, einer substituierten oder nicht substituierten C₁-C₆₀-Heteroarylgruppe, einer substituierten oder nicht substituierten monovalenten, nichtaromatischen, kondensierten, polycyclischen Gruppe und einer substituierten oder nicht substituierten monovalenten, nichtaromatischen, kondensierten, heteropolycyclischen Gruppe ausgewählt ist; oder
ii) R₇₁ aus einer Phenanthrenylgruppe, einer Anthracenylgruppe, einer Tetraphenylgruppe, einer Carbazolylgruppe und einer Gruppe, repräsentiert durch eine aus den Formeln 7A-1 bis 7A-31, 7B-1 bis 7B-3, 7C-1 bis 7C-3, 7D-1 bis 7D-3, 7E-1 und 7E-2 ausgewählte, ausgewählt ist;
einer Phenanthrenylgruppe, einer Anthracenylgruppe, einer Tetraphenylgruppe, einer Carbazolylgruppe, jede substituiert mit mindestens einer, ausgewählt aus Deuterium, einer Methylgruppe, einer Ethylgruppe, einer n-Propylgruppe, einer Isopropylgruppe, einer n-Butylgruppe, einer sec-Butylgruppe, einer Isobutylgruppe, einer tert-Butylgruppe, einer Phenylgruppe, einer Biphenylgruppe, einer Terphenylgruppe und einer Naphthylgruppe; und
einer Phenanthrenylgruppe, einer Anthracenylgruppe, einer Tetraphenylgruppe, einer Carbazolylgruppe, jede substituiert mit mindestens einem Substituenten, ausgewählt aus einer Phenylgruppe und einer Naphthylgruppe, wobei jeder des mindestens einen Substituenten mit mindestens einem substituiert ist, ausgewählt aus Deuterium, einer Methylgruppe, einer Ethylgruppe, einer n-Propylgruppe, einer Isopropylgruppe, einer n-Butylgruppe, einer sec-Butylgruppe, einer Isobutylgruppe, einer tert-Butylgruppe und einer Phenylgruppe: 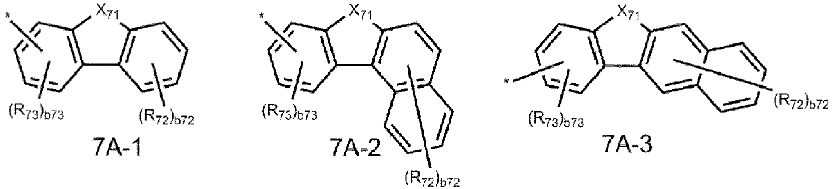 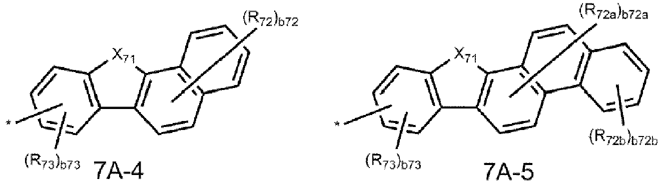 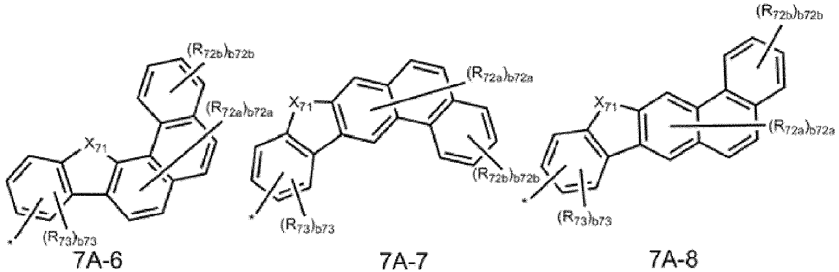 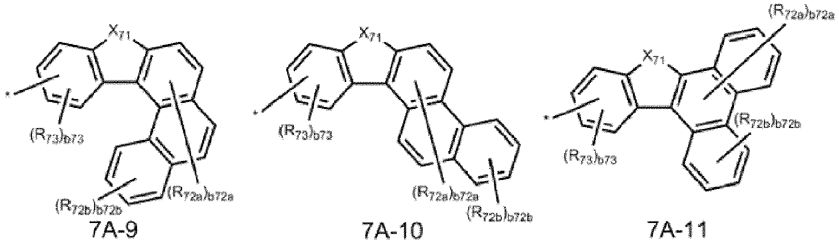 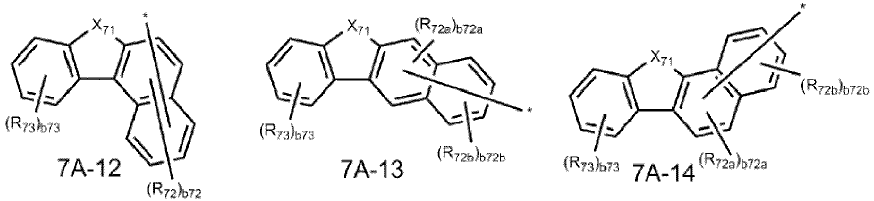 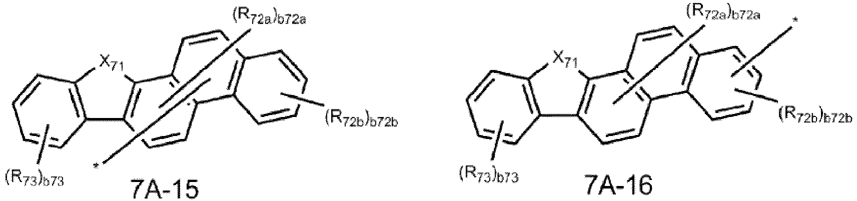 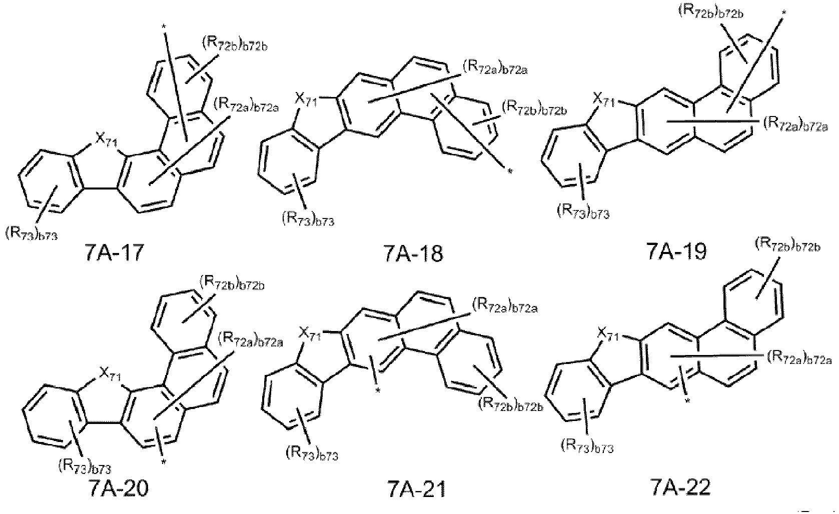 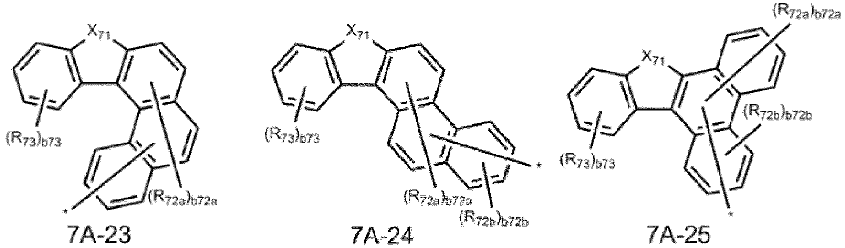 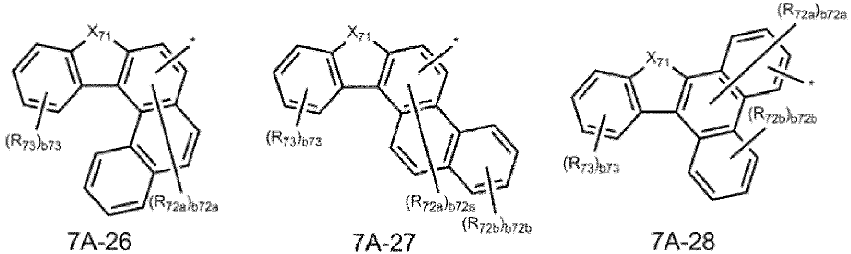 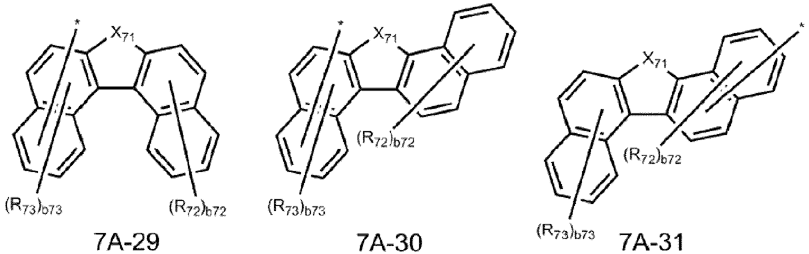 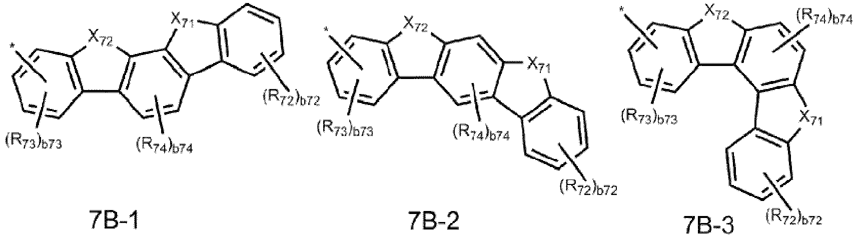 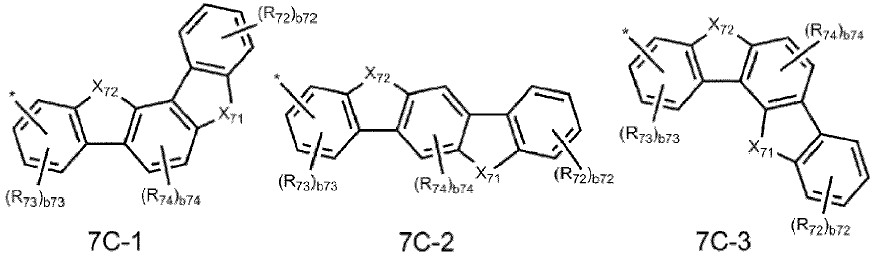 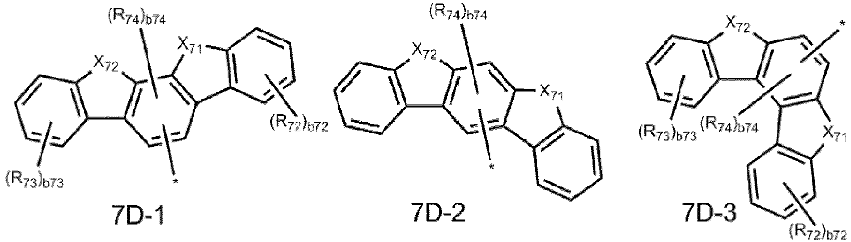 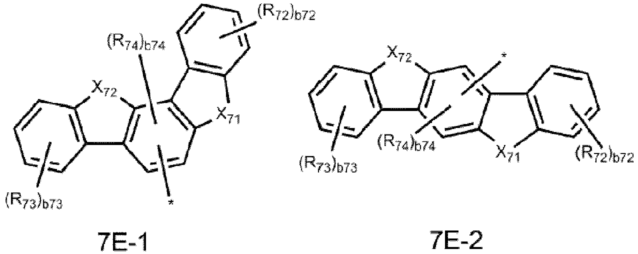
wobei in den Formeln 7A-1 bis 7A-31, 7B-1 bis 7B-3, 7C-1 bis 7C-3, 7D-1 bis 7D-3, 7E-1 und 7E-2,
X₇₁ aus O, S, N(R₇₅) und C(R₇₅)(R₇₆) ausgewählt ist;
X₇₂ aus O, S, N(R₇₇) und C(R₇₇)(R₇₈) ausgewählt ist;
R₇₂ bis R₇₈, R₇₂ₐ und R_{72b} jeweils unabhängig aus der Gruppe ausgewählt sind, bestehend aus:
Wasserstoff, Deuterium, einer Methylgruppe, einer Ethylgruppe, einer n-Propylgruppe, einer Isopropylgruppe, einer n-Butylgruppe, einer sec-Butylgruppe, einer Isobutylgruppe, einer tert-Butylgruppe, einer Phenylgruppe, einer Biphenylgruppe, einer Terphenylgruppe und einer Naphthylgruppe; und
einer Phenylgruppe, einer Biphenylgruppe und einer Naphthylgruppe, jede substituiert mit mindestens einem, ausgewählt aus Deuterium, einer Methylgruppe, einer Ethylgruppe, einer n-Propylgruppe, einer Isopropylgruppe, einer n-Butylgruppe, einer sec-Butylgruppe, einer Isobutylgruppe, einer tert-Butylgruppe und einer Phenylgruppe;
R₇₅ und R₇₆ wahlweise verknüpft sind, um einem Ring zu bilden;
R₇₇ und R₇₈ wahlweise verknüpft sind, um einem Ring zu bilden;
b72 bis b74, b72a und b72b jeweils unabhängig aus 1, 2, 3, 4, 5, 6, 7 und 8 ausgewählt sind; und
* eine Bindungsstelle an ein benachbartes Atom angibt;
L₇₁ aus einer substituierten oder nicht substituierten C₆-C₆₀-Arylengruppe, einer substituierten oder nicht substituierten C₁-C₆₀-Heteroarylengruppe, einer substituierten oder nicht substituierten divalenten, nichtaromatischen, kondensierten, polycyclischen Gruppe und einer substituierten oder nicht substituierten divalenten, nichtaromatischen, kondensierten, heteropolycyclischen Gruppe ausgewählt ist;
a71 aus 0, 1, 2 und 3 ausgewählt ist;
Ar₂₁ eine substituierte oder nicht substituierte C₅-C₆₀-Carbocyclusgruppe oder eine substituierte oder nicht substituierte C₁-C₆₀-Heterocyclusgruppe ist;
L₂₁ bis L₂₃ jeweils unabhängig aus einer substituierten oder nicht substituierten C₆-C₆₀-Arylengruppe und einer substituierten oder nicht substituierten C₁-C₆₀-Heteroarylengruppe ausgewählt sind;
a21 bis a23 jeweils unabhängig aus 0, 1, 2 und 3 ausgewählt sind;
R₂₁ und R₂₂ jeweils unabhängig aus einer durch Formel 8 repräsentierten Gruppe, einer substituierten oder nicht substituierten C₆-C₆₀-Arylgruppe, einer substituierten oder nicht substituierten C₁-C₆₀-Heteroarylgruppe, einer substituierten oder nicht substituierten monovalenten, nichtaromatischen, kondensierten, polycyclischen Gruppe und einer substituierten oder nicht substituierten monovalenten, nichtaromatischen, kondensierten, heteropolycyclischen Gruppe ausgewählt sind, mit der Maßgabe, dass mindestens eine aus R₂₁ und R₂₂ ausgewählte die durch Formel 8 repräsentierte Gruppe ist;
X₈₁ aus O und S ausgewählt ist;
R₈₁ und R₈₂ jeweils unabhängig aus der Gruppe ausgewählt sind, bestehend aus:
-F, -Cl, -Br, -I, einer Cyanogruppe, einer C₁-C₆₀-Alkylgruppe, einer C₃-C₁₀-Cycloalkylgruppe, einer C₁-C₁₀-Heterocycloalkylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe und -Si(Q₁)(Q₂)(Q₃); und
einer C₃-C₁₀-Cycloalkylgruppe, einer C₁-C₁₀-Heterocycloalkylgruppe, einer C₆-C₆₀-Arylgruppe, einer C₆-C₆₀-Aryloxygruppe, einer C₆-C₆₀-Arylthiogruppe und einer C₁-C₆₀-Heteroarylgruppe, jede substituiert mit mindestens einem, ausgewählt aus Deuterium, -F, -Cl, -Br, -I, einer Cyanogruppe, einer C₁-C₆₀-Alkylgruppe, einer C₆-C₆₀-Arylgruppe, einer C₁-C₆₀-Heteroarylgruppe und -Si(Q₃₁)(Q₃₂)(Q₃₃);
b81 aus 0, 1, 2 und 3 ausgewählt ist; b82 aus 0, 1, 2, 3 und 4 ausgewählt ist; eine Summe von b81 und b82 gleich 1 oder mehr ist;
n21 aus 1, 2 und 3 ausgewählt ist;
A₃₁ aus einer substituierten oder nicht substituierten C₅-C₆₀-Carbocyclusgruppe und einer substituierten oder nicht substituierten C₁-C₆₀-Heterocyclusgruppe ausgewählt ist;
X₃₁ aus N und C(R₃₁) ausgewählt ist, X₃₂ aus N und C(R₃₂) ausgewählt ist, X₃₃ aus N und C(R₃₃) ausgewählt ist, X₃₄ aus N und C(R₃₄) ausgewählt ist;
Z₃₃ aus einer Einzelbindung und C=Y₃₃ ausgewählt ist; Z₃₄ aus einer Einzelbindung und C=Y₃₄ ausgewählt ist; Z₃₅ aus einer Einzelbindung und C=Y₃₅ ausgewählt ist; Z₃₆ aus einer Einzelbindung und C=Y₃₆ ausgewählt ist; mindestens eine aus Z₃₃ bis Z₃₆ ausgewählte keine Einzelbindung ist;
Y₃₁ bis Y₃₉ jeweils unabhängig aus N(CN), C(CN)(R₉₁), C(R₉₁)(R₉₂), einer durch Formel 9-1 repräsentierten Gruppe und einer durch Formel 9-2 repräsentierten Gruppe ausgewählt sind;
R₉₁ und R₉₂ jeweils unabhängig aus -F, -Cl, -Br, -I, einer Cyanogruppe, einer substituierten oder nicht substituierten C₁-C₆₀-Alkylgruppe, einer substituierten oder nicht substituierten C₆-C₆₀-Arylgruppe, einer substituierten oder nicht substituierten C₁-C₆₀-Heteroarylgruppe und -C(=O)OR₉₇ ausgewählt sind; und
R₃₁ bis R₃₈ und R₉₃ bis R₉₇ jeweils unabhängig aus Wasserstoff, Deuterium, -F, - Cl, -Br, -I, einer Hydroxylgruppe, einer Cyanogruppe, einer Nitrogruppe, einer Amidinogruppe, einer Hydrazinogruppe, einer Hydrazonogruppe, einer substituierten oder nicht substituierten C₁-C₆₀-Alkylgruppe, einer substituierten oder nicht substituierten C₂-C₆₀-Alkenylgruppe, einer substituierten oder nicht substituierten C₂-C₆₀-Alkynylgruppe, einer substituierten oder nicht substituierten C₁-C₆₀-Alkoxygruppe, einer substituierten oder nicht substituierten C₃-C₁₀-Cycloalkylgruppe, einer substituierten oder nicht substituierten C₁-C₁₀-Heterocycloalkylgruppe, einer substituierten oder nicht substituierten C₃-C₁₀-Cycloalkenylgruppe, einer substituierten oder nicht substituierten C₁-C₁₀-Heterocycloalkenylgruppe, einer substituierten oder nicht substituierten C₆-C₆₀-Arylgruppe, einer substituierten oder nicht substituierten C₆-C₆₀-Aryloxygruppe, einer substituierten oder nicht substituierten C₆-C₆₀-Arylthiogruppe, einer substituierten oder nicht substituierten C₁-C₆₀-Heteroarylgruppe, einer substituierten oder nicht substituierten monovalenten, nichtaromatischen, kondensierten, polycyclischen Gruppe, einer substituierten oder nicht substituierten monovalenten, nichtaromatischen, kondensierten, heteropolycyclischen Gruppe, -Si(Q₁)(Q₂)(Q₃), -N(Q₁)(Q₂), -B(Q₁)(Q₂), -C(=O)(Q₁), - S(=O)₂(Q₁) und -P(=O)(Q₁)(Q₂) ausgewählt sind,
wobei Q₁ bis Q₃ und Q₃₁ bis Q₃₃ jeweils unabhängig aus Wasserstoff, Deuterium, - F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer monovalenten, nichtaromatischen, kondensierten, polycyclischen Gruppe, einer monovalenten, nichtaromatischen, kondensierten, heteropolycyclischen Gruppe, einer Biphenylgruppe und einer Terphenylgruppe ausgewählt sind; und
* eine Bindungsstelle an ein benachbartes Atom angibt.

2. Organische lichtemittierende Vorrichtung (10) nach Anspruch 1, wobei
die dritte Verbindung notwendigerweise mindestens einen Substituenten enthält, ausgewählt aus der Gruppe, bestehend aus:
einer Cyanogruppe, -F, -Cl, -Br und -I; und
einer C₁-C₂₀-Alkylgruppe, substituiert mit mindestens einem, ausgewählt aus -F, - Cl, -Br und -I.

3. Organische lichtemittierende Vorrichtung nach Anspruch 1 oder Anspruch 2, wobei
R₁₁ bis R₂₀ jeweils unabhängig aus der durch Formel 7 repräsentierten Gruppe, Wasserstoff, Deuterium, -F, -Cl, -Br, -I, einer Cyanogruppe, einer C₁-C₆₀-Alkylgruppe, einer C₆-C₆₀-Arylgruppe, einer C₁-C₆₀-Heteroarylgruppe und -Si(Q₁)(Q₂)(Q₃) ausgewählt sind,
wobei Q₁ bis Q₃ jeweils unabhängig aus einer C₁-C₆₀-Alkylgruppe, einer C₆-C₆₀-Arylgruppe, einer Biphenylgruppe und einer Terphenylgruppe ausgewählt sind.

4. Organische lichtemittierende Vorrichtung (10) nach einem der Ansprüche 1 bis 3, wobei
L₇₁ aus der Gruppe ausgewählt ist, bestehend aus:
einer Phenylengruppe, einer Naphthylengruppe, einer Fluorenylengruppe, einer Phenanthrenylengruppe, einer Anthracenylengruppe, einer Triphenylenylengruppe, einer Pyrenylengruppe, einer Chrysenylengruppe, einer Pyrrolylengruppe, einer Thiophenylengruppe, einer Furanylengruppe, einer Imidazolylengruppe, einer Pyridinylengruppe, einer Pyrazinylengruppe, einer Pyrimidinylengruppe, einer Pyridazinylengruppe, einer Indolylengruppe, einer Chinolinylengruppe, einer Isochinolinylengruppe, einer Benzochinolinylengruppe, einer Phenanthridinylengruppe, einer Acridinylengruppe, einer Phenanthrolinylengruppe, einer Benzofuranylengruppe, einer Benzothiophenylengruppe, einer Triazolylengruppe, einer Tetrazolylengruppe, einer Triazinylengruppe, einer Dibenzofuranylengruppe und einer Dibenzothiophenylengruppe; und
einer Phenylengruppe, einer Naphthylengruppe, einer Fluorenylengruppe, einer Phenanthrenylengruppe, einer Anthracenylengruppe, einer Triphenylenylengruppe, einer Pyrenylengruppe, einer Chrysenylengruppe, einer Pyrrolylengruppe, einer Thiophenylengruppe, einer Furanylengruppe, einer Imidazolylengruppe, einer Pyridinylengruppe, einer Pyrazinylengruppe, einer Pyrimidinylengruppe, einer Pyridazinylengruppe, einer Indolylengruppe, einer Chinolinylengruppe, einer Isochinolinylengruppe, einer Benzochinolinylengruppe, einer Phenanthridinylengruppe, einer Acridinylengruppe, einer Phenanthrolinylengruppe, einer Benzofuranylengruppe, einer Benzothiophenylengruppe, einer Triazolylengruppe, einer Tetrazolylengruppe, einer Triazinylengruppe, einer Dibenzofuranylengruppe und einer Dibenzothiophenylengruppe, jede substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Terphenylgruppe, einer Naphthylgruppe, einer Fluorenylgruppe, einer Spiro-Fluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Tetraphenylgruppe, einer Chrysenylgruppe, einer Perylenylgruppe, einer Pentaphenylgruppe, einer Hexacenylgruppe, einer Pentacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Indazolylgruppe, einer Chinolinylgruppe, einer Isochinolinylgruppe, einer Carbazolylgruppe, einer Benzochinolinylgruppe, einer Phthalazinylgruppe, einer Naphthyridinylgruppe, einer Chinoxalinylgruppe, einer Chinazolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe und einer Dibenzocarbazolylgruppe.

5. Organische lichtemittierende Vorrichtung (10) nach einem der Ansprüche 1 bis 4, wobei
R₇₁ aus den Formeln 7-4 bis 7-12, 7-17 bis 7-186 und 7-194 bis 7-202 ausgewählt ist: 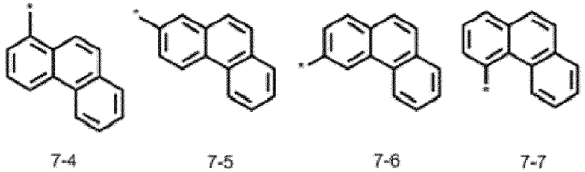 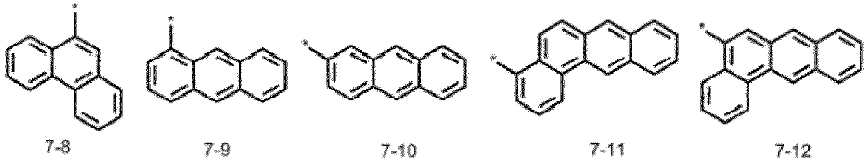 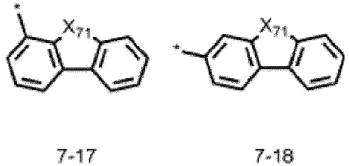 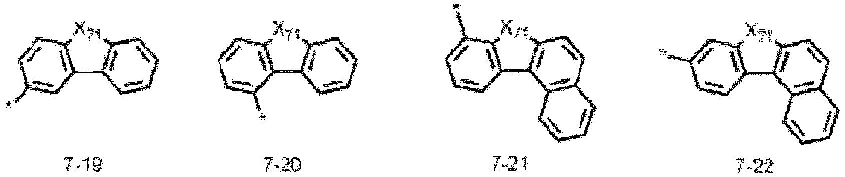 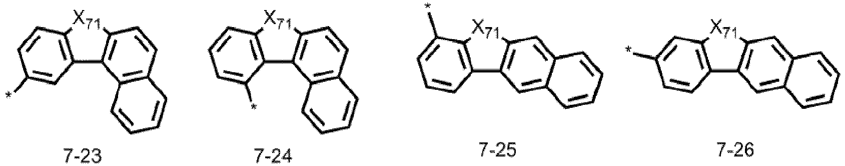 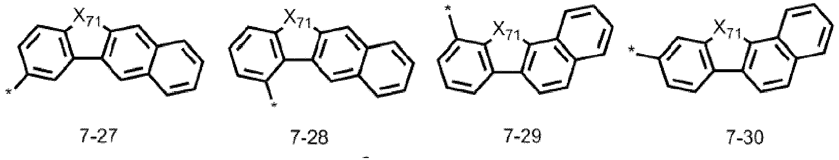 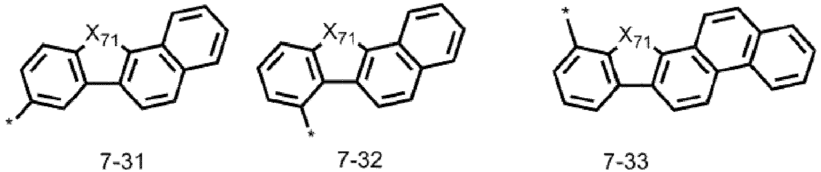 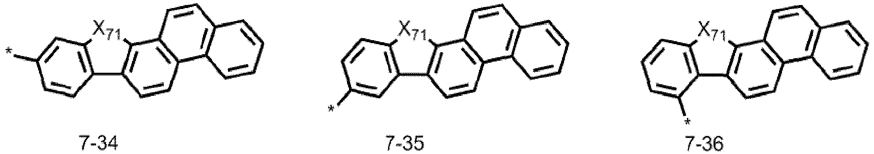 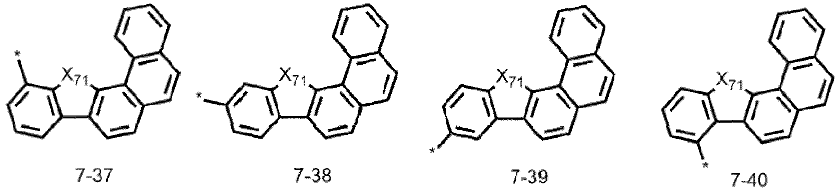 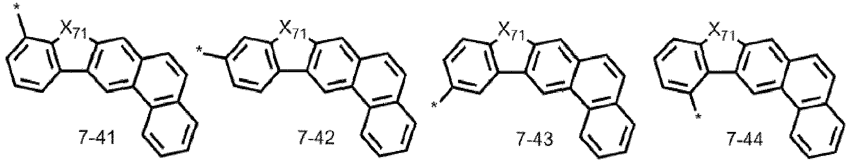 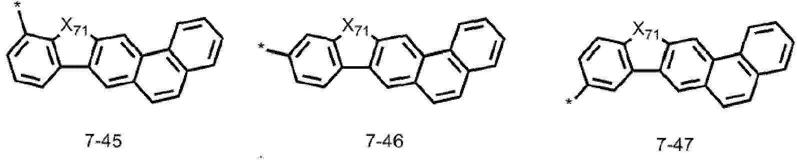 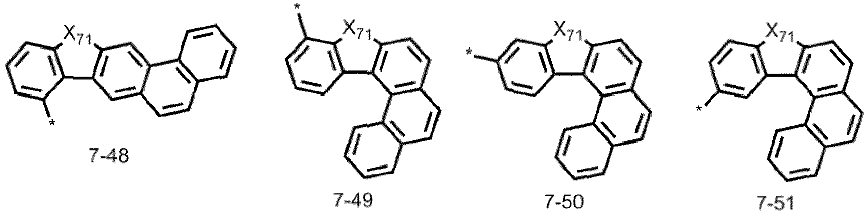 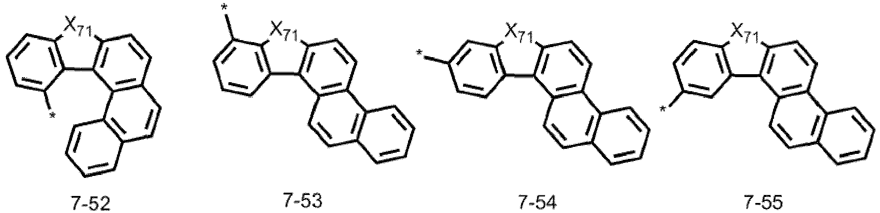 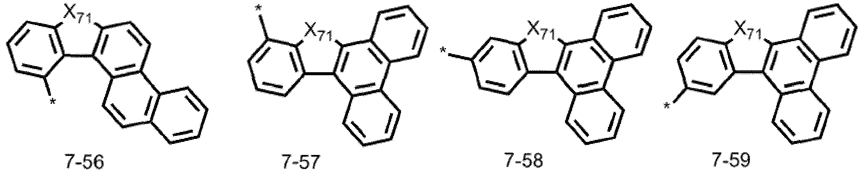 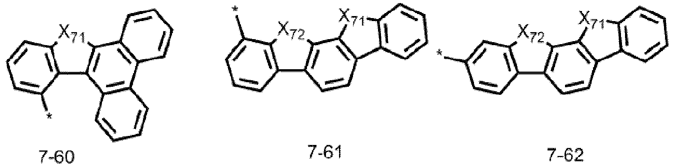 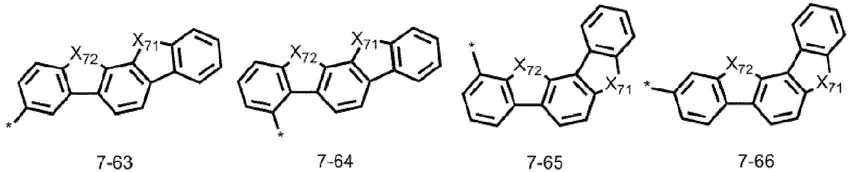 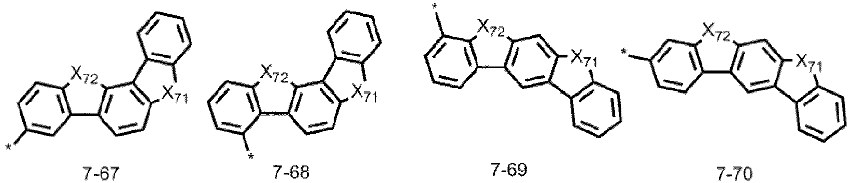 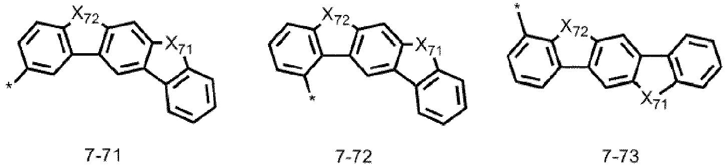 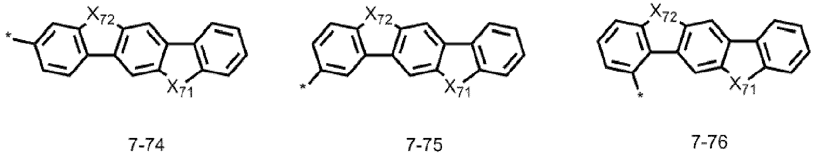 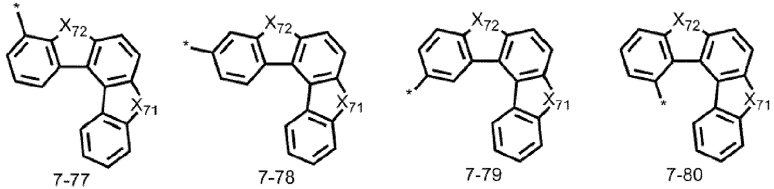 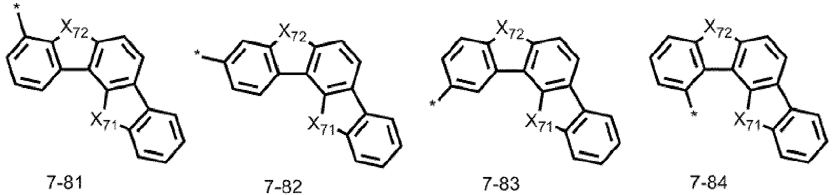 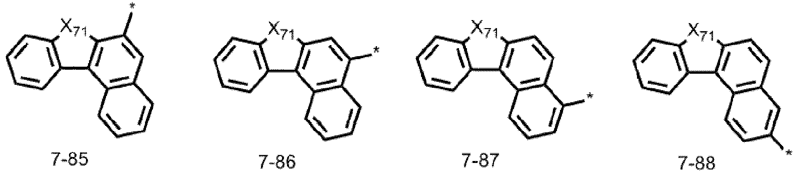 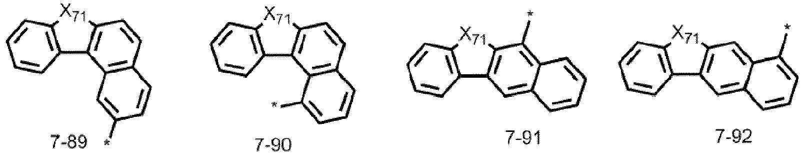 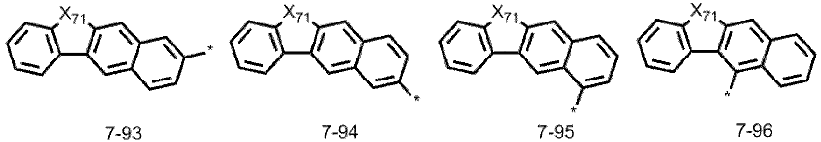 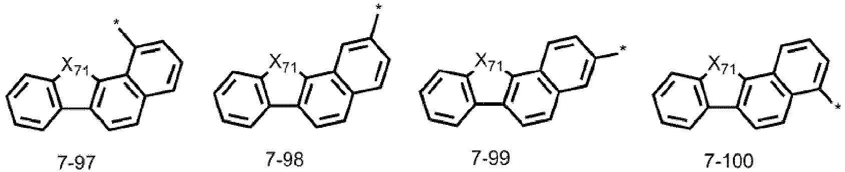 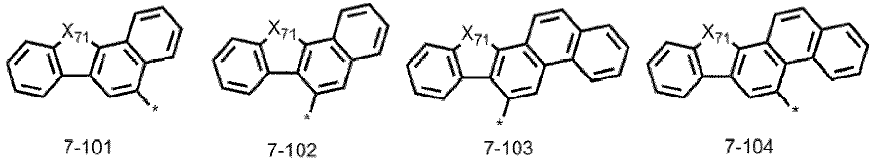 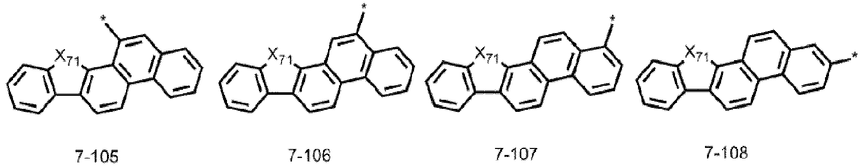 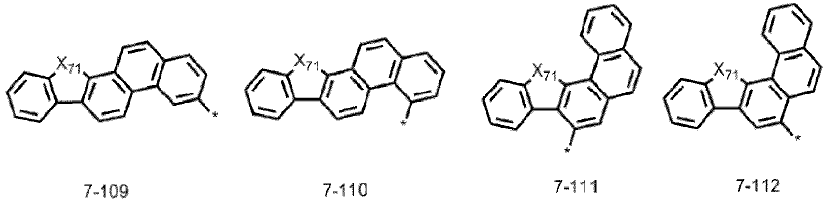 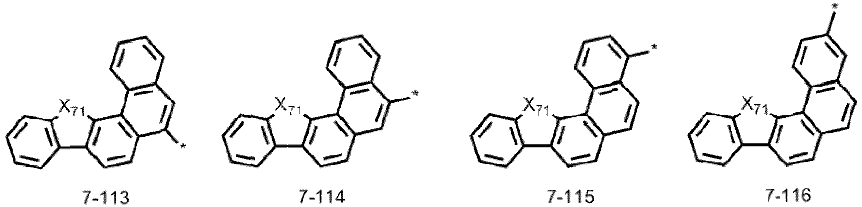 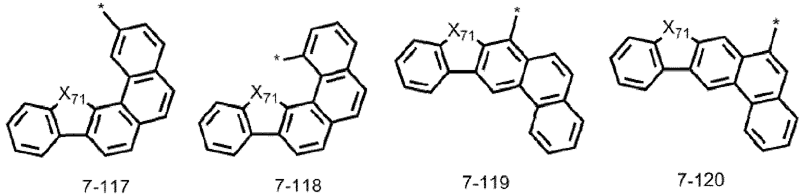 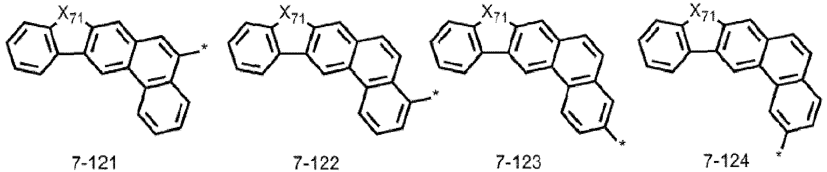 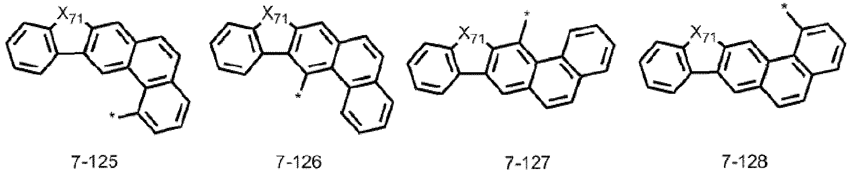 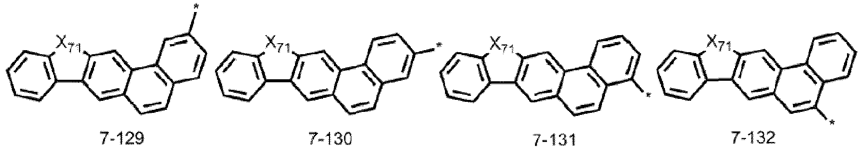 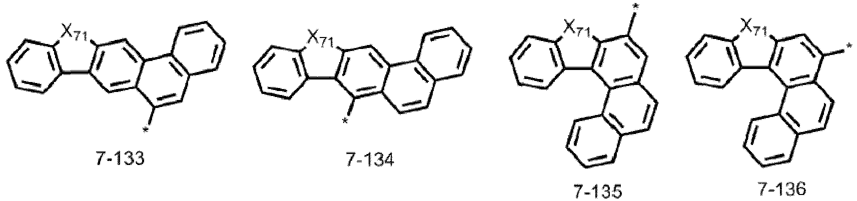 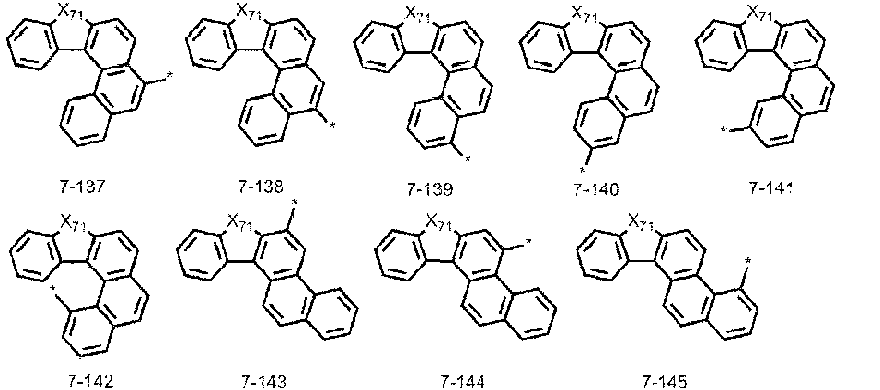 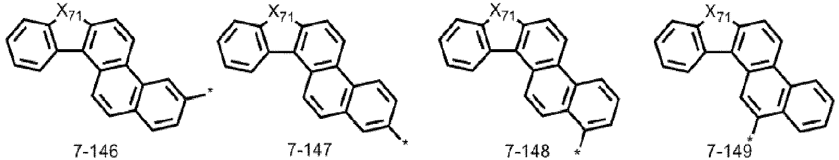 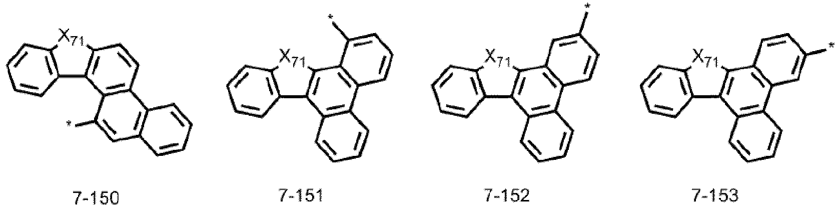 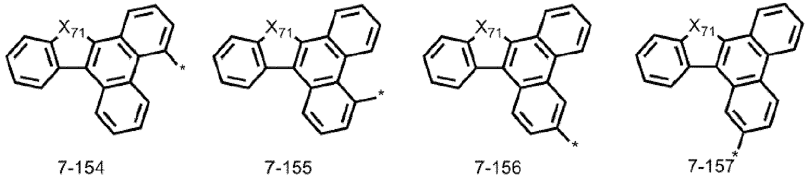 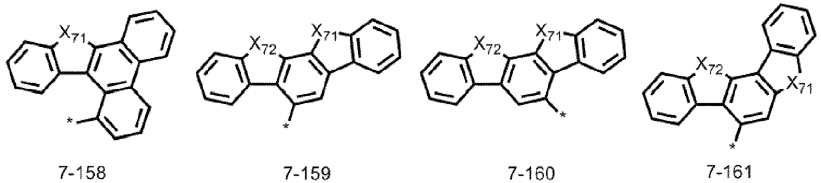 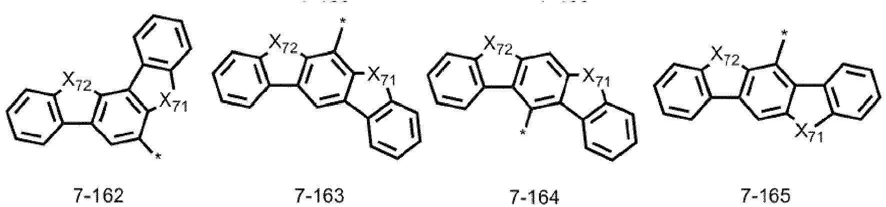 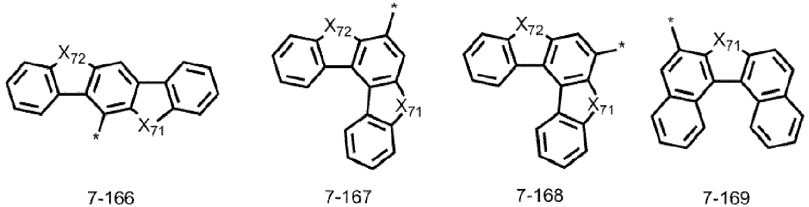 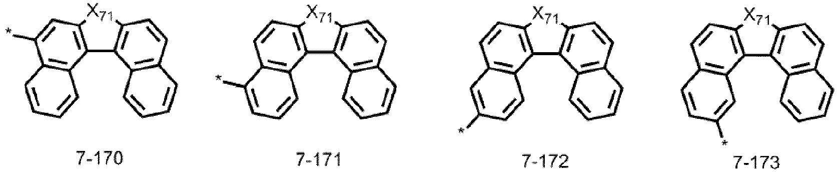 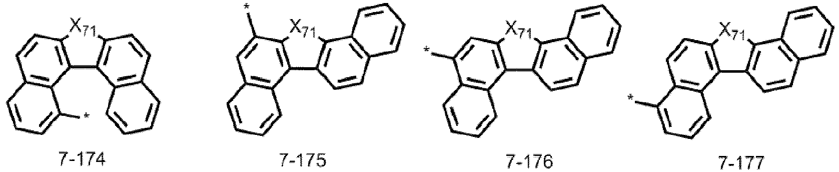 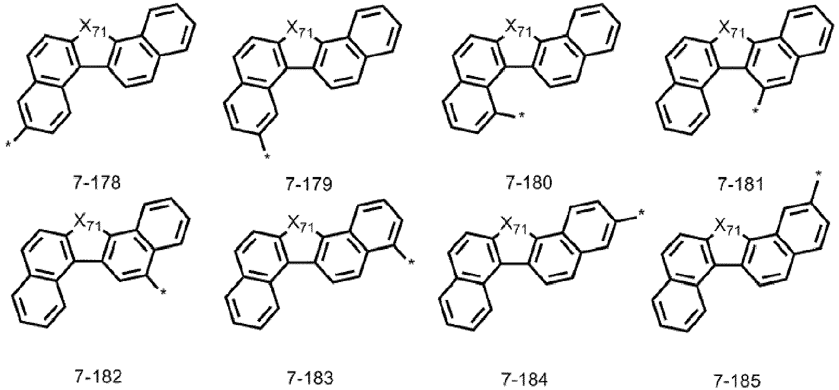 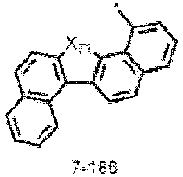 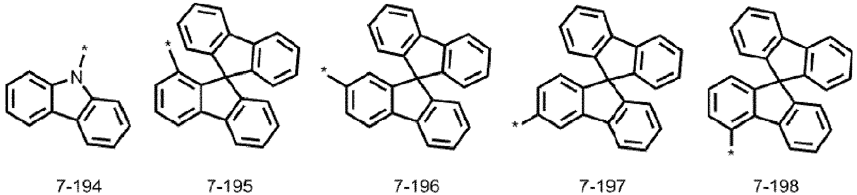 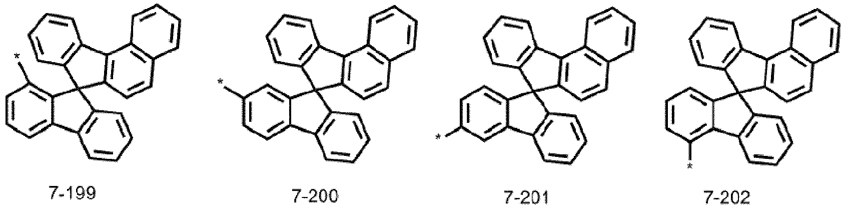 wobei in den Formeln 7-4 bis 7-12, 7-17 bis 7-186 und 7-194 bis 7-202
X₇₁ und X₇₂ jeweils unabhängig aus O, S, N(Ph), N(D₆-Ph), N(2-biPh), N(3-biPh), N(4-biPh), C(CH₃)₂, C(CH₃)(Ph) und C(Ph)₂ ausgewählt sind; und
* eine Bindungsstelle an ein benachbartes Atom angibt.

6. Organische lichtemittierende Vorrichtung (10) nach einem der Ansprüche 1 bis 5, wobei
Ar₂₁ aus der Gruppe ausgewählt ist, bestehend aus:
einer Benzengruppe, einer Naphthalengruppe, einer Fluorengruppe, einer Spiro-Bifluorengruppe, einer Phenanthrengruppe, einer Anthracengruppe, einer Triphenylengruppe, einer Pyridingruppe, einer Pyrazingruppe, einer Pyrimidingruppe, einer Pyridazingruppe, einer Chinolingruppe, einer Isochinolingruppe, einer Carbazolgruppe, einer Dibenzofurangruppe und einer Dibenzothiophengruppe; und
einer Benzengruppe, einer Naphthalengruppe, einer Fluorengruppe, einer Spiro-Bifluorengruppe, einer Phenanthrengruppe, einer Anthracengruppe, einer Triphenylengruppe, einer Pyridingruppe, einer Pyrazingruppe, einer Pyrimidingruppe, einer Pyridazingruppe, einer Chinolingruppe, einer Isochinolingruppe, einer Carbazolgruppe, einer Dibenzofurangruppe und einer Dibenzothiophengruppe, jede substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Terphenylgruppe, einer Naphthylgruppe, -Si(Q₃₁)(Q₃₂)(Q₃₃), -N(Q₃₁)(Q₃₂), -B(Q₃₁)(Q₃₂), -+C(=O)(Q₃₁), - S(=O)₂(Q₃₁) und -P(=O)(Q₃₁)(Q₃₂),
wobei Q₃₁ bis Q₃₃ jeweils unabhängig aus einer C₁-C₁₀-Alkylgruppe, einer Phenylgruppe, einer Biphenylgruppe, einer Terphenylgruppe, einer Naphthylgruppe, einer Fluorenylgruppe, einer Dibenzofuranylgruppe, einer Dibenzothiophenylgruppe und einer Carbazolylgruppe ausgewählt sind; und
einer Phenylgruppe, einer Biphenylgruppe, einer Terphenylgruppe, einer Naphthylgruppe, einer Fluorenylgruppe, einer Dibenzofuranylgruppe, einer Dibenzothiophenylgruppe und einer Carbazolylgruppe, jede substituiert mit mindestens einem, ausgewählt aus einer C₁-C₁₀-Alkylgruppe, einer Phenylgruppe und einer Naphthylgruppe.

7. Organische lichtemittierende Vorrichtung (10) nach einem der Ansprüche 1 bis 6, wobei
L₂₁ bis L₂₃ jeweils unabhängig aus der Gruppe ausgewählt sind, bestehend aus:
einer Phenylengruppe, einer Naphthylengruppe, einer Phenanthrenylengruppe, einer Anthracenylengruppe, einer Triphenylenylengruppe, einer Pyrenylengruppe, einer Chrysenylengruppe, einer Pyrrolylengruppe, einer Thiophenylengruppe, einer Furanylengruppe, einer Imidazolylengruppe, einer Pyridinylengruppe, einer Pyrazinylengruppe, einer Pyrimidinylengruppe, einer Pyridazinylengruppe, einer Indolylengruppe, einer Chinolinylengruppe, einer Isochinolinylengruppe, einer Benzochinolinylengruppe, einer Phenanthridinylengruppe, einer Acridinylengruppe, einer Phenanthrolinylengruppe, einer Triazolylengruppe, einer Tetrazolylengruppe und einer Triazinylengruppe; und
einer Phenylengruppe, einer Naphthylengruppe, einer Phenanthrenylengruppe, einer Anthracenylengruppe, einer Triphenylenylengruppe, einer Pyrenylengruppe, einer Chrysenylengruppe, einer Pyrrolylengruppe, einer Thiophenylengruppe, einer Furanylengruppe, einer Imidazolylengruppe, einer Pyridinylengruppe, einer Pyrazinylengruppe, einer Pyrimidinylengruppe, einer Pyridazinylengruppe, einer Indolylengruppe, einer Chinolinylengruppe, einer Isochinolinylengruppe, einer Benzochinolinylengruppe, einer Phenanthridinylengruppe, einer Acridinylengruppe, einer Phenanthrolinylengruppe, einer Triazolylengruppe, einer Tetrazolylengruppe und einer Triazinylengruppe, jede substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Terphenylgruppe, einer Naphthylgruppe, einer Fluorenylgruppe, einer Spiro-Fluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Tetraphenylgruppe, einer Chrysenylgruppe, einer Perylenylgruppe, einer Pentaphenylgruppe, einer Hexacenylgruppe, einer Pentacenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Indazolylgruppe, einer Chinolinylgruppe, einer Isochinolinylgruppe, einer Carbazolylgruppe, einer Benzochinolinylgruppe, einer Phthalazinylgruppe, einer Naphthyridinylgruppe, einer Chinoxalinylgruppe, einer Chinazolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe und einer Dibenzocarbazolylgruppe.

8. Organische lichtemittierende Vorrichtung (10) nach einem der Ansprüche 1 bis 7, wobei
R₂₁ und R₂₂ jeweils unabhängig aus der Gruppe ausgewählt sind, bestehend aus:
der durch Formel 8 repräsentierten Gruppe, einer Phenylgruppe, einer Biphenylgruppe, einer Terphenylgruppe, einer Naphthylgruppe, einer Fluorenylgruppe, einer Benzofluorenylgruppe, einer Dibenzofluorenylgruppe, einer Spiro-Bifluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Tetraphenylgruppe, einer Chrysenylgruppe, einer Perylenylgruppe, einer Pentaphenylgruppe, einer Hexacenylgruppe, einer Pentacenylgruppe, einer Carbazolylgruppe, einer Benzocarbazolylgruppe, einer Dibenzocarbazolylgruppe, einer Benzofuranylgruppe, einer Benzothiophenylgruppe, einer Dibenzofuranylgruppe und einer Dibenzothiophenylgruppe; und
einer Phenylgruppe, einer Biphenylgruppe, einer Terphenylgruppe, einer Naphthylgruppe, einer Fluorenylgruppe, einer Benzofluorenylgruppe, einer Dibenzofluorenylgruppe, einer Spiro-Bifluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Tetraphenylgruppe, einer Chrysenylgruppe, einer Perylenylgruppe, einer Pentaphenylgruppe, einer Hexacenylgruppe, einer Pentacenylgruppe, einer Carbazolylgruppe, einer Benzocarbazolylgruppe, einer Dibenzocarbazolylgruppe, einer Benzofuranylgruppe, einer Benzothiophenylgruppe, einer Dibenzofuranylgruppe und einer Dibenzothiophenylgruppe, jede substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Phenylgruppe, einer Biphenylgruppe, einer Terphenylgruppe und einer Naphthylgruppe.

9. Organische lichtemittierende Vorrichtung (10) nach einem der Ansprüche 1 bis 8, wobei
R₈₁ und R₈₂ jeweils unabhängig aus der Gruppe ausgewählt sind, bestehend aus:
-F, -Cl, -Br, -I, einer Cyanogruppe, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Cyclopentylgruppe, einer Cyclohexylgruppe, einer Cycloheptylgruppe, einer Phenylgruppe, einer Biphenylgruppe, einer Terphenylgruppe, einer Naphthylgruppe, einer Phenanthrenylgruppe, einer Pyridinylgruppe, einer Pyrimidinylgruppe, einer Pyridazinylgruppe, einer Triazinylgruppe, einer Chinolinylgruppe, einer Isochinolinylgruppe und -Si(Q₁)(Q₂)(Q₃); und
einer Cyclopentylgruppe, einer Cyclohexylgruppe, einer Cycloheptylgruppe, einer Phenylgruppe, einer Biphenylgruppe, einer Terphenylgruppe, einer Naphthylgruppe, einer Phenanthrenylgruppe, einer Pyridinylgruppe, einer Pyrimidinylgruppe, einer Pyridazinylgruppe, einer Triazinylgruppe, einer Chinolinylgruppe und einer Isochinolinylgruppe, jede substituiert mit mindestens einem, ausgewählt aus Deuterium, - F, -Cl, -Br, -I, einer Cyanogruppe, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer Phenylgruppe, einer Biphenylgruppe, einer Terphenylgruppe, einer Naphthylgruppe und -Si(Q₃₁)(Q₃₂)(Q₃₃),
wobei Q₁ bis Q₃ und Q₃₁ bis Q₃₃ jeweils unabhängig aus einer Methylgruppe, einer Ethylgruppe, einer n-Propylgruppe, einer Isopropylgruppe, einer Phenylgruppe, einer Biphenylgruppe und einer Terphenylgruppe ausgewählt sind.

10. Organische lichtemittierende Vorrichtung (10) nach einem der Ansprüche 1 bis 9, wobei
die durch Formel 8 repräsentierte Gruppe durch eine aus den Formeln 8-1 bis 8-11 ausgewählte repräsentiert wird: 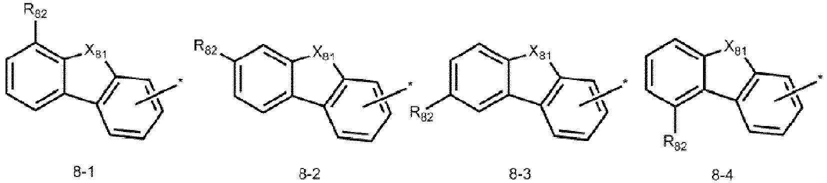 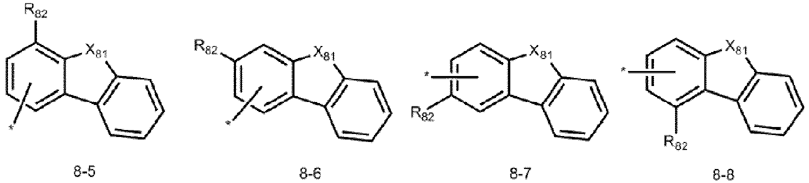 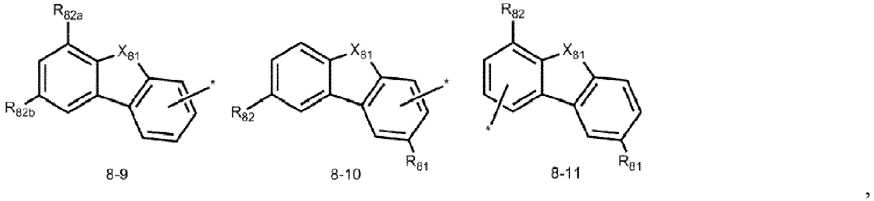 wobei in den Formeln 8-1 bis 8-11
X₈₁ aus O und S ausgewählt ist; und
R₈₁, R₈₂, R₈₂ₐ und R_{82b} jeweils unabhängig aus der Gruppe ausgewählt sind, bestehend aus:
-F, -Cl, -Br, -I, einer Cyanogruppe, einer Phenylgruppe, einer Biphenylgruppe, einer Terphenylgruppe, einer Naphthylgruppe, -Si(CH₃)₃ und -Si(Ph)₃; und
einer Phenylgruppe, einer Biphenylgruppe, einer Terphenylgruppe, einer Naphthylgruppe und einer Phenanthrenylgruppe, jede substituiert mit mindestens einem, ausgewählt aus Deuterium, -F, -Cl, -Br, -I, einer Cyanogruppe, einer Methylgruppe, einer Ethylgruppe, einer n-Propylgruppe, einer Isopropylgruppe, einer n-Butylgruppe, einer Isobutylgruppe, einer sec-Butylgruppe, einer tert-Butylgruppe, einer Phenylgruppe, einer Naphthylgruppe, -Si(CH₃)₃ und -Si(Ph)₃.

11. Organische lichtemittierende Vorrichtung (10) nach einem der Ansprüche 1 bis 10, wobei
A₃₁ aus der Gruppe ausgewählt ist, bestehend aus:
einer Benzengruppe, einer Naphthalengruppe, einer Pyridingruppe, einer Pyrazingruppe, einer Pyrimidingruppe, einer Pyridazingruppe, einer Chinolingruppe und einer Isochinolingruppe; und
einer Benzengruppe, einer Naphthalengruppe, einer Pyridingruppe, einer Pyrazingruppe, einer Pyrimidingruppe, einer Pyridazingruppe, einer Chinolingruppe und einer Isochinolingruppe, jede substituiert mit mindestens einem, ausgewählt aus Deuterium, -F, -Cl, -Br, -I, einer Cyanogruppe, einer C₁-C₂₀-Alkylgruppe, einer Phenylgruppe, einer Biphenylgruppe, einer Terphenylgruppe und einer Naphthylgruppe.

12. Organische lichtemittierende Vorrichtung (10) nach einem der Ansprüche 1 bis 11, wobei
R₃₁ bis R₃₈ und R₉₃ bis R₉₇ jeweils unabhängig aus der Gruppe ausgewählt sind, bestehend aus:
Wasserstoff, -F, -Cl, -Br, -I, einer Cyanogruppe, einer C₁-C₆₀-Alkylgruppe, einer C₆-C₆₀-Arylgruppe und einer C₁-C₆₀-Heteroarylgruppe; und
einer C₁-C₆₀-Alkylgruppe, einer C₆-C₆₀-Arylgruppe und einer C₁-C₆₀-Heteroarylgruppe, jede substituiert mit mindestens einem, ausgewählt aus -F, einer Cyanogruppe und einer mit -F substituierten C₁-C₆₀-Alkylgruppe.

13. Organische lichtemittierende Vorrichtung (10) nach einem der Ansprüche 1 bis 12, wobei
die durch Formel 1 repräsentierte erste Verbindung durch Formel 1-1 repräsentiert wird: 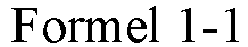 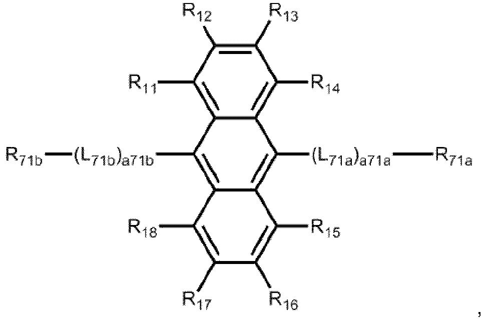 wobei in Formel 1-1
R₁₁ bis R₁₈ jeweils unabhängig aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer substituierten oder nicht substituierten C₁-C₆₀-Alkylgruppe, einer substituierten oder nicht substituierten C₂-C₆₀-Alkenylgruppe, einer substituierten oder nicht substituierten C₂-C₆₀-Alkynylgruppe, einer substituierten oder nicht substituierten C₁-C₆₀-Alkoxygruppe, einer substituierten oder nicht substituierten C₃-C₁₀-Cycloalkylgruppe, einer substituierten oder nicht substituierten C₁-C₁₀-Heterocycloalkylgruppe, einer substituierten oder nicht substituierten C₃-C₁₀-Cycloalkenylgruppe, einer substituierten oder nicht substituierten C₁-C₁₀-Heterocycloalkenylgruppe, einer substituierten oder nicht substituierten C₆-C₆₀-Arylgruppe, einer substituierten oder nicht substituierten C₆-C₆₀-Aryloxygruppe, einer substituierten oder nicht substituierten C₆-C₆₀-Arylthiogruppe, einer substituierten oder nicht substituierten C₁-C₆₀-Heteroarylgruppe, einer substituierten oder nicht substituierten monovalenten, nichtaromatischen, kondensierten, polycyclischen Gruppe, einer substituierten oder nicht substituierten monovalenten, nichtaromatischen, kondensierten, heteropolycyclischen Gruppe, -Si(Q₁)(Q₂)(Q₃), -N(Q₁)(Q₂), -B(Q₁)(Q₂), -C(=O)(Q₁), - S(=O)₂(Q₁) und -P(=O)(Q₁)(Q₂) ausgewählt sind;
i) R₁₁ und R₁₂, R₁₂ und R₁₃ oder R₁₃ und R₁₄ verknüpft sind, um einen Ring zu bilden, und R₇₁ₐ und R_{71b} jeweils unabhängig aus einer substituierten oder nicht substituierten C₆-C₆₀-Arylgruppe, einer substituierten oder nicht substituierten C₁-C₆₀-Heteroarylgruppe, einer substituierten oder nicht substituierten monovalenten, nichtaromatischen, kondensierten, polycyclischen Gruppe und einer substituierten oder nicht substituierten monovalenten, nichtaromatischen, kondensierten, heteropolycyclischen Gruppe ausgewählt sind; oder
ii) R₇₁ₐ und R_{71b} jeweils unabhängig aus einer Phenanthrenylgruppe, einer Anthracenylgruppe, einer Tetraphenylgruppe, einer Carbazolylgruppe und einer Gruppe, repräsentiert durch eine aus den Formeln 7A-1 bis 7A-31, 7B-1 bis 7B-3, 7C-1 bis 7C-3, 7D-1 bis 7D-3, 7E-1 und 7E-2 ausgewählte, ausgewählt sind;
einer Phenanthrenylgruppe, einer Anthracenylgruppe, einer Tetraphenylgruppe, einer Carbazolylgruppe, jede substituiert mit mindestens einem, ausgewählt aus Deuterium, einer Methylgruppe, einer Ethylgruppe, einer n-Propylgruppe, einer Isopropylgruppe, einer n-Butylgruppe, einer sec-Butylgruppe, einer Isobutylgruppe, einer tert-Butylgruppe, einer Phenylgruppe, einer Biphenylgruppe, einer Terphenylgruppe und einer Naphthylgruppe; und
einer Phenanthrenylgruppe, einer Anthracenylgruppe, einer Tetraphenylgruppe, einer Carbazolylgruppe, jede substituiert mit mindestens einem Substituenten, ausgewählt aus einer Phenylgruppe und einer Naphthylgruppe, wobei jeder des mindestens einen Substituenten mit mindestens einem substituiert ist, ausgewählt aus Deuterium, einer Methylgruppe, einer Ethylgruppe, einer n-Propylgruppe, einer Isopropylgruppe, einer n-Butylgruppe, einer sec-Butylgruppe, einer Isobutylgruppe, einer tert-Butylgruppe und einer Phenylgruppe: 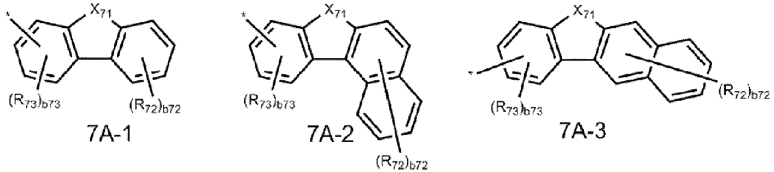 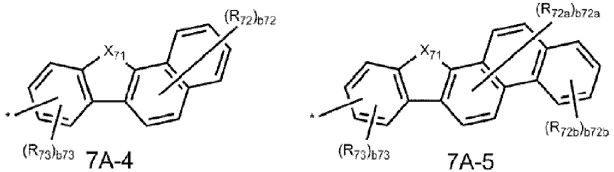 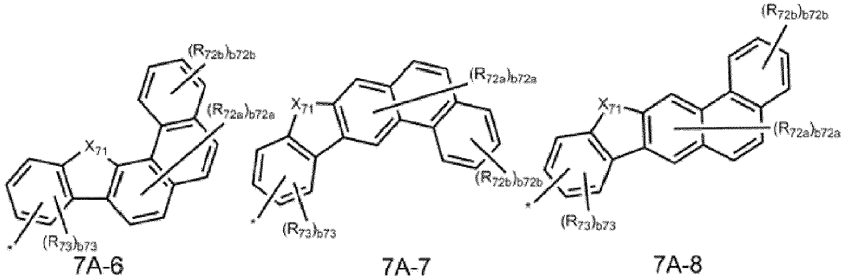 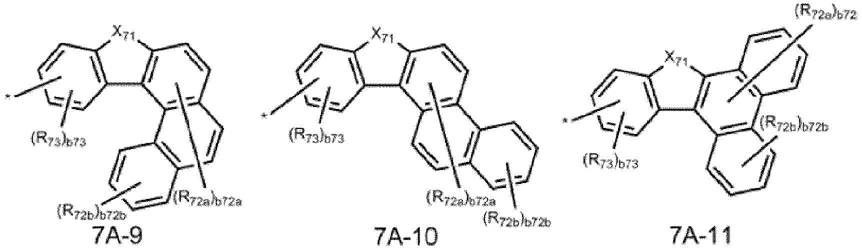 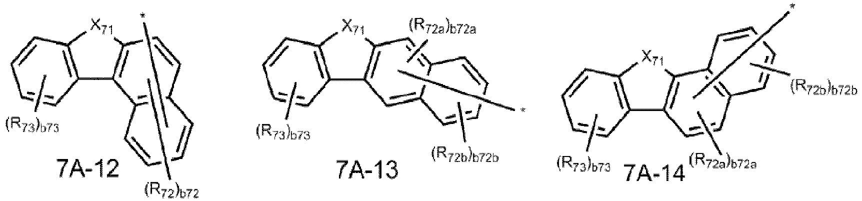 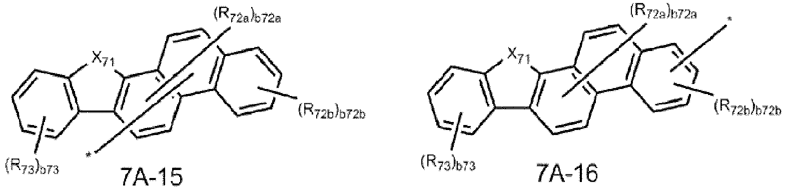 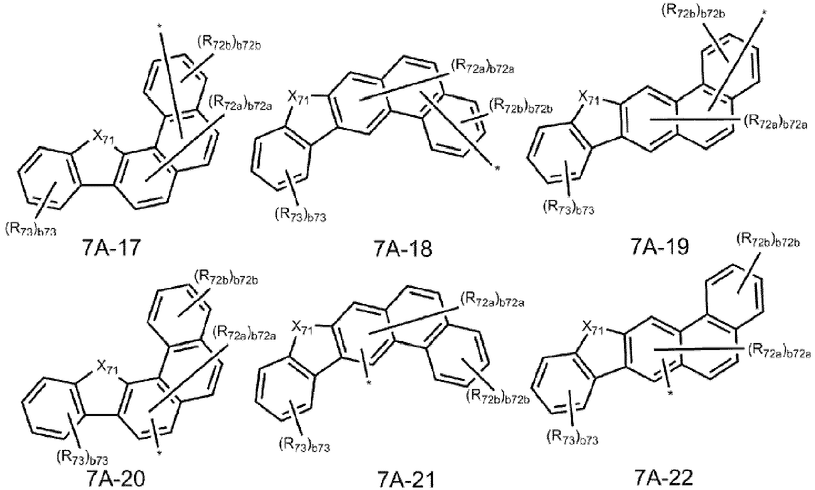 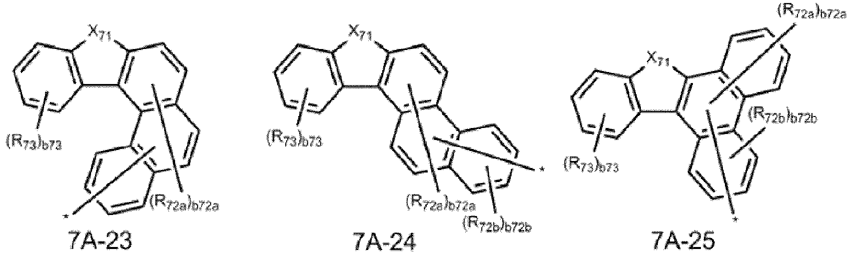 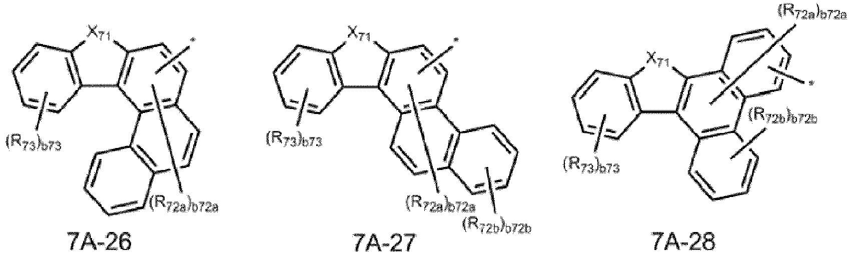 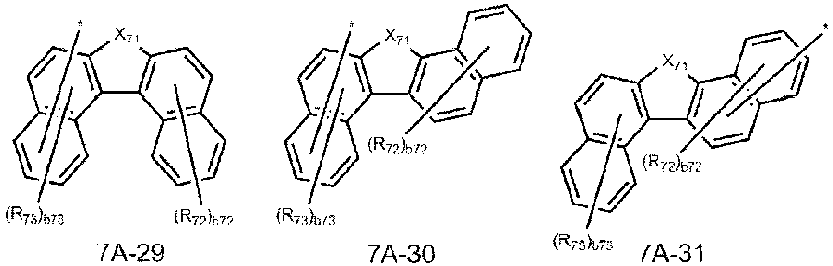 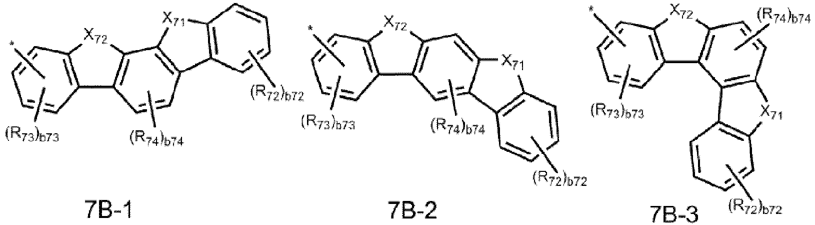 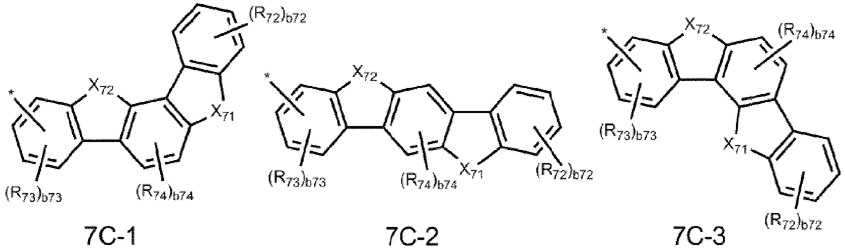 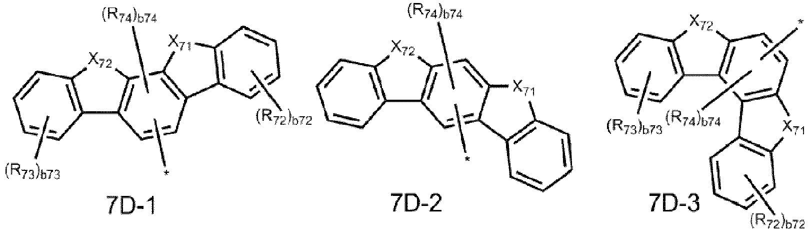 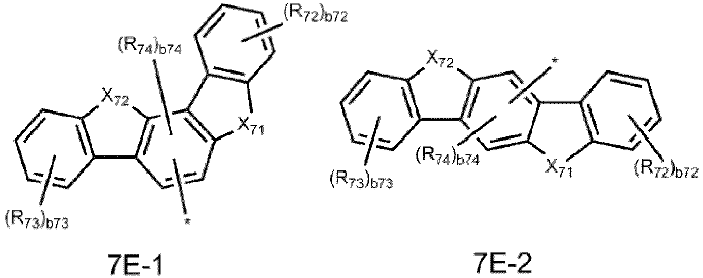
wobei in den Formeln 7A-1 bis 7A-31, 7B-1 bis 7B-3, 7C-1 bis 7C-3, 7D-1 bis 7D-3, 7E-1 und 7E-2
X₇₁ aus O, S, N(R₇₅) und C(R₇₅)(R₇₆) ausgewählt ist;
X₇₂ aus O, S, N(R₇₇) und C(R₇₇)(R₇₈) ausgewählt ist;
R₇₂ bis R₇₈, R₇₂ₐ und R_{72b} jeweils unabhängig aus der Gruppe ausgewählt sind, bestehend aus:
Wasserstoff, Deuterium, einer Methylgruppe, einer Ethylgruppe, einer n-Propylgruppe, einer Isopropylgruppe, einer n-Butylgruppe, einer sec-Butylgruppe, einer Isobutylgruppe, einer tert-Butylgruppe, einer Phenylgruppe, einer Biphenylgruppe, einer Terphenylgruppe und einer Naphthylgruppe; und
einer Phenylgruppe, einer Biphenylgruppe und einer Naphthylgruppe, jede substituiert mit mindestens einem, ausgewählt aus Deuterium, einer Methylgruppe, einer Ethylgruppe, einer n-Propylgruppe, einer Isopropylgruppe, einer n-Butylgruppe, einer sec-Butylgruppe, einer Isobutylgruppe, einer tert-Butylgruppe und einer Phenylgruppe;
R₇₅ und R₇₆ wahlweise verknüpft sind, um einem Ring zu bilden;
R₇₇ und R₇₈ wahlweise verknüpft sind, um einem Ring zu bilden;
b72 bis b74, b72a und b72b jeweils unabhängig aus 1, 2, 3, 4, 5, 6, 7 und 8 ausgewählt sind; und
* eine Bindungsstelle an ein benachbartes Atom angibt;
L₇₁ₐ und L_{71b} jeweils unabhängig aus einer substituierten oder nicht substituierten C₆-C₆₀-Arylengruppe, einer substituierten oder nicht substituierten C₁-C₆₀-Heteroarylengruppe, einer substituierten oder nicht substituierten divalenten, nichtaromatischen, kondensierten, polycyclischen Gruppe und einer substituierten oder nicht substituierten divalenten, nichtaromatischen, kondensierten, heteropolycyclischen Gruppe ausgewählt sind;
a71a und a71b jeweils unabhängig aus 0, 1, 2 und 3 ausgewählt sind; und
wobei Q₁ bis Q₃ jeweils unabhängig aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe,einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer monovalenten, nichtaromatischen, kondensierten, polycyclischen Gruppe, einer monovalenten, nichtaromatischen, kondensierten, heteropolycyclischen Gruppe, einer Biphenylgruppe und einer Terphenylgruppe ausgewählt sind.

14. Organische lichtemittierende Vorrichtung (10) nach einem der Ansprüche 1 bis 13, wobei
die durch Formel 2 repräsentierte zweite Verbindung durch eine aus den Formeln 2-1 und 2-2 ausgewählte repräsentiert wird: 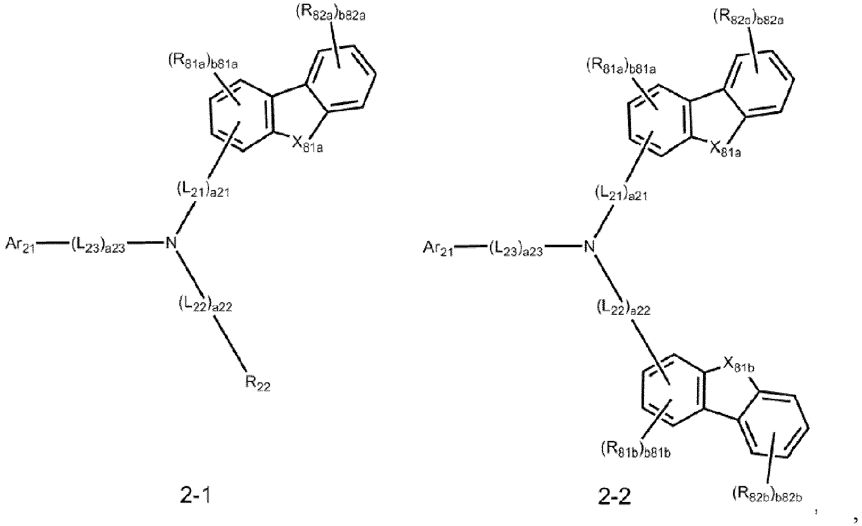 wobei in den Formeln 2-1 und 2-2
Ar₂₁ aus einer substituierten oder nicht substituierten C₅-C₆₀-Carbocyclusgruppe und einer substituierten oder nicht substituierten C₁-C₆₀-Heterocyclusgruppe ausgewählt ist,
L₂₁ bis L₂₃ jeweils unabhängig aus einer substituierten oder nicht substituierten C₆-C₆₀-Arylengruppe und einer substituierten oder nicht substituierten C₁-C₆₀-Heteroarylengruppe ausgewählt sind;
a21 bis a23 jeweils unabhängig aus 0, 1, 2 und 3 ausgewählt sind;
R₂₂ aus einer substituierten oder nicht substituierten C₆-C₆₀-Arylgruppe, einer substituierten oder nicht substituierten C₁-C₆₀-Heteroarylgruppe, einer substituierten oder nicht substituierten monovalenten, nichtaromatischen, kondensierten, polycyclischen Gruppe und einer substituierten oder nicht substituierten monovalenten, nichtaromatischen, kondensierten, heteropolycyclischen Gruppe ausgewählt ist;
X₈₁ₐ und X_{81b} jeweils unabhängig aus O und S ausgewählt sind;
R₈₁ₐ, R_{81b}, R₈₂ₐ und R_{82b} jeweils unabhängig aus der Gruppe ausgewählt sind, bestehend aus:
-F, -Cl, -Br, -I, einer Cyanogruppe, einer C₁-C₆₀-Alkylgruppe, einer C₃-C₁₀-Cycloalkylgruppe, einer C₁-C₁₀-Heterocycloalkylgruppe,einer C₆-C₆₀-Arylgruppe, einer C₆-C₆₀-Aryloxygruppe, einer C₆-C₆₀-Arylthiogruppe, einer C₁-C₆₀-Heteroarylgruppe und -Si(Q₁)(Q₂)(Q₃); und
einer C₃-C₁₀-Cycloalkylgruppe, einer C₁-C₁₀-Heterocycloalkylgruppe,einer C₆-C₆₀-Arylgruppe, einer C₆-C₆₀-Aryloxygruppe, einer C₆-C₆₀-Arylthiogruppe und einer C₁-C₆₀-Heteroarylgruppe, jede substituiert mit mindestens einem, ausgewählt aus -F, -Cl, - Br, -I, einer Cyanogruppe und einer C₁-C₆₀-Alkylgruppe;
b81a und b81b jeweils unabhängig aus 0, 1, 2 und 3 ausgewählt sind;
b82a und b82b jeweils unabhängig aus 0, 1, 2, 3 und 4 ausgewählt sind;
eine Summe von b81a und b82a gleich 1 oder mehr ist;
eine Summe von b81b und b82b gleich 1 oder mehr ist; und
Q₁ bis Q₃ jeweils unabhängig aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe,einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer monovalenten, nichtaromatischen, kondensierten, polycyclischen Gruppe, einer monovalenten, nichtaromatischen, kondensierten, heteropolycyclischen Gruppe, einer Biphenylgruppe und einer Terphenylgruppe ausgewählt sind.

15. Organische lichtemittierende Vorrichtung (10) nach einem der Ansprüche 1 bis 14, wobei
die organische Schicht (150) eine Emissionsschicht umfasst;
die Emissionsschicht die erste Verbindung und einen Dotanden umfasst; und
der Dotand eine Arylminverbindung oder eine Styrylaminverbindung umfasst.

16. Organische lichtemittierende Vorrichtung (10) nach einem der Ansprüche 1 bis 15, wobei
die organische Schicht (150) eine Emissionsschicht umfasst;
die Emissionsschicht die erste Verbindung und eine durch Formel 501 repräsentierte Verbindung umfasst: 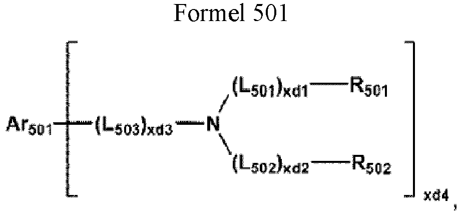 wobei in Formel 501
Ar₅₀₁ aus einer substituierten oder nicht substituierten C₅-C₆₀-Carbocyclusgruppe und einer substituierten oder nicht substituierten C₁-C₆₀-Heterocyclusgruppe ausgewählt ist,
L₅₀₁ bis L₅₀₃ jeweils unabhängig aus einer substituierten oder nicht substituierten C₃-C₁₀-Cycloalkylengruppe, einer substituierten oder nicht substituierten C₁-C₁₀-Heterocycloalkylengruppe, einer substituierten oder nicht substituierten C₃-C₁₀-Cycloalkenylengruppe, einer substituierten oder nicht substituierten C₁-C₁₀-Heterocycloalkenylengruppe, einer substituierten oder nicht substituierten C₆-C₆₀-Arylengruppe, einer substituierten oder nicht substituierten C₁-C₆₀-Heteroarylengruppe, einer substituierten oder nicht substituierten divalenten, nichtaromatischen, kondensierten, polycyclischen Gruppe und einer substituierten oder nicht substituierten divalenten, nichtaromatischen, kondensierten, heteropolycyclischen Gruppe ausgewählt sind,
xdl bis xd3 jeweils unabhängig eine ganze Zahl sind, ausgewählt aus 0 bis 3;
R₅₀₁ und R₅₀₂ jeweils unabhängig aus einer substituierten oder nicht substituierten C₃-C₁₀-Cycloalkylgruppe, einer substituierten oder nicht substituierten C₁-C₁₀-Heterocycloalkylgruppe, einer substituierten oder nicht substituierten C₃-C₁₀-Cycloalkenylgruppe, einer substituierten oder nicht substituierten C₁-C₁₀-Heterocycloalkenylgruppe, einer substituierten oder nicht substituierten C₆-C₆₀-Arylgruppe, einer substituierten oder nicht substituierten C₆-C₆₀-Aryloxygruppe, einer substituierten oder nicht substituierten C₆-C₆₀-Arylthiogruppe, einer substituierten oder nicht substituierten C₁-C₆₀-Heteroarylgruppe, einer substituierten oder nicht substituierten monovalenten, nichtaromatischen, kondensierten, polycyclischen Gruppe und einer substituierten oder nicht substituierten monovalenten, nichtaromatischen, kondensierten, heteropolycyclischen Gruppe ausgewählt sind und
xd4 eine ganze Zahl ist, ausgewählt aus 1 bis 6.

17. Organische lichtemittierende Vorrichtung (10) nach einem der Ansprüche 1 bis 16, wobei
die organische Schicht (150) umfasst:
eine Emissionsschicht; und
eine Elektronentransportregion zwischen der Emissionsschicht und der zweiten Elektrode (190),
wobei die Elektronentransportregion Alkalimetall, Erdalkalimetall, Seltenerdmetall, eine Alkalimetallverbindung, eine Erdalkalimetallverbindung, eine Seltenerdmetallverbindung, einen Alkalimetallkomplex, einen Erdalkalimetallkomplex, einen Seltenerdmetallkomplex oder eine Kombination davon umfasst.

18. Organische lichtemittierende Vorrichtung (10) nach Anspruch 17, wobei
die Elektronentransportregion eine Elektronentransportschicht und eine Elektroneninj ektionsschicht umfasst,
wobei mindestens eine, ausgewählt aus der Elektronentransportschicht und der Elektroneninjektionsschicht, Alkalimetall, Erdalkalimetall, Seltenerdmetall, eine Alkalimetallverbindung, eine Erdalkalimetallverbindung, eine Seltenerdmetallverbindung, einen Alkalimetallkomplex, einen Erdalkalimetallkomplex, einen Seltenerdmetallkomplex oder eine Kombination davon umfasst.

19. Organische lichtemittierende Vorrichtung (10) nach einem der Ansprüche 15 bis 18, wobei
die Emissionsschicht eine Emissionsschicht eines Lichts einer ersten Farbe ist; und
die organische Schicht (150) ferner i) mindestens eine Emissionsschicht eines Lichts einer zweiten Farbe oder ii) mindestens eine Emissionsschicht eines Lichts einer zweiten Farbe und mindestens eine Emissionsschicht eines Lichts einer dritten Farbe umfasst,
wobei ein Licht einer ersten Farbe der Emissionsschicht eines Lichts einer ersten Farbe und ein Licht einer zweiten Farbe der Emissionsschicht eines Lichts einer zweiten Farbe identisch zueinander oder verschieden voneinander sind; oder das Licht einer ersten Farbe, das Licht einer zweiten Farbe und ein Licht einer dritten Farbe der Emissionsschicht des Lichts einer dritten Farbe identisch zueinander oder verschieden voneinander sind; und
das Licht einer ersten Farbe und das Licht einer zweiten Farbe als gemischtes Licht emittiert werden; oder das Licht einer ersten Farbe, das Licht einer zweiten Farbe und das Licht einer dritten Farbe als gemischtes Licht emittiert werden.

## Revendications

1. Dispositif électroluminescent organique (10) comprenant:
une première électrode (110);
une seconde électrode (190) qui fait face à la première électrode (110); et
une couche organique (150) entre la première électrode (110) et la seconde électrode (190);
dans lequel la couche organique (150) comprend:
une couche d'émission; et
une région de transport de trous entre la couche d'émission et la première électrode (110);
dans lequel la couche d'émission comprend le premier composé qui est représenté par la Formule 1; et
la région de transport de trous comprend le deuxième composé qui est représenté par la Formule 2 et le troisième composé qui est représenté par une Formule qui est sélectionnée parmi les Formules 3-1 à 3-3: 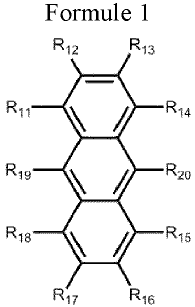 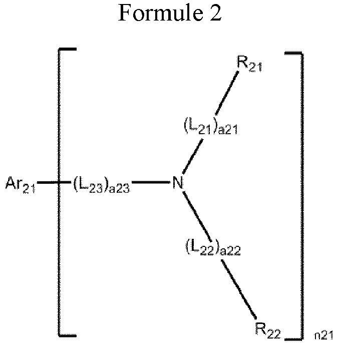 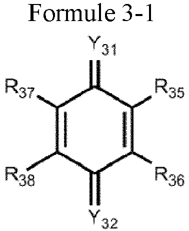 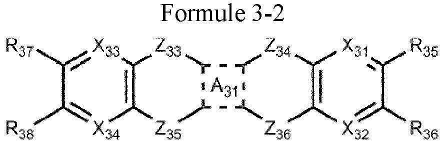 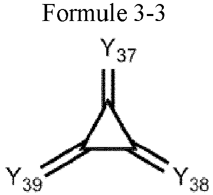
Formule 7 *-(L₇₁)ₐ₇₁-R₇₁ 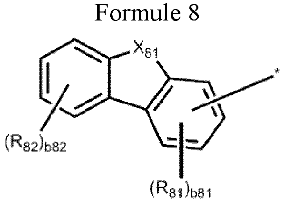 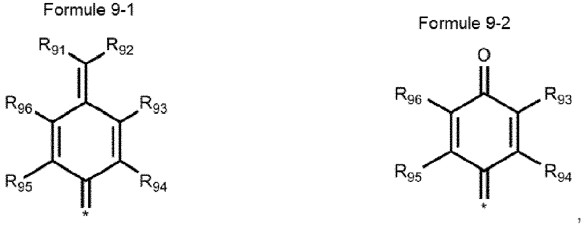
dans lequel, dans les Formules 1, 2, 3-1 à 3-3, 7, 8, 9-1 et 9-2:
Ru à R₂₀ sont chacun de manière indépendante sélectionnés parmi un groupe qui est représenté par la Formule 7, hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle substitué ou non substitué, un groupe C₂-C₆₀ alkényle substitué ou non substitué, un groupe C₂-C₆₀ alkynyle substitué ou non substitué, un groupe C₁-C₆₀ alcoxy substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalkényle substitué ou non substitué, un groupe C₁-C₁₀ hétérocycloalkényle substitué ou non substitué, un groupe C₆-C₆₀ aryle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe monovalent non aromatique condensé polycyclique substitué ou non substitué, un groupe monovalent non aromatique condensé hétéropolycyclique substitué ou non substitué, -Si(Q₁)(Q₂)(Q₃), - N(Q₁)(Q₂), -B(Q₁)(Q₂), -C(=O)(Q₁), -S(=O)₂(Q₁) et -P(=O)(Q₁)(Q₂), étant entendu qu'au moins un groupe qui est sélectionné parmi Ru à R₂₀ est le groupe qui est représenté par la Formule 7;
i) deux groupes voisins qui sont sélectionnés parmi R₁₁ à R₂₀ sont liés pour former un cycle, et R₇₁ est sélectionné parmi un groupe C₆-C₆₀ aryle substitué ou non substitué, un groupe C₁-C₆₀ hétéroaryle substitué ou non substitué, un groupe monovalent non aromatique condensé polycyclique substitué ou non substitué et un groupe monovalent non aromatique condensé hétéropolycyclique substitué ou non substitué; ou
ii) R₇₁ est sélectionné parmi un groupe phénanthrényle, un groupe anthracényle, un groupe tétraphényle, un groupe carbazolyle et un groupe qui est représenté par une Formule qui est sélectionnée parmi les Formules 7A-1 à 7A-31, 7B-1 à 7B-3, 7C-1 à 7C-3, 7D-1 à 7D-3, 7E-1 et 7E-2;
un groupe phénanthrényle, un groupe anthracényle, un groupe tétraphényle, un groupe carbazolyle, dont chacun est substitué par au moins l'un sélectionné parmi deutérium, un groupe méthyle, un groupe éthyle, un groupe n-propyle, un group iso-propyle, un groupe n-butyle, un groupe sec-butyle, un groupe iso-butyle, un groupe tert-butyle, un groupe phényle, un groupe biphényle, un groupe terphényle et un groupe naphtyle; et
un groupe phénanthrényle, un groupe anthracényle, un groupe tétraphényle, un groupe carbazolyle, dont chacun est substitué par au moins un substituant qui est sélectionné parmi un groupe phényle et un groupe naphtyle, chacun de l'au moins un substituant est substitué par au moins l'un sélectionné parmi deutérium, un groupe méthyle, un groupe éthyle, un groupe n-propyle, un groupe iso-propyle, un groupe n-butyle, un groupe sec-butyle, un groupe iso-butyle, un groupe tert-butyle et un groupe phényle: 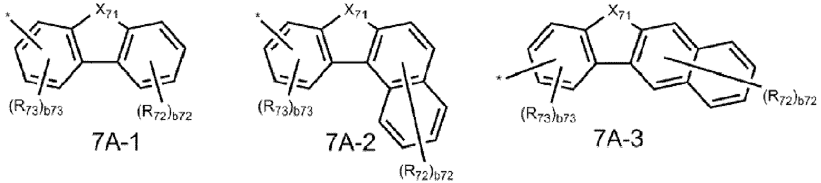 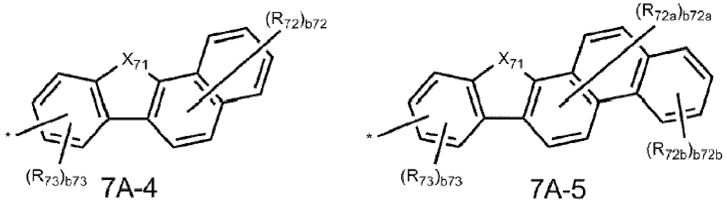 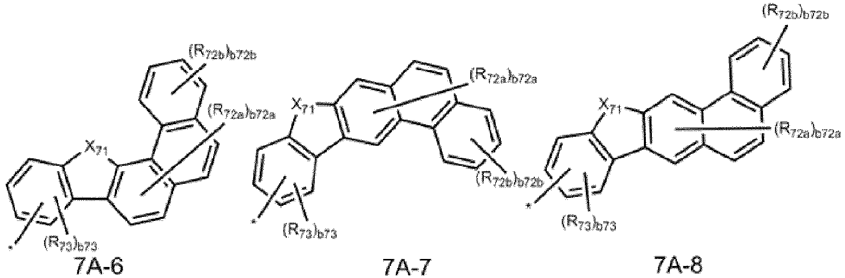 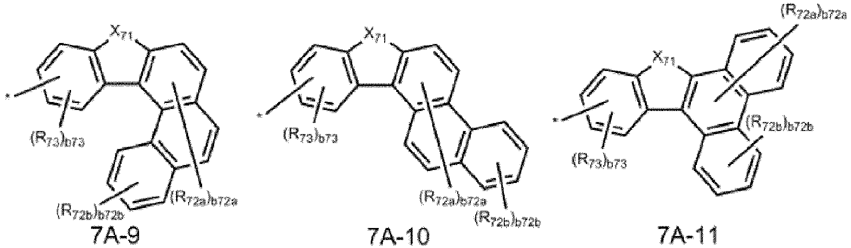 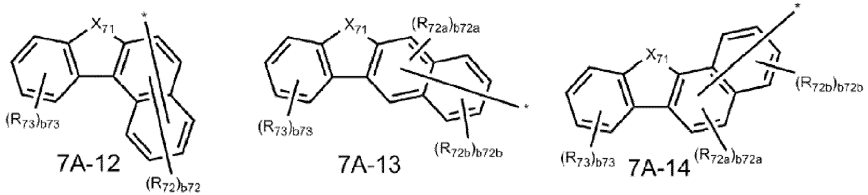 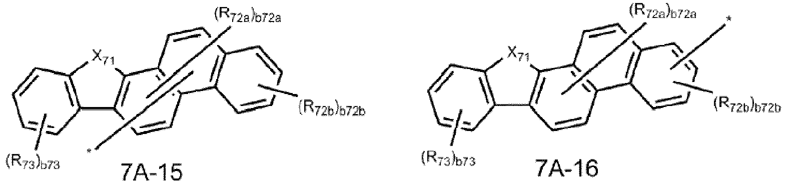 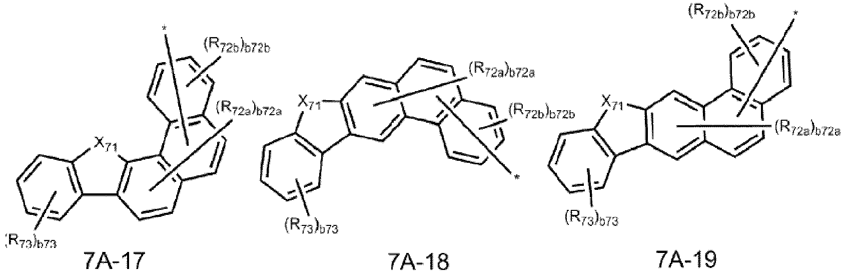 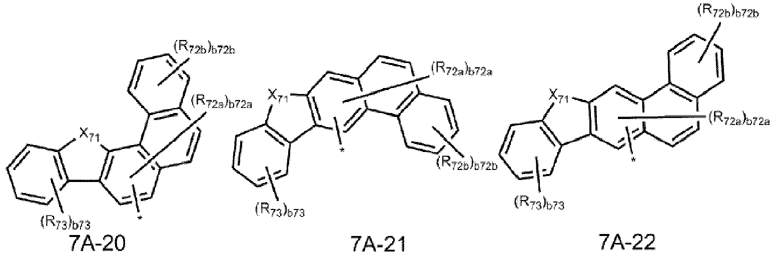 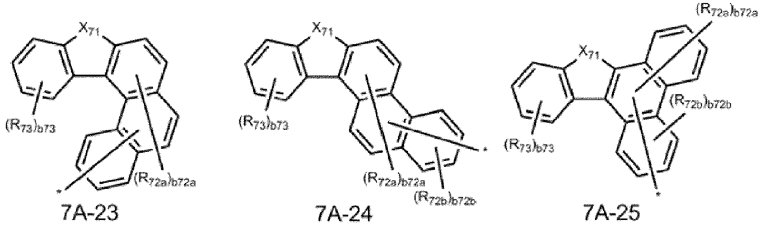 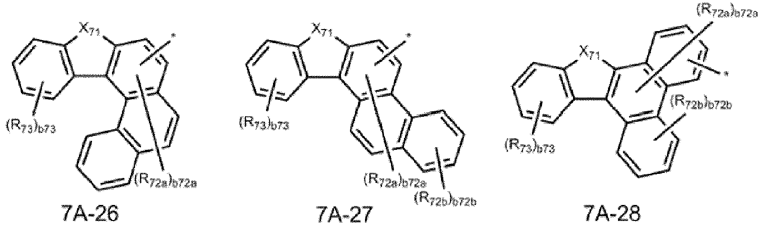 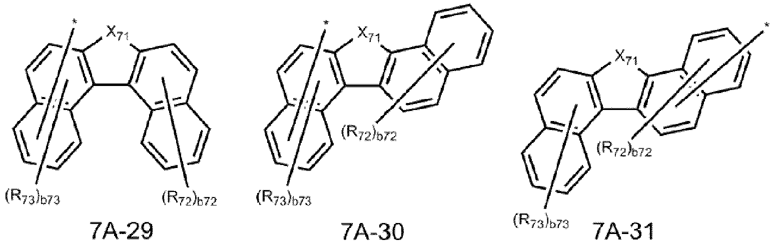 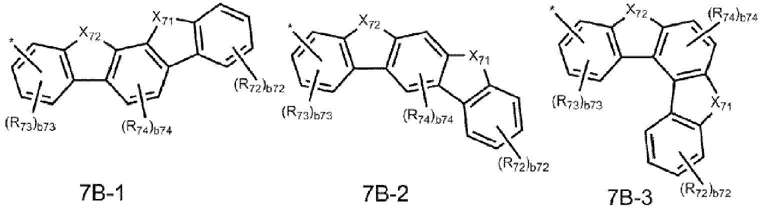 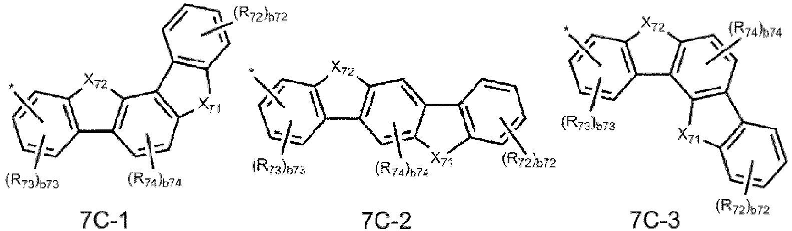 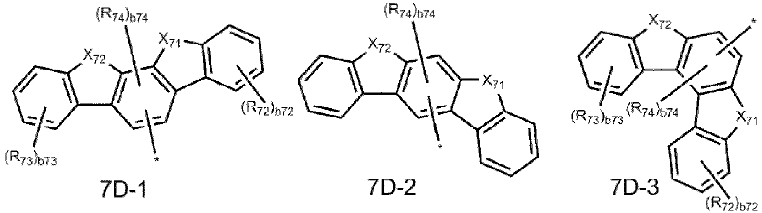 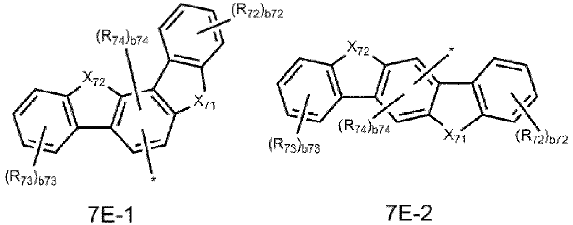
dans les Formules 7A-1 à 7A-31, 7B-1 à 7B-3, 7C-1 à 7C-3, 7D-1 à 7D-3, 7E-1 et 7E-2:
X₇₁ est sélectionné parmi O, S, N(R₇₅) et C(R₇₅)(R₇₆);
X₇₂ est sélectionné parmi O, S, N(R₇₇) et C(R₇₇)(R₇₈);
R₇₂ à R₇₈, R₇₂ₐ et R_{72b} sont chacun de manière indépendante sélectionnés parmi le groupe qui est constitué par:
hydrogène, deutérium, un groupe méthyle, un groupe éthyle, un groupe n-propyle, un groupe iso-propyle, un groupe n-butyle, un groupe sec-butyle, un groupe iso-butyle, un groupe tert-butyle, un groupe phényle, un groupe biphényle, un groupe terphényle et un groupe naphtyle; et
un groupe phényle, un groupe biphényle et un groupe naphtyle, dont chacun est substitué par au moins l'un sélectionné parmi deutérium, un groupe méthyle, un groupe éthyle, un groupe n-propyle, un groupe iso-propyle, un groupe n-butyle, un groupe sec-butyle, un groupe iso-butyle, un groupe tert-butyle et un groupe phényle;
R₇₅ et R₇₆ sont en option liés pour former un cycle;
R₇₇ et R₇₈ sont en option liés pour former un cycle;
b72 à b74, b72a et b72b sont chacun de manière indépendante sélectionnés parmi 1, 2, 3, 4, 5, 6, 7 et 8; et
* indique un site de liaison sur un atome voisin;
L₇₁ est sélectionné parmi un groupe C₆-C₆₀ arylène substitué ou non substitué, un groupe C₁-C₆₀ hétéroarylène substitué ou non substitué, un groupe divalent non aromatique condensé polycyclique substitué ou non substitué et un groupe divalent non aromatique condensé hétéropolycyclique substitué ou non substitué;
a71 est sélectionné parmi 0, 1, 2 et 3;
Ar₂₁ est un groupe C₅-C₆₀ carbocyclique substitué ou non substitué ou un groupe C₁-C₆₀ hétérocyclique substitué ou non substitué;
L₂₁ à L₂₃ sont chacun de manière indépendante sélectionnés parmi un groupe C₆-C₆₀ arylène substitué ou non substitué et un groupe C₁-C₆₀ hétéroarylène substitué ou non substitué;
a21 à a23 sont chacun de manière indépendante sélectionnés parmi 0, 1, 2 et 3;
R₂₁ et R₂₂ sont chacun de manière indépendante sélectionnés parmi un groupe qui est représenté par la Formule 8, un groupe C₆-C₆₀ aryle substitué ou non substitué, un groupe C₁-C₆₀ hétéroaryle substitué ou non substitué, un groupe monovalent non aromatique condensé polycyclique substitué ou non substitué et un groupe monovalent non aromatique condensé hétéropolycyclique substitué ou non substitué, étant entendu qu'au moins un groupe qui est sélectionné parmi R₂₁ et R₂₂ est le groupe qui représenté par la Formule 8;
X₈₁ est sélectionné parmi O et S;
R₈₁ et R₈₂ sont chacun de manière indépendante sélectionnés parmi le groupe qui est constitué par:
-F, -Cl, -Br, -I, un groupe cyano, un groupe C₁-C₆₀ alkyle, un groupe C₃-C₁₀ cycloalkyle, un groupe C₁-C₁₀ hétérocycloalkyle, un groupe C₆-C₆₀ aryle, un groupe C₆-C₆₀ aryloxy, un groupe C₆-C₆₀ arylthio, un groupe C₁-C₆₀ hétéroaryle et -Si(Q₁)(Q₂)(Q₃); et
un groupe C₃-C₁₀ cycloalkyle, un groupe C₁-C₁₀ hétérocycloalkyle, un groupe C₆-C₆₀ aryle, un groupe C₆-C₆₀ aryloxy, un groupe C₆-C₆₀ arylthio et un groupe C₁-C₆₀ héteroaryle, dont chacun est substitué par l'au moins un sélectionné parmi deutérium, -F, - C1, -Br, -I, un groupe cyano, un groupe C₁-C₆₀ alkyle, un groupe C₆-C₆₀ aryle, un groupe C₁-C₆₀ hétéroaryle et -Si(Q₃₁)(Q₃₂)(Q₃₃);
b81 est sélectionné parmi 0, 1, 2 et 3; b82 est sélectionné parmi 0, 1, 2, 3 et 4; une somme de b81 et de b82 est égale à 1 ou plus;
n21 est sélectionné parmi 1, 2 et 3;
A₃₁ est sélectionné parmi un groupe C₅-C₆₀ carbocyclique substitué ou non substitué et un groupe C₁-C₆₀ hétérocyclique substitué ou non substitué;
X₃₁ est sélectionné parmi N et C(R₃₁), X₃₂ est sélectionné parmi N et C(R₃₂), X₃₃ est sélectionné parmi N et C(R₃₃) et X₃₄ est sélectionné parmi N et C(R₃₄);
Z₃₃ est sélectionné parmi une liaison simple et C=Y_{33;} Z₃₄ est sélectionné parmi une liaison simple et C=Y₃₄; Z₃₅ est sélectionné parmi une liaison simple et C=Y₃₅ ; Z₃₆ est sélectionné parmi une liaison simple et C=Y_{36;} au moins l'un sélectionné parmi Z₃₃ à Z₃₆ n'est pas une liaison simple;
Y₃₁ à Y₃₉ sont chacun de manière indépendante sélectionnés parmi N(CN), C(CN)(R₉₁), C(R₉₁)(R₉₂), un groupe qui est représenté par la Formule 9-1 et un groupe qui est représenté par la Formule 9-2;
R₉₁ et R₉₂ sont chacun de manière indépendante sélectionnés parmi -F, -Cl, -Br, -I, un groupe cyano, un groupe C₁-C₆₀ alkyle substitué ou non substitué, un groupe C₆-C₆₀ aryle substitué ou non substitué, un groupe C₁-C₆₀ hétéroaryle substitué ou non substitué et -C(=O)OR₉₇; et
R₃₁ à R₃₈ et R₉₃ à R₉₇ sont chacun de manière indépendante sélectionnés parmi hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle substitué ou non substitué, un groupe C₂-C₆₀ alkényle substitué ou non substitué, un groupe C₂-C₆₀ alkynyle substitué ou non substitué, un groupe C₁-C₆₀ alcoxy substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalkényle substitué ou non substitué, un groupe C₁-C₁₀ hétérocycloalkényle substitué ou non substitué, un groupe C₆-C₆₀ aryle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe monovalent non aromatique condensé polycyclique substitué ou non substitué, un groupe monovalent non aromatique condensé hétéropolycyclique substitué ou non substitué, -Si(Q₁)(Q₂)(Q₃), -N(Q₁)(Q₂), -B(Q₁)(Q₂), - C(=O)(Q₁), -S(=O)₂(Q₁) et -P(=O)(Q₁)(Q₂);
dans lequel Q₁ à Q₃ et Q₃₁ à Q₃₃ sont chacun de manière indépendante sélectionnés parmi hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alkényle, un groupe C₂-C₆₀ alkynyle, un groupe C₁-C₆₀ alcoxy, un groupe C₃-C₁₀cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₁-C₆₀ hétéroaryle, un groupe monovalent non aromatique condensé polycyclique, un groupe monovalent non aromatique condensé hétéropolycyclique, un groupe biphényle et un groupe terphényle; et
* indique un site de liaison sur un atome voisin.

2. Dispositif électroluminescent organique (10) selon la revendication 1, dans lequel:
le troisième composé inclut nécessairement au moins un substituant qui est sélectionné parmi le groupe qui est constitué par:
un groupe cyano, -F, -Cl, -Br et -I; et
un groupe C₁-C₂₀ alkyle, qui est substitué par au moins l'un sélectionné parmi -F, - Cl, -Br et -I.

3. Dispositif électroluminescent organique selon la revendication 1 ou la revendication 2, dans lequel:
R₁₁ à R₂₀ sont chacun de manière indépendante sélectionnés parmi le groupe qui est représenté par la Formule 7, hydrogène, deutérium, -F, -Cl, -Br, -I, un groupe cyano, un groupe C₁-C₆₀ alkyle, un groupe C₆-C₆₀ aryle, un groupe C₁-C₆₀ hétéroaryle et - Si(Q₁)(Q₂)(Q₃);
dans lequel Q₁ à Q₃ sont chacun de manière indépendante sélectionnés parmi un groupe C₁-C₆₀ alkyle, un groupe C₆-C₆₀ aryle, un groupe biphényle et un groupe terphényle.

4. Dispositif électroluminescent organique (10) selon l'une quelconque des revendications 1 à 3, dans lequel:
L₇₁ est sélectionné parmi le groupe qui est constitué par:
un groupe phénylène, un groupe naphtylène, un groupe fluorénylène, un groupe phénanthrénylène, un groupe anthracénylène, un groupe triphénylénylène, un groupe pyrénylène, un groupe chrysénylène, un groupe pyrrolylène, un groupe thiophénylène, un groupe furanylène, un groupe imidazolylène, un groupe pyridinylène, un groupe pyrazinylène, un groupe pyrimidinylène, un groupe pyridazinylène, un groupe indolylène, un groupe quinolinylène, un groupe isoquinolinylène, un groupe benzoquinolinylène, un groupe phénanthridinylène, un groupe acridinylène, un groupe phénanthrolinylène, un groupe benzofuranylène, un groupe benzothiophénylène, un groupe triazolylène, un groupe tétrazolylène, un groupe triazinylène, un groupe dibenzofuranylène et un groupe dibenzothiophénylène; et
un groupe phénylène, un groupe naphtylène, un groupe fluorénylène, un groupe phénanthrénylène, un groupe anthracénylène, un groupe triphénylénylène, un groupe pyrénylène, un groupe chrysénylène, un groupe pyrrolylène, un groupe thiophénylène, un groupe furanylène, un groupe imidazolylène, un groupe pyridinylène, un groupe pyrazinylène, un groupe pyrimidinylène, un groupe pyridazinylène, un groupe indolylène, un groupe quinolinylène, un groupe isoquinolinylène, un groupe benzoquinolinylène, un groupe phénanthridinylène, un groupe acridinylène, un groupe phénanthrolinylène, un groupe benzofuranylène, un groupe benzothiophénylène, un groupe triazolylène, un groupe tétrazolylène, un groupe triazinylène, un groupe dibenzofuranylène et un groupe dibenzothiophénylène, dont chacun est substitué par au moins l'un sélectionné parmi deutérium, -F, -Cl, -Br, -I, un groupe hydroxyle, un groupe cyano, un groupe nitro, un groupe amidino, un groupe hydrazino, un groupe hydrazono, un groupe C₁-C₂₀ alkyle, un groupe C₁-C₂₀ alcoxy, un groupe phényle, un groupe biphényle, un groupe terphényle, un groupe naphtyle, un groupe fluorényle, un groupe spiro-fluorényle, un groupe phénalényle, un groupe phénanthrényle, un groupe anthracényle, un groupe fluoranthényle, un groupe triphénylényle, un groupe pyrényle, un groupe tétraphényle, un groupe chrysényle, un groupe perylényle, un groupe pentaphényle, un groupe hexacényle, un groupe pentacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe indazolyle, un groupe quinolinyle, un groupe isoquinolinyle, un groupe carbazolyle, un groupe benzoquinolinyle, un groupe phtalazinyle, un groupe naphtyridinyle, un groupe quinoxalinyle, un groupe quinazolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle et un groupe dibenzocarbazolyle.

5. Dispositif électroluminescent organique (10) selon l'une quelconque des revendications 1 à 4, dans lequel:
R₇₁ est sélectionné parmi les Formules 7-4 à 7-12, 7-17 à 7-186 et 7-194 à 7-202: 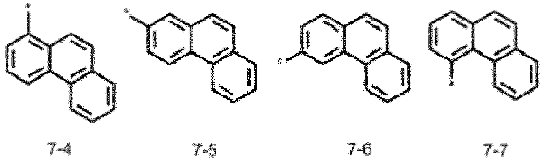 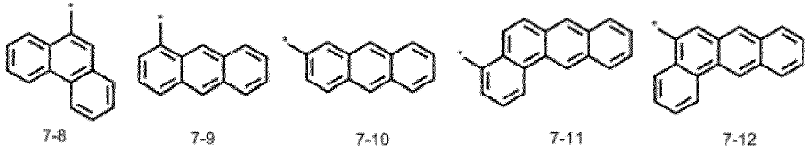 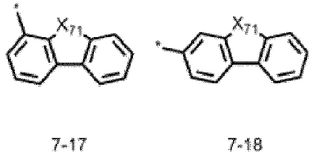 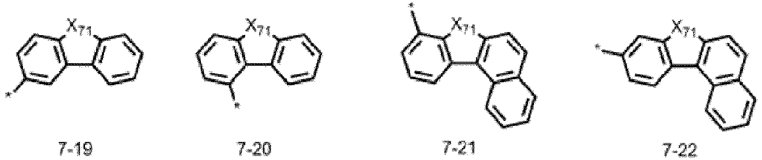 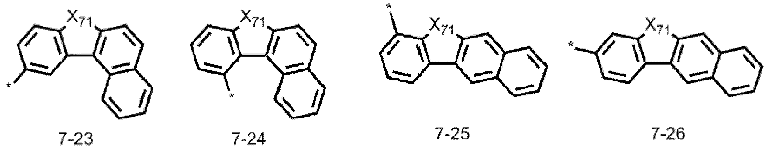 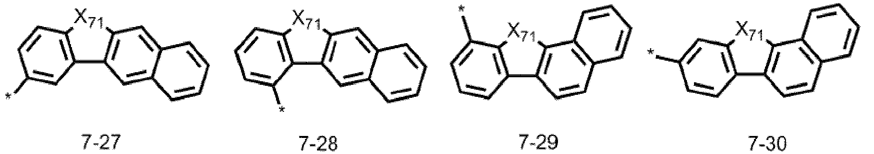 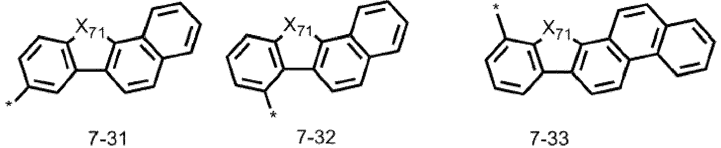 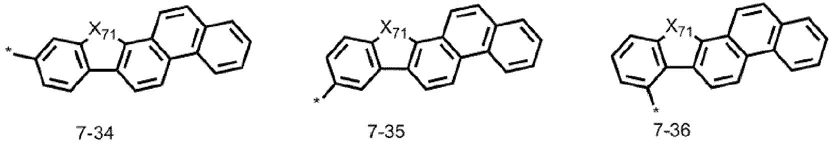 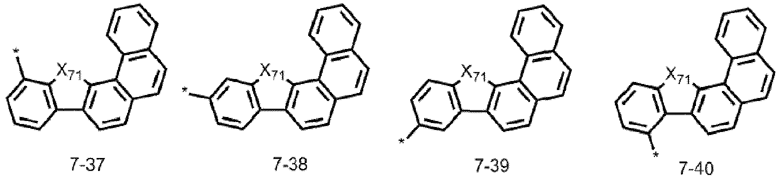 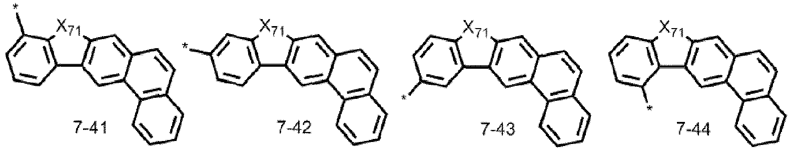 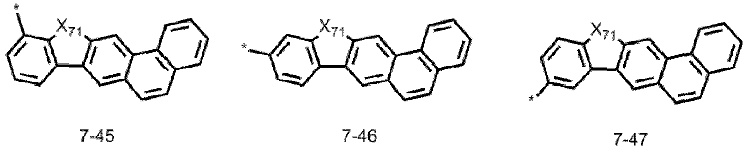 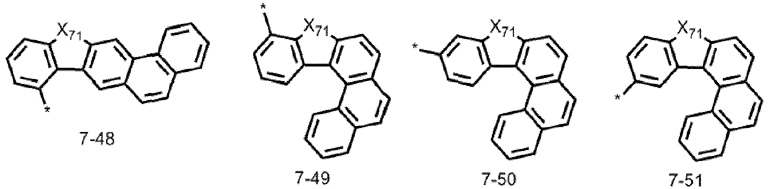 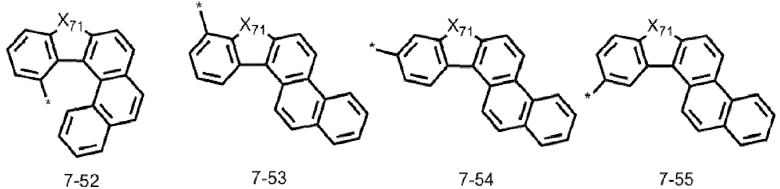 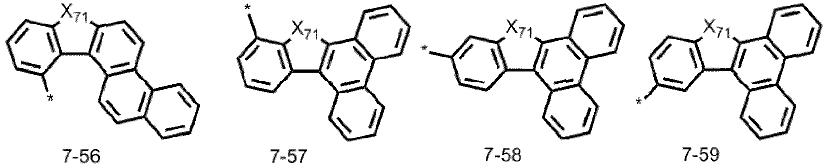 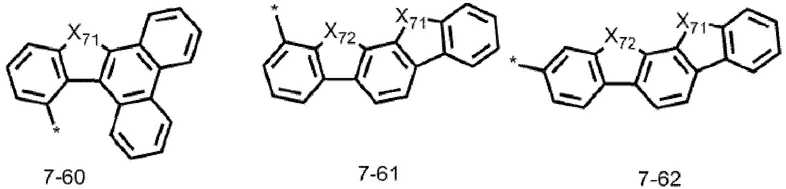 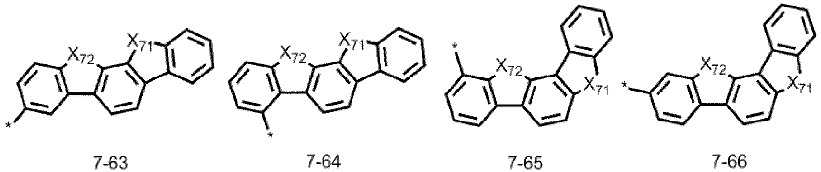 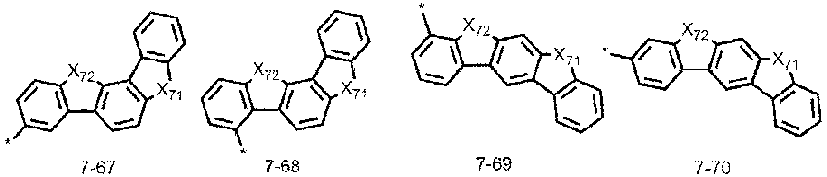 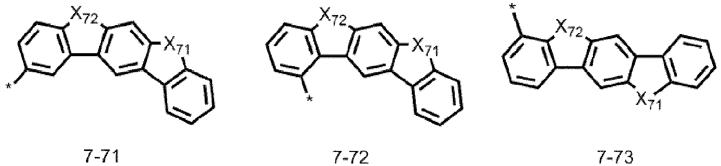 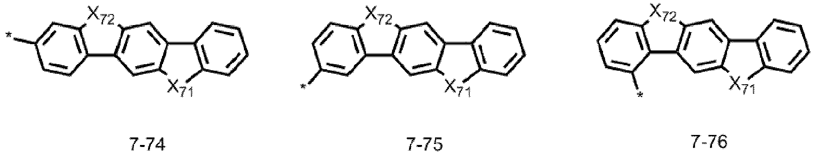 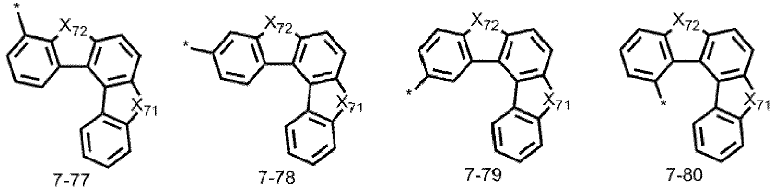 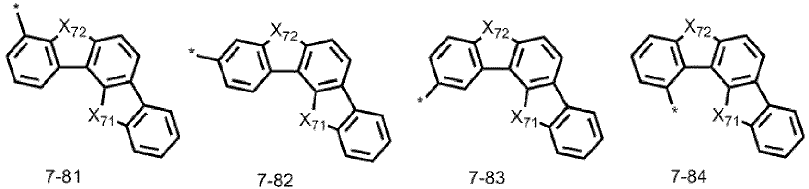 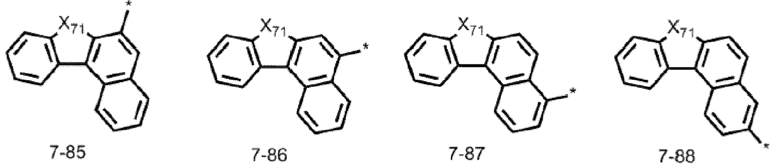 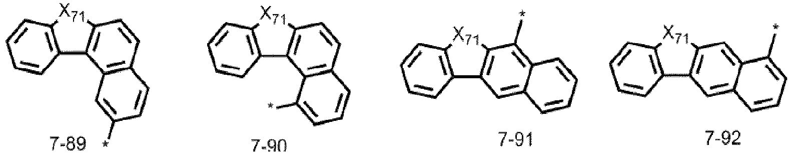 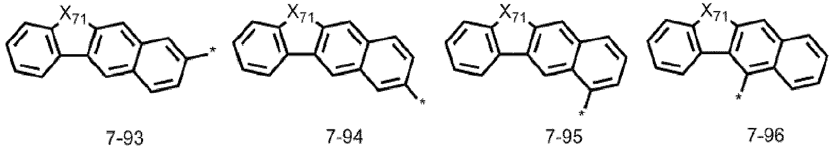 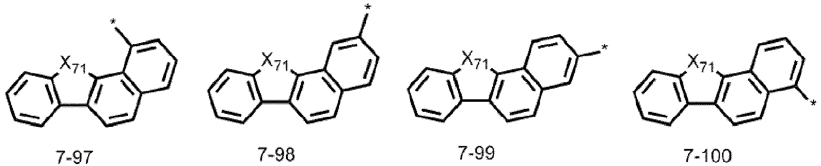 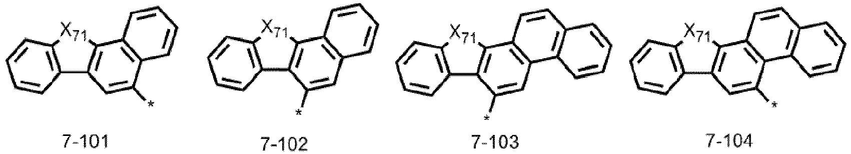 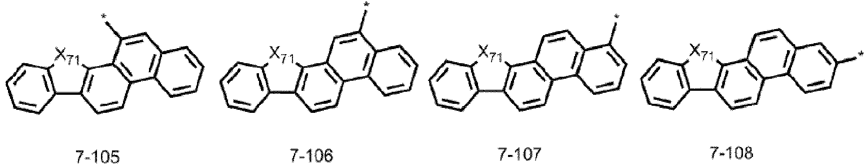 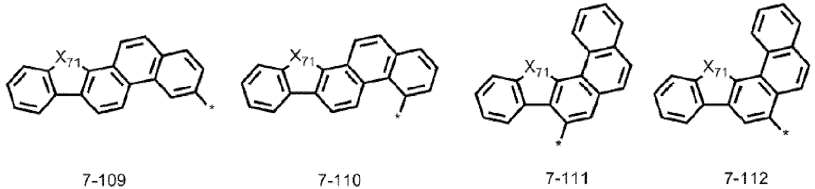 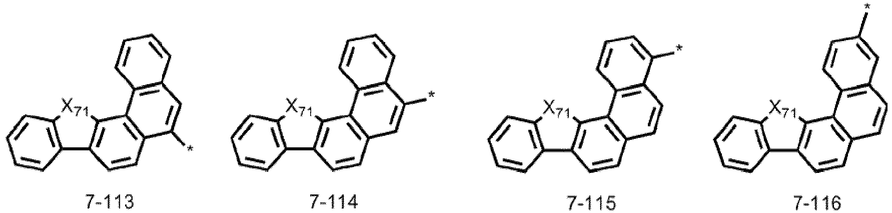 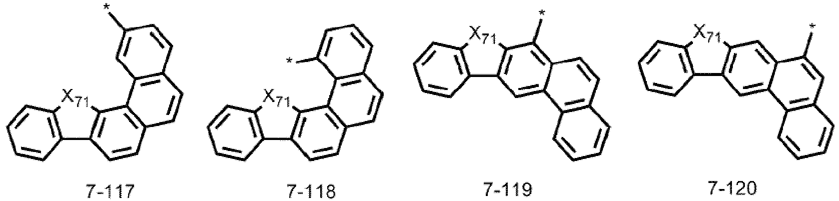 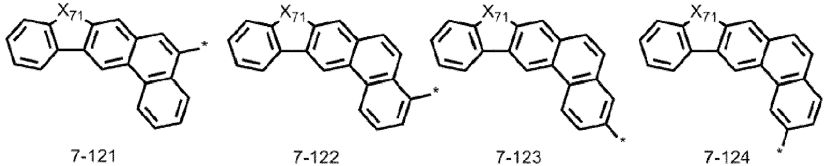 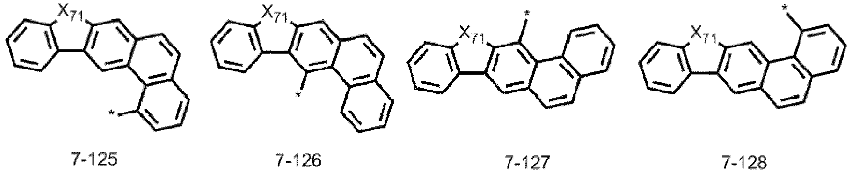 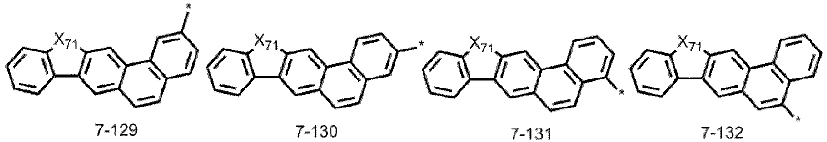 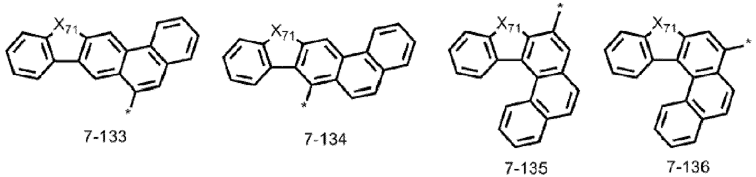 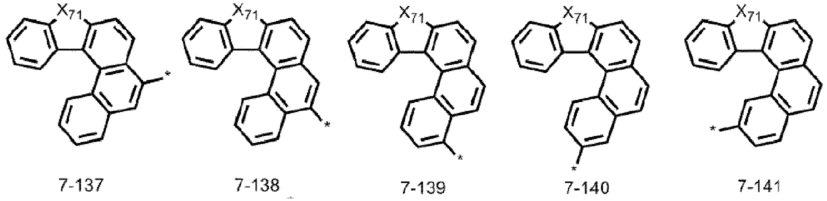 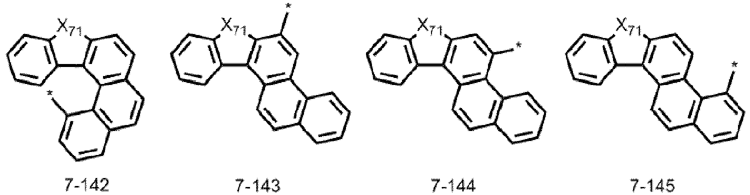 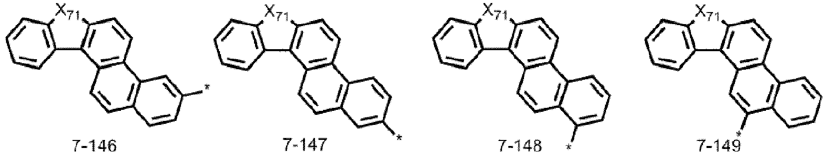 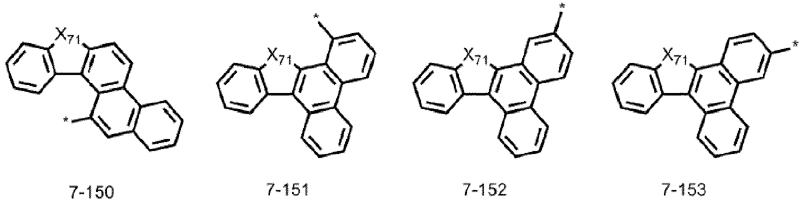 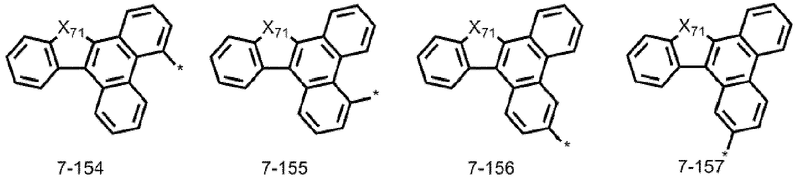 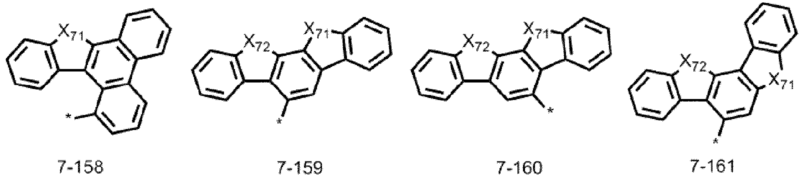 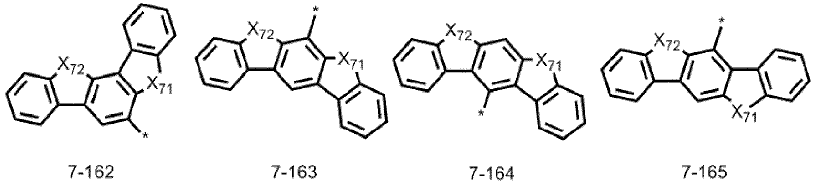 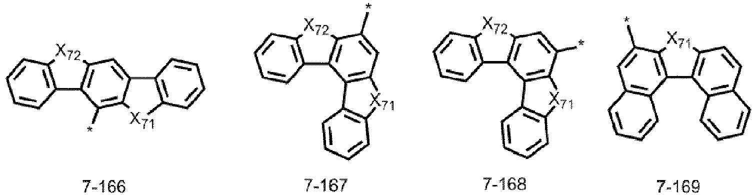 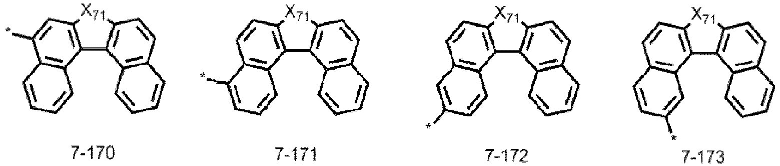 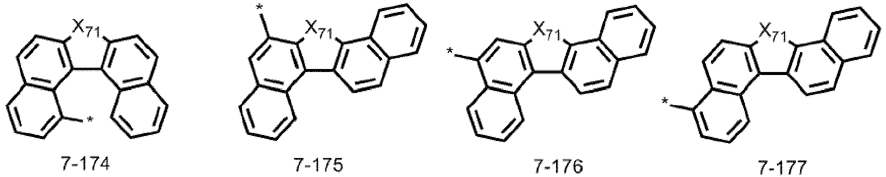 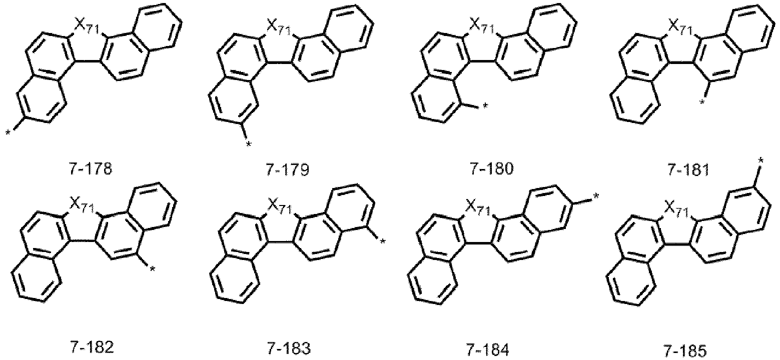 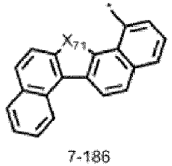 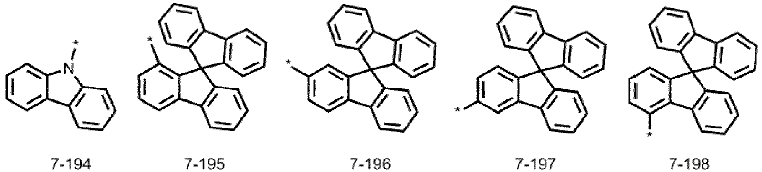 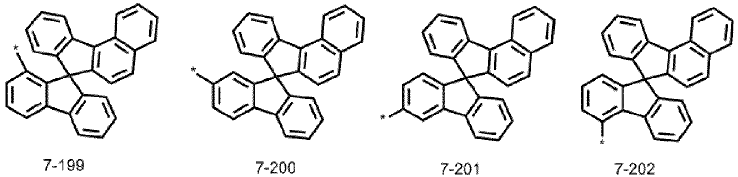 dans les Formules 7-4 à 7-12, 7-17 à 7-186 et 7-194 à 7-202:
X₇₁ et X₇₂ sont chacun de manière indépendante sélectionnés parmi O, S, N(Ph), N(D₆-Ph), N(2-biPh), N(3-biPh), N(4-biPh), C(CH₃)₂, C(CH₃)(Ph) et C(Ph)_{2;} et
* indique un site de liaison sur un atome voisin.

6. Dispositif électroluminescent organique (10) selon l'une quelconque des revendications 1 à 5, dans lequel:
Ar₂₁ est sélectionné parmi le groupe qui est constitué par:
un groupe benzène, un groupe naphtalène, un groupe fluorène, un groupe spirobifluorène, un groupe phénanthrène, un groupe anthracène, un groupe triphénylène, un groupe pyridine, un groupe pyrazine, un groupe pyrimidine, un groupe pyridazine, un groupe quinoline, un groupe isoquinoline, un groupe carbazole, un groupe dibenzofurane et un groupe dibenzothiophène; et
un groupe benzène, un groupe naphtalène, un groupe fluorène, un groupe spirobifluorène, un groupe phénanthrène, un groupe anthracène, un groupe triphénylène, un groupe pyridine, un groupe pyrazine, un groupe pyrimidine, un groupe pyridazine, un groupe quinoline, un groupe isoquinoline, un groupe carbazole, un groupe dibenzofurane et un groupe dibenzothiophène, dont chacun est substitué par au moins l'un sélectionné parmi deutérium, -F, -Cl, -Br, -I, un groupe hydroxyle, un groupe cyano, un groupe nitro, un groupe amidino, un groupe hydrazino, un groupe hydrazono, un groupe C₁-C₂₀ alkyle, un groupe C₁-C₂₀ alcoxy, un groupe phényle, un groupe biphényle, un groupe terphényle, un groupe naphtyle, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), et -P(=O)(Q₃₁)(Q₃₂);
dans lequel Q₃₁ à Q₃₃ sont chacun de manière indépendante sélectionnés parmi un groupe C₁-C₁₀ alkyle, un groupe phényle, un groupe biphényle, un groupe terphényle, un groupe naphtyle, un groupe fluorényle, un groupe dibenzofuranyle, un groupe dibenzothiophényle et un groupe carbazolyle; et
un groupe phényle, un groupe biphényle, un groupe terphényle, un groupe naphtyle, un groupe fluorényle, un groupe dibenzofuranyle, un groupe dibenzothiophényle et un groupe carbazolyle, dont chacun est substitué par au moins l'un sélectionné parmi un groupe C₁-C₁₀ alkyle, un groupe phényle et un groupe naphtyle.

7. Dispositif électroluminescent organique (10) selon l'une quelconque des revendications 1 à 6, dans lequel:
L₂₁ à L₂₃ sont chacun de manière indépendante sélectionnée parmi le groupe qui est constitué par:
un groupe phénylène, un groupe naphtylène, un groupe phénanthrénylène, un groupe anthracénylène, un groupe triphénylénylène, un groupe pyrénylène, un groupe chrysénylène, un groupe pyrrolylène, un groupe thiophénylène, un groupe furanylène, un groupe imidazolylène, un groupe pyridinylène, un groupe pyrazinylène, un groupe pyrimidinylène, un groupe pyridazinylène, un groupe indolylène, un groupe quinolinylène, un groupe isoquinolinylène, un groupe benzoquinolinylène, un groupe phénanthridinylène, un groupe acridinylène, un groupe phénanthrolinylène, un groupe triazolylène, un groupe tétrazolylène et un groupe triazinylène; et
un groupe phénylène, un groupe naphtylène, un groupe phénanthrénylène, un groupe anthracénylène, un groupe triphénylénylène, un groupe pyrénylène, un groupe chrysénylène, un groupe pyrrolylène, un groupe thiophénylène, un groupe furanylène, un groupe imidazolylène, un groupe pyridinylène, un groupe pyrazinylène, un groupe pyrimidinylène, un groupe pyridazinylène, un groupe indolylène, un groupe quinolinylène, un groupe isoquinolinylène, un groupe benzoquinolinylène, un groupe phénanthridinylène, un groupe acridinylène, un groupe phénanthrolinylène, un groupe triazolylène, un groupe tétrazolylène et un groupe triazinylène, dont chacun est substitué par au moins l'un sélectionné parmi deutérium, -F, -Cl, -Br, -I, un groupe hydroxyle, un groupe cyano, un groupe nitro, un groupe amidino, un groupe hydrazino, un groupe hydrazono, un groupe C₁-C₂₀ alkyle, un groupe C₁-C₂₀ alcoxy, un groupe phényle, un groupe biphényle, un groupe terphényle, un groupe naphtyle, un groupe fluorényle, un groupe spiro-fluorényle, un groupe phénalényle, un groupe phénanthrényle, un groupe anthracényle, un groupe fluoranthényle, un groupe triphénylényle, un groupe pyrényle, un groupe tétraphényle, un groupe chrysényle, un groupe perylényle, un groupe pentaphényle, un groupe hexacényle, un groupe pentacényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe indazolyle, un groupe quinolinyle, un groupe isoquinolinyle, un groupe carbazolyle, un groupe benzoquinolinyle, un groupe phtalazinyle, un groupe naphtyridinyle, un groupe quinoxalinyle, un groupe quinazolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle et un groupe dibenzocarbazolyle.

8. Dispositif électroluminescent organique (10) selon l'une quelconque des revendications 1 à 7, dans lequel:
R₂₁ et R₂₂ sont chacun de manière indépendante sélectionnés parmi le groupe qui est constitué par:
le groupe qui est représenté par la Formule 8, un groupe phényle, un groupe biphényle, un groupe terphényle, un groupe naphtyle, un groupe fluorényle, un groupe benzofluorényle, un groupe dibenzofluorényle, un groupe spiro-bifluorényle, un groupe phénalényle, un groupe phénanthrényle, un groupe anthracényle, un groupe fluoranthényle, un groupe triphénylényle, un groupe pyrényle, un groupe tétraphényle, un groupe chrysényle, un groupe perylényle, un groupe pentaphényle, un groupe hexacényle, un groupe pentacényle, un groupe carbazolyle, un groupe benzocarbazolyle, un groupe dibenzocarbazolyle, un groupe benzofuranyle, un groupe benzothiophényle, un groupe dibenzofuranyle et un groupe dibenzothiophényle; et
un groupe phényle, un groupe biphényle, un groupe terphényle, un groupe naphtyle, un groupe fluorényle, un groupe benzofluorényle, un groupe dibenzofluorényle, un groupe spiro-bifluorényle, un groupe phénalényle, un groupe phénanthrényle, un groupe anthracényle, un groupe fluoranthényle, un groupe triphénylényle, un groupe pyrényle, un groupe tétraphényle, un groupe chrysényle, un groupe perylényle, un groupe pentaphényle, un groupe hexacényle, un groupe pentacényle, un groupe carbazolyle, un groupe benzocarbazolyle, un groupe dibenzocarbazolyle, un groupe benzofuranyle, un groupe benzothiophényle, un groupe dibenzofuranyle et un groupe dibenzothiophényle, dont chacun est substitué par au moins l'un sélectionné parmi deutérium, -F, -Cl, -Br, -I, un groupe hydroxyle, un groupe cyano, un groupe nitro, un groupe amidino, un groupe hydrazino, un groupe hydrazono, un groupe C₁-C₂₀ alkyle, un groupe C₁-C₂₀ alcoxy, un groupe phényle, un groupe biphényle, un groupe terphényle et un groupe naphtyle.

9. Dispositif électroluminescent organique (10) selon l'une quelconque des revendications 1 à 8, dans lequel:
R₈₁ et R₈₂ sont chacun de manière indépendante sélectionnés parmi le groupe qui est constitué par:
-F, -Cl, -Br, -I, un groupe cyano, un groupe méthyle, un groupe éthyle, un groupe n-propyle, un groupe iso-propyle, un groupe n-butyle, un groupe iso-butyle, un groupe sec-butyle, un groupe tert-butyle, un groupe n-pentyle, un groupe cyclopentyle, un groupe cyclohexyle, un groupe cycloheptyle, un groupe phényle, un groupe biphényle, un groupe terphényle, un groupe naphtyle, un groupe phénanthrényle, un groupe pyridinyle, un groupe pyrimidinyle, un groupe pyridazinyle, un groupe triazinyle, un groupe quinolinyle, un groupe isoquinolinyle et -Si(Q₁)(Q₂)(Q₃); et
un groupe cyclopentyle, un groupe cyclohexyle, un groupe cycloheptyle, un groupe phényle, un groupe biphényle, un groupe terphényle, un groupe naphtyle, un groupe phénanthrényle, un groupe pyridinyle, un groupe pyrimidinyle, un groupe pyridazinyle, un groupe triazinyle, un groupe quinolinyle et un groupe isoquinolinyle, dont chacun est substitué par au moins l'un sélectionné parmi deutérium, -F, -Cl, -Br, -I, un groupe cyano, un groupe méthyle, un groupe éthyle, un groupe n-propyle, un groupe iso-propyle, un groupe n-butyle, un groupe iso-butyle, un groupe sec-butyle, un groupe tert-butyle, un groupe phényle, un groupe biphényle, un groupe terphényle, un groupe naphtyle et - Si(Q₃₁)(Q₃₂)(Q₃₃);
dans lequel Q₁ à Q₃ et Q₃₁ à Q₃₃ sont chacun de manière indépendante sélectionnés parmi un groupe méthyle, un groupe éthyle, un groupe n-propyle, un groupe iso-propyle, un groupe phényle, un groupe biphényle et un groupe terphényle.

10. Dispositif électroluminescent organique (10) selon l'une quelconque des revendications 1 à 9, dans lequel:
le groupe qui est représenté par la Formule 8 est représenté par une Formule qui est sélectionnée parmi les Formules 8-1 à 8-11: 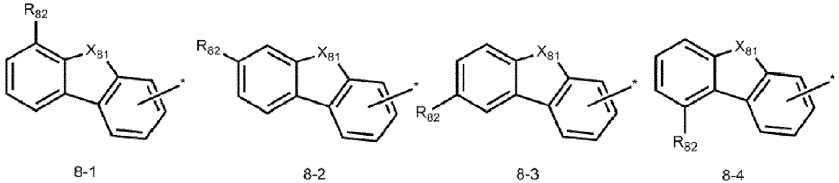 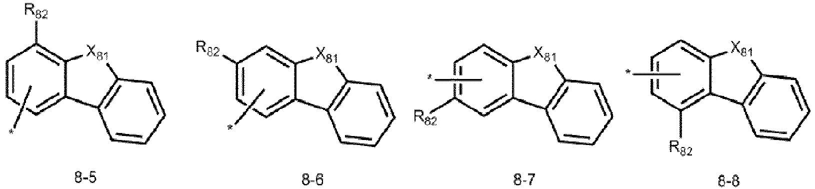 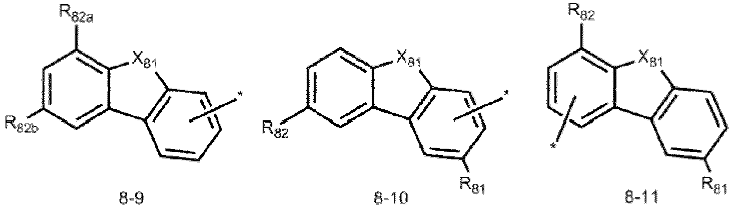 lequel, dans les Formules 8-1 à 8-11:
X₈₁ est sélectionné parmi O et S; et
R₈₁, R₈₂, R₈₂ₐ et R_{82b} sont chacun de manière indépendante sélectionnés parmi le groupe qui est constitué par:
-F, -Cl, -Br, -I, un groupe cyano, un groupe phényle, un groupe biphényle, un groupe terphényle, un groupe naphtyle, -Si(CH₃)₃ et -Si(Ph)₃; et
un groupe phényle, un groupe biphényle, un groupe terphényle, un groupe naphtyle et un groupe phénanthrényle, dont chacun est substitué par au moins l'un sélectionné parmi deutérium, -F, -Cl, -Br, -I, un groupe cyano, un groupe méthyle, un groupe éthyle, un groupe n-propyle, un groupe iso-propyle, un groupe n-butyle, un groupe iso-butyle, un groupe sec-butyle, un groupe tert-butyle, un groupe phényle, un groupe naphtyle, -Si(CH₃)₃ et -Si(Ph)₃.

11. Dispositif électroluminescent organique (10) selon l'une quelconque des revendications 1 à 10, dans lequel:
A₃₁ est sélectionné parmi le groupe qui est constitué par:
un groupe benzène, un groupe naphtalène, un groupe pyridine, un groupe pyrazine, un groupe pyrimidine, un groupe pyridazine, un groupe quinoline et un groupe isoquinoline; et
un groupe benzène, un groupe naphtalène, un groupe pyridine, un groupe pyrazine, un groupe pyrimidine, un groupe pyridazine, un groupe quinoline et un groupe isoquinoline, dont chacun est substitué par au moins l'un sélectionné parmi deutérium, -F, -Cl, -Br, -I, un groupe cyano, un groupe C₁-C₂₀ alkyle, un groupe phényle, un groupe biphényle, un groupe terphényle et un groupe naphtyle.

12. Dispositif électroluminescent organique (10) selon l'une quelconque des revendications 1 à 11, dans lequel:
R₃₁ à R₃₈ et R₉₃ à R₉₇ sont chacun de manière indépendante sélectionnés parmi le groupe qui est constitué par:
hydrogène, -F, -Cl, -Br, -I, un groupe cyano, un groupe C₁-C₆₀ alkyle, un groupe C₆-C₆₀ aryle et un groupe C₁-C₆₀ hétéroaryle; et
un groupe C₁-C₆₀ alkyle, un groupe C₆-C₆₀ aryle et un groupe C₁-C₆₀ hétéroaryle, dont chacun est substitué par au moins l'un sélectionné parmi -F, un groupe cyano et un groupe C₁-C₆₀ alkyle qui est substitué par -F.

13. Dispositif électroluminescent organique (10) selon l'une quelconque des revendications 1 à 12, dans lequel:
le premier composé qui est représenté par la Formule 1 est représenté par la Formule 1-1: 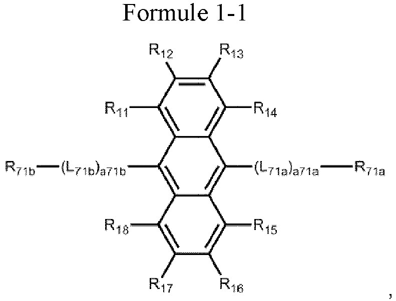 dans lequel, dans la Formule 1-1:
Ru à R₁₈ sont chacun de manière indépendante sélectionnés parmi hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle substitué ou non substitué, un groupe C₂-C₆₀ alkényle substitué ou non substitué, un groupe C₂-C₆₀ alkynyle substitué ou non substitué, un groupe C₁-C₆₀ alcoxy substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalkényle substitué ou non substitué, un groupe C₁-C₁₀ hétérocycloalkényle substitué ou non substitué, un groupe C₆-C₆₀ aryle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe monovalent non aromaticque condensé polycyclique substitué ou non substitué, un groupe monovalent non aromatique condensé hétéropolycyclique substitué ou non substitué, -Si(Q₁)(Q₂)(Q₃), -N(Q₁)(Q₂), -B(Q₁)(Q₂), - C(=O)(Q₁), -S(=O)₂(Q₁) et -P(=O)(Q₁)(Q₂);
i) R₁₁ et R₁₂, R₁₂ et R₁₃, ou R₁₃ et R₁₄ sont liés de manière à former un cycle, et R₇₁ₐ et R_{71b} sont chacun de manière indépendante sélectionnés parmi un groupe C₆-C₆₀ aryle substitué ou non substitué, un groupe C₁-C₆₀ hétéroaryle substitué ou non substitué, un groupe monovalent non aromatique condensé polycyclique substitué ou non substitué et un groupe monovalent non aromatique condensé hétéropolycyclique substitué ou non substitué; ou
ii) R₇₁ₐ et R_{71b} sont chacun de manière indépendante sélectionnés parmi un groupe phénanthrényle, un groupe anthracényle, un groupe tétraphényle, un groupe carbazolyle et un groupe qui est représenté par une formule qui est sélectionnée parmi les Formules 7A-1 à 7A-31, 7B-1 à 7B-3, 7C-1 à 7C-3, 7D-1 à 7D-3, 7E-1 et 7E-2;
un groupe phénanthrényle, un groupe anthracényle, un groupe tétraphényle, un groupe carbazolyle, dont chacun est substitué par au moins l'un sélectionné parmi deutérium, un groupe méthyle, un groupe éthyle, un groupe n-propyle, un groupe iso-propyle, un groupe n-butyle, un groupe sec-butyle, un groupe iso-butyle, un groupe tert-butyle, un groupe phényle, un groupe biphényle, un groupe terphényle et un groupe naphtyle; et
un groupe phénanthrényle, un groupe anthracényle, un groupe tétraphényle, un groupe carbazolyle, dont chacun peut être substitué par au moins un substituant qui est sélectionné parmi un groupe phényle et un groupe naphtyle, chacun de l'au moins un substituant est substitué par au moins l'un sélectionné parmi deutérium, un groupe méthyle, un groupe éthyle, un groupe n-propyle, un groupe iso-propyle, un groupe n-butyle, un groupe sec-butyle, un groupe iso-butyle, un groupe tert-butyle et un groupe phényle: 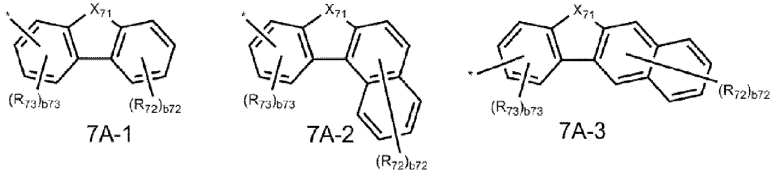 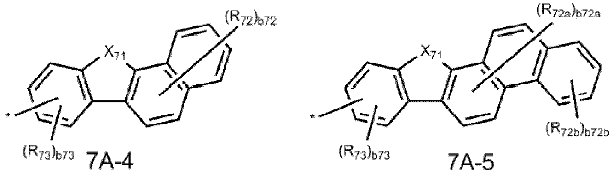 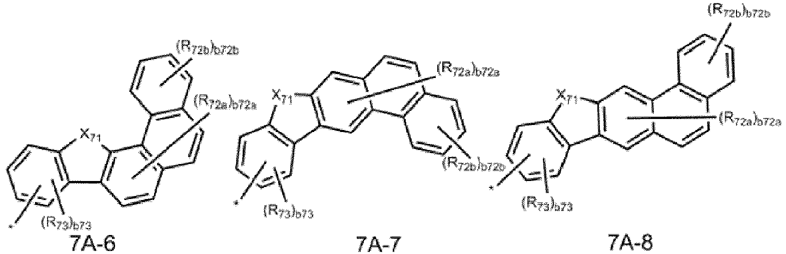 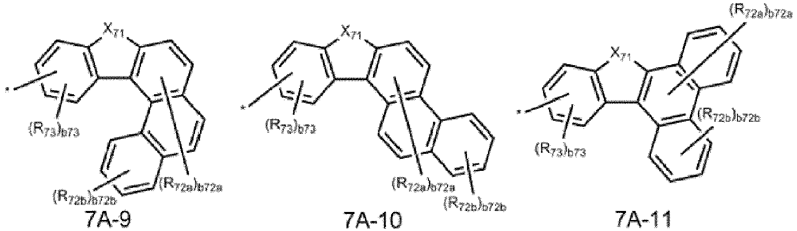 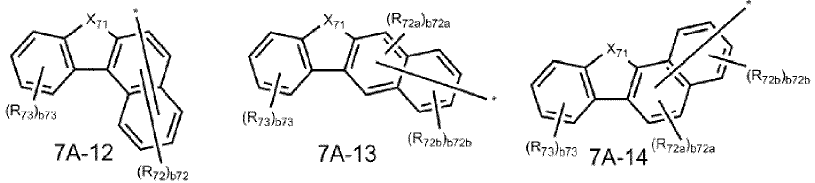 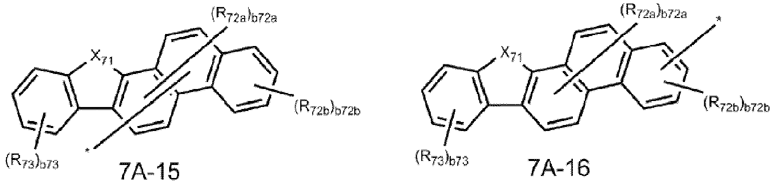 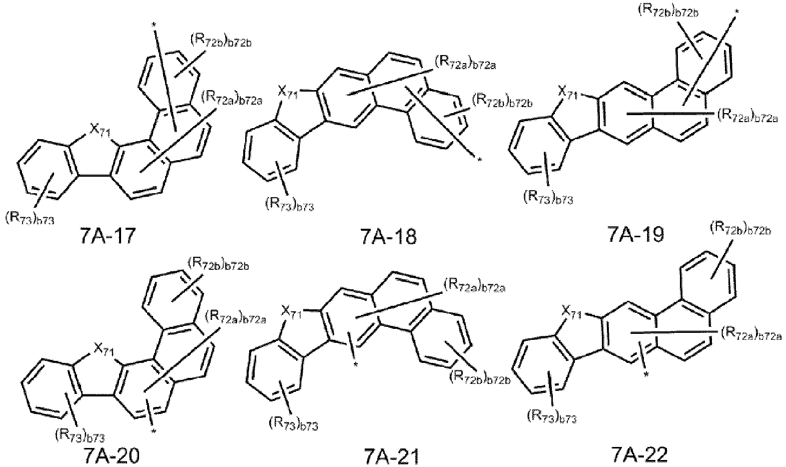 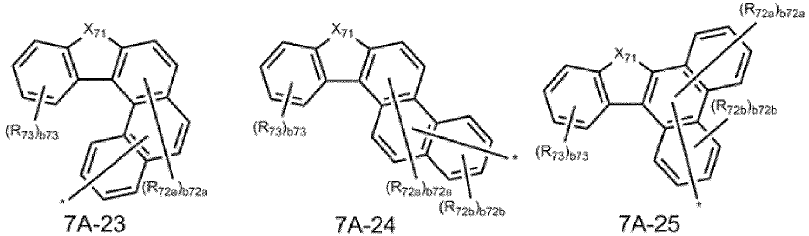 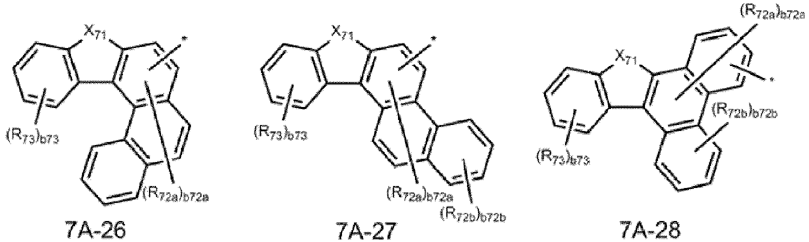 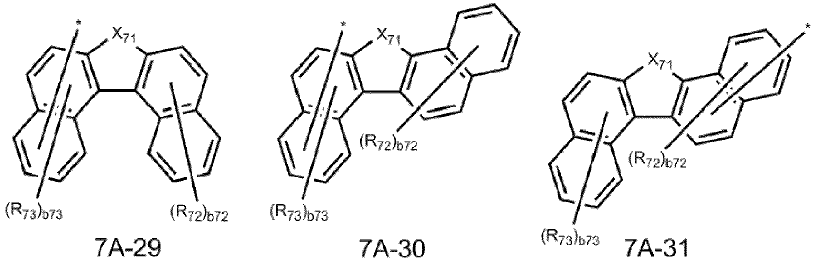 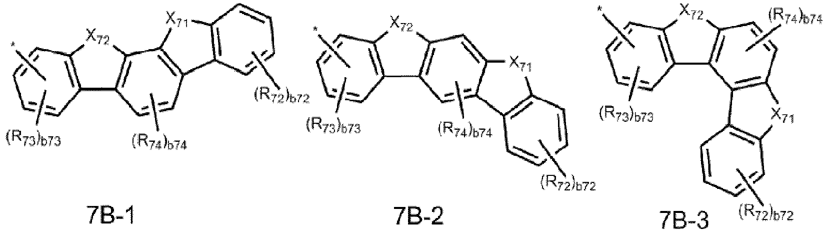 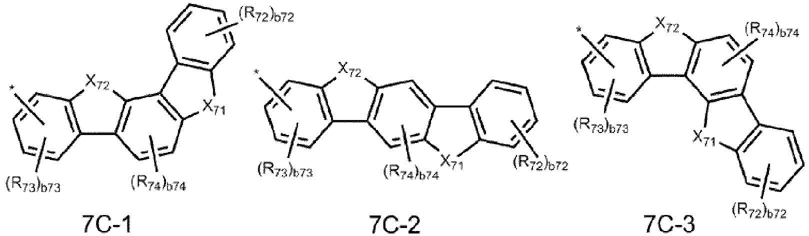 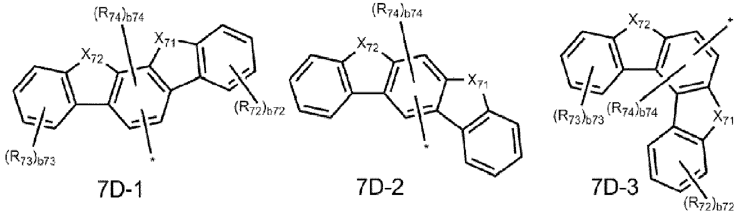 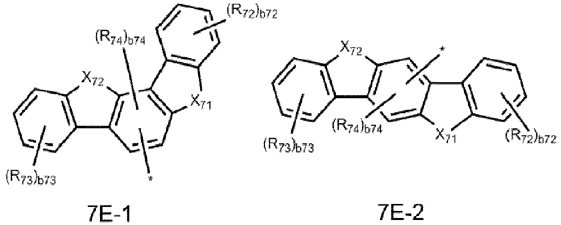 dans les Formules 7A-1 à 7A-31, 7B-1 à 7B-3, 7C-1 à 7C-3, 7D-1 à 7D-3, 7E-1 et 7E-2:
X₇₁ est sélectionné parmi O, S, N(R₇₅) et C(R₇₅)(R₇₆),
X₇₂ est sélectionné parmi O, S, N(R₇₇) et C(R₇₇)(R₇₈);
R₇₂ à R₇₈, R₇₂ₐ et R_{72b} sont chacun de manière indépendante sélectionnés parmi le groupe qui est constitué par:
hydrogène, deutérium, un groupe méthyle, un groupe éthyle, un groupe n-propyle, un groupe iso-propyle, un groupe n-butyle, un groupe sec-butyle, un groupe iso-butyle, un groupe tert-butyle, un groupe phényle, un groupe biphényle, un groupe terphényle et un groupe naphtyle; et
un groupe phényle, un groupe biphényle et un groupe naphtyle, dont chacun est substitué par au moins l'un sélectionné parmi deutérium, un groupe méthyle, un groupe éthyle, un groupe n-propyle, un groupe iso-propyle, un groupe n-butyle, un groupe sec-butyle, un groupe iso-butyle, un groupe tert-butyle et un groupe phényle;
R₇₅ et R₇₆ sont en option liés pour former un cycle;
R₇₇ et R₇₈ sont en option liés pour former un cycle;
b72 à b74, b72a et b72b sont chacun de manière indépendante sélectionnés parmi 1, 2, 3, 4, 5, 6, 7 et 8; et
* indique un site de liaison sur un atome voisin;
L₇₁ₐ et L_{71b} sont chacun de manière indépendante sélectionnés parmi un groupe C₆-C₆₀ arylène substitué ou non substitué, un groupe C₁-C₆₀ hétéroarylène substitué ou non substitué, un groupe divalent non aromatique condensé polycyclique substitué ou non substitué et un groupe divalent non aromatique condensé hétéropolycyclique substitué ou non substitué;
a71a et a71b sont chacun de manière indépendante sélectionnés parmi 0, 1, 2 et 3; et
dans lequel Q₁ à Q₃ sont chacun de manière indépendante sélectionnés parmi hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alkényle, un groupe C₂-C₆₀ alkynyle, un groupe C₁-C₆₀ alcoxy, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₁-C₆₀ hétéroaryle, un groupe monovalent non aromatique condensé polycyclique, un groupe monovalent non aromatique condensé hétéropolycyclique, un groupe biphényle et un groupe terphényle.

14. Dispositif électroluminescent organique (10) selon l'une quelconque des revendications 1 à 13, dans lequel:
le deuxième composé qui est représenté par la Formule 2 est représenté par une Formule qui est sélectionnée parmi les Formules 2-1 et 2-2: 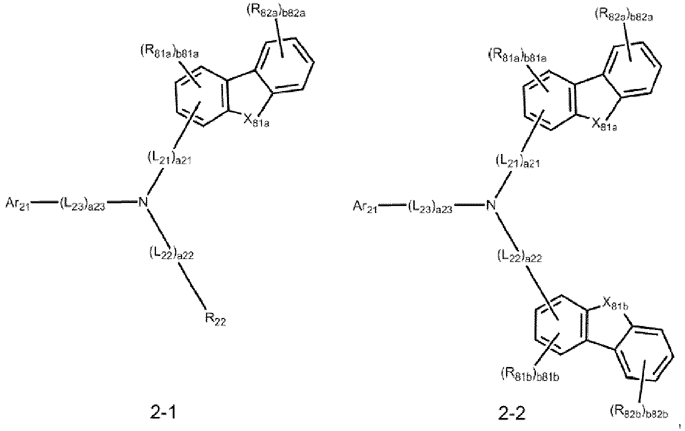 dans lequel, dans les Fomules 2-1 et 2-2:
Ar₂₁ est sélectionné parmi un groupe C₅-C₆₀ carbocyclique substitué ou non substitué et un groupe C₁-C₆₀ hétérocyclique substitué ou non substitué;
L₂₁ à L₂₃ sont chacun de manière indépendante sélectionnés parmi un groupe C₆-C₆₀ arylène substitué ou non substitué et un groupe C₁-C₆₀ hétéroarylène substitué ou non substitué;
a21 à a23 sont chacun de manière indépendante sélectionnés parmi 0, 1, 2 et 3;
R₂₂ est sélectionné parmi un groupe C₆-C₆₀ aryle substitué ou non substitué, un groupe C₁-C₆₀ hétéroaryle substitué ou non substitué, un groupe monovalent non aromatique condensé polycyclique substitué ou non substitué et un groupe monovalent non aromatique condensé hétéropolycyclique substitué ou non substitué;
X₈₁ₐ et X_{81b} sont chacun de manière indépendante sélectionnés parmi O et S;
R₈₁ₐ, R_{81b}, R₈₂ₐ et R_{82b} sont chacun de manière indépendante sélectionnés parmi le groupe qui est constitué par:
-F, -Cl, -Br, -I, un groupe cyano, un groupe C₁-C₆₀ alkyle, un groupe C₃-C₁₀ cycloalkyle, un groupe C₁-C₁₀ hétérocycloalkyle, un groupe C₆-C₆₀ aryle, un groupe C₆-C₆₀ aryloxy, un groupe C₆-C₆₀ arylthio, un groupe C₁-C₆₀ hétéroaryle et -Si(Q₁)(Q₂)(Q₃); et
un groupe C₃-C₁₀ cycloalkyle, un groupe C₁-C₁₀ hétérocycloalkyle, un groupe C₆-C₆₀ aryle, un groupe C₆-C₆₀ aryloxy, un groupe C₆-C₆₀ arylthio et un groupe C₁-C₆₀ hétéroaryle, dont chacun est substitué par au moins l'un sélectionné parmi -F, -Cl, -Br, -I, un groupe cyano et un groupe C₁-C₆₀ alkyle;
b81a et b81b sont chacun de manière indépendante sélectionnés parmi 0, 1, 2 et 3;
b82a et b82b sont chacun de manière indépendante sélectionnés parmi 0, 1, 2, 3 et 4;
une somme de b81a et de b82a est égale à 1 ou plus;
une somme de b81b et de b82b est égale à 1 ou plus; et
Q₁ à Q₃ sont sélectionnés chacun de manière indépendante parmi hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alkényle, un groupe C₂-C₆₀ alkynyle, un groupe C₁-C₆₀ alcoxy, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₁-C₆₀ hétéroaryle, un groupe monovalent non aromatique condensé polycyclique, un groupe monovalent non aromatique condensé hétéropolycyclique, un groupe biphényle et un groupe terphényle.

15. Dispositif électroluminescent organique (10) selon l'une quelconque des revendications 1 à 14, dans lequel:
la couche organique (150) comprend une couche d'émission;
la couche d'émission comprend le premier composé et un dopant; et
le dopant comprend un composé arylamine ou un composé styrylamine.

16. Dispositif électroluminescent organique (10) selon l'une quelconque des revendications 1 à 15, dans lequel:
la couche organique (150) comprend une couche d'émission;
la couche d'émission comprend le premier composé et un composé qui est représenté par la Formule 501: 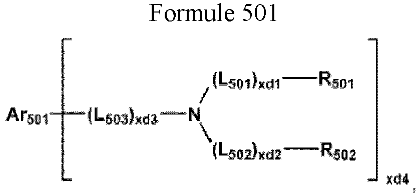 dans lequel, dans la Formule 501:
Ar₅₀₁ est sélectionné parmi un groupe C₅-C₆₀ carbocyclique substitué ou non substitué et un groupe C₁-C₆₀ hétérocyclique substitué ou non substitué;
L₅₀₁ à L₅₀₃ sont chacun de manière indépendante sélectionnés parmi un groupe C₃-C₁₀ cycloalkylène substitué ou non substitué, un groupe C₁-C₁₀ hétérocycloalkylène substitué ou non substitué, un groupe C₃-C₁₀ cycloalkénylène substitué ou non substitué, un groupe C₁-C₁₀ hétérocycloalkénylène substitué ou non substitué, un groupe C₆-C₆₀ arylène substitué ou non substitué, un groupe C₁-C₆₀ hétéroarylène substitué ou non substitué, un groupe divalent non aromatique condensé polycyclique substitué ou non substitué et un groupe divalent non aromatique condensé hétéropolycyclique substitué ou non substitué;
xd1 à xd3 sont chacun de manière indépendante un entier sélectionné parmi 0 à 3;
R₅₀₁ et R₅₀₂ sont chacun de manière indépendante sélectionnés parmi un groupe C₃-C₁₀ cycloalkyle substitué ou non substitué, un groupe C₁-C₁₀ hétérocycloalkyle substitué ou non substitué, un groupe C₃-C₁₀cycloalkényle substitué ou non substitué, un groupe C₁-C₁₀ hétérocycloalkényle substitué ou non substitué, un groupe C₆-C₆₀ aryle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe monovalent non aromatique condensé polycyclique substitué ou non substitué et un groupe monovalent non aromatique condensé hétéropolycyclique substitué ou non substitué; et
xd4 est un entier sélectionné parmi 1 à 6.

17. Dispositif électroluminescent organique (10) selon l'une quelconque des revendications 1 à 16, dans lequel:
la couche organique (150) comprend:
une couche d'émission; et
une région de transport d'électrons entre la couche d'émission et la seconde électrode (190);
dans lequel la région de transport d'électrons comprend un métal alcalin, un métal alcalino-terreux, un métal des terres rares, un composé de métal alcalin, un composé de métal alcalino-terreux, un composé de métal des terres rares, un complexe de métal alcalin, un complexe de métal alcalino-terreux, un complexe de métal des terres rares ou une combinaison de ceux-ci.

18. Dispositif électroluminescent organique (10) selon la revendication 17, dans lequel:
la région de transport d'électrons comprend une couche de transport d'électrons et une couche d'injection d'électrons;
dans lequel au moins une sélectionnée parmi la couche de transport d'électrons et la couche d'injection d'électrons comprend un métal alcalin, un métal alcalino-terreux, un métal des terres rares, un composé de métal alcalin, un composé de métal alcalino-terreux, un composé de métal des terres rares, un complexe de métal alcalin, un complexe de métal alcalino-terreux, un complexe de métal des terres rares ou une combinaison de ceux-ci.

19. Dispositif électroluminescent organique (10) selon l'une quelconque des revendications 15 à 18, dans lequel:
la couche d'émission est une couche d'émission de lumière de première couleur; et
la couche organique (150) comprend en outre i) au moins une couche d'émission de lumière de deuxième couleur ou ii) au moins une couche d'émission de lumière de deuxième couleur et au moins une couche d'émission de lumière de troisième couleur;
dans lequel une lumière de première couleur de la couche d'émission de lumière de première couleur et une lumière de deuxième couleur de la couche d'émission de lumière de deuxième couleur sont identiques l'une à l'autre ou sont différentes l'une de l'autre; ou la lumière de première couleur, la lumière de deuxième couleur et une lumière de troisième couleur de la couche d'émission de lumière de troisième couleur sont identiques les unes aux autres ou sont différentes les unes des autres; et
la lumière de première couleur et la lumière de deuxième couleur sont émises en tant que lumière mélangée; ou la lumière de première couleur, la lumière de deuxième couleur et la lumière de troisième couleur sont émises en tant que lumière mélangée.
